# EUROPEAN PATENT SPECIFICATION

(11) **EP 3 715 437 B1**
(45) Date of publication and mention of the grant of the patent: **01.12.2021**
(21) Application number: 20165786.3
(22) Date of filing: 26.03.2020
(51) Int. Cl.: C09K 11/06, H05B 33/18, H05B 33/20, H01L 51/00, H01L 51/50

(54) **COMPOSITION AND ORGANIC LIGHT-EMITTING DEVICE INCLUDING THE SAME**
VERBINDUNG UND ORGANISCHE LICHTEMITTIERENDE VORRICHTUNG DAMIT
COMPOSITION ET DISPOSITIF ÉLECTROLUMINESCENT ORGANIQUE LE COMPRENANT

(30) Priority: 29.03.2019 KR 20190037215; 30.10.2019 KR 20190136948
(43) Date of publication of application: 30.09.2020
(73) Proprietor: Samsung Electronics Co., Ltd., Gyeonggi-do 16677 (KR); Samsung SDI Co., Ltd., Gyeonggi-do (KR)
(72) Inventor: LEE, Banglin, 16678 Gyeonggi-do (KR); KANG, Dongmin, Gyeonggi-do (KR); KIM, Soyeon, 16678 Gyeonggi-do (KR); LEE, Jiyoun, 16678 Gyeonggi-do (KR); CHO, Yongsuk, 16678 Gyeonggi-do (KR); CHOI, Jongwon, 16678 Gyeonggi-do (KR); KRAVCHUK, Dmitry, 16678 Gyeonggi-do (KR); KIM, Dongyeong, Gyeonggi-do (KR); KIM, Junseok, Gyeonggi-do (KR); LEE, Namheon, Gyeonggi-do (KR); LEE, Byeonggwan, Gyeonggi-do (KR); LEE, Sangshin, Gyeonggi-do (KR); KOISHIKAWA, Yasushi, 16678 Gyeonggi-do (KR)
(74) Representative: Elkington and Fife LLP

(56) References cited:
- EP-A1- 3 637 489
- WO-A1-2014/112450
- WO-A1-2014/112657
- WO-A1-2014/112658
- WO-A1-2014/123239

## Description

### FIELD OF THE INVENTION

One or more embodiments relate to compositions and organic light-emitting devices including the same.

### BACKGROUND OF THE INVENTION

Organic light-emitting devices are self-emission devices, which have improved characteristics in terms of a viewing angle, a response time, brightness, a driving voltage, and a response speed, and produce full-color images.

In an example, an organic light-emitting device includes an anode, a cathode, and an organic layer between the anode and the cathode, wherein the organic layer includes an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transition from an excited state to a ground state, thereby generating light.

### SUMMARY OF THE INVENTION

One or more embodiments include a novel composition and an organic light-emitting device including the same.

Additional aspects will be set forth in part in the description which follows and, in part, will be apparent from the description, or may be learned by practice of the presented embodiments.

According to an aspect, provided is a composition including
a first compound, a second compound, and a third compound, wherein
the first compound may include a compound represented by Formula 1,
the second compound may include a compound represented by Formula 2, and
the third compound may include a compound represented by Formula 3: 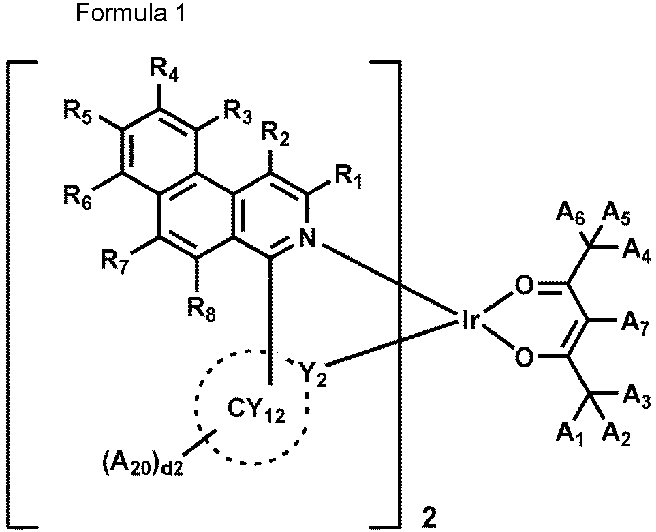 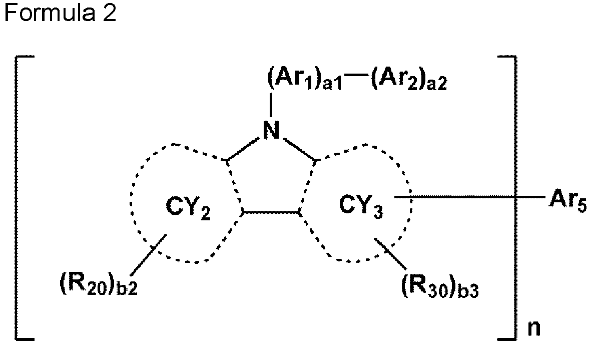 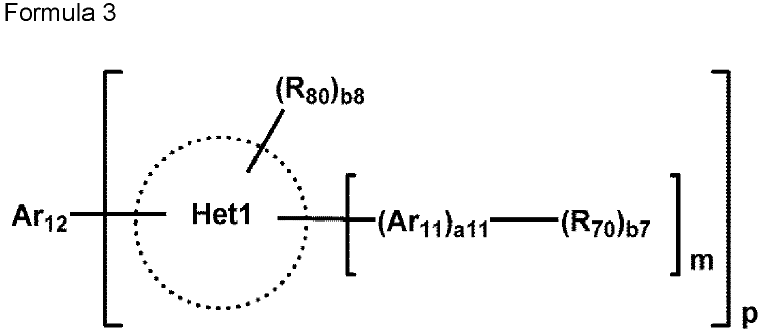
   Y₂ in Formula 1 may be C,
      ring CY₁₂ in Formula 1 may be a C₅-C₆₀ carbocyclic group or a C₁-C₆₀ heterocyclic group,
      Ar₁, Ar₂, and Ar₁₁ in Formulae 2 and 3 may each independently be a C₅-C₆₀ carbocyclic group which is unsubstituted or substituted with at least one R₆₁ or a C₁-C₆₀ heterocyclic group which is unsubstituted or substituted with at least one R₆₁,
      Ar₅ and Ar₁₂ in Formulae 2 and 3 may each independently be a single bond, a C₅-C₆₀ carbocyclic group which is unsubstituted or substituted with at least one R₆₅, or a C₁-C₆₀ heterocyclic group which is unsubstituted or substituted with at least one R₆₅, or may not exist,
      n in Formula 2 may be 1, 2, or 3, and when n is 1, Ar₅ does not exist,
      p in Formula 3 may be 1, 2, or 3, and when p is 1, Ar₁₂ does not exist,
      a1 and a2 in Formula 2 may each independently be an integer from 0 to 5, and the sum of a1 and a2 may be 1 or more,
      ring CY₂ and ring CY₃ in Formula 2 may each independently be a C₅-C₆₀ carbocyclic group or a C₁-C₆₀ heterocyclic group, and ring CY₂ and ring CY₃ may be optionally linked to each other with a C₅-C₆₀ carbocyclic group which is unsubstituted or substituted with at least one R₆₆ or a C₁-C₆₀ heterocyclic group which is unsubstituted or substituted with at least one R₆₆ therebetween,
      Het1 in Formula 3 may be a π electron-depleted nitrogen-containing C₁-C₆₀ cyclic group,
      a11 and m in Formula 3 may each independently be an integer from 1 to 10,
      R₁ to R₈, A₂₀, A₁ to A₇, R₂₀, R₃₀, R₆₁, R₆₅, R₆₆, R₇₀, and R₈₀ in Formulae 1 to 3 may each independently be hydrogen, deuterium, -F, -CI, -Br, -I, -SF₅, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₂-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅),-Ge(Q₃)(Q₄)(Q₅), -B(Q₆)(Q₇), -P(=O)(Q₈)(Q₉), or -P(Q₈)(Q₉),
   b2, b3, b7, and b8 in Formulae 2 and 3 may each independently be an integer from 0 to 20, when b2 is 2 or more, two or more R₂₀(s) may be identical to or different from each other, when b3 is 2 or more, two or more R₃₀(s) may be identical to or different from each other, when b7 is 2 or more, two or more R₇₀(s) may be identical to or different from each other, and when b8 is 2 or more, two or more R₈₀(s) may be identical to or different from each other,
   d2 may be an integer from 0 to 10, and when d2 is 2 or more, two or more A₂₀(s) may be identical to or different from each other,
   at least one of R₁ to R₈, A₂₀, or any combination thereof may comprise at least one fluoro group (-F),
      two or more of R₁ to R₈ and A₂₀ in Formula 1 may optionally be linked to form a C₅-C₆₀ carbocyclic group which is unsubstituted or substituted with at least one R₁ₐ or a C₁-C₆₀ heterocyclic group which is unsubstituted or substituted with at least one R₁ₐ,
      two or more of A₁ to A₇ in Formula 1 may optionally be linked to form a C₅-C₆₀ carbocyclic group which is unsubstituted or substituted with at least one R₁ₐ or a C₁-C₆₀ heterocyclic group which is unsubstituted or substituted with at least one R₁ₐ,
      two or more of ring CY₂, ring CY₃, R₂₀, and R₃₀ in Formula 2 may optionally be linked to form a C₅-C₆₀ carbocyclic group which is unsubstituted or substituted with at least one R₁ₐ or a C₁-C₆₀ heterocyclic group which is unsubstituted or substituted with at least one R₁ₐ,
      R₁ₐ is the same as described in connection with A₇,
      a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₂-C₁₀ heterocycloalkyl group, the substituted C₃-C₁₀ cycloalkenyl group, the substituted C₂-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group may be:
         deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group;
         a C₁-C₆₀ alkyl group, a C₂-C₆₀ alkenyl group, a C₂-C₆₀ alkynyl group, or a C₁-C₆₀ alkoxy group, each substituted with deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₃-C₁₀ cycloalkyl group, a C₂-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂),-Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉), or any combination thereof;
         a C₃-C₁₀ cycloalkyl group, a C₂-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₂-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅),-B(Q₂₆)(Q₂₇), -P(=O)(Q₂₈)(Q₂₉), -P(Q₂₈)(Q₂₉), or any combination thereof;
         -N(Q₃₁)(Q₃₂), -Si(Q₃₃)(Q₃₄)(Q₃₅), -Ge(Q₃₃)(Q₃₄)(Q₃₅), -B(Q₃₆)(Q₃7),-P(=O)(Q₃₈)(Q₃₉), or -P(Q₃₈)(Q₃₉); or
         any combination thereof, and
         wherein Q₁ to Q₉, Q₁₁ to Q₁₉, Q₂₁ to Q₂₉, and Q₃₁ to Q₃₉ are each independently hydrogen; deuterium; -F; -CI; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group, unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₃-C₁₀ cycloalkyl group; a C₂-C₁₀ heterocycloalkyl group; a C₃-C₁₀ cycloalkenyl group; a C₂-C₁₀ heterocycloalkenyl group; a C₆-C₆₀ aryl group, unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group;
   a C₁-C₆₀ heteroaryl group; a monovalent non-aromatic condensed polycyclic group;
   or a monovalent non-aromatic condensed heteropolycyclic group.

Another aspect provides an organic light-emitting device including: a first electrode; a second electrode; and an organic layer disposed between the first electrode and the second electrode and including an emission layer, wherein the organic layer includes the composition including the first compound, the second compound and the third compound.

The composition may be included in the emission layer of the organic layer, and the first compound included in the emission layer may act as a dopant. A similar composition is known from e.g. WO 2014/112450 A1.

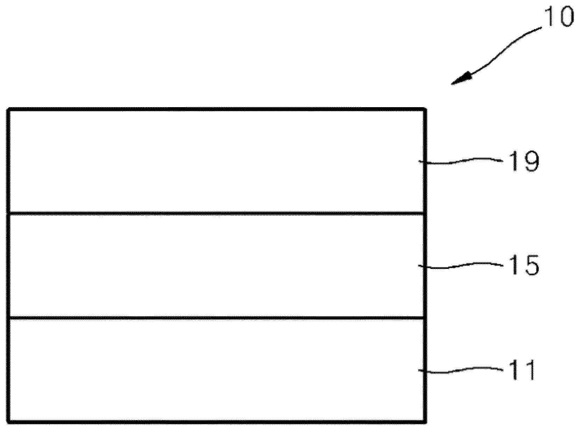

### BRIEF DESCRIPTION OF THE DRAWING

The above and other aspects, features, and advantages of certain embodiments of the disclosure will be more apparent from the following description taken in conjunction with FIGURE which is a schematic cross-sectional view of an organic light-emitting device according to an embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a," "an," "the," and "at least one" do not denote a limitation of quantity, and are intended to cover both the singular and plural, unless the context clearly indicates otherwise. For example, "an element" has the same meaning as "at least one element," unless the context clearly indicates otherwise.

"Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

A composition according to an embodiment may include a first compound, a second compound, and a third compound, and the first compound may include a compound represented by Formula 1, the second compound may include a compound represented by Formula 2, and the third compound may include a compound represented by Formula 3:

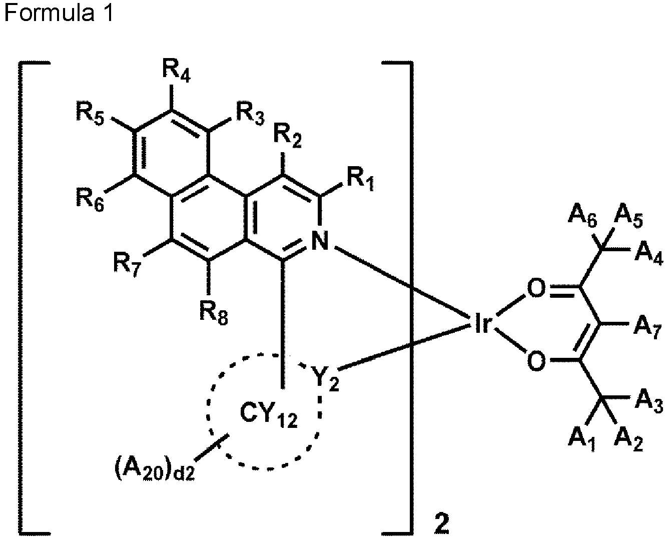

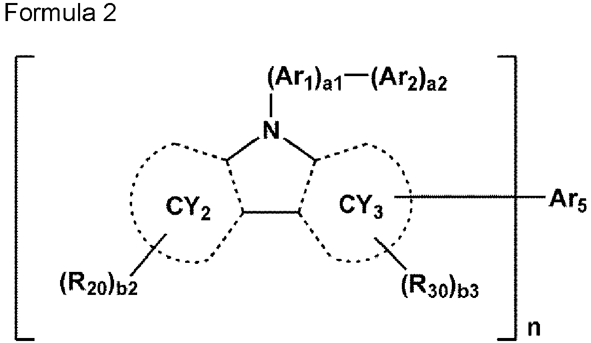

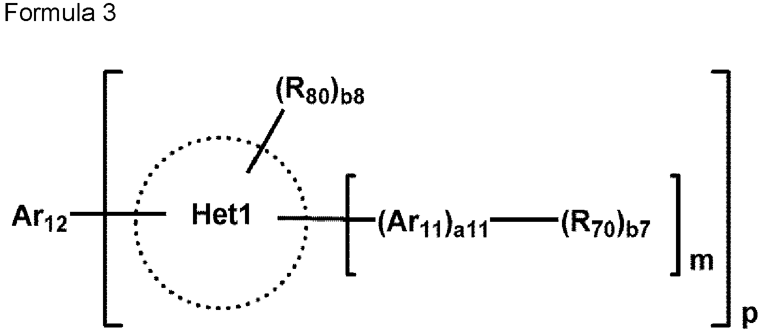

The first compound may include one compound encompassed in the first compound represented by Formula 1 only or at least two different compounds encompassed in the first compound represented by Formula 1.

The second compound may include one compound encompassed in the second compound represented by Formula 2 only or at least two different compounds encompassed in the second compound represented by Formula 2.

The third compound may include one compound encompassed in the third compound represented by Formula 3 only or at least two different compounds encompassed in the third compound represented by Formula 3.

The first compound, the second compound and the third compound may be different from each other.

### Description of Formula 1

Y₂ in Formula 1 may be C.

A ring CY₁₂ in Formula 1 may be a C₅-C₆₀ carbocyclic group or a C₁-C₆₀ heterocyclic group.

For example, the ring CY₁₂ in Formula 1 may be i) a third ring, ii) a fourth ring, iii) a condensed cyclic group in which two or more third rings are condensed with each other, iv) a condensed cyclic group in which two or more fourth rings are condensed with each other, or v) a condensed cyclic group in which at least one third ring is condensed with at least one fourth ring,
the third ring may be a cyclopentane group, a cyclopentadiene group, a furan group, a thiophene group, a pyrrole group, a silole group, an indene group, a benzofuran group, a benzothiophene group, an indole group, a benzosilole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, or a triazasilole group, and
the fourth ring may be an adamantane group, a norbornene group, a bicyclo[1.1.1]pentane group, a bicyclo[2.1.1]hexane group, a bicyclo[2.2.1]heptane group (a norbornane group), a bicyclo[2.2.2]octane group, a cyclohexane group, a cyclohexene group, a benzene group, a pyridine group, a pyrimidine group, a pyrazine group, a pyridazine group, or a triazine group.

In one or more embodiments, the ring CY₁₂ in Formula 1 may be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a thiophene group, a furan group, a pyrrole group, a cyclopentadiene group, a silole group, a borole group, a phosphole group, a selenophene group, a germole group, a benzothiophene group, a benzofuran group, an indole group, an indene group, a benzosilole group, a benzoborole group, a benzophosphole group, a benzoselenophene group, a benzogermole group, a dibenzothiophene group, a dibenzofuran group, a carbazole group, a fluorene group, a dibenzosilole group, a dibenzoborole group, a dibenzophosphole group, a dibenzoselenophene group, a dibenzogermole group, a dibenzothiophene 5-oxide group, 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group.

In one or more embodiments, the ring CY₁₂ may be a benzene group, a naphthalene group, a 1, 2, 3, 4-tetrahydronaphthalene group, a thiophene group, a furan group, a pyrrole group, a cyclopentadiene group, a silole group, a benzothiophene group, a benzofuran group, an indole group, an indene group, a benzosilole group, a dibenzothiophene group, a dibenzofuran group, a carbazole group, a fluorene group, or a dibenzosilole group.

R₁ to R₈, A₂₀ and A₁ to A₇ in Formula 1 may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₂-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or -P(Q₈)(Q₉). Q₁ to Q₉ are the same as described herein.

In embodiments, A₂₀ in Formula 1 may include neither a fluoro group (-F) nor a cyano group. For example, A₂₀ may be a group that includes neither a fluoro group (-F) nor a cyano group.

In one or more embodiments, R₁ to R₈, A₂₀ and A₁ to A₇ in Formula 1 may each independently be:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, or a C₁-C₂₀ alkoxy group;
a C₁-C₂₀ alkyl group or a C₁-C₂₀ alkoxy group, each substituted with deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterium-containing C₁-C₂₀ alkyl group, a fluorinated C₁-C₂₀ alkyl group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group (a norbornyl group), a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a pyridinyl group, a pyrimidinyl group, or any combination thereof;
a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, - CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterium-containing C₁-C₂₀ alkyl group, a fluorinated C₁-C₂₀ alkyl group, a C₁-C₂₀ alkoxy group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof; or
-N(Q₁)(Q₂), -Si(Q₃)(Q₄)(Q₅), -Ge(Q₃)(Q₄)(Q₅), -B(Q₆)(Q₇), -P(=O)(Q₈)(Q₉), or -P(Q₈)(Q₉),
Q₁ to Q₉ may each independently be:
   -CH₃, -CD₃, -CD₂H, -CDH₂, -CH₂CH₃, -CH₂CD₃, -CH₂CD₂H, -CH₂CDH₂,-CHDCH₃, -CHDCD₂H, -CHDCDH₂, -CHDCD₃, -CD₂CD₃, -CD₂CD₂H or -CD₂CDH₂; or
   an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₂₀ alkyl group, a phenyl group, or any combination thereof. Herein, A₂₀ in Formula 1 may include neither a fluoro group (-F) nor a cyano group.

In one or more embodiments, R₁ to R₈, A₂₀ and A₁ to A₇ in Formula 1 may each independently be hydrogen, deuterium, -F, a substituted or unsubstituted C₁-C₂₀ alkyl group, a substituted or unsubstituted C₃-C₁₀ cycloalkyl group, a substituted or unsubstituted C₂-C₁₀ heterocycloalkyl group, a substituted or unsubstituted phenyl group, - Si(Q₃)(Q₄)(Q₅), or -Ge(Q₃)(Q₄)(Q₅). Herein, A₂₀ may include neither a fluoro group nor a cyano group.

In one or more embodiments, R₁ to R₈ and A₁ to A₇ in Formula 1 may each independently be:
hydrogen, deuterium, or -F;
a C₁-C₂₀ alkyl group, a C₃-C₁₀ cycloalkyl group, a C₂-C₁₀ heterocycloalkyl group, or a phenyl group, each unsubstituted or substituted with deuterium, -F, C₁-C₂₀ alkyl group, a C₃-C₁₀ cycloalkyl group, a C₂-C₁₀ heterocycloalkyl group, a phenyl group, or any combination thereof; or
-Si(Q₃)(Q₄)(Q₅), or -Ge(Q₃)(Q₄)(Q₅).

In one or more embodiments, A₂₀ in Formula 1 may be:
hydrogen or deuterium;
a C₁-C₂₀ alkyl group, a C₃-C₁₀ cycloalkyl group, a C₂-C₁₀ heterocycloalkyl group, or a phenyl group, each unsubstituted or substituted with deuterium, a C₁-C₂₀ alkyl group, a C₃-C₁₀ cycloalkyl group, a C₂-C₁₀ heterocycloalkyl group, a phenyl group, or any combination thereof; or
-Si(Q₃)(Q₄)(Q₅), or -Ge(Q₃)(Q₄)(Q₅).

The designation d2 in Formula 1 indicates the number of A₂₀(s), and may be an integer from 0 to 10. When d2 is 2 or more, two or more A₂₀(s) may be identical to or different from each other. For example, d2 may be an integer from 0 to 6.

For example, at least one of R₁ to R₈, A₂₀ or any combination thereof in Formula 1 may include at least one fluoro group (-F).

For example, at least one of R₁ to R₈ (for example, at least one of R₂ to R₈, or at least one of R₃ to R₆) of Formula 1 may include at least one fluoro group (-F).

For example, at least one of R₁ to R₈ (for example, at least one of R₂ to R₈, or at least one of R₃ to R₆) of Formula 1 may be a group including at least one fluoro group (-F).

In one or more embodiments, at least one of R₁ to R₈ in Formula 1 may each independently be:
a fluoro group (-F); or
a fluorinated C₁-C₂₀ alkyl group, a fluorinated C₃-C₁₀ cycloalkyl group, a fluorinated C₂-C₁₀ heterocycloalkyl group, or a fluorinated phenyl group, each unsubstituted or substituted with deuterium, a C₁-C₂₀ alkyl group, a C₃-C₁₀ cycloalkyl group, a C₂-C₁₀ heterocycloalkyl group, a phenyl group, or any combination thereof.

In one or more embodiments, at least one of A₁ to A₆ in Formula 1 may each independently be a substituted or unsubstituted C₂-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₂-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

In one or more embodiments, at least one of A₁ to A₆ in Formula 1 may each independently be a substituted or unsubstituted C₂-C₆₀ alkyl group, a substituted or unsubstituted C₃-C₁₀ cycloalkyl group, or a substituted or unsubstituted C₂-C₁₀ heterocycloalkyl group.

In one or more embodiments, at least one of A₁ to A₃ and at least one of A₄ to A₆ in Formula 1 may each independently be a substituted or unsubstituted C₂-C₆₀ alkyl group, a substituted or unsubstituted C₃-C₁₀ cycloalkyl group, or a substituted or unsubstituted C₂-C₁₀ heterocycloalkyl group.

In one or more embodiments, at least one of A₁ to A₆ in Formula 1 may each independently be a C₂-C₆₀ alkyl group, a C₃-C₁₀ cycloalkyl group, or a C₂-C₁₀ heterocycloalkyl group, each unsubstituted or substituted with deuterium, -F, a C₁-C₂₀ alkyl group, a C₃-C₁₀ cycloalkyl group, a C₂-C₁₀ heterocycloalkyl group, or any combination thereof.

In one or more embodiments, A₁ to A₆ in Formula 1 may each independently be a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₂-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

In one or more embodiments, A₁ to A₆ in Formula 1 may each independently be a substituted or unsubstituted C₁-C₆₀ alkyl group, a substituted or unsubstituted C₃-C₁₀ cycloalkyl group, or a substituted or unsubstituted C₂-C₁₀ heterocycloalkyl group.

In one or more embodiments, A₁ to A₆ in Formula 1 may each independently be a C₁-C₆₀ alkyl group, a C₃-C₁₀ cycloalkyl group, or a C₂-C₁₀ heterocycloalkyl group, each unsubstituted or substituted with deuterium, -F, a C₁-C₂₀ alkyl group, a C₃-C₁₀ cycloalkyl group, a C₂-C₁₀ heterocycloalkyl group, or any combination thereof.

In one or more embodiments, A₇ in Formula 1 may be hydrogen or deuterium.

In one or more embodiments, A₇ in Formula 1 may not be hydrogen.

In one or more embodiments, A₇ in Formula 1 may be a substituted or unsubstituted C₁-C₆₀ alkyl group, a substituted or unsubstituted C₃-C₁₀ cycloalkyl group, or a substituted or unsubstituted C₂-C₁₀ heterocycloalkyl group.

In one or more embodiments, A₇ in Formula 1 may be a C₁-C₆₀ alkyl group, a C₃-C₁₀ cycloalkyl group, or a C₂-C₁₀ heterocycloalkyl group, each unsubstituted or substituted with deuterium, -F, a C₁-C₂₀ alkyl group, a C₃-C₁₀ cycloalkyl group, a C₂-C₁₀ heterocycloalkyl group, or any combination thereof.

For example, R₁ to R₈, A₂₀ and A₁ to A₇ in Formula 1 may each independently be hydrogen, deuterium, -F, -CH₃, -CD₃, -CD₂H, -CDH₂, -CF₃, -CF₂H, -CFH₂, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-233, a group represented by one of Formulae 9-201 to 9-233 in which at least one hydrogen is substituted with deuterium, a group represented by one of Formulae 9-201 to 9-233 in which at least one hydrogen is substituted with -F, a group represented by one of Formulae 10-1 to 10-126, a group represented by one of Formulae 10-1 to 10-126 in which at least one hydrogen is substituted with deuterium, a group represented by one of Formulae 10-1 to 10-126 in which at least one hydrogen is substituted with -F, a group represented by one of Formulae 10-201 to 10-343, a group represented by one of Formulae 10-201 to 10-343 in which at least one hydrogen is substituted with deuterium, a group represented by one of Formulae 10-201 to 10-343 in which at least one hydrogen is substituted with -F, - Si(Q₃)(Q₄)(Q₅), or -Ge(Q₃)(Q₄)(Q₅) (herein Q₃ to Q₅ are the same as described in the present specification), and at least one of R₁ to R₈ (for example, at least one of R₂ to R₈, or at least one of R₃ to R₆) may be -F, -CF₃, -CF₂H, -CFH₂, a group represented by one of Formulae 9-1 to 9-39 in which at least one hydrogen is substituted with -F, a group represented by one of Formulae 9-201 to 9-233 in which at least one hydrogen is substituted with -F, a group represented by one of Formulae 10-1 to 10-126 in which at least one hydrogen is substituted with -F, or a group represented by one of Formulae 10-201 to 10-343 in which at least one hydrogen is substituted with -F.

In one or more embodiments, A₂₀ in Formula 1 may be hydrogen, deuterium, -CH₃, -CD₃, -CD₂H, -CDH₂, a group represented by one of Formulae 9-1 to 9-39, a group represented by one of Formulae 9-1 to 9-39 in which at least one hydrogen is substituted with deuterium, a group represented by one of Formulae 9-201 to 9-233, a group represented by one of Formulae 9-201 to 9-233 in which at least one hydrogen is substituted with deuterium, a group represented by one of Formulae 10-1 to 10-126, a group represented by one of Formulae 10-1 to 10-126 in which at least one hydrogen is substituted with deuterium, a group represented by one of Formulae 10-201 to 10-343, a group represented by one of Formulae 10-201 to 10-343 in which at least one hydrogen is substituted with deuterium, -Si(Q₃)(Q₄)(Q₅), or -Ge(Q₃)(Q₄)(Q₅) (herein Q₃ to Q₅ are the same as described in the present specification).

In one or more embodiments, at least one of A₁ to A₆ in Formula 1 may each independently be a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-233, a group represented by one of Formulae 9-201 to 9-233 in which at least one hydrogen is substituted with deuterium, a group represented by one of Formulae 9-201 to 9-233 in which at least one hydrogen is substituted with -F, a group represented by one of Formulae 10-1 to 10-126, a group represented by one of Formulae 10-1 to 10-126 in which at least one hydrogen is substituted with deuterium, a group represented by one of Formulae 10-1 to 10-126 in which at least one hydrogen is substituted with -F, a group represented by one of Formulae 10-201 to 10-343, a group represented by one of Formulae 10-201 to 10-343 in which at least one hydrogen is substituted with deuterium, or a group represented by one of Formulae 10-201 to 10-343 in which at least one hydrogen is substituted with -F.

In one or more embodiments, A₁ to A₆ in Formula 1 may each independently be - CH₃, -CD₃, -CD₂H, -CDH₂, -CF₃, -CF₂H, -CFH₂, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-233, a group represented by one of Formulae 9-201 to 9-233 in which at least one hydrogen is substituted with deuterium, a group represented by one of Formulae 9-201 to 9-233 in which at least one hydrogen is substituted with -F, a group represented by one of Formulae 10-1 to 10-126, a group represented by one of Formulae 10-1 to 10-126 in which at least one hydrogen is substituted with deuterium, a group represented by one of Formulae 10-1 to 10-126 in which at least one hydrogen is substituted with -F, a group represented by one of Formulae 10-201 to 10-343, a group represented by one of Formulae 10-201 to 10-343 in which at least one hydrogen is substituted with deuterium, or a group represented by one of Formulae 10-201 to 10-343 in which at least one hydrogen is substituted with -F: 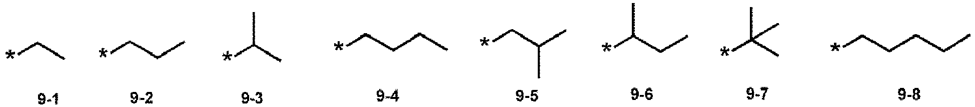 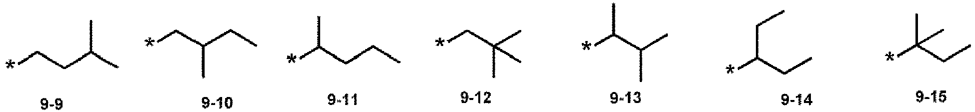 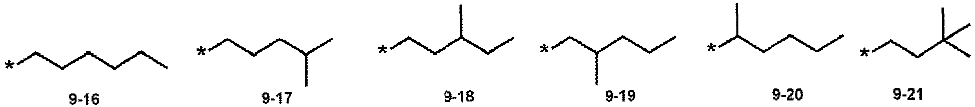 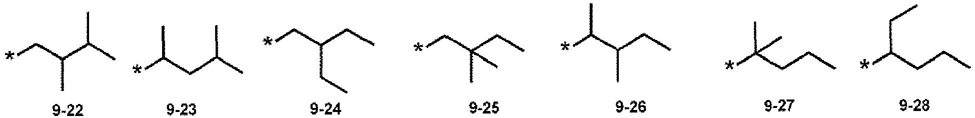 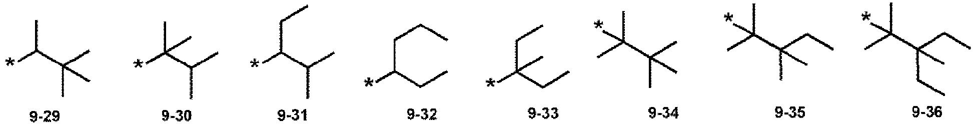 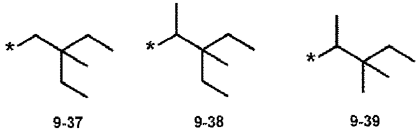 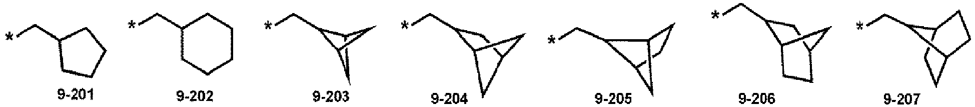 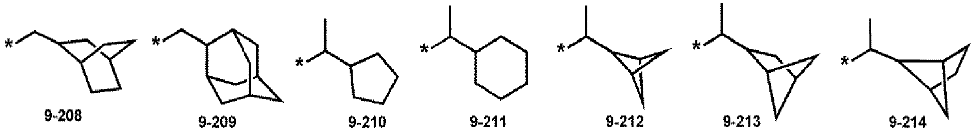 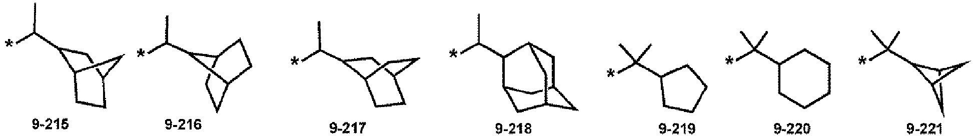 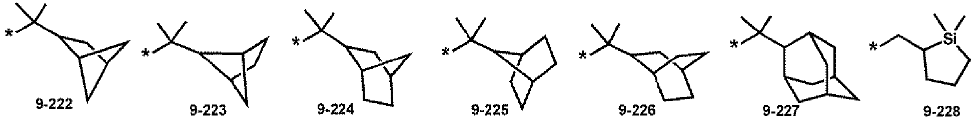 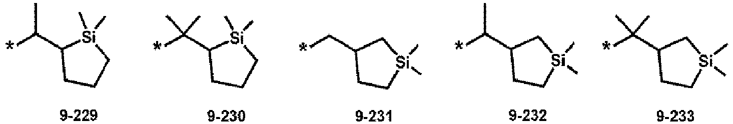 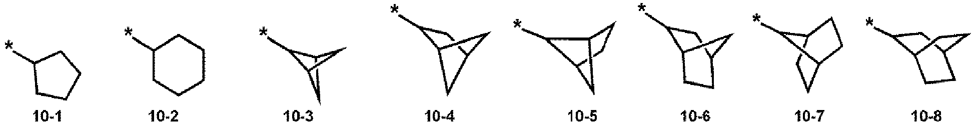 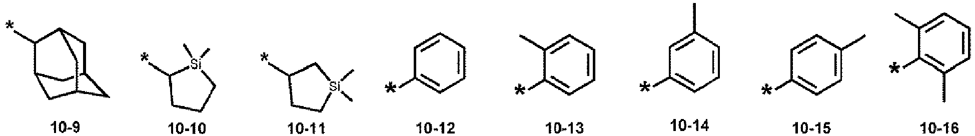 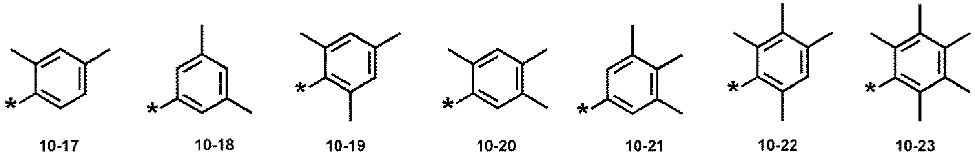 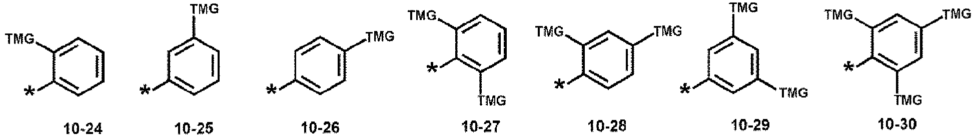 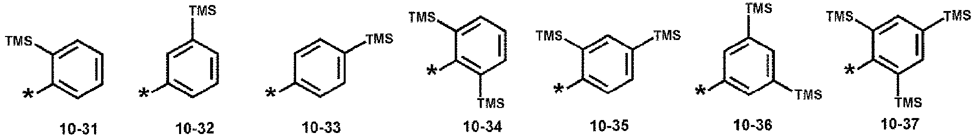 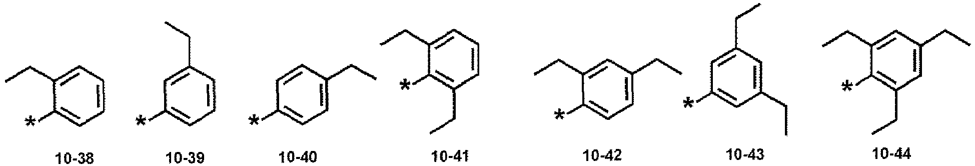 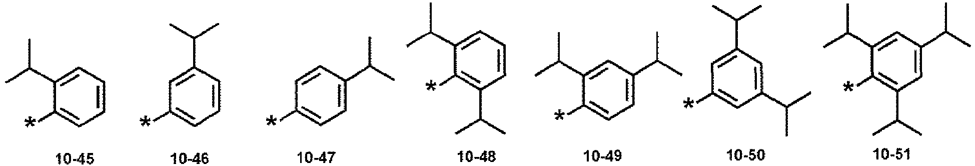 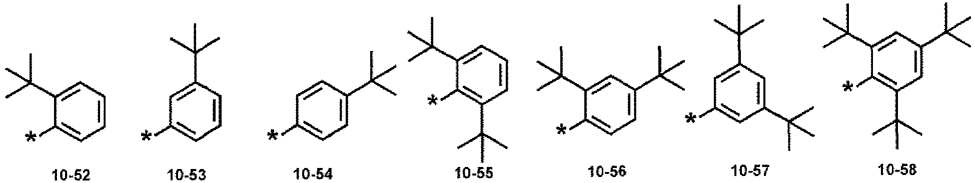 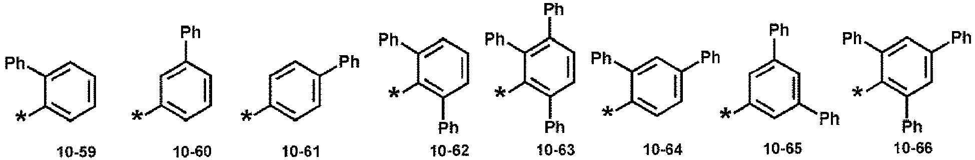 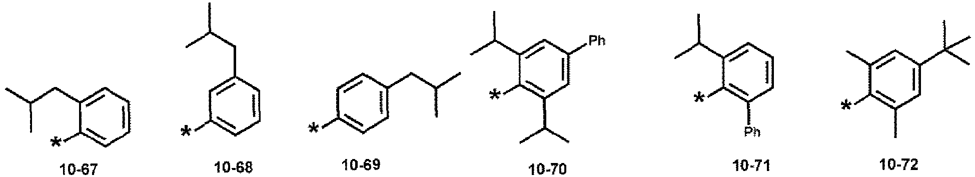 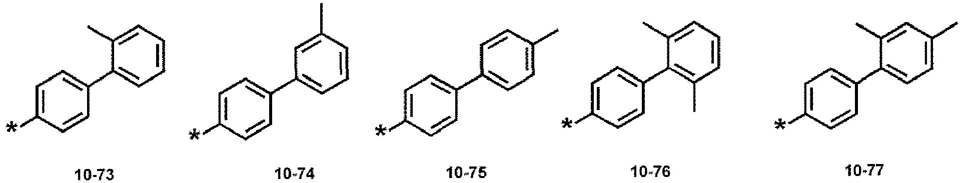 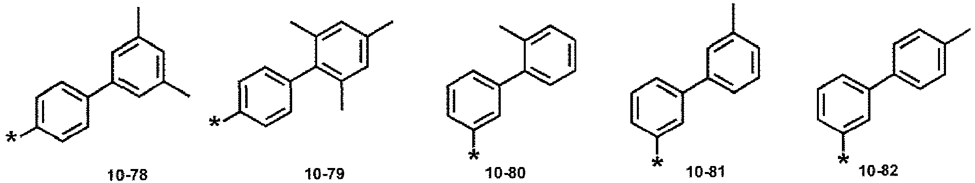 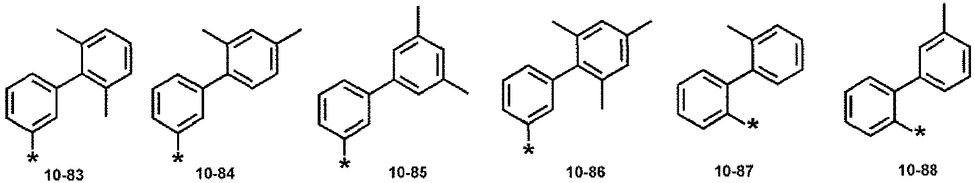 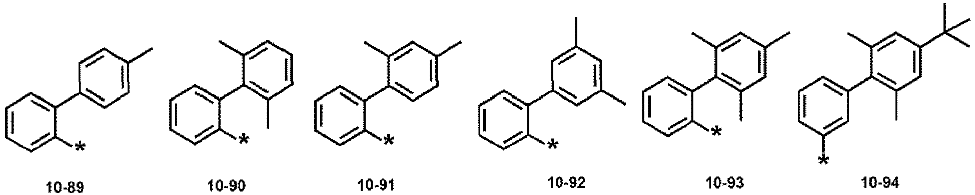 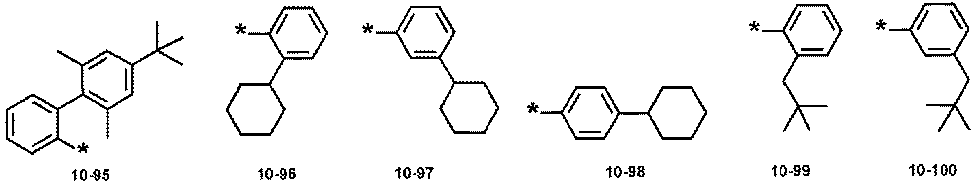 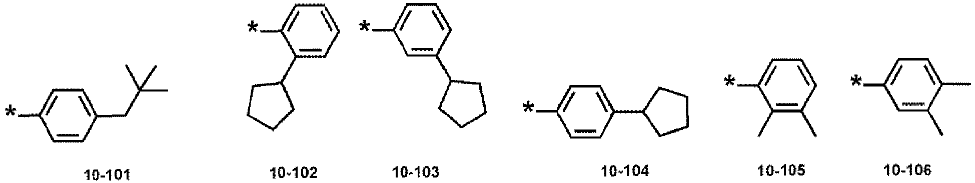 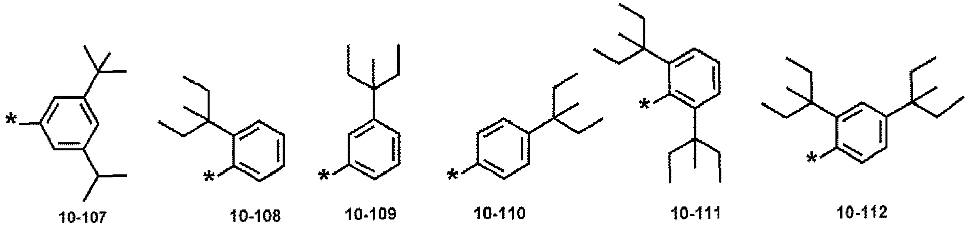 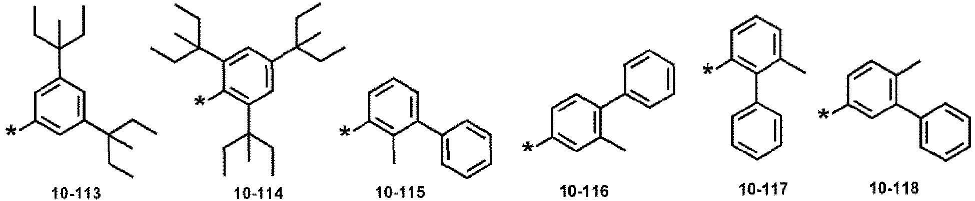 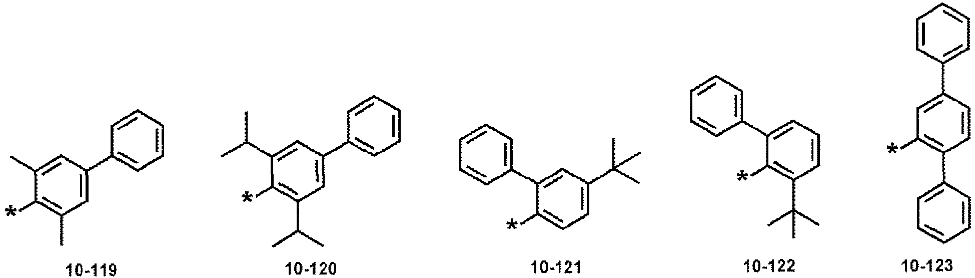 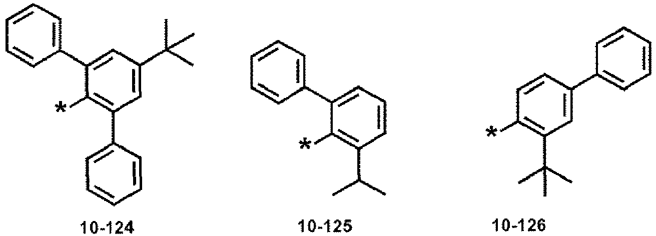 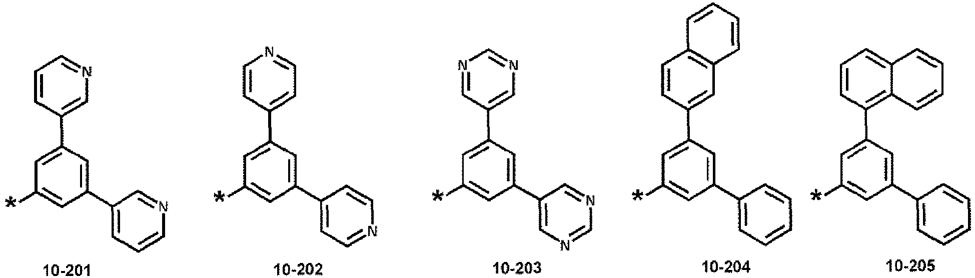 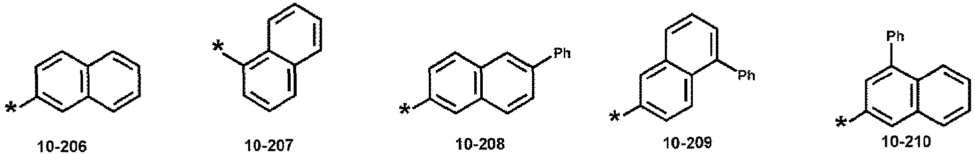 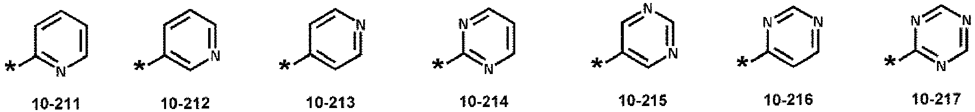 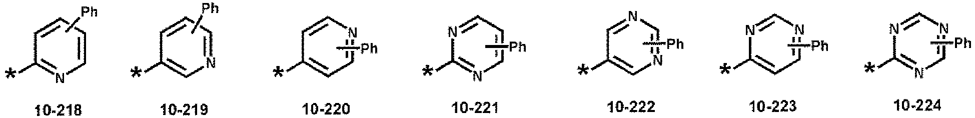 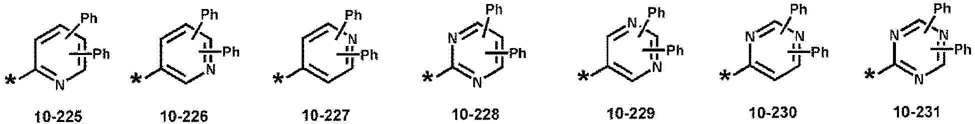 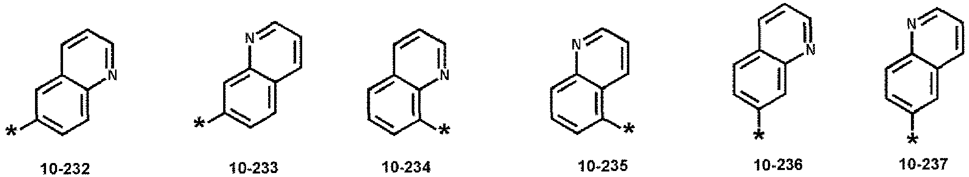 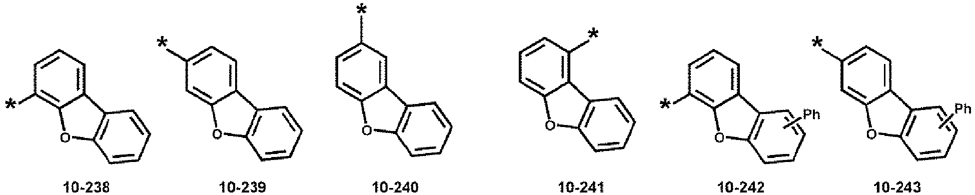 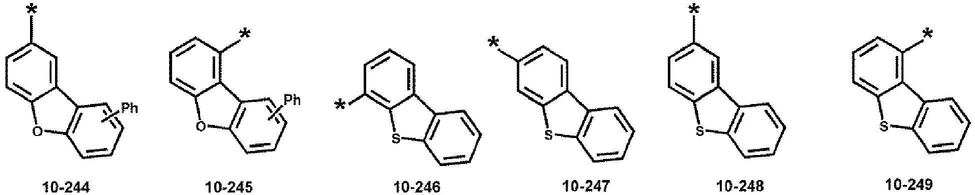 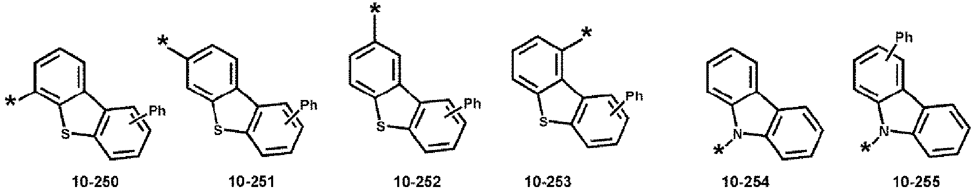 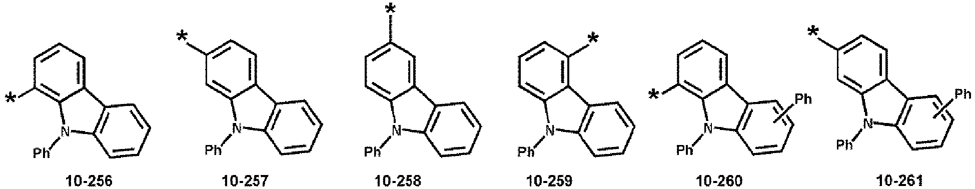 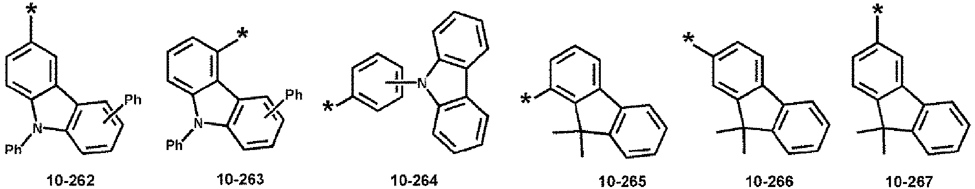 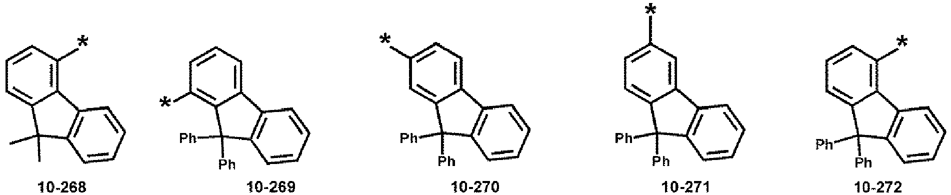 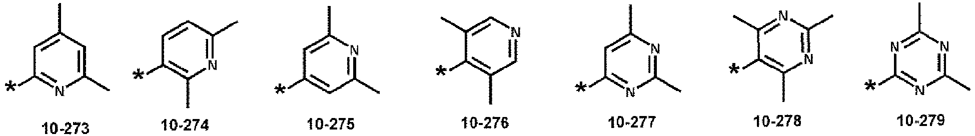 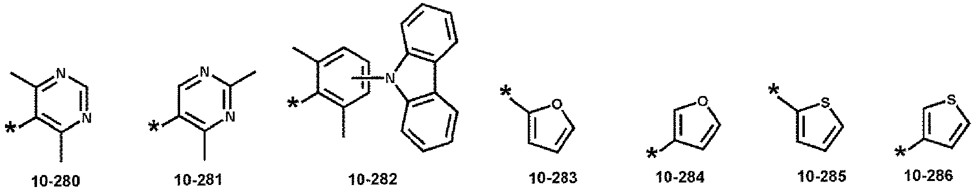 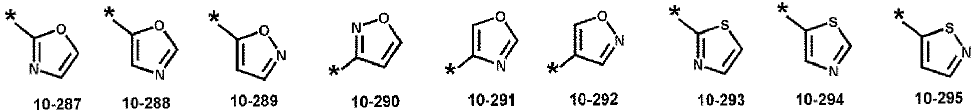 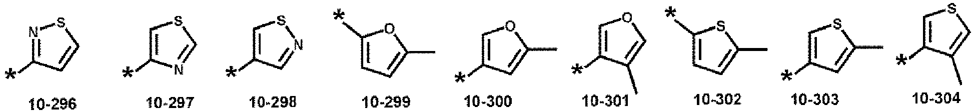 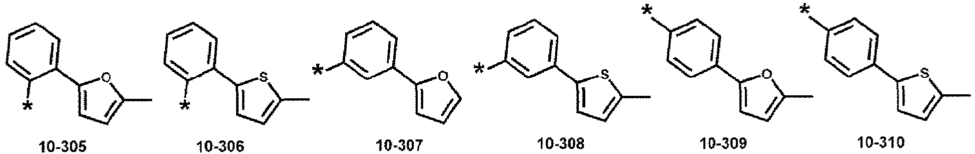 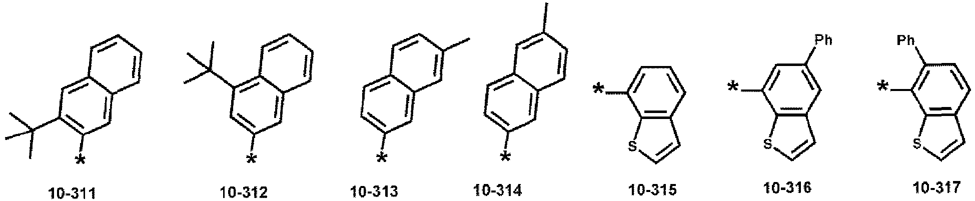 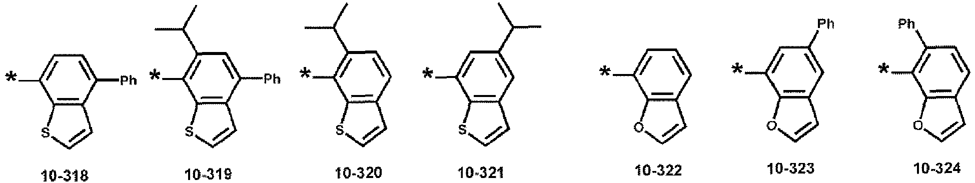 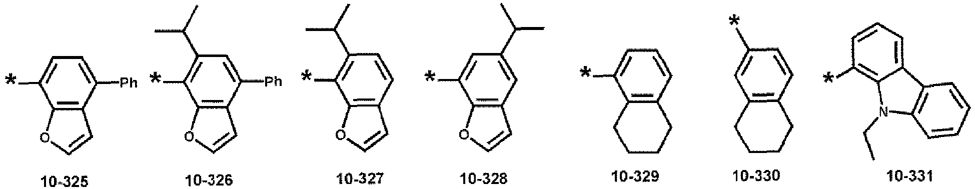 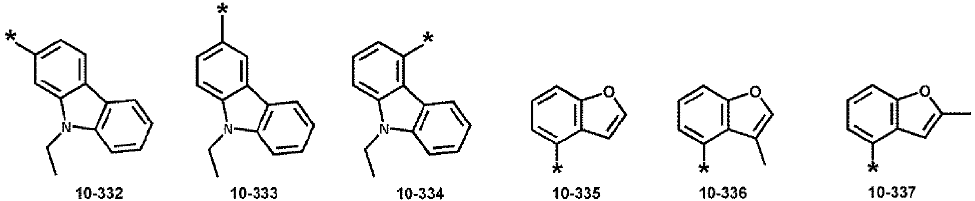 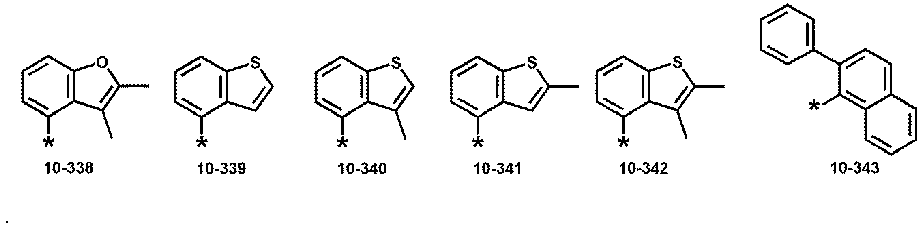 * in Formulae 9-1 to 9-39, 9-201 to 9-233, 10-1 to 10-126, and 10-201 to 10-343 indicates a binding site to a neighboring atom, Ph is a phenyl group, TMS is a trimethylsilyl group, and TMG is a trimethylgermyl group.

The "group represented by one of Formulae 9-1 to 9-39 in which at least one hydrogen is substituted with deuterium" and the "group represented by one of Formulae 9-201 to 9-233 in which at least one hydrogen is substituted with deuterium" may each be, for example, a group represented by one of Formulae 9-501 to 9-514 and 9-601 to 9-635:

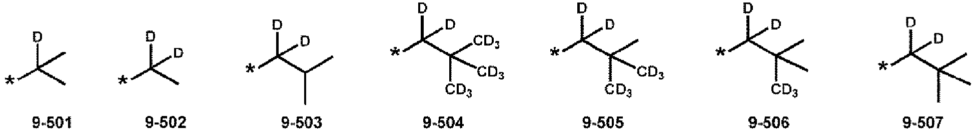

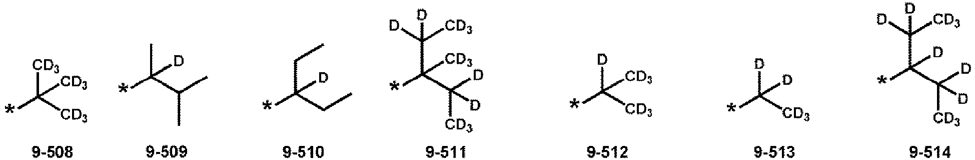

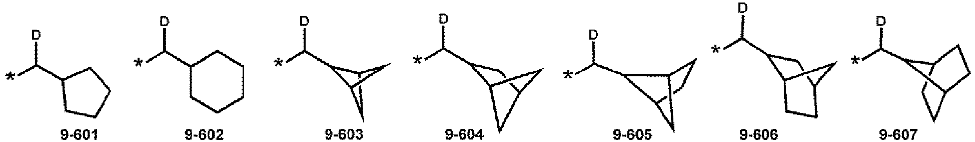

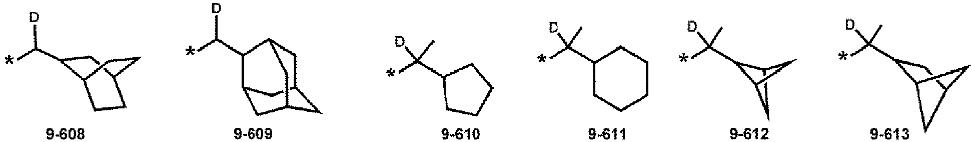

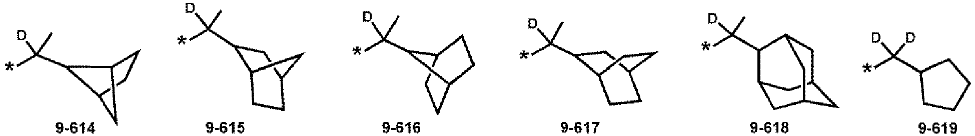

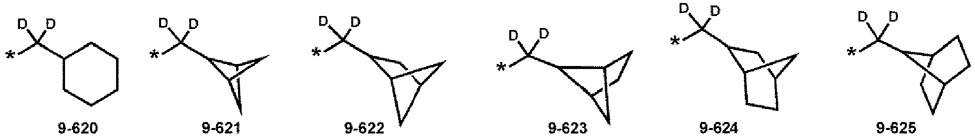

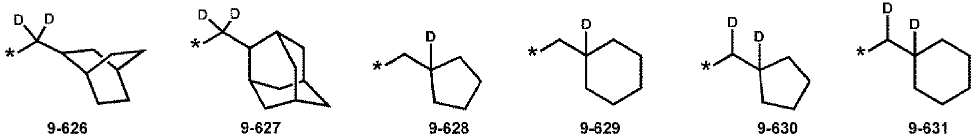

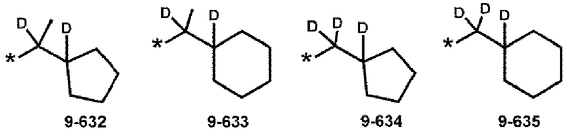

The "group represented by one of Formulae 9-1 to 9-39 in which at least one hydrogen is substituted with -F" and the "group represented by one of Formulae 9-201 to 9-233 in which at least one hydrogen is substituted with -F" may each be, for example, a group represented by one of Formulae 9-701 to 9-710:

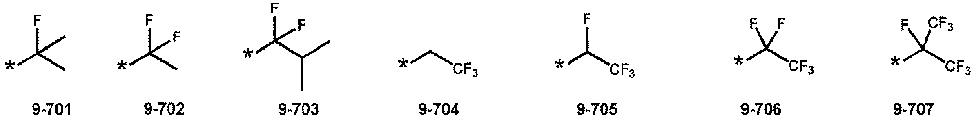

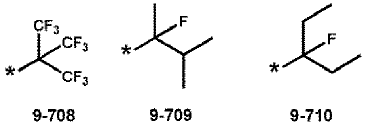

The "group represented by one of Formulae 10-1 to 10-126 in which at least one hydrogen is substituted with deuterium" and the "group represented by one of Formulae 10-201 to 10-343 in which at least one hydrogen is substituted with deuterium" may each be, for example, a group represented by one of Formulae 10-501 to 10-553:

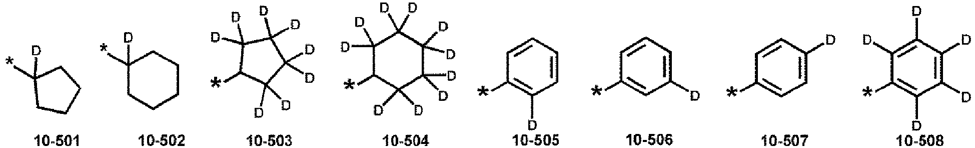

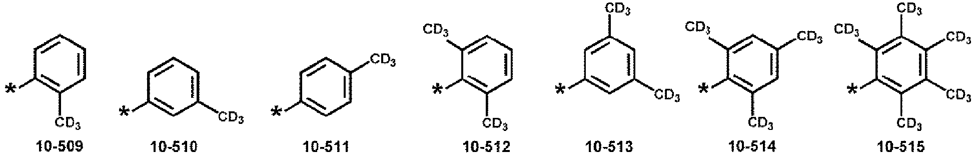

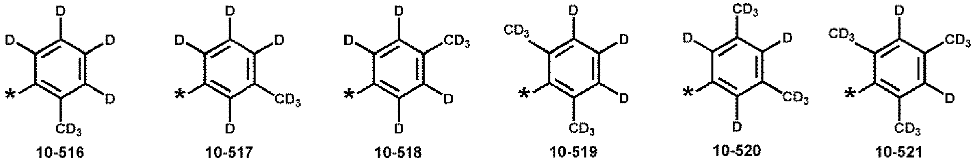

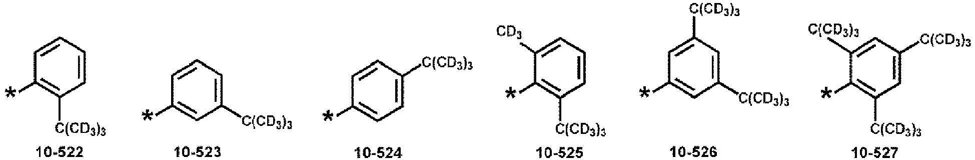

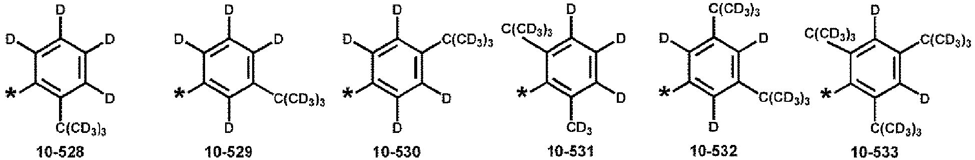

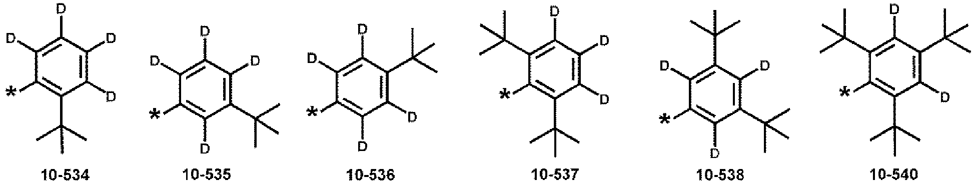

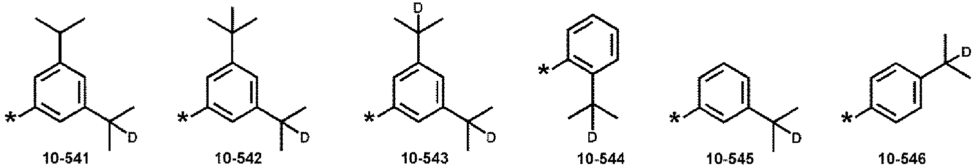

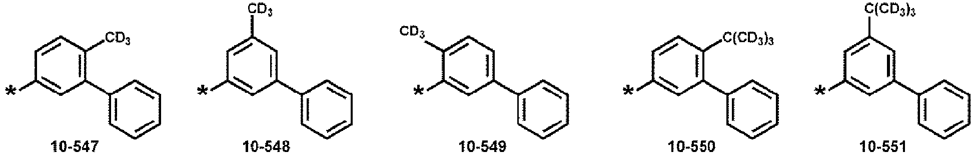

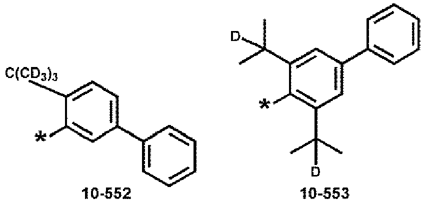

The "group represented by one of Formulae 10-1 to 10-126 in which at least one hydrogen is substituted with -F" and the "group represented by one of Formulae 10-201 to 10-343 in which at least one hydrogen is substituted with -F" may each be, for example, a group represented by one of Formulae 10-601 to 10-617:

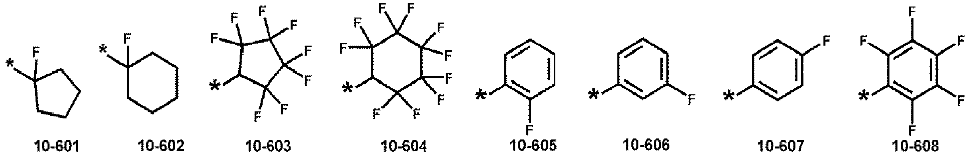

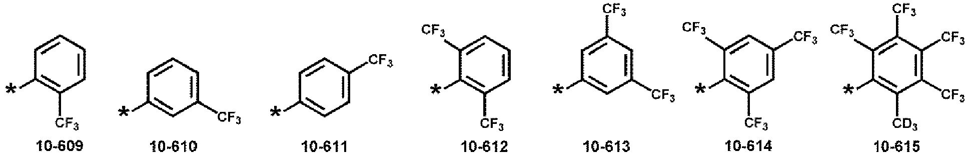

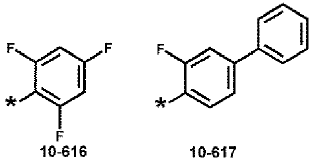

In one or more embodiments, in Formula 1,
1) R₂ may include at least one fluoro group (-F);
2) R₃ may include at least one fluoro group (-F);
3) R₄ may include at least one fluoro group (-F);
4) R₅ may include at least one fluoro group (-F);
5) R₆ may include at least one fluoro group (-F);
6) R₇ may include at least one fluoro group (-F);
7) R₈ may include at least one fluoro group (-F);
8) R₄ and R₅ may each include at least one fluoro group (-F);
9) R₄ and R₆ may each include at least one fluoro group (-F);
10) R₅ and R₆ may each include at least one fluoro group (-F);
11) R₃ and R₄ may each include at least one fluoro group (-F); or
12) R₃ and R₆ may each include at least one fluoro group (-F).

In one or more embodiments, regarding Formula 1,
one or two of R₁ to R₈ may each independently include at least one fluoro group (-F), and
at least one of R₁ to R₈ i) may not include a fluoro group (-F), and ii) may not be hydrogen.

In one or more embodiments, A₂₀ in Formula 1 may be a C₁-C₂₀ alkyl group, a C₃-C₁₀ cycloalkyl group, or a C₂-C₁₀ heterocycloalkyl group, each unsubstituted or substituted with deuterium, a C₁-C₂₀ alkyl group, a C₃-C₁₀ cycloalkyl group, a C₂-C₁₀ heterocycloalkyl group, or any combination thereof.

In one or more embodiments, A₂₀ in Formula 1 may be a C₁-C₂₀ alkyl group, unsubstituted or substituted with deuterium, a C₁-C₂₀ alkyl group, or any combination thereof.

In one or more embodiments, d2 in Formula 1 may be 2.

In one or more embodiments, A₂₀ in Formula 1 may be a C₁-C₂₀ alkyl group, unsubstituted or substituted with deuterium, a C₁-C₂₀ alkyl group, or any combination thereof, and d2 may be 2.

In one or more embodiments, the organometallic compound represented by Formula 1 may have at least one deuterium.

In one or more embodiments, at least one of R₁ to R₈ of Formula 1 may have at least one deuterium.

In one or more embodiments, at least one of R₂₀ in number of d2 may have at least one deuterium.

In one or more embodiments, at least one of R₂₀ in number of d2 may be a deuterium-containing C₁-C₂₀ alkyl group, a deuterium-containing C₃-C₁₀ cycloalkyl group, or a deuterium-containing C₂-C₁₀ heterocycloalkyl group, each unsubstituted or substituted with a C₁-C₂₀ alkyl group, a C₃-C₁₀ cycloalkyl group, a C₂-C₁₀ heterocycloalkyl group, or any combination thereof.

In one or more embodiments, a group represented by 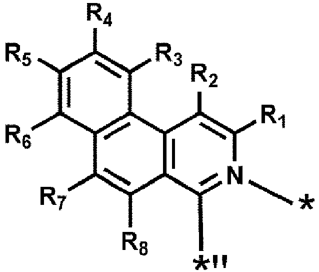 in Formula 1 may be a group represented by one of Formulae CY1 to CY108:

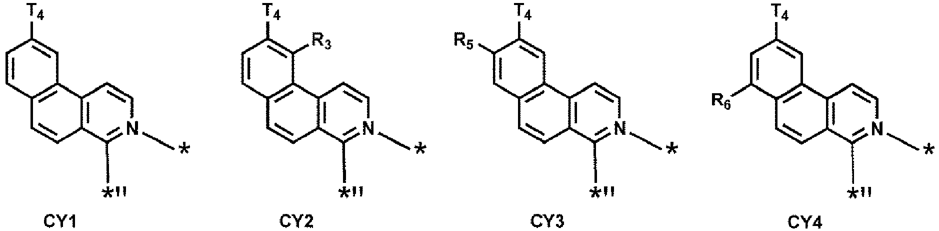

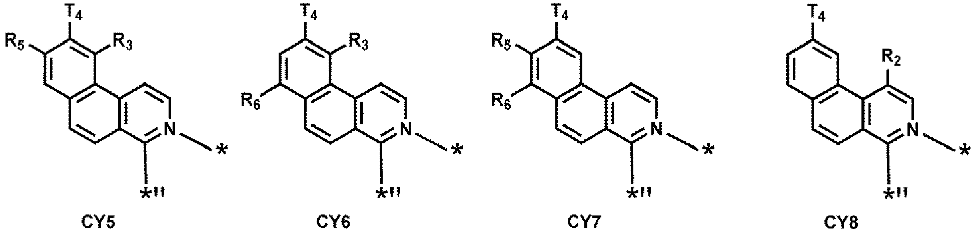

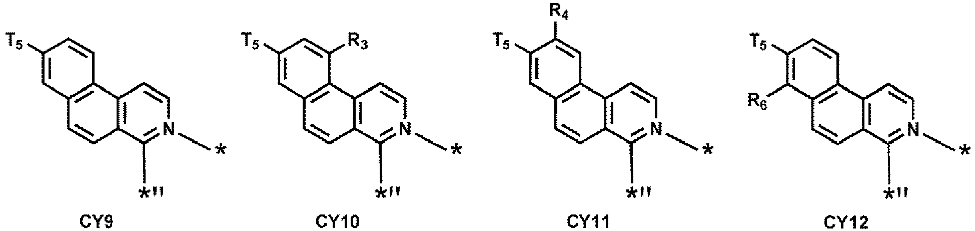

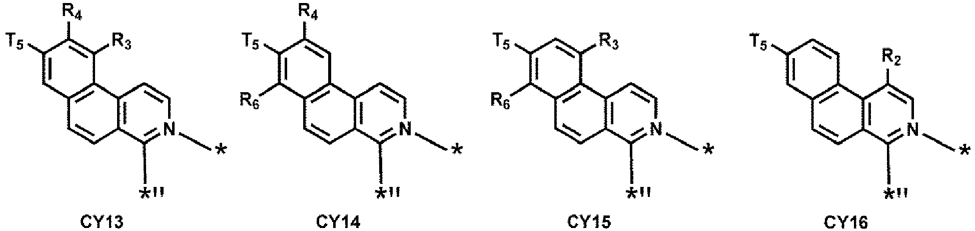

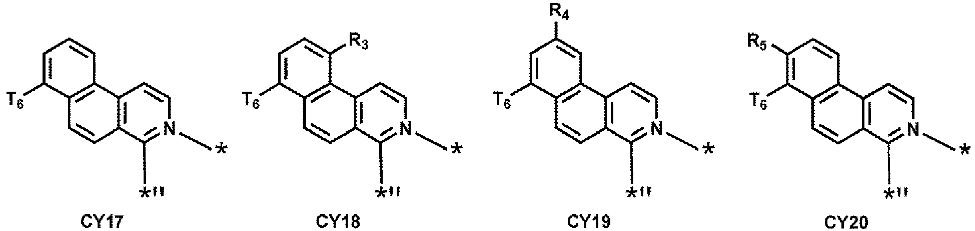

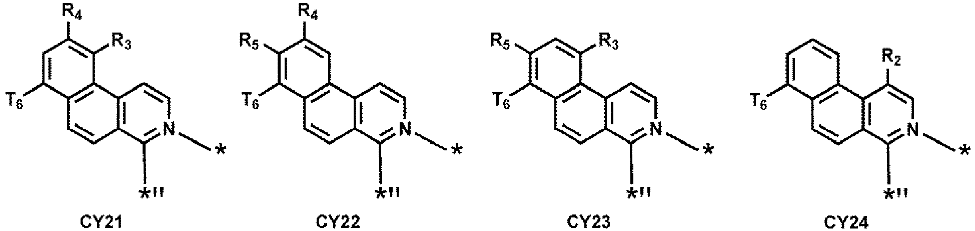

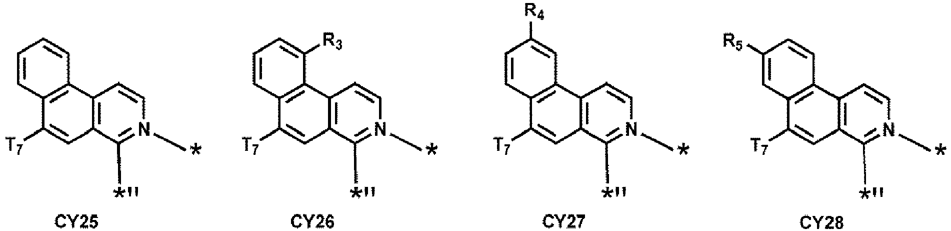

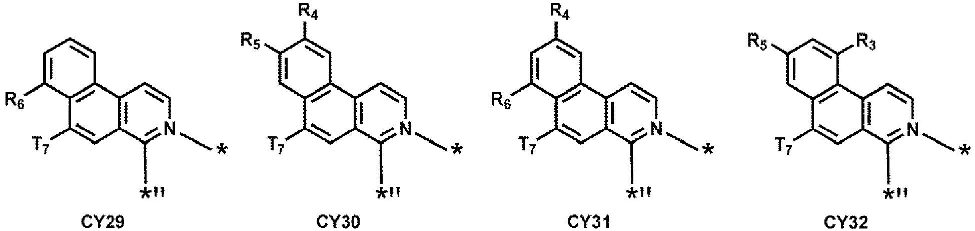

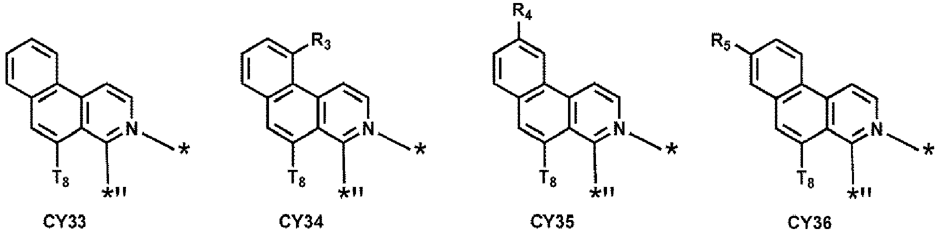

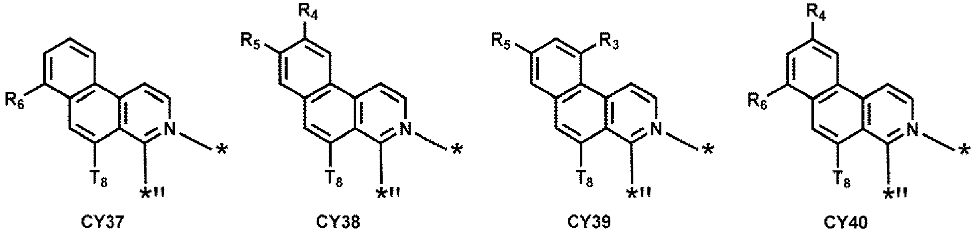

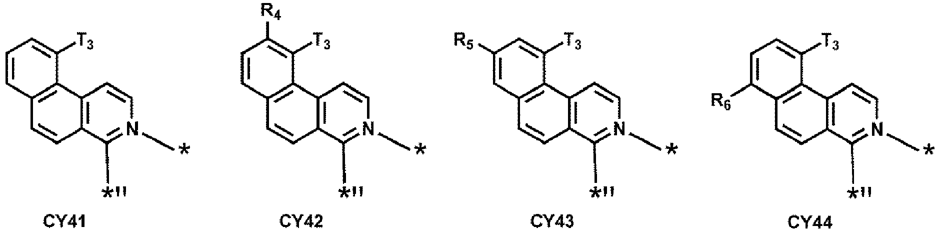

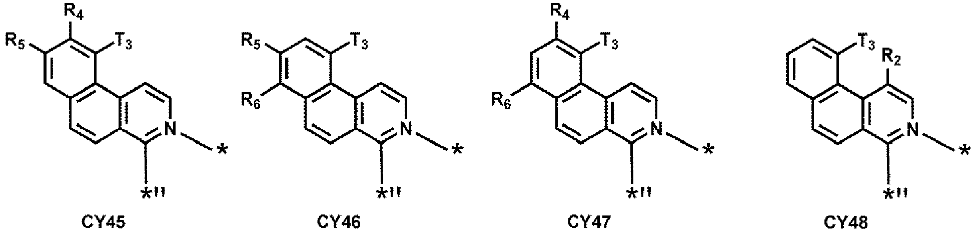

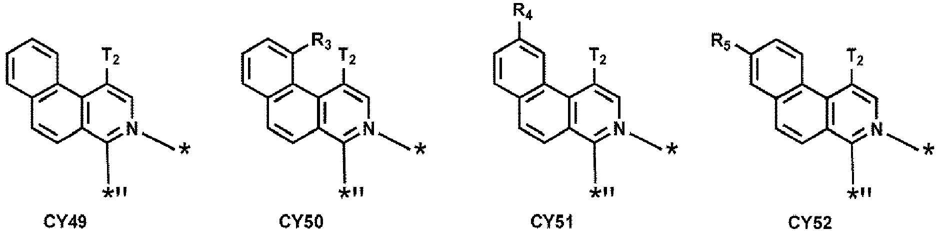

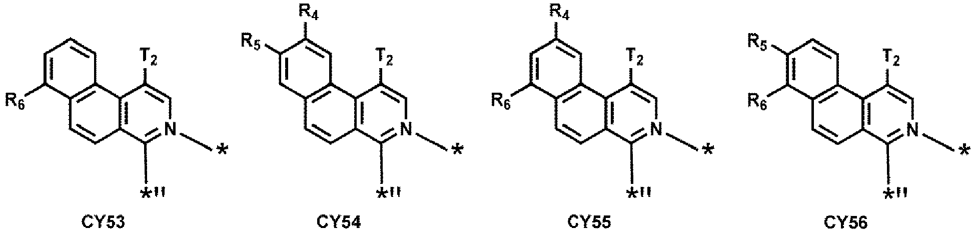

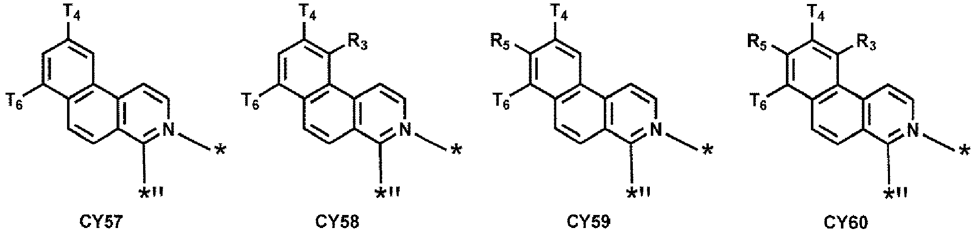

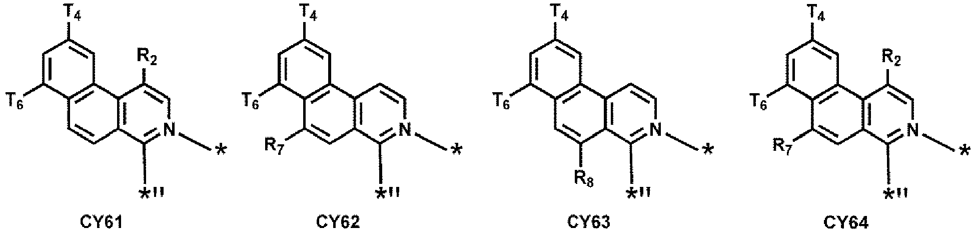

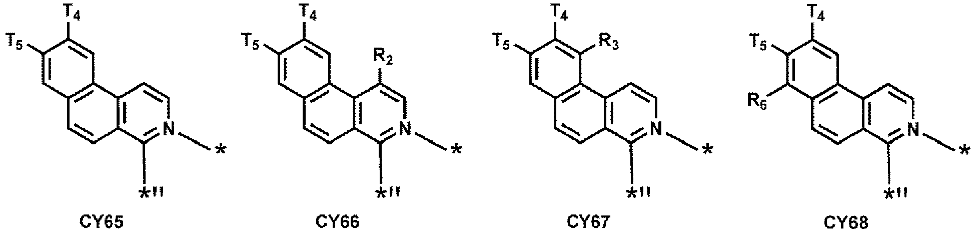

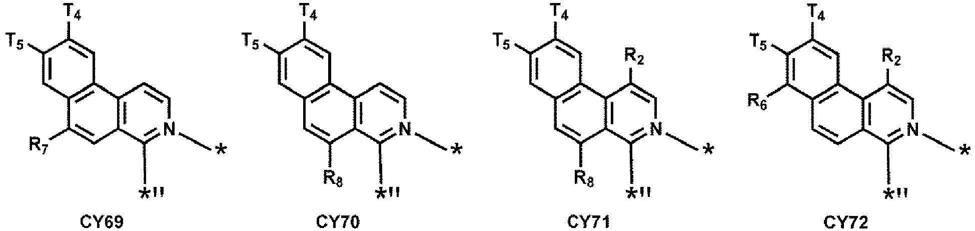

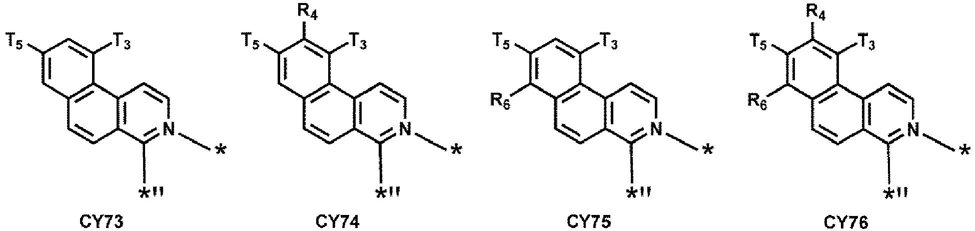

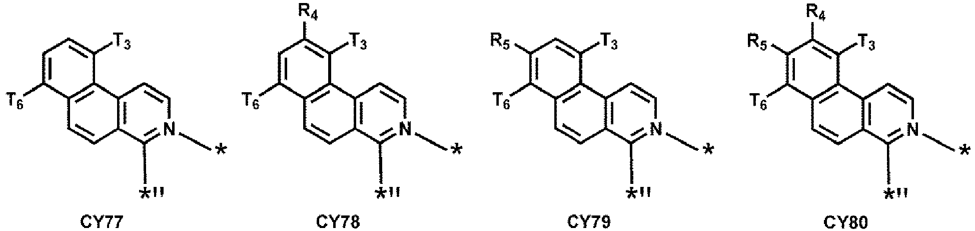

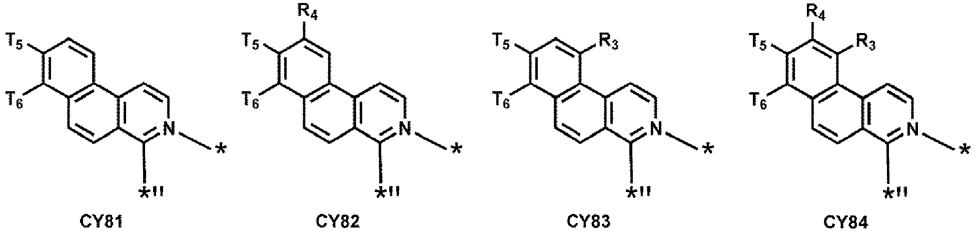

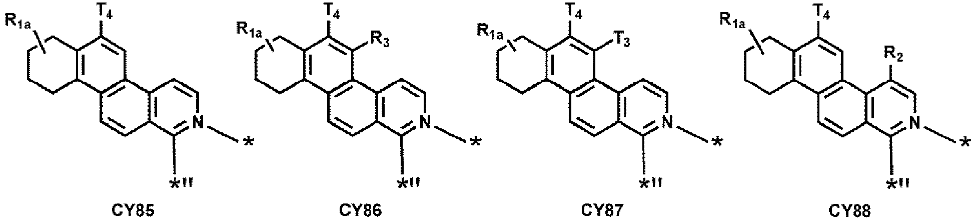

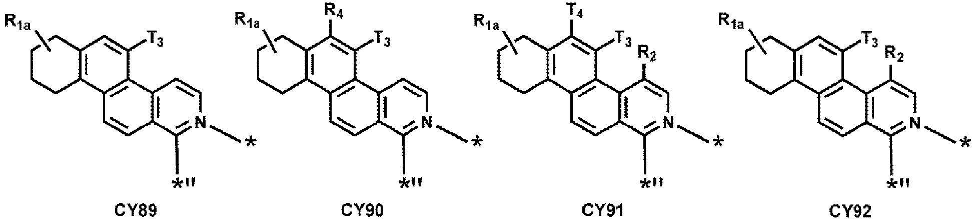

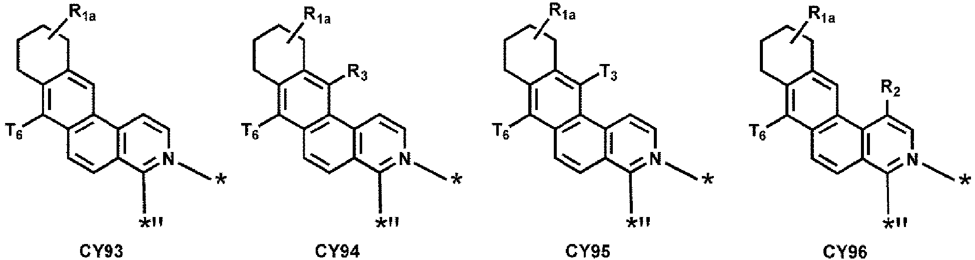

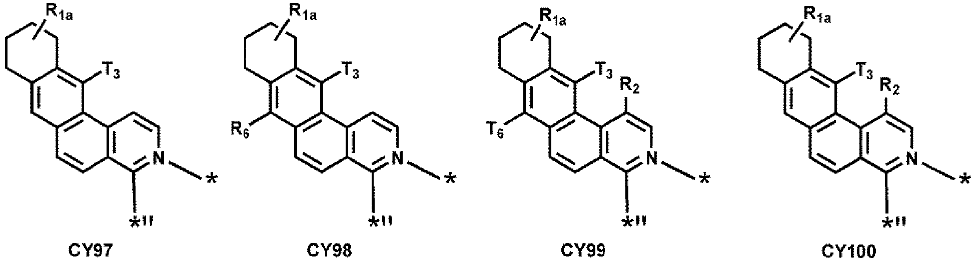

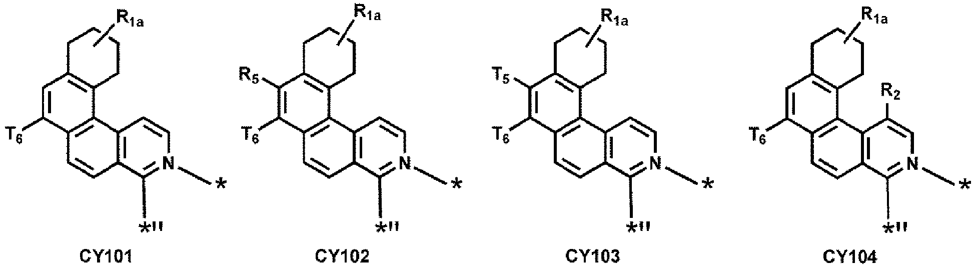

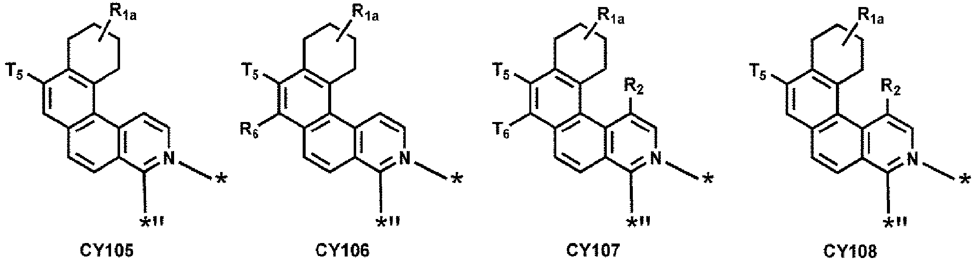

In Formulae CY1 to CY108,
T₂ to T₈ may each independently be:
a fluoro group (-F); or
a fluorinated C₁-C₂₀ alkyl group, a fluorinated C₃-C₁₀ cycloalkyl group, a fluorinated C₂-C₁₀ heterocycloalkyl group, or a fluorinated phenyl group, each unsubstituted or substituted with deuterium, a C₁-C₂₀ alkyl group, a C₃-C₁₀ cycloalkyl group, a C₂-C₁₀ heterocycloalkyl group, a phenyl group, or any combination thereof;
each of R₂ to R₈ and R₁ₐ are the same as described above, and R₂ to R₈ may not be hydrogen,
* indicates a binding site to Ir in Formula 1,
*" indicates a binding site to a neighboring atom in Formula 1.

For example, R₂ to R₈ in Formulae CY1 to CY108 may each independently be:
deuterium; or
a C₁-C₂₀ alkyl group, a C₃-C₁₀ cycloalkyl group, a C₂-C₁₀ heterocycloalkyl group, or a phenyl group, each unsubstituted or substituted with deuterium, a C₁-C₂₀ alkyl group, a C₃-C₁₀ cycloalkyl group, a C₂-C₁₀ heterocycloalkyl group, a phenyl group, or any combination thereof.

In one or more embodiments, the group represented by 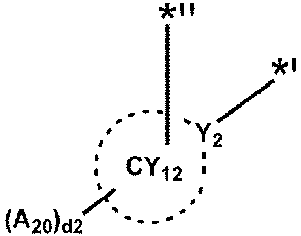 in Formula 1 may be a group represented by one of Formulae A(1) to A(7):

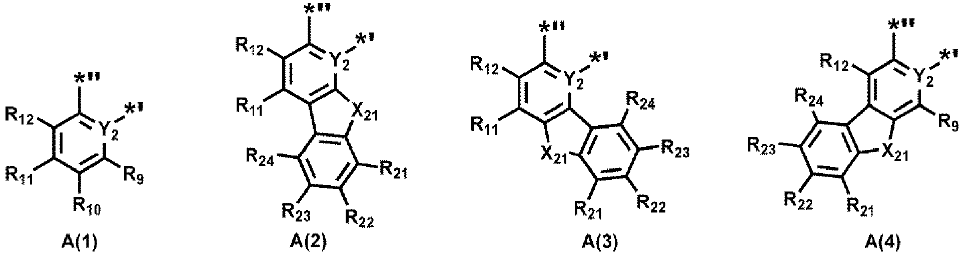

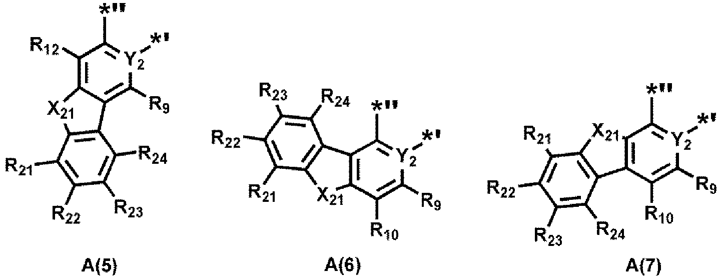

In Formulae A(1) to A(7),
Y₂ may be C,
X₂₁ may be O, S, N(R₂₅), C(R₂₅)(R₂₆), or Si(R₂₅)(R₂₆),
each of R₉ to R₁₂ and R₂₁ to R₂₆ may be the same as described in connection with A₂₀,
*' may indicate a binding site to Ir in Formula 1, and
*" may indicate a binding site to a neighboring atom in Formula 1.

For example, R₉ and R₁₁ in Formula A(1) may each independently be a C₁-C₂₀ alkyl group, a C₃-C₁₀ cycloalkyl group, a C₂-C₁₀ heterocycloalkyl group, or a phenyl group, each unsubstituted or substituted with deuterium, a C₁-C₂₀ alkyl group, a C₃-C₁₀ cycloalkyl group, a C₂-C₁₀ heterocycloalkyl group, a phenyl group, or any combination thereof.

In one or more embodiments, R₉ and R₁₁ in Formula A(1) may each independently be a C₁-C₂₀ alkyl group, unsubstituted or substituted with deuterium, a C₁-C₂₀ alkyl group, or any combination thereof.

In one or more embodiments, R₁₀ and R₁₂ in Formula A(1) may each independently be hydrogen or deuterium.

In one or more embodiments, R₉ and R₁₁ in Formula A(1) may be identical to each other.

In one or more embodiments, R₉ and R₁₁ in Formula A(1) may be different from each other.

In one or more embodiments, R₉ and R₁₁ in Formula A(1) may be different from each other, and the number of carbons included in R₁₁ may be greater than the number of carbon included in R_{9.}

In one or more embodiments, i) at least one of R₉ to R₁₂ in Formula A(1), ii) R₁₁, R₁₂, one of R₂₁ to R₂₆, or any combination thereof in Formulae A(2) and A(3), iii) R₉, R₁₂, one of R₂₁ to R₂₆, or any combination thereof in Formulae A(4) and A(5), and iv) R₉, R₁₀, one of R₂₁ to R₂₆, or any combination thereof in Formulae A(6) and A(7), may each independently be a deuterium-containing C₁-C₂₀ alkyl group, a deuterium-containing C₃-C₁₀ cycloalkyl group, or a deuterium-containing C₂-C₁₀ heterocycloalkyl group, each unsubstituted or substituted with a C₁-C₂₀ alkyl group, a C₃-C₁₀ cycloalkyl group, a C₂-C₁₀ heterocycloalkyl group, or any combination thereof.

In one or more embodiments, at least one of R₉ and R₁₁ in Formula A(1) (for example, R₉ and R₁₁ in Formula A(1)) may each independently be a deuterium-containing C₁-C₂₀ alkyl group, a deuterium-containing C₃-C₁₀ cycloalkyl group, or a deuterium-containing C₂-C₁₀ heterocycloalkyl group, each unsubstituted or substituted with a C₁-C₂₀ alkyl group, a C₃-C₁₀ cycloalkyl group, a C₂-C₁₀ heterocycloalkyl group, or any combination thereof.

In one or more embodiments, the group represented by 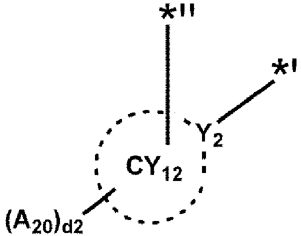 in Formula 1 may be a group represented by Formula A(1) or A(5).

In one or more embodiments, the number of carbons included in the group represented by *-C(A₁)(A₂)(A₃) in Formula 1 may be 5 or more, and/or the number of carbons included in the group represented by *-C(A₄)(A₅)(A₆) in Formula 1 may be 5 or more.

In one or more embodiments, A₁, A₂, and A₃ of the group represented by *-C(A₁)(A₂)(A₃) in Formula 1 may be linked to each other to form a C₅-C₆₀ carbocyclic group which is unsubstituted or substituted with at least one R₁ₐ or a C₁-C₆₀ heterocyclic group which is unsubstituted or substituted with at least one R₁ₐ. That is, the group represented by *-C(A₁)(A₂)(A₃) in Formula 1 may be a C₅-C₆₀ carbocyclic group which is unsubstituted or substituted with at least one R₁ₐ or a C₁-C₆₀ heterocyclic group which is unsubstituted or substituted with at least one R₁ₐ (for example, an adamantane group, a norbornene group, a bicyclo[1.1.1]pentane group, a bicyclo[2.1.1]hexane group, a bicyclo[2.2.1]heptane group (a norbornane group), a bicyclo[2.2.2]octane group, a cyclopentane group, a cyclohexane group, or a cyclohexene group, each unsubstituted or substituted with at least one R₁ₐ).

In one or more embodiments, A₄, A₅, and A₆ of the group represented by *-C(A₄)(A₅)(A₆) in Formula 1 may be linked to each other to form a C₅-C₆₀ carbocyclic group which is unsubstituted or substituted with at least one R₁ₐ or a C₁-C₆₀ heterocyclic group which is unsubstituted or substituted with at least one R₁ₐ. That is, the group represented by *-C(A₄)(A₅)(A₆) in Formula 1 may be a C₅-C₆₀ carbocyclic group which is unsubstituted or substituted with at least one R₁ₐ or a C₁-C₆₀ heterocyclic group which is unsubstituted or substituted with at least one R₁ₐ (for example, an adamantane group, a norbornene group, a bicyclo[1.1.1]pentane group, a bicyclo[2.1.1]hexane group, a bicyclo[2.2.1]heptane group (a norbornane group), a bicyclo[2.2.2]octane group, a cyclopentane group, a cyclohexane group, or a cyclohexene group, each unsubstituted or substituted with at least one R₁ₐ).

In one or more embodiments, in Formula 1, a group represented by *-C(A₁)(A₂)(A₃) may be identical to a group represented by *-C(A₄)(A₅)(A₆).

In one or more embodiments, in Formula 1, a group represented by *-C(A₁)(A₂)(A₃) may be different from a group represented by *-C(A₄)(A₅)(A₆).

In one or more embodiments, the first compound may include at least one of Compounds 1 to 53:

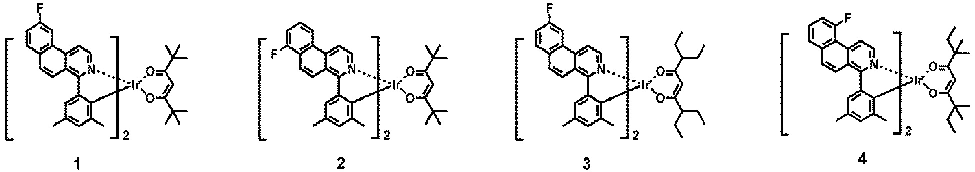

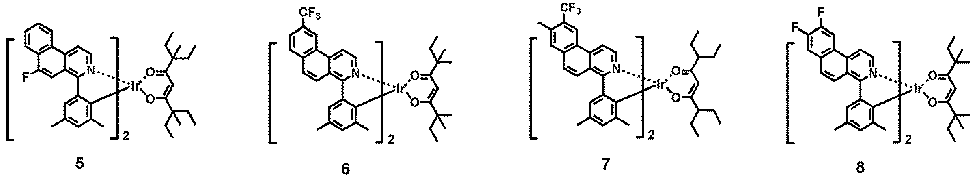

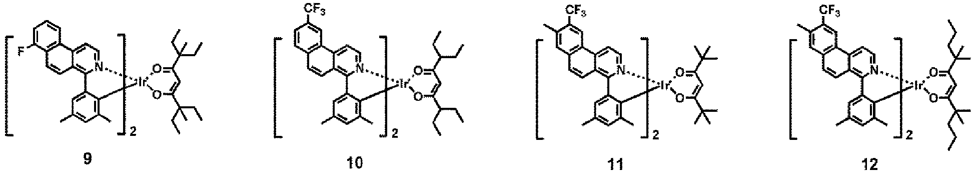

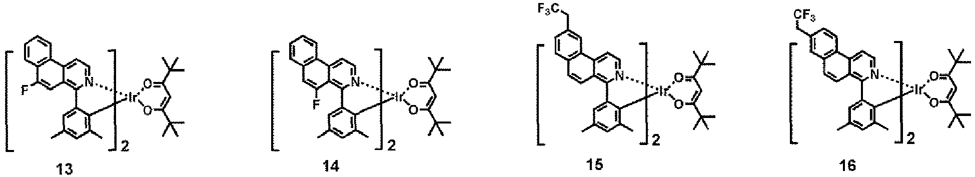

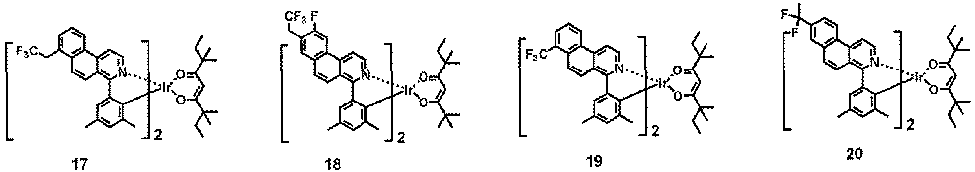

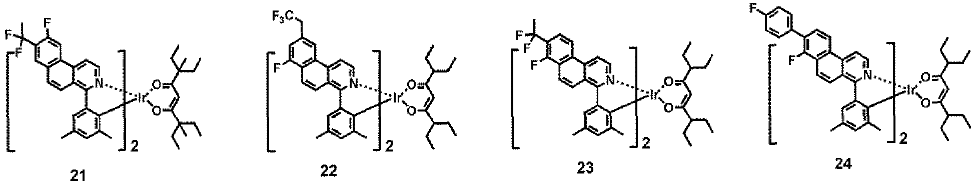

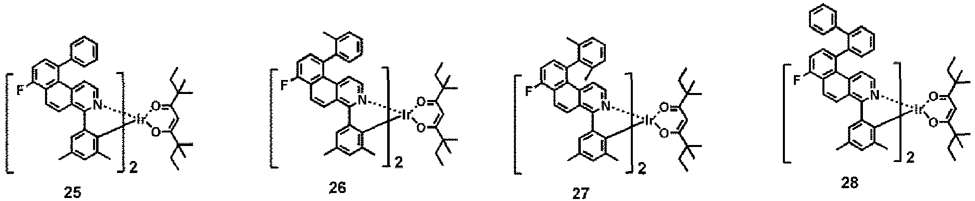

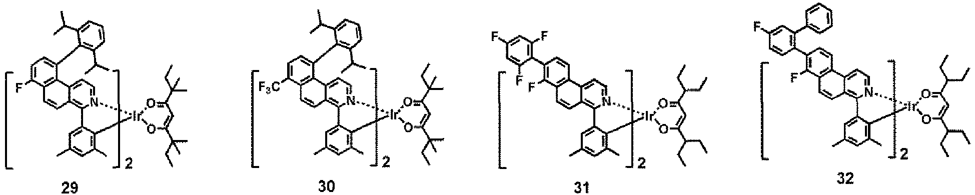

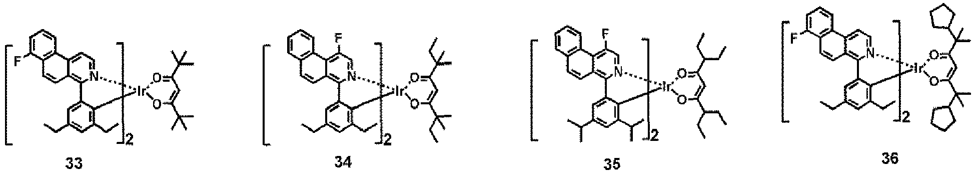

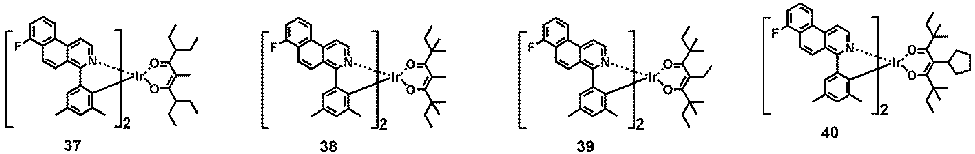

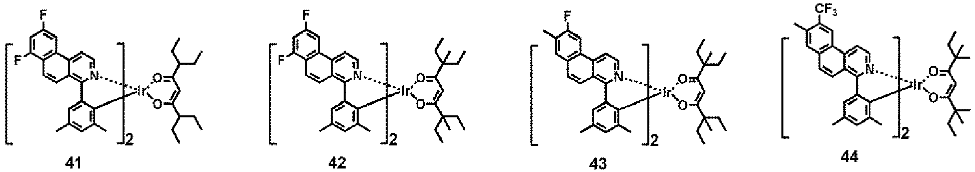

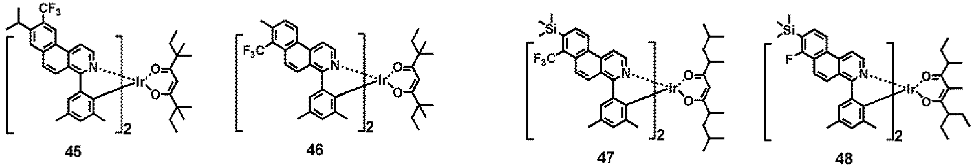

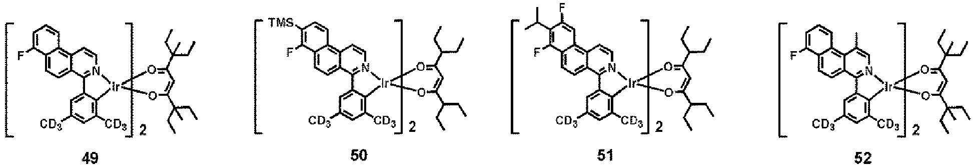

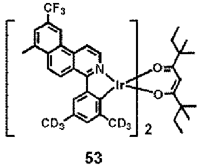

The first compound may include an organometallic compound represented by Formula 1. In an organometallic compound represented by Formula 1, 1) ring CY₁ (see Formula 1') is, as illustrated in Formula 1, a condensed cyclic group in which two benzene groups are condensed with one pyridine group, and 2) at least one of R₁ to R₈, A₂₀, or any combination thereof includes at least one a fluoro group (-F). Accordingly, the transition dipole moment of the organometallic compounds may be increased, and the conjugation length of the organometallic compounds may be relatively increased and structural rigidity thereof may be increased, leading to a decrease in non-radiative transition. Thus, an electronic device, for example, an organic light-emitting device, including the organometallic compound represented by Formula 1 may have high external quantum efficiency (EQE), and thus, may have high luminescence efficiency.

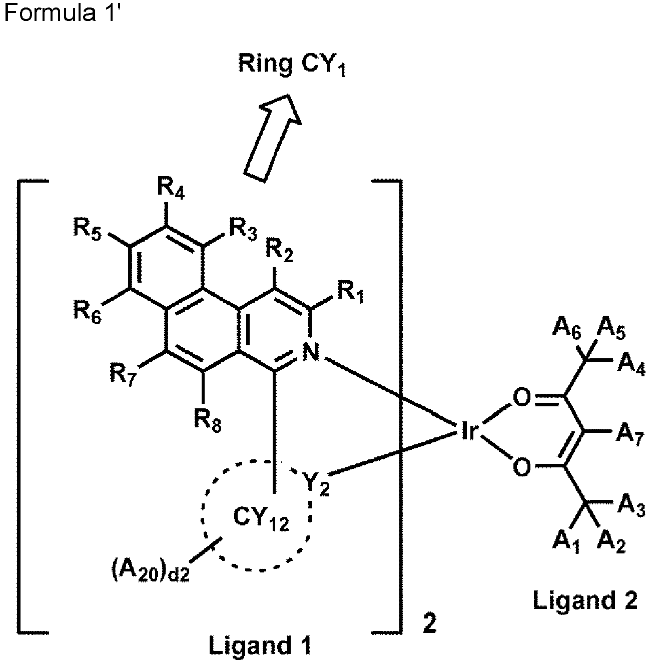

In one or more embodiments, when at least one of A₁ to A₆ in Formula 1 is each independently be a substituted or unsubstituted C₂-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₂-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group, an electron donating capability of Ligand 2 (see Formula 1') in Formula 1 may be improved, and thus, an interaction between Ligand 1 and Ligand 2 in Formula 1 may be enhanced. Thus, the organometallic compound represented by Formula 1 may have improved luminescent transition characteristics, improved optical orientation characteristics, and improved structural rigidity. Accordingly, an electronic device, for example, an organic light-emitting device, including the organometallic compound represented by Formula 1 may have high luminescence efficiency and a long lifespan.

In one or more embodiments, when A₁ to A₆ in Formula 1 are each independently a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₂-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group (that is, when A₁ to A₆ in Formula 1 each have one or more carbons), carbons bound to each A₁ to A₆ in Formula 1 as described above may not include an α-proton, and in this regard, the organometallic compound represented by Formula 1 may have a stable chemical structure with minimal occurrence of a side reaction before/after synthesis, and at the same time, an intermolecular interaction of the organometallic compound represented by Formula 1 may be minimized during the operation of an electronic device (for example, an organic light-emitting device) including the organometallic compound represented by Formula 1. Furthermore, an interaction between Ligand 1 and Ligand 2 in Formula 1 may be enhanced and thus, the organometallic compound represented by Formula 1 may have improved structural rigidity, a full width at half maximum (FWHM) in the photoluminescent spectrum or electroluminescent spectrum of the organometallic compound represented by Formula 1 may be reduced, and a vibronic state of the organometallic compound represented by Formula 1 may be reduced. Accordingly a non-radiative decay of the organometallic compound represented by Formula 1 can be reduced and thus an electronic device, for example, an organic light-emitting device, including the organometallic compound represented by Formula 1 may have high luminescence efficiency and long lifespan.

Synthesis methods of the first compound may be recognizable by one of ordinary skill in the art by referring to Synthesis Examples provided below.

### Description of Formulae 2 and 3

Ar₁, Ar₂, and Ar₁₁ in Formulae 2 and 3 may each independently be a C₅-C₆₀ carbocyclic group which is unsubstituted or substituted with at least one R₆₁ or a C₁-C₆₀ heterocyclic group which is unsubstituted or substituted with at least one R₆₁,
Ar₅ and Ar₁₂ in Formulae 2 and 3 may each independently be a single bond, a C₅-C₆₀ carbocyclic group which is unsubstituted or substituted with at least one R₆₅, or a C₁-C₆₀ heterocyclic group which is unsubstituted or substituted with at least one R₆₅, or may not exist,
n in Formula 2 may be 1, 2, or 3, and when n is 1, Ar₅ does not exist,
p in Formula 3 may be 1, 2, or 3, and when p is 1, Ar₁₂ does not exist,
a1 and a2 in Formula 2 may each independently be an integer from 0 to 5, and the sum of a1 and a2 is 1 or more,
ring CY₂ and ring CY₃ in Formula 2 may each independently be a C₅-C₆₀ carbocyclic group or a C₁-C₆₀ heterocyclic group, and ring CY₂ and ring CY₃ may be optionally linked to each other with a C₅-C₆₀ carbocyclic group which is unsubstituted or substituted with at least one R₆₆ or a C₁-C₆₀ heterocyclic group which is unsubstituted or substituted with at least one R₆₆ therebetween,
Het1 in Formula 3 may be a π electron-depleted nitrogen-containing C₁-C₆₀ cyclic group, and
a11 and m in Formula 3 may each independently be an integer from 1 to 10.

The term "a π electron-depleted nitrogen-containing C₁-C₆₀ cyclic group" may be a cyclic group having 1 to 60 carbon atoms and at least one *-N=*' as a ring-forming moiety. The examples of π electron-depleted nitrogen-containing C₁-C₆₀ cyclic group may include a) a first ring, b) a condensed ring in which at least two first rings are condensed or c) a condensed ring in which at least one first ring and at least one second ring are condensed. The examples of the first ring and the second ring may be understood by referring the descriptions herein.

For example, the π electron-depleted nitrogen-containing C₁-C₆₀ cyclic group may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group, an azadibenzofuran group, an azadibenzothiophene group, an azadibenzosilole group, a benzonaphthofuran group, a benzonaphthothiophene group, an indolophenanthrene group, a benzofuranophenanthrene group, a benzothienophenanthrene group, or a pyridopyrazine group.

The term "a π electron-rich C₃-C₆₀ cyclic group" may be a cyclic group having 3 to 60 carbon atoms and not having *-N=*' as a ring-forming moiety. The examples of π electron-rich C₃-C₆₀ cyclic group may include a) a second ring, or b) a condensed ring in which at least two second rings are condensed. The examples of the second ring may be understood by referring the descriptions herein.

For example, the π electron-rich C₃-C₆₀ cyclic group may be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, a furan group, a thiophene group, an isoindole group, an indole group, a benzofuran group, a benzothiophene group, a benzosilole group, a naphthopyrrole group, a naphthofuran group, a naphthothiophene group, a naphthosilole group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a benzosilolocarbazole group, a triindolobenzene group, an acridine group, a dihydroacridine group, a pyrrolophenanthrene group, a furanophenanthrene group, or a thienophenanthrene group.

In one or more embodiments,
Ar₁, Ar₂, and Ar₁₁ in Formulae 2 and 3 may each independently be a group derived from i) a first ring unsubstituted or substituted with at least one R₆₁, ii) a second ring unsubstituted or substituted with at least one R₆₁, iii) a condensed cyclic group in which two or more first rings are condensed with each other, unsubstituted or substituted with at least one R₆₁, iv) a condensed cyclic group in which two or more second rings are condensed with each other, unsubstituted or substituted with at least one R₆₁, or v) a condensed cyclic group in which at least one first ring and at least one second ring are condensed with each other, unsubstituted or substituted with at least one R₆₁,
Ar₅ and Ar₁₂ in Formulae 2 and 3 may each independently be a single bond, or a group derived from i) a first ring unsubstituted or substituted with at least one R₆₅, ii) a second ring unsubstituted or substituted with at least one R₆₅, iii) a condensed cyclic group in which two or more first rings are condensed with each other, unsubstituted or substituted with at least one R₆₅, iv) a condensed cyclic group in which two or more second rings are condensed with each other, unsubstituted or substituted with at least one R₆₅, or v) a condensed cyclic group in which at least one first ring and at least one second ring are condensed with each other, unsubstituted or substituted with at least one R₆₅, or may not exist,
ring CY₂ and ring CY₃ in Formula 2 may each independently be i) a first ring, ii) a second ring, iii) a condensed cyclic group in which two or more first rings are condensed with each other, iv) a condensed cyclic group in which two or more second rings are condensed with each other, or v) a condensed cyclic group in which at least one first ring and at least one second ring are condensed with each other,
Het1 in Formula 3 may be a group derived from i) a first ring, ii) a condensed cyclic group in which two or more first rings are condensed with each other or iii) a condensed cyclic group in which at least one first ring and at least one second ring are condensed with each other,
the first ring may be an imidazole group, a pyrazole group, a thiazole group, an isothiazole group, an oxazole group, an isoxazole group, a pyridine group, a pyrazine group, a pyridazine group, a pyrimidine group, a triazole group, a tetrazole group, an oxadiazole group, a triazine group, or a thiadiazole group, and
the second ring may be a benzene group, a cyclopentadiene group, a pyrrole group, a furan group, a thiophene group, or a silole group.

In one or more embodiments, Ar₁, Ar₂, and Ar₁₁ in Formulae 2 and 3 may each independently be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, a furan group, a thiophene group, an isoindole group, an indole group, a benzofuran group, a benzothiophene group, a benzosilole group, a naphthopyrrole group, a naphthofuran group, a naphthothiophene group, a naphthosilole group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a benzosilolocarbazole group, a triindolobenzene group, an acridine group, a dihydroacridine group, an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group, an azadibenzofuran group, an azadibenzothiophene group, an azadibenzosilole group, a benzonaphthofuran group, a benzonaphthothiophene group, an indolophenanthrene group, a benzofuranophenanthrene group, or a benzothienophenanthrene group, each unsubstituted or substituted with at least one R₆₁.

In one or more embodiments, Ar₅ and Ar₁₂ in Formulae 2 and 3 may each independently be a single bond, a benzene group, a naphthalene group, or a carbazole group, each unsubstituted or substituted with at least one R₆₁, or may not exist.

In one or more embodiments, ring CY₂ and ring CY₃ in Formula 2 may each independently be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, a furan group, a thiophene group, an isoindole group, an indole group, a benzofuran group, a benzothiophene group, a benzosilole group, a naphthopyrrole group, a naphthofuran group, a naphthothiophene group, a naphthosilole group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a benzosilolocarbazole group, a triindolobenzene group, a dihydroacridine group, an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group, an azadibenzofuran group, an azadibenzothiophene group, an azadibenzosilole group, a pyrrolophenanthrene group, a furanophenanthrene group, or a thienophenanthrene group.

In one or more embodiments, Het1 in Formula 3 may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group, an azadibenzofuran group, an azadibenzothiophene group, an azadibenzosilole group, or a pyridopyrazine group.

In one or more embodiments, Ar₁, Ar₂, and Ar₁₁ in Formulae 2 and 3 may each independently be a π electron-rich C₃-C₆₀ cyclic group unsubstituted or substituted with at least one R₆₁.

In one or more embodiments, Ar₅ and Ar₁₂ in Formulae 2 and 3 may each independently be a single bond or a π electron-rich C₃-C₆₀ cyclic group unsubstituted or substituted with at least one R₆₅, or may not exist.

In one or more embodiments, ring CY₂ and ring CY₃ in Formula 2 may each independently be a π electron-rich C₃-C₆₀ cyclic group.

In one or more embodiments, n and p in Formulae 2 and 3 may each independently be 1 or 2.

In one or more embodiments, in Formula 2, when n is 1, at least one of the ring CY₂ and the ring CY₃ may not be a benzene group.

In one or more embodiments, in Formula 2, when n is 1, at least one of the ring CY₂ and the ring CY₃ may be a) a condensed ring in which at least two first rings are condensed, b) a condensed ring in which at least two second rings are condensed, or c) a condensed ring in which at least one first ring and at least one second ring are condensed. The examples of the first ring and the second ring may be understood by referring the descriptions herein.

In one or more embodiments, the second compound may include a compound represented by Formula 2(1):

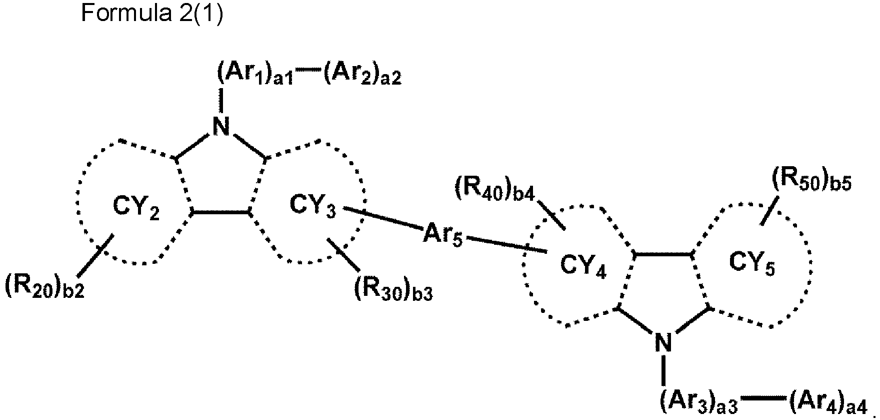

In Formula 2(1),
Ar₅ may be a single bond, a C₅-C₆₀ carbocyclic group unsubstituted or substituted with at least one R₆₅, or a C₁-C₆₀ heterocyclic group unsubstituted or substituted with at least one R₆₅,
Ar₁, Ar₂, Ar₅, a1, a2, ring CY₂, ring CY₃, R₂₀, R₃₀, b2, and b3 may be the same as described above,
Ar₃ and Ar₄ may be the same as described in connection with Ar₁, and
a3, a4, ring CY₄, ring CY₅, R₄₀, R₅₀, b4, and b5 may be the same as described in connection with a1, a2, ring CY₂, ring CY₃, R₂₀, R₃₀, b2, and b3.

For example, Ar₅ in Formula 2(1) may be a single bond.

In one or more embodiments, the third compound may include a compound represented by Formula 3(1):

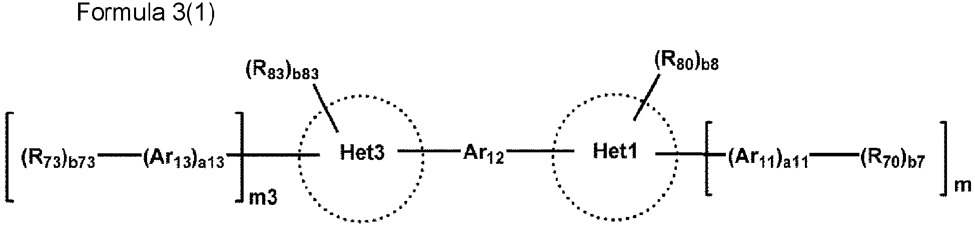

In Formula 3(1),
Ar₁₂ may be a single bond, a C₅-C₆₀ carbocyclic group unsubstituted or substituted with at least one R₆₅, or a C₁-C₆₀ heterocyclic group unsubstituted or substituted with at least one R₆₅,
Het1, Ar₁₁, R₇₀, R₈₀, a11, b7, b8 and m may be the same as described above, and
Het3, Ar₁₃, R₇₃, R₈₃, a13, b73, b83 and m3 may be the same as described in connection with Het1, Ar₁₁, R₇₀, R₈₀, a11, b7, b8 and m.

In one or more embodiments, a group represented by 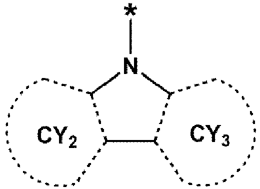 in Formula 2 and a group represented by 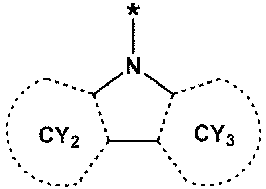 and a group represented by 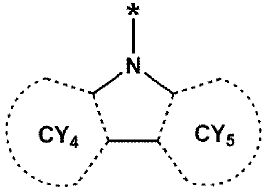 in Formula 2(1) may each independently be a group represented by one of Formulae 2-1 to 2-93:

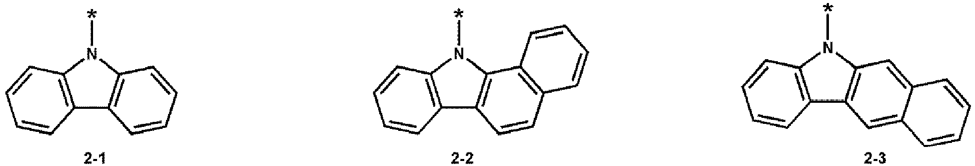

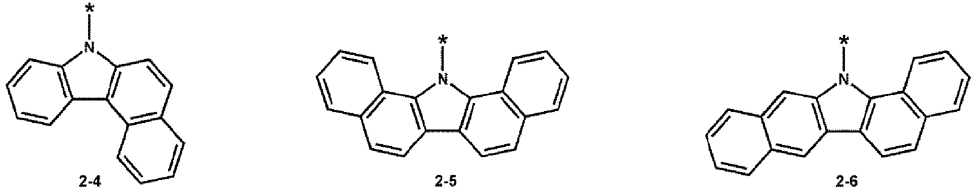

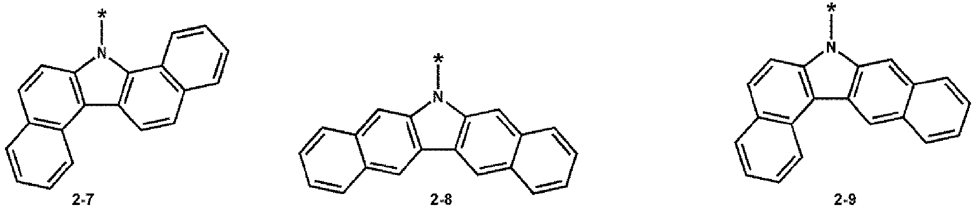

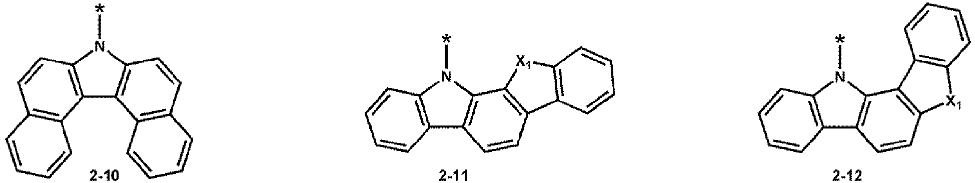

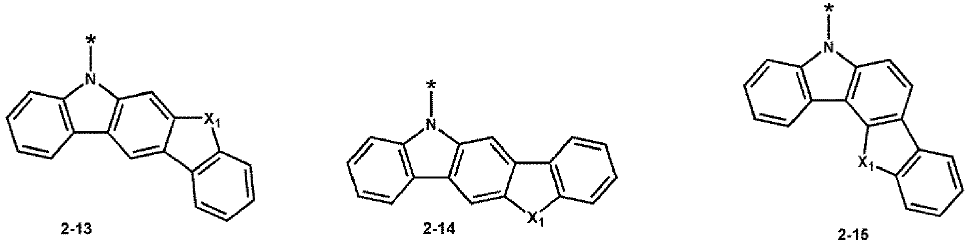

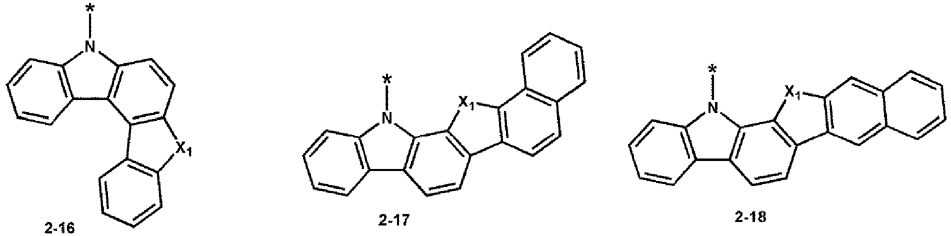

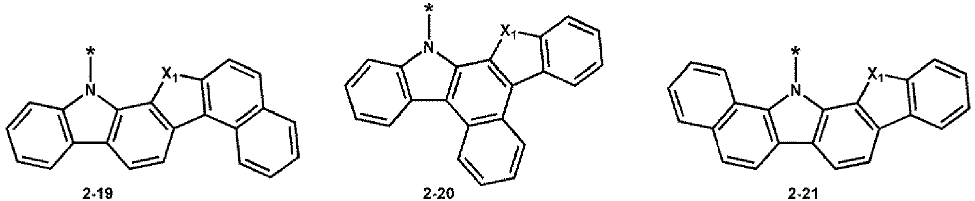

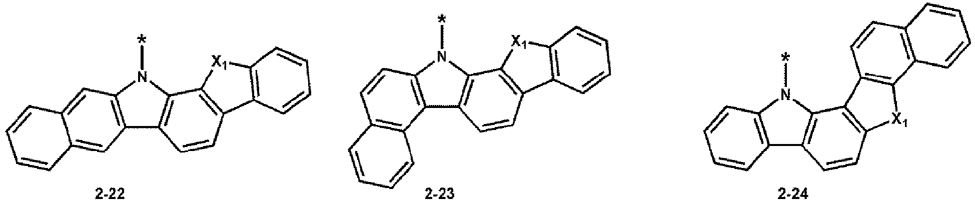

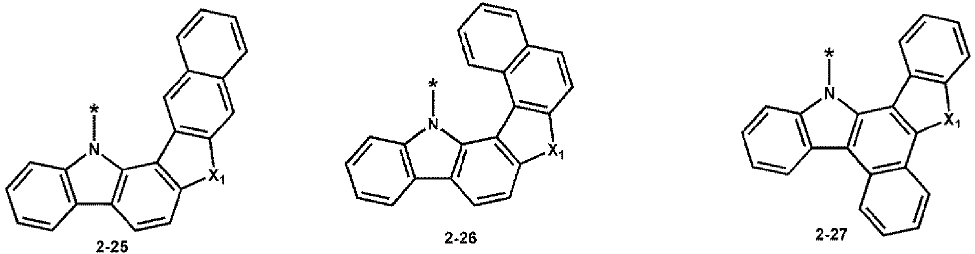

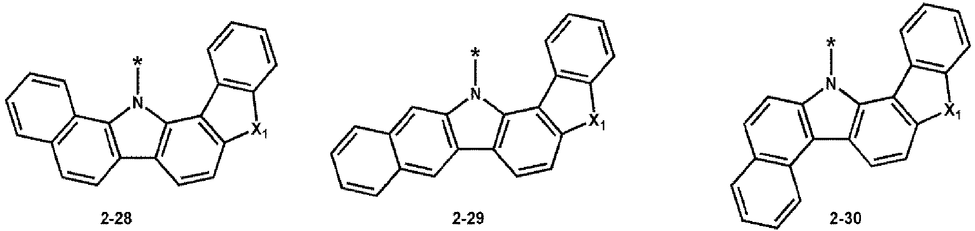

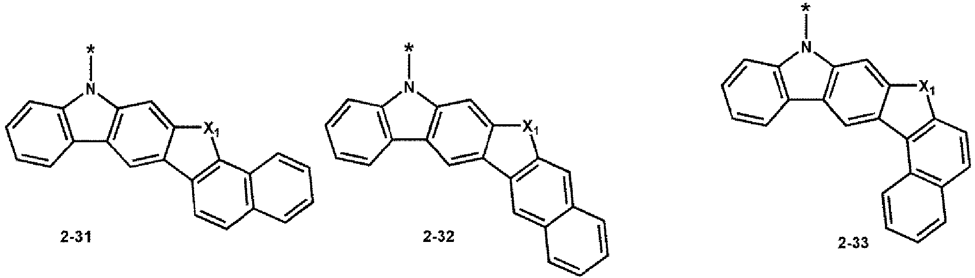

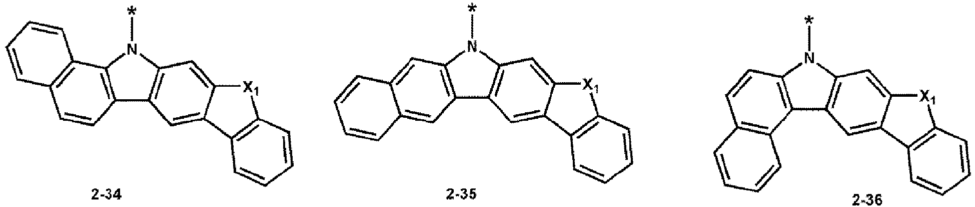

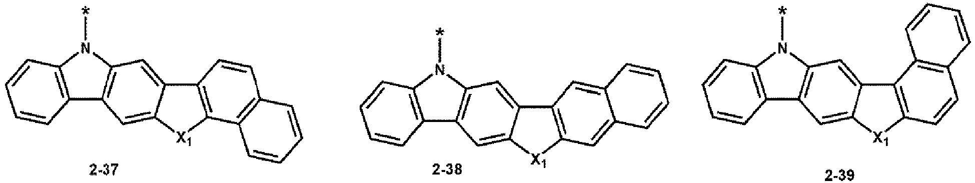

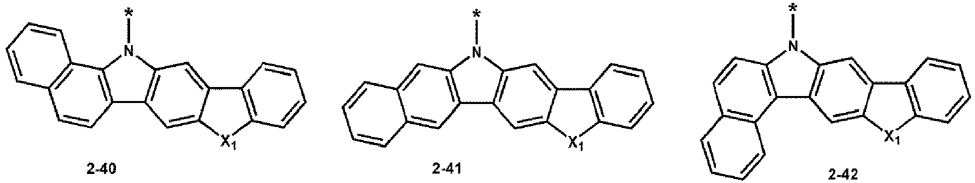

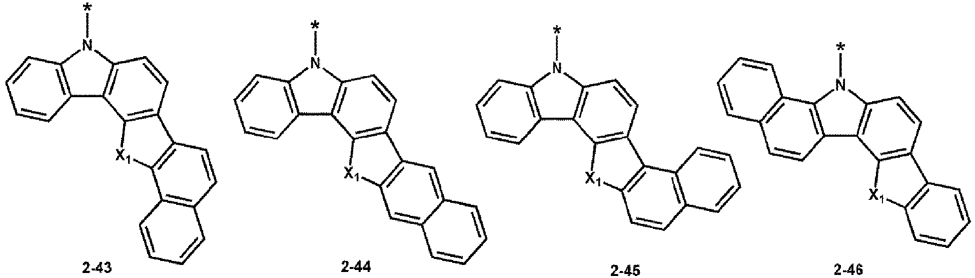

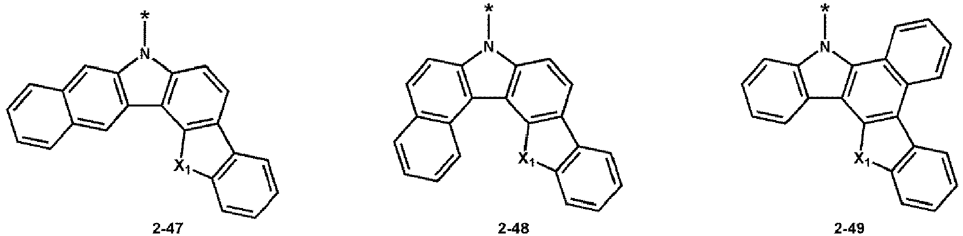

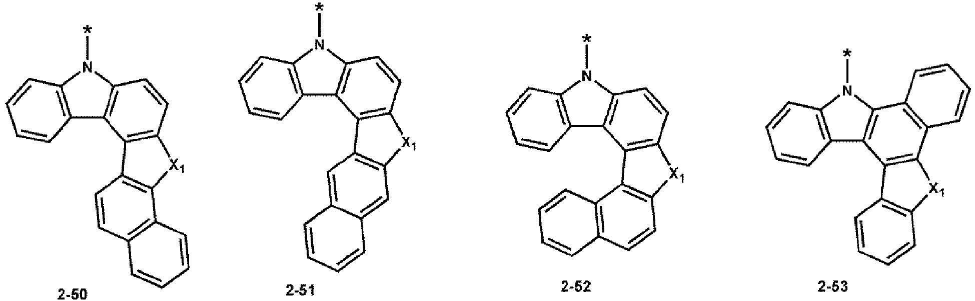

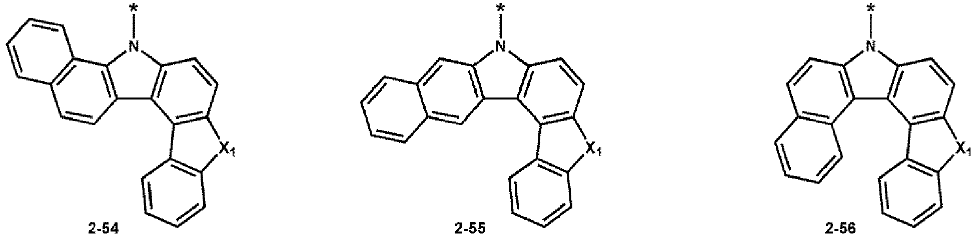

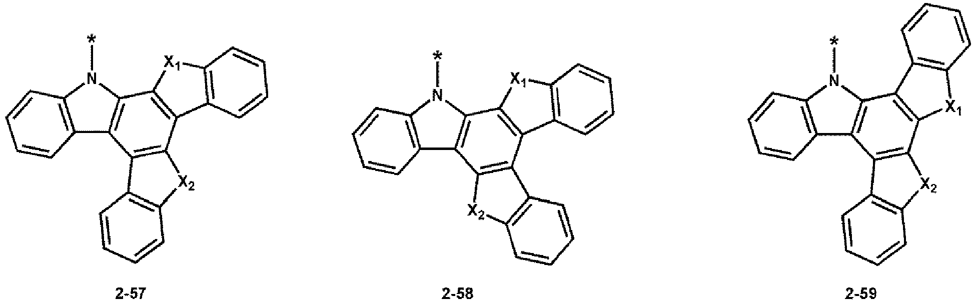

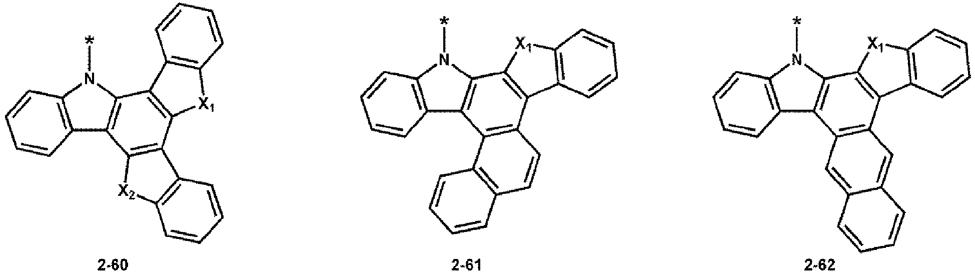

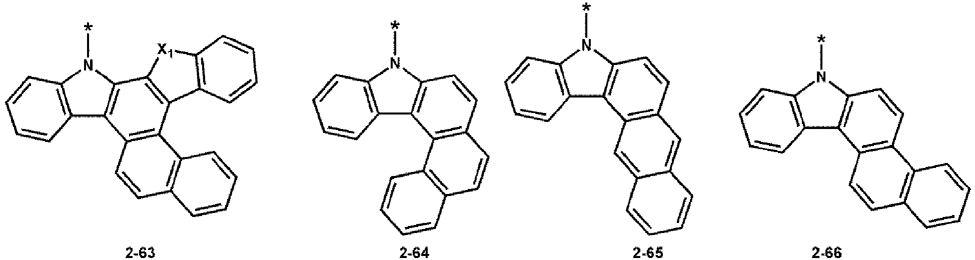

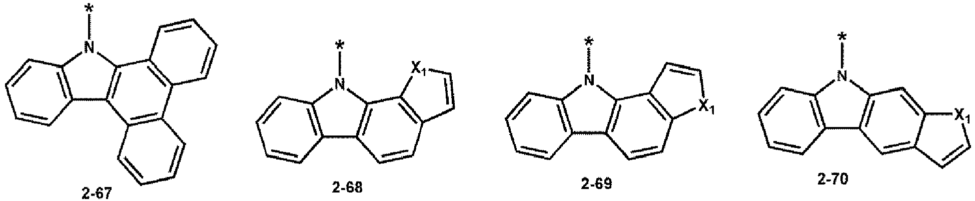

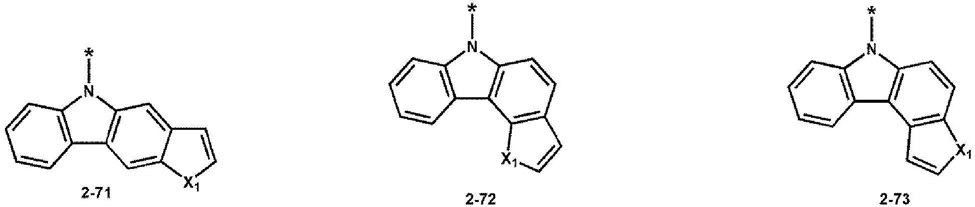

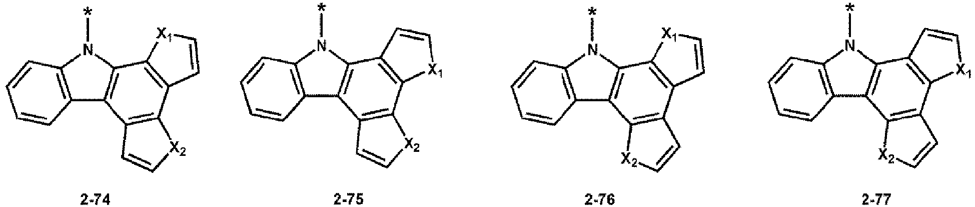

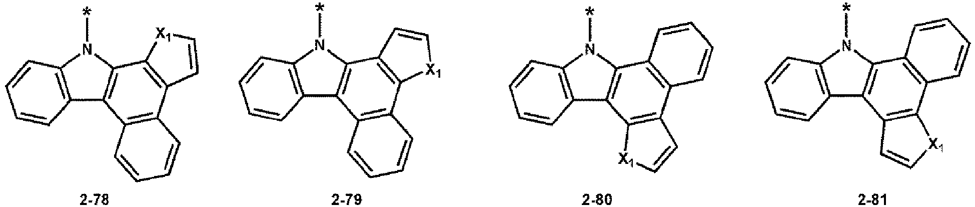

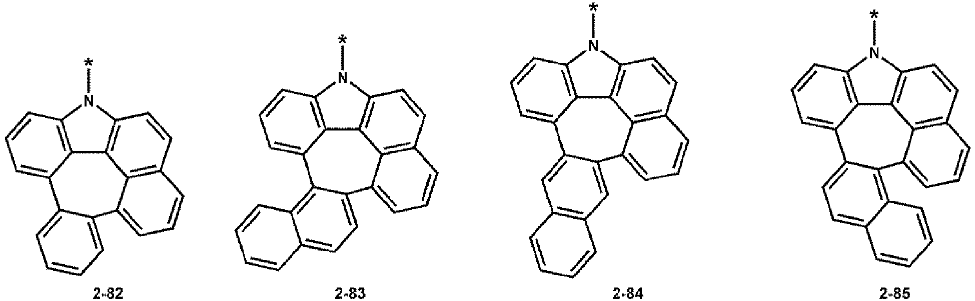

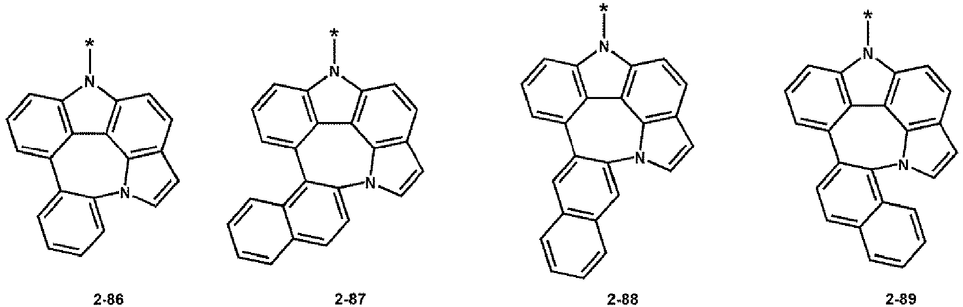

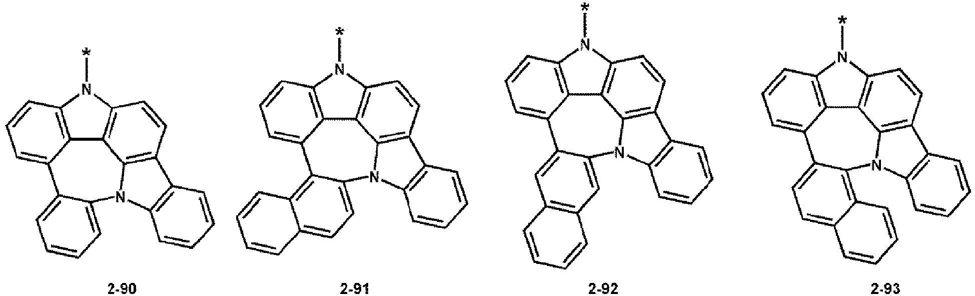

In Formulae 2-1 to 2-93,
X₁ may be O, S, N(R₃₁), C(R₃₁)(R₃₂), or Si(R₃₁)(R₃₂),
X₂ may be O, S, N(R₃₃), C(R₃₃)(R₃₄), or Si(R₃₃)(R₃₄),
R₃₁ to R₃₄ are the same as described in connection with R₃₀, and
* indicates a binding site to Ar₁ or Ar₂ in Formula 2, or Ar₁, Ar₂, Ar₃ or Ar₄ in Formula 2(1).

In one or more embodiments, Het1 in Formula 3 and Het1 and Het3 in Formula 3(1) may each independently be a group derived from one of Formulae 3-1 to 3-40:

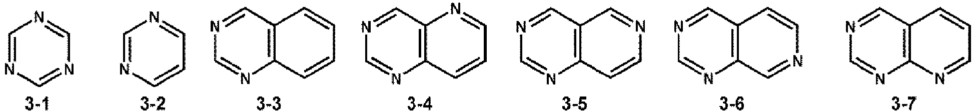

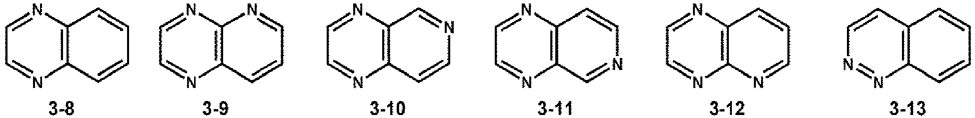

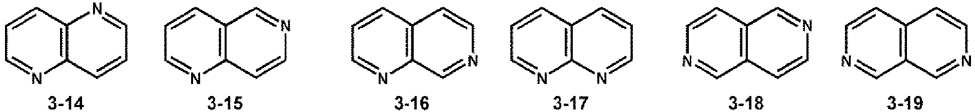

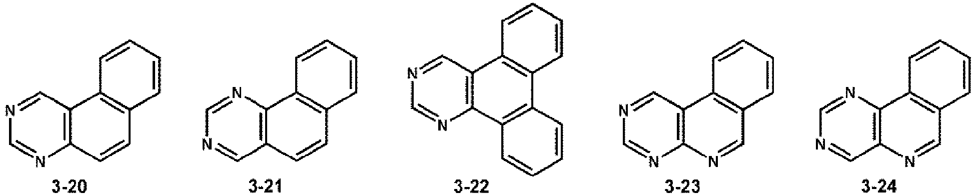

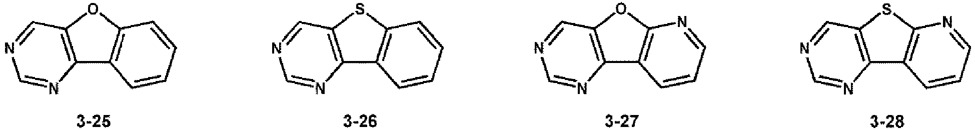

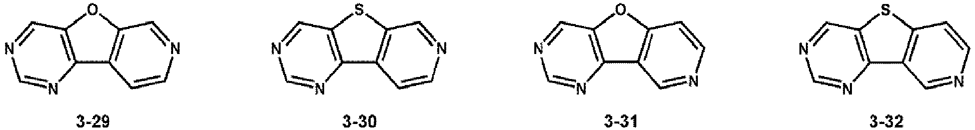

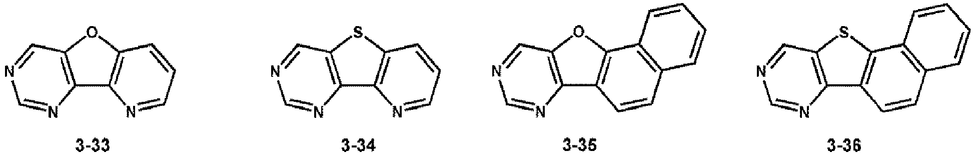

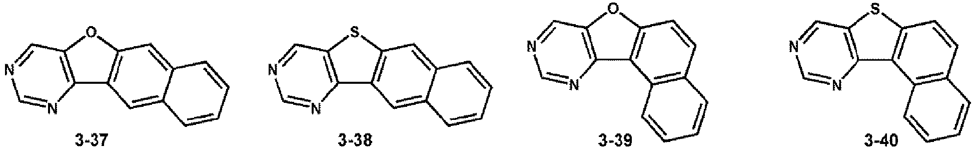

The designations a1 and a2 in Formulae 2 and 2(1) respectively indicate the number of Ar₁ and the number of Ar₂, and may each independently be an integer from 0 to 5 (for example, 0, 1 or 2), and the sum of a1 and a2 may be 1 or more. When a1 is 2 or more, two or more Ar₁(s) may be identical to or different from each other, and when a2 is 2 or more two or more Ar₂(s) may be identical to or different from each other. When a1 is 0, *-(Ar₁)ₐ₁-*' in Formula 2 may be a single bond.

The designations a11 and m in Formulae 3 and 3(1) respectively indicate the number of Ar₁₁ and the number of *-(Ar₁₁)ₐ₁₁-(R₇₀)ₐ₇₀, and may each independently be an integer from 1 to 10. When a11 is 2 or more, two or more Ar₁₁(s) may be identical to or different from each other, and when m is 2 or more, two or more *-(Ar₁₁)ₐ₁₁-(R₇₀)ₐ₇₀ (s) may be identical to or different from each other.

In one or more embodiments, a11 and m in Formula 3 and 3(1) may each independently be an integer from 1 to 3.

R₂₀, R₃₀, R₆₁, R₆₅, R₆₆, R₇₀, and R₈₀ in Formulae 2 and 3 may each independently be hydrogen, deuterium, -F, -CI, -Br, -I, -SF₅, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₂-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), - Si(Q₃)(Q₄)(Q₅), -Ge(Q₃)(Q₄)(Q₅), -B(Q₆)(Q₇), -P(=O)(Q₈)(Q₉), or -P(Q₈)(Q₉). Q₁ to Q₉ are the same as described herein.

For example, R₂₀, R₃₀, R₆₁, R₆₅, R₆₆, R₇₀, and R₈₀ in Formulae 2 and 3 may each independently be:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, or a C₁-C₂₀ alkoxy group;
a C₁-C₂₀ alkyl group or a C₁-C₂₀ alkoxy group, each substituted with deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterium-containing C₁-C₂₀ alkyl group, a fluorinated C₁-C₂₀ alkyl group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group (a norbornyl group), a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a pyridinyl group, a pyrimidinyl group, or any combination thereof;
a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, - CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterium-containing C₁-C₂₀ alkyl group, a fluorinated C₁-C₂₀ alkyl group, a C₁-C₂₀ alkoxy group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof; or
-N(Q₁)(Q₂), -Si(Q₃)(Q₄)(Q₅), -Ge(Q₃)(Q₄)(Q₅), -B(Q₆)(Q₇), -P(=O)(Q₈)(Q₉₎, or-P(Q₈)(Q₉),
Q₁ to Q₉ may each independently be:
   -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H or -CD₂CDH₂; or
   an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₂₀ alkyl group, a phenyl group, or any combination thereof.

The designations b2, b3, b7, and b8 in Formulae 2 and 3 indicate the numbers of R₂₀, R₃₀, R₇₀, and R₈₀, respectively, and may each independently be an integer from 0 to 20. For example, b2, b3, b7, and b8 may each independently be an integer from 0 to 10. When b2 is 2 or more, two or more R₂₀(s) may be identical to or different from each other, when b3 is 2 or more, two or more R₃₀ (s) may be identical to or different from each other, when b7 is 2 or more, two or more R₇₀(s) may be identical to or different from each other, and when b8 is 2 or more, two or more R₈₀(s) may be identical to or different from each other.

In one or more embodiments, R₂₀, R₃₀, R₆₁, R₆₅, R₆₆, R₇₀ and R₈₀ in Formulae 2 and 3 may each independently be:
hydrogen or deuterium;
a C₁-C₂₀ alkyl group or a C₁-C₂₀ alkoxy group, each unsubstituted or substituted with deuterium, a phenyl group, a naphthyl group, an anthracenyl group, a phenanthrenyl group, a triphenylenyl group, a fluorenyl group, a di(C₁-C₁₀ alkyl)fluorenyl group, a di(C₆-C₆₀ aryl)fluorenyl group, a dibenzosilolyl group, a di(C₁-C₁₀ alkyl)dibenzosilolyl group, a di(C₆-C₆₀ aryl)dibenzosilolyl group, a carbazolyl group, a (C₁-C₁₀ alkyl)carbazolyl group, a (C₆-C₆₀ aryl)carbazolyl group, a dibenzofuranyl group, a dibenzothiophenyl group, a biphenyl group, a terphenyl group, -N(Q₃₁)(Q₃₂), or any combination thereof;
a π electron-rich C₃-C₆₀ cyclic group, unsubstituted or substituted with deuterium, a C₁-C₂₀ alkyl group, a C₁-C₂₀ alkoxy group, a phenyl group, a naphthyl group, an anthracenyl group, a phenanthrenyl group, a triphenylenyl group, a fluorenyl group, a di(C₁-C₁₀ alkyl)fluorenyl group, a di(C₆-C₆₀ aryl)fluorenyl group, a dibenzosilolyl group, a di(C₁-C₁₀ alkyl)dibenzosilolyl group, a di(C₆-C₆₀ aryl)dibenzosilolyl group, a carbazolyl group, a (C₁-C₁₀ alkyl)carbazolyl group, a (C₆-C₆₀ aryl)carbazolyl group, a dibenzofuranyl group, a dibenzothiophenyl group, a biphenyl group, a terphenyl group, -N(Q₃₁)(Q₃₂), or any combination thereof; or
-N(Q₁)(Q₂).

Herein, Q₁, Q₂, Q₃₁ and Q₃₂ are each independently the same as described herein.

In one or more embodiments, R₂₀, R₃₀, R₆₁, R₆₅, R₆₆, R₇₀ and R₈₀ in Formulae 2 and 3 may each independently be:
hydrogen or deuterium;
a C₁-C₂₀ alkyl group unsubstituted or substituted with deuterium, a phenyl group, a naphthyl group, an anthracenyl group, a phenanthrenyl group, a triphenylenyl group, a fluorenyl group, a di(C₁-C₁₀ alkyl)fluorenyl group, a di(C₆-C₆₀ aryl)fluorenyl group, a dibenzosilolyl group, a di(C₁-C₁₀ alkyl)dibenzosilolyl group, a di(C₆-C₆₀ aryl)dibenzosilolyl group, a carbazolyl group, a (C₁-C₁₀ alkyl)carbazolyl group, a (C₆-C₆₀ aryl)carbazolyl group, a dibenzofuranyl group, a dibenzothiophenyl group, a biphenyl group, a terphenyl group, -N(Q₃₁)(Q₃₂), or any combination thereof; or
a phenyl group, a naphthyl group, an anthracenyl group, a phenanthrenyl group, a triphenylenyl group, a fluorenyl group, a dibenzosilolyl group, a carbazolyl group, a dibenzofuranyl group, or a dibenzothiophenyl group, unsubstituted or substituted with deuterium, a C₁-C₂₀ alkyl group, a C₁-C₂₀ alkoxy group, a phenyl group, a naphthyl group, an anthracenyl group, a phenanthrenyl group, a triphenylenyl group, a fluorenyl group, a di(C₁-C₁₀ alkyl)fluorenyl group, a di(C₆-C₆₀ aryl)fluorenyl group, a dibenzosilolyl group, a di(C₁-C₁₀ alkyl)dibenzosilolyl group, a di(C₆-C₆₀ aryl)dibenzosilolyl group, a carbazolyl group, a (C₁-C₁₀ alkyl)carbazolyl group, a (C₆-C₆₀ aryl)carbazolyl group, a dibenzofuranyl group, a dibenzothiophenyl group, a biphenyl group, a terphenyl group, -N(Q₃₁)(Q₃₂), or any combination thereof. Herein, Q₃₁ and Q₃₂ are each independently the same as described herein.

In one or more embodiments, the second compound may include at least one of Compounds H1-1 to H1-72:

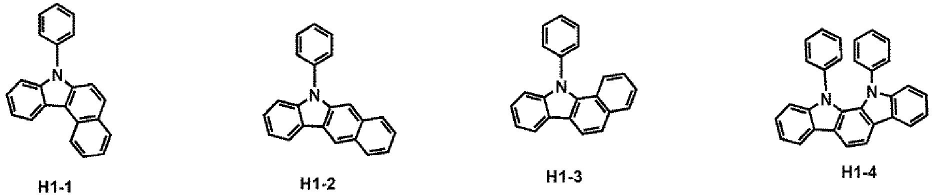

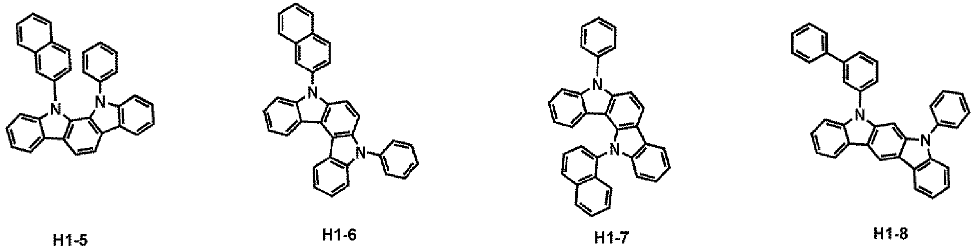

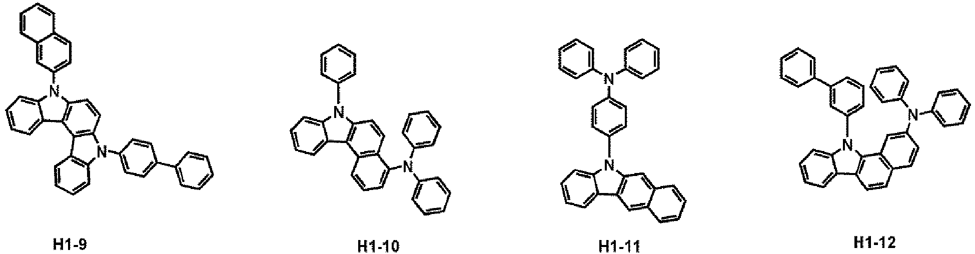

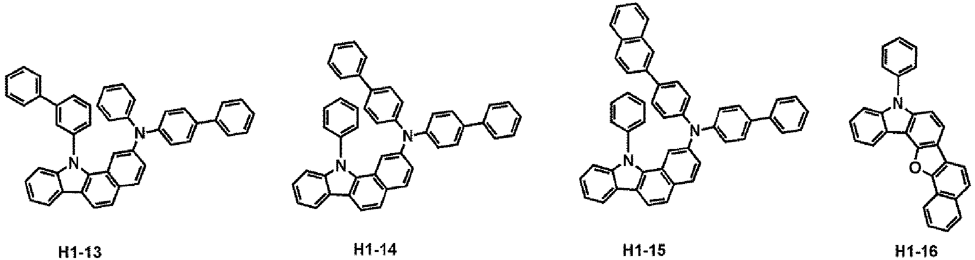

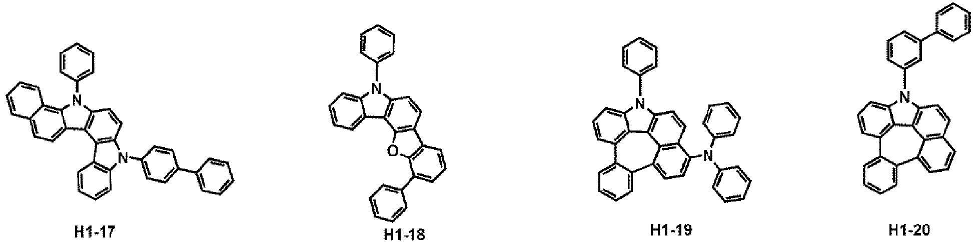

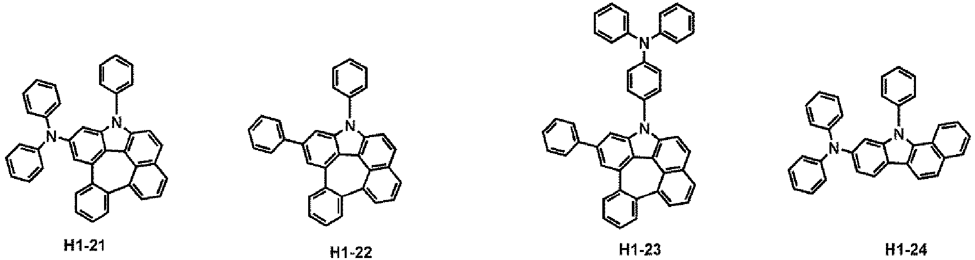

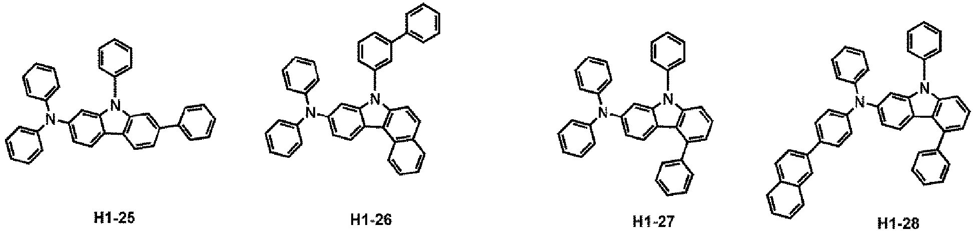

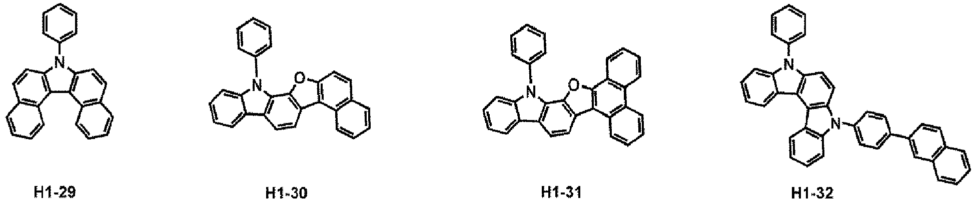

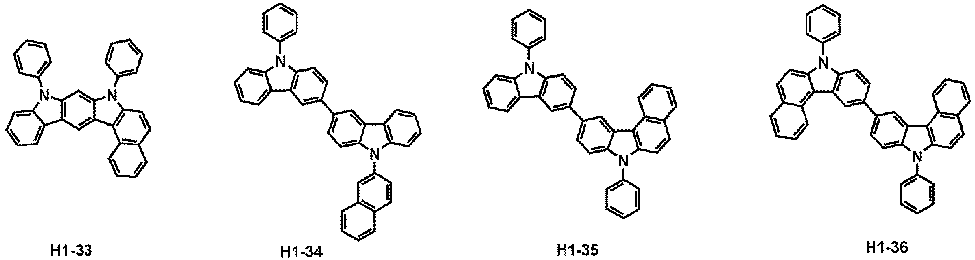

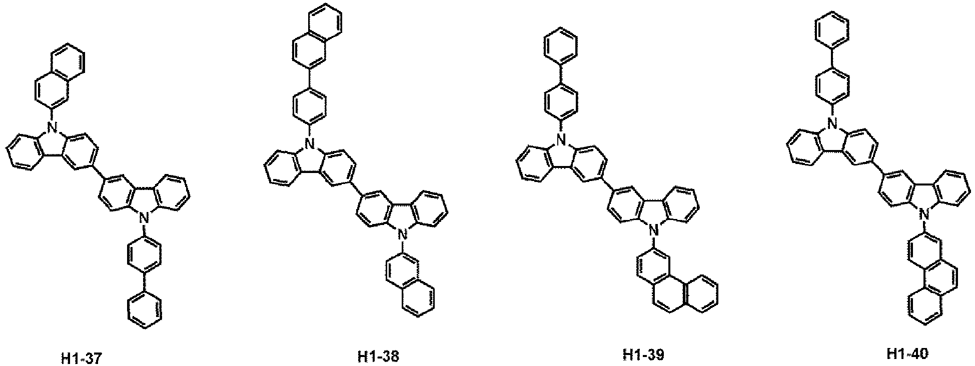

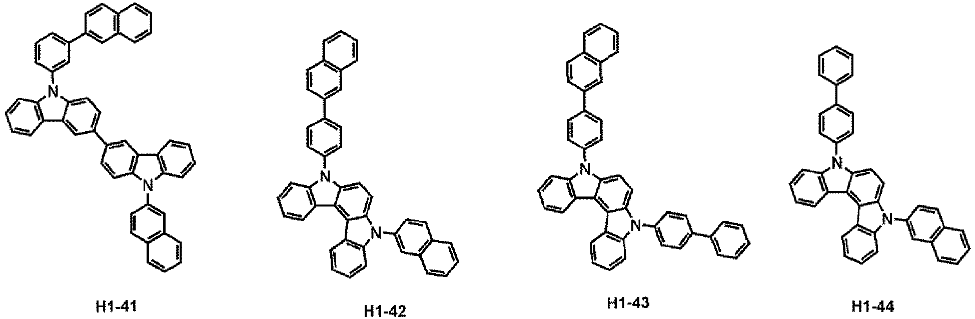

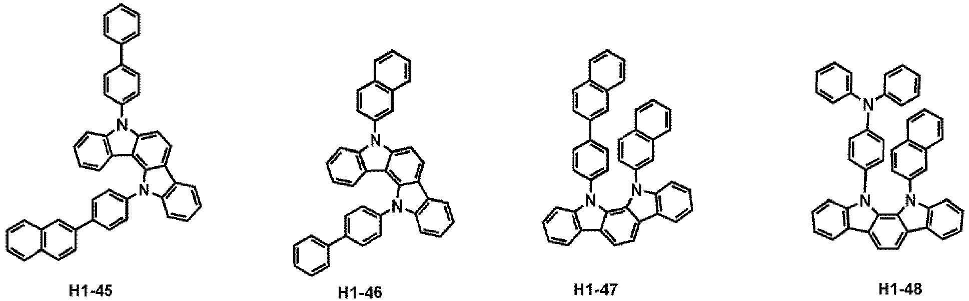

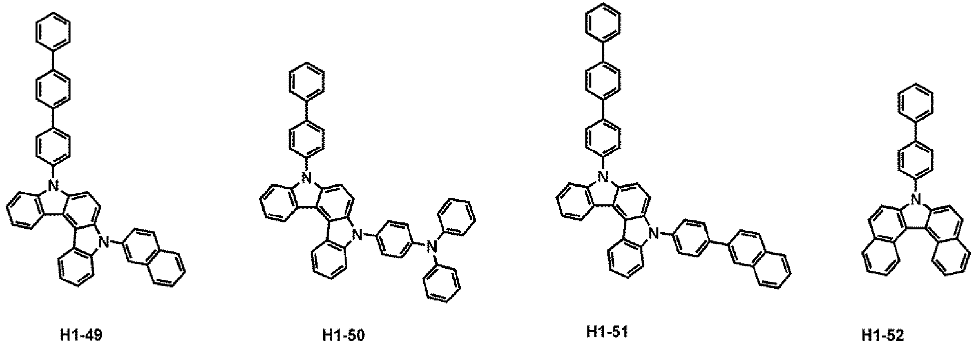

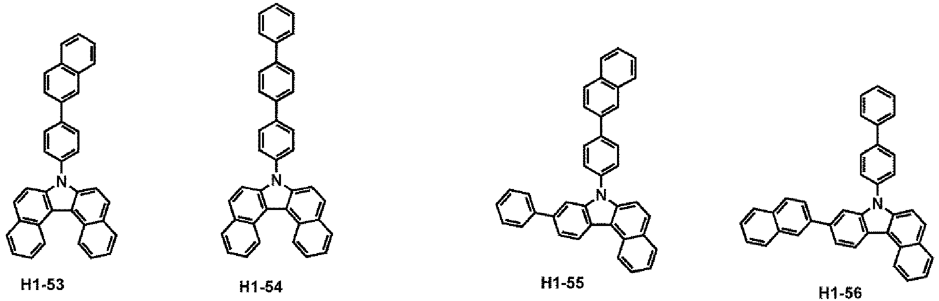

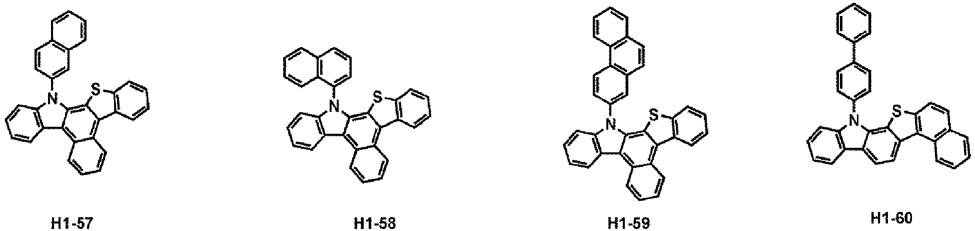

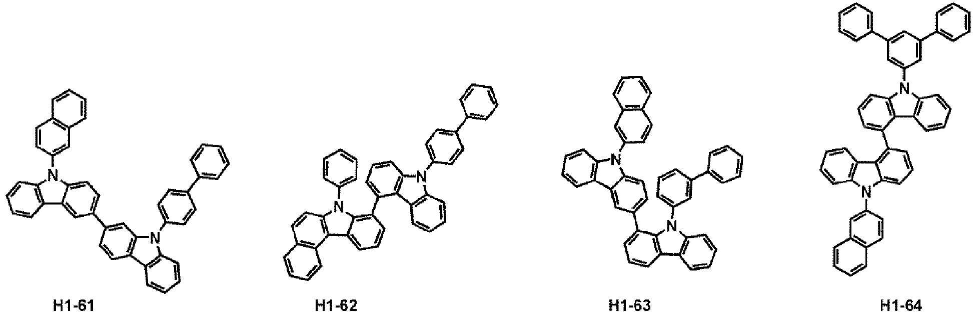

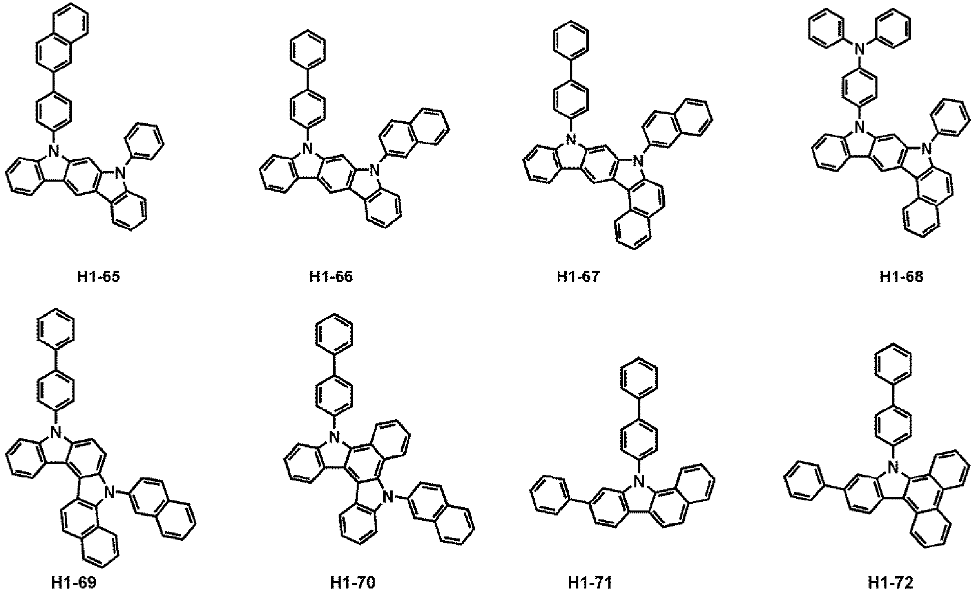

In one or more embodiments, the third compound may include at least one of Compounds H2-1 to H2-61:

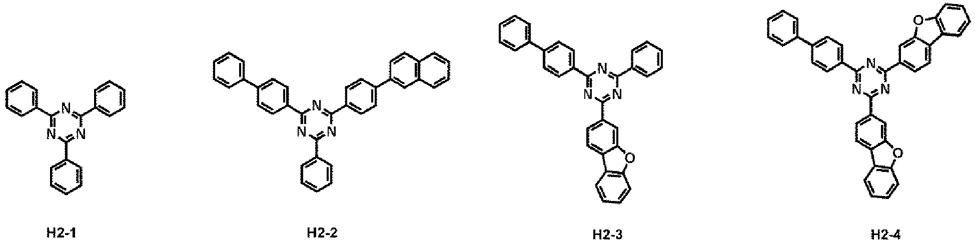

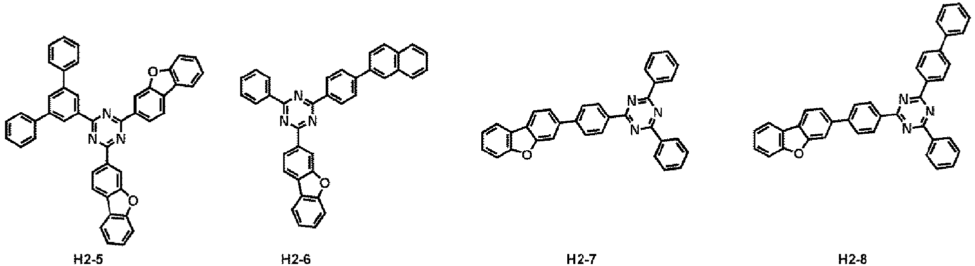

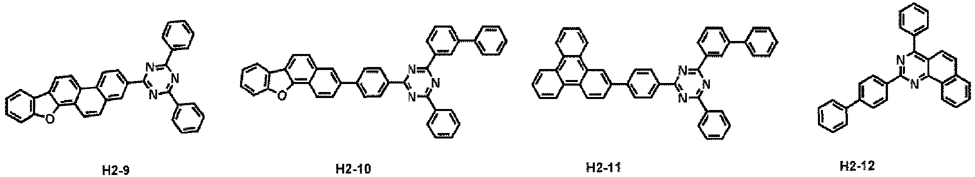

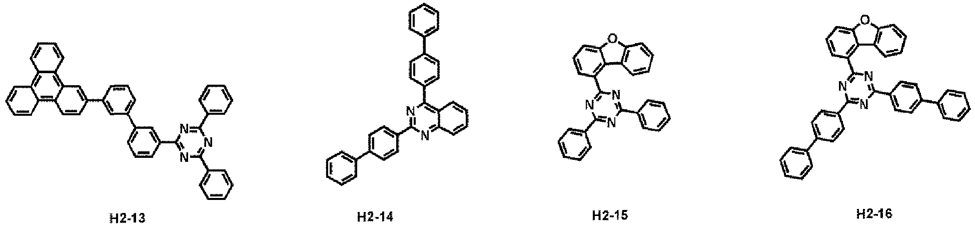

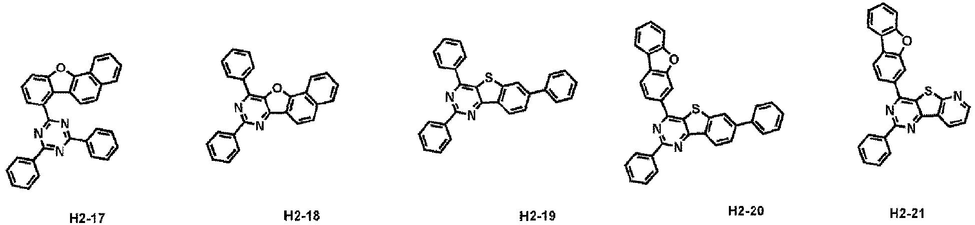

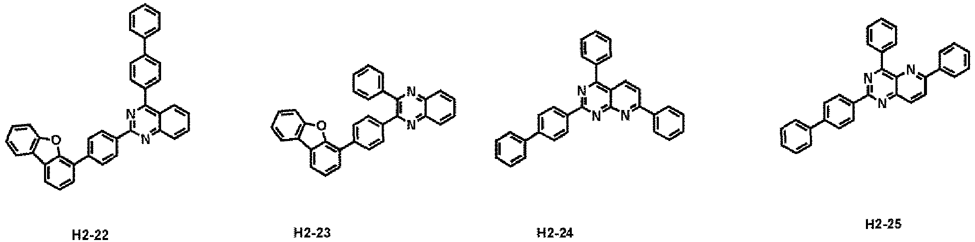

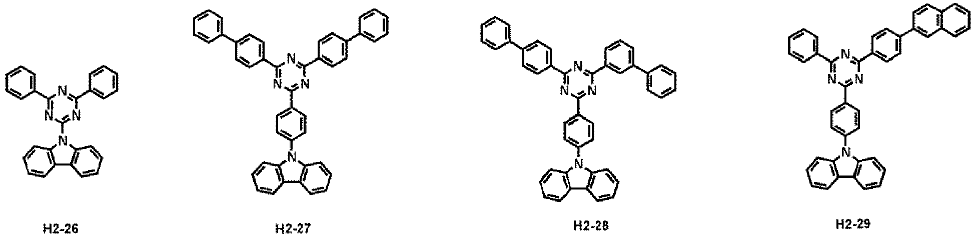

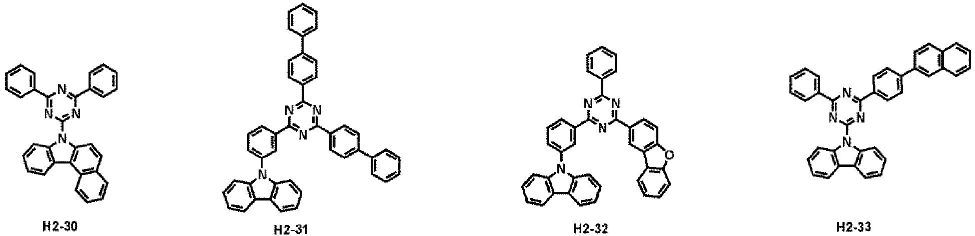

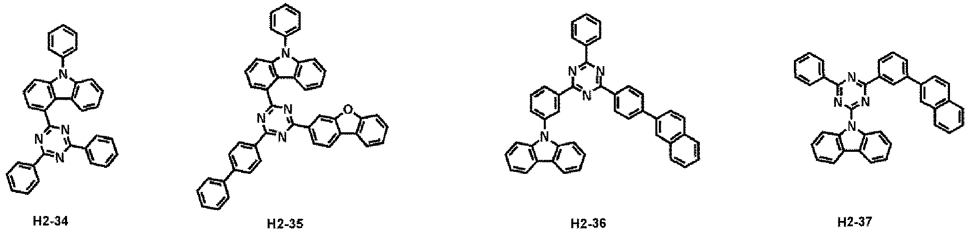

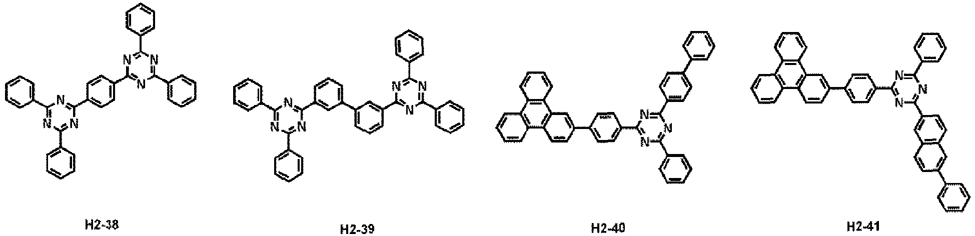

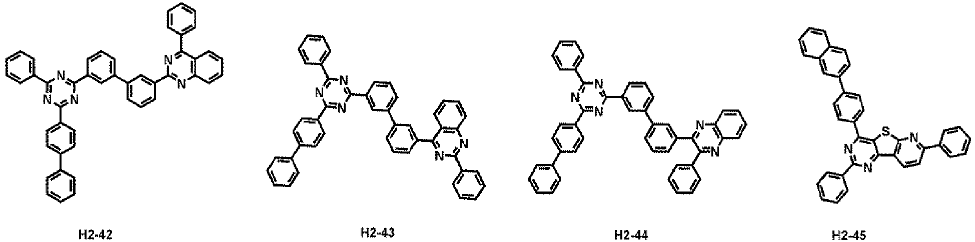

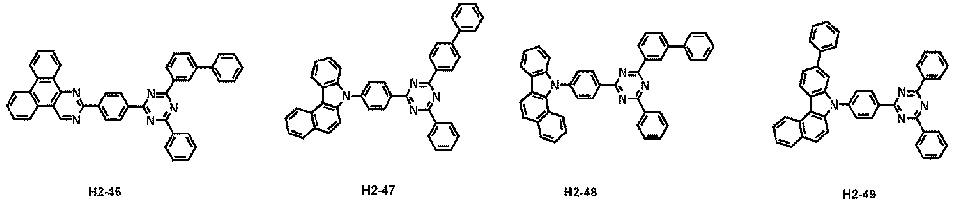

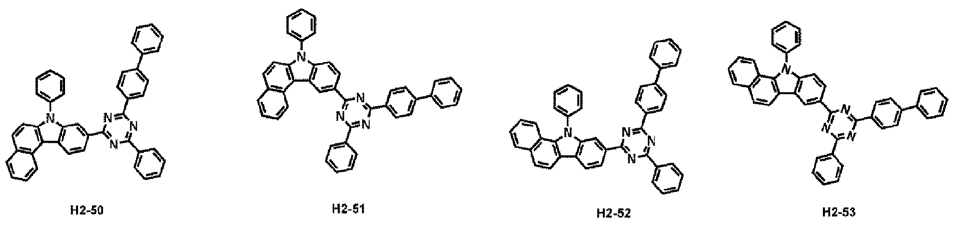

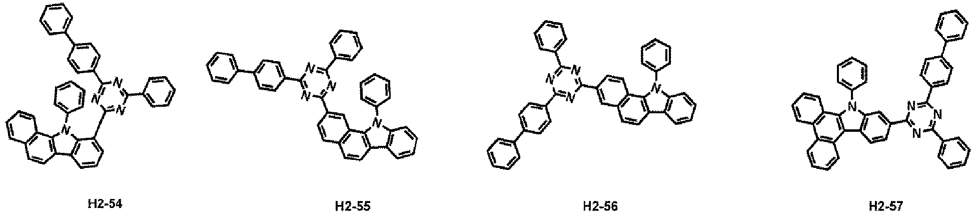

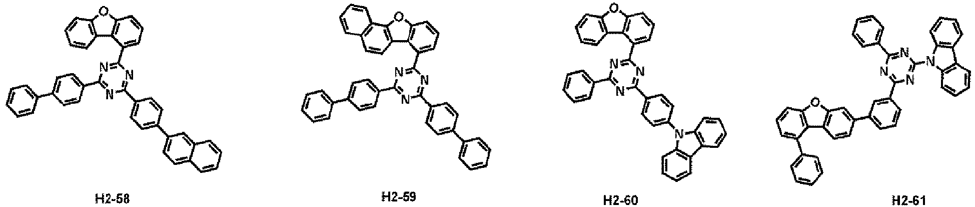

In one or more embodiments, the highest occupied molecular orbital (HOMO) energy level of the second compound may be -5.5 eV or more.

In one or more embodiments, the lowest unoccupied molecular orbital (LUMO) energy level of the third compound may be -2.8 eV or less.

An electronic device, for example, an organic light-emitting device, including the second compound and the third compound may have high external quantum efficiency (EQE) and long lifespan.

In Formulae 1 to 3, 1) two or more of R₁ to R₈ and A₂₀ may be optionally linked to each other to form a C₅-C₆₀ carbocyclic group which is unsubstituted or substituted with at least one R₁ₐ or a C₁-C₆₀ heterocyclic group which is unsubstituted or substituted with at least one R₁ₐ, 2) two or more of A₁ to A₇ may be optionally linked to each other to form a C₅-C₆₀ carbocyclic group which is unsubstituted or substituted with at least one R₁ₐ or a C₁-C₆₀ heterocyclic group which is unsubstituted or substituted with at least one R₁ₐ and 3) two or more of ring CY₂, ring CY₃, R₂₀ and R₃₀ may be optionally linked to each other to form a C₅-C₆₀ carbocyclic group which is unsubstituted or substituted with at least one R₁ₐ or a C₁-C₆₀ heterocyclic group which is unsubstituted or substituted with at least one R₁ₐ. Herein, R₁ₐ may be understood by referring to the description of A₇.

The term "C₅-C₆₀ carbocyclic group" as used herein refers to a saturated or unsaturated cyclic group having, as a ring-forming atom, 5 to 60 carbon atoms only. The C₅-C₆₀ carbocyclic group may be a monocyclic group or a polycyclic group.

The term "a C₅-C₆₀ carbocyclic group (which is unsubstituted or substituted with at least one R₁ₐ)" may include, for example, an adamantane group, a norbornene group, a bicyclo[1.1.1]pentane group, a bicyclo[2.1.1]hexane group, a bicyclo[2.2.1]heptane group (a norbornane group), a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, cyclopentadiene group, a fluorene group, and a 1,2,3,4-tetrahydronaphthalene group each being unsubstituted or substituted with at least one R₁ₐ.

The term "C₁-C₆₀ heterocyclic group" as used herein refers to a saturated or unsaturated cyclic group having, as a ring-forming atom, at least one heteroatom of N, O, Si, P, Se, B, Ge, or S other than 1 to 60 carbon atoms. The C₁-C₆₀ heterocyclic group may be a monocyclic group or a polycyclic group.

The term "a C₁-C₆₀ heterocyclic group (which is unsubstituted or substituted with at least one Ria)" may include a thiophene group, a furan group, a pyrrole group, a silole group, a borole group, a phosphole group, a selenophene group, a germole group, a benzothiophene group, a benzofuran group, an indole group, an indene group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, and a 5,6,7,8-tetrahydroquinoline group, each being unsubstituted or substituted with at least one R₁ₐ.

The term "C₁-C₆₀ alkyl group" as used herein refers to a linear or branched saturated aliphatic hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an isoamyl group, and a hexyl group. The term "C₁-C₆₀ alkylene group" used herein refers to a divalent group having the same structure as that of the C₁-C₆₀ alkyl group.

Examples of the C₁-C₆₀ alkyl group, the C₁-C₂₀ alkyl group, and/or the C₁-C₁₀ alkyl group are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an iso-nonyl group, a sec-nonyl group, a tert-nonyl group, an n-decyl group, an iso-decyl group, a sec-decyl group, and a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, or any combination thereof. For example, Formula 9-33 may be a branched C₆ alkyl group, and may be a tert-butyl group that is substituted with two methyl groups.

The term "C₁-C₆₀ alkoxy group" used herein refers to a monovalent group represented by -OA₁₀₁ (wherein A₁₀₁ is the C₁-C₆₀ alkyl group), and examples thereof include a methoxy group, an ethoxy group, and an isopropyloxy group. Examples of the C₁-C₆₀ alkoxy group, the C₁-C₂₀ alkoxy group, or the C₁-C₁₀ alkoxy group are a methoxy group, an ethoxy group, a propoxy group, a butoxy group, or a pentoxy group.

The term "C₃-C₁₀ cycloalkyl group" as used herein refers to a monovalent saturated hydrocarbon monocyclic group having 3 to 10 carbon atoms, and examples thereof include a cyclopropyl group, a cyclobutyl group, a cyclopentyl group, a cyclohexyl group, and a cycloheptyl group. The term "C₃-C₁₀ cycloalkylene group" as used herein refers to a divalent group having the same structure as that of the C₃-C₁₀ cycloalkyl group. Examples of the C₃-C₁₀ cycloalkyl group are a cyclopropyl group, a cyclobutyl group, a cyclopentyl group, a cyclohexyl group, a cycloheptyl group, a cyclooctyl group, an adamantyl group, a bicyclo[1.1.1]pentyl group (bicyclo[1.1.1]pentyl), a bicyclo[2.1.1]hexyl group (bicyclo[2.1.1]hexyl), a bicyclo[2.2.1]heptyl group (bicyclo[2.2.1]heptyl)(a norbornyl group), and a bicyclo[2.2.2]octyl group.

The term "C₂-C₁₀ heterocycloalkyl group" as used herein refers to a monovalent saturated monocyclic group having at least one heteroatom of N, O, P, Se, Si, B, Ge, or S as a ring-forming atom and 2 to 10 carbon atoms, and non-limiting examples thereof include a tetrahydrofuranyl group, and a tetrahydrothiophenyl group. The term "C₂-C₁₀ heterocycloalkylene group" as used herein refers to a divalent group having the same structure as the C₂-C₁₀ heterocycloalkyl group. Examples of the C₂-C₁₀ heterocycloalkyl group are a silolanyl group, a silinanyl group, a tetrahydrofuranyl group, a tetrahydro-2H-pyranyl group, and a tetrahydrothiophenyl group.

The term "deuterium-containing C₁-C₆₀ alkyl group (or, deuterium-containing C₁-C₂₀ alkyl group, a deuterium-containing C₂-C₂₀ alkyl group, or the like)" as used herein refers to a C₁-C₆₀ alkyl group substituted with at least one deuterium (or a C₁-C₂₀ alkyl group substituted with at least one deuterium, a C₂-C₂₀ alkyl substituted with at least one deuterium, or the like). For example, the term "the deuterium-containing C₁ alkyl group (that is, a deuterium-containing methyl group)" as used herein includes -CD₃, -CD₂H, and - CDH₂.

The term "deuterium-containing C₃-C₁₀ cycloalkyl group" as used herein refers to a C₃-C₁₀ cycloalkyl group substituted with at least one deuterium. Examples of the "deuterium-containing C₃-C₁₀ cycloalkyl group" are provided in connection with, for example, Formula 10-501.

The terms "fluorinated C₁-C₆₀ alkyl group (or a fluorinated C₁-C₂₀ alkyl group, or the like)", "fluorinated C₃-C₁₀ cycloalkyl group", "fluorinated C₂-C₁₀ heterocycloalkyl group" or "fluorinated phenyl group" as used herein refer to a C₁-C₆₀ alkyl group (or, C₁-C₂₀ alkyl group, or the like) substituted with at least one a fluoro group (-F), a C₃-C₁₀ cycloalkyl group substituted with at least one a fluoro group (-F), a C₂-C₁₀ heterocycloalkyl group substituted with at least one a fluoro group (-F), and a phenyl group substituted with at least one a fluoro group (-F), respectively. For example, the term "the fluorinated C₁ alkyl group (that is, the fluorinated methyl group)" includes -CF₃, -CF₂H, and -CFH₂. The "fluorinated C₁-C₆₀ alkyl group (or the fluorinated C₁-C₂₀ alkyl group, or the like)", "the fluorinated C₃-C₁₀ cycloalkyl group", or "the fluorinated C₂-C₁₀ heterocycloalkyl group" may be i) a fully fluorinated C₁-C₆₀ alkyl group (or, fully fluorinated C₁-C₂₀ alkyl group, or the like), a fully fluorinated C₃-C₁₀ cycloalkyl group, or a fully fluorinated C₂-C₁₀ heterocycloalkyl group, each group in which all hydrogen are substituted with a fluoro group, or ii) a partially fluorinated C₁-C₆₀ alkyl group (or, a partially fluorinated C₁-C₂₀ alkyl group, or the like), a partially fluorinated C₃-C₁₀ cycloalkyl group, or a partially fluorinated C₂-C₁₀ heterocycloalkyl group, each group in which some hydrogen are substituted with a fluoro group.

The term "(C₁-C₂₀ alkyl)'X' group" as used herein refers to a 'X' group substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group substituted with at least one C₁-C₂₀ alkyl group and the term "(C₁-C₂₀ alkyl)phenyl group" as used herein refers to a phenyl group substituted with at least one C₁-C₂₀ alkyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, and an azadibenzothiophene 5,5-dioxide group" respectively refer to a heterocyclic group having the same backbone as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, 9H-fluorene-9-one group, and a dibenzothiophene 5,5-dioxide group" in which at least one carbon atoms constituting the cyclic groups is substituted with a nitrogen.

The term "C₂-C₆₀ alkenyl group" as used herein refers to a hydrocarbon group formed by substituting at least one carbon-carbon double bond in the middle or at the terminus of the C₂-C₆₀ alkyl group, and examples thereof include an ethenyl group, a propenyl group, and a butenyl group. The term "C₂-C₆₀ alkenylene group" used herein refers to a divalent group having the same structure as that of the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and examples thereof include an ethynyl group, and a propynyl group. The term "C₂-C₆₀ alkynylene group" as used herein refers to a divalent group having the same structure as that of the C₂-C₆₀ alkynyl group.

The term "C₃-C₁₀ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₂-C₁₀ heterocycloalkenyl group" as used herein refers to a monovalent monocyclic group that has at least one heteroatom of N, O, P, Si, Se, B, Ge, or S as a ring-forming atom, 2 to 10 carbon atoms, and at least one double bond in its ring. Examples of the C₂-C₁₀ heterocycloalkenyl group are a 2,3-dihydrofuranyl group, and a 2,3-dihydrothiophenyl group. The term "C₂-C₁₀ heterocycloalkenylene group" as used herein refers to a divalent group having the same structure as the C₂-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Non-limiting examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other.

The term "C₁-C₆₀ heteroaryl group" as used herein refers to a monovalent group having a cyclic aromatic system that has at least one heteroatom of N, O, P, Si, Se, B, Ge, or S as a ring-forming atom, and 1 to 60 carbon atoms. The term "C₁-C₆₀ heteroarylene group" as used herein refers to a divalent group having a cyclic aromatic system that has at least one heteroatom of N, O, P, Si, Se, B, Ge, or S as a ring-forming atom, and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₆-C₆₀ heteroaryl group and the C₆-C₆₀ heteroarylene group each include two or more rings, the rings may be fused to each other.

The term "C₆-C₆₀ aryloxy group" as used herein indicates -OA₁₀₂ (wherein A₁₀₂ is the C₆-C₆₀ aryl group), and the term "C₆-C₆₀ arylthio group" as used herein indicates -SA₁₀₃ (wherein A₁₀₃ is the C₆-C₆₀ aryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom of N, O, P, Si, Se, B, Ge, or S, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "C₁-C₆₀ cyclic group" includes the C₅-C₆₀ carbocyclic group and the C₁-C₆₀ heterocyclic group.

A substituent of the substituted C₅-C₆₀ carbocyclic group, the substituted C₁-C₆₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₂-C₁₀ heterocycloalkyl group, the substituted C₃-C₁₀ cycloalkenyl group, the substituted C₂-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group may be:
deuterium, -F, -CI, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -CI, -Br, - I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₂-C₁₀ heterocycloalkyl group, a C₃-C₁₀ cycloalkenyl group, a C₂-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -Ge(Q₁₃)(Q₁₄)(Q₁₅),-B(Q₁₆)(Q₁₇), -P(=O)(Q₁₈)(Q₁₉), -P(Q₁₈)(Q₁₉), or any combination thereof;
a C₃-C₁₀ cycloalkyl group, a C₂-C₁₀ heterocycloalkyl group, a C₃-C₁₀ cycloalkenyl group, a C₂-C₁₀ heterocycloalkenyl group, a C₆-C₆₀ aryl group, a C₇-C₆₀ alkylaryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, or a monovalent non-aromatic condensed heteropolycyclic group, each unsubstituted or substituted with deuterium, -F, -CI, - Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₂-C₁₀ heterocycloalkyl group, a C₃-C₁₀ cycloalkenyl group, a C₂-C₁₀ heterocycloalkenyl group, a C₆-C₆₀ aryl group, a C₇-C₆₀ alkylaryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, -N(Q₂₁)(Q₂₂),-Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), -P(Q₂₈)(Q₂₉), or any combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇),-P(=O)(Q₃₈)(Q₃₉), or -P(Q₃₈)(Q₃₉); or
any combination thereof.

In the present specification, Q₁ to Q₉, Q₁₁ to Q₁₉, Q₂₁ to Q₂₉, and Q₃₁ to Q₃₉ may each independently be hydrogen; deuterium; -F; -CI; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group, unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₃-C₁₀ cycloalkyl group; a C₂-C₁₀ heterocycloalkyl group; a C₃-C₁₀ cycloalkenyl group; a C₂-C₁₀ heterocycloalkenyl group; a C₆-C₆₀ aryl group, unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

For example, in the present specification, Q₁ to Q₉, Q₁₁ to Q₁₉, Q₂₁ to Q₂₉, and Q₃₁ to Q₃₉ may each independently be
-CH₃, -CD₃, -CD₂H, -CDH₂, -CH₂CH₃, -CH₂CD₃, -CH₂CD₂H, -CH₂CDH₂,-CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or any combination thereof.

Accordingly, since the composition including the first compound, the second compound, and the third compound is suitable for use in an organic layer of an organic light-emitting device, for example, for use as a material for an emission layer in the organic layer, another aspect provides an organic light-emitting device including: a first electrode; a second electrode; and an organic layer disposed between the first electrode and the second electrode and including an emission layer, wherein the organic layer includes the composition.

Due to the inclusion of the first compound, the second compound, and the third compound, the organic light-emitting device may have, a low driving voltage, high external quantum efficiency, and a long lifespan.

The composition may be used between a pair of electrodes of an organic light-emitting device. For example, the composition may be included in the emission layer of the organic light-emitting device. At this time, the first compound may act as a dopant, and the second compound and third compound may each act as a host (for example, a co-host). For example, the total amount of the second compound and third compound may be greater than the amount of the first compound. The emission layer may emit red light, for example, red light having a maximum emission wavelength of 550 nm or more (for example, from 550 nm or more and 900 nm or less).

The first electrode may be an anode, which is a hole injection electrode, and the second electrode may be a cathode, which is an electron injection electrode, or the first electrode may be a cathode, which is an electron injection electrode, and the second electrode may be an anode, which is a hole injection electrode.

In one or more embodiments, in the organic light-emitting device, the first electrode is an anode, and the second electrode is a cathode, and the organic layer further includes a hole transport region between the first electrode and the emission layer and an electron transport region between the emission layer and the second electrode, and the hole transport region includes a hole injection layer, a hole transport layer, an electron blocking layer, or any combination thereof, and the electron transport region includes a hole blocking layer, an electron transport layer, an electron injection layer, or any combination thereof.

The term "organic layer" used herein refers to a single layer and/or a plurality of layers between the first electrode and the second electrode of the organic light-emitting device. The "organic layer" may include, in addition to an organic compound, an organometallic complex including metal.

FIGURE is a schematic view of an organic light-emitting device 10 according to one embodiment. Hereinafter, the structure of an organic light-emitting device according to an embodiment and a method of manufacturing an organic light-emitting device according to an embodiment will be described in connection with FIGURE. The organic light-emitting device 10 includes a first electrode 11, an organic layer 15, and a second electrode 19, which are sequentially stacked.

A substrate may be additionally located under the first electrode 11 or above the second electrode 19. For use as the substrate, any substrate that is used in organic light-emitting devices may be used, and the substrate may be a glass substrate or a transparent plastic substrate, each having excellent mechanical strength, thermal stability, transparency, surface smoothness, ease of handling, and water resistance.

In one or more embodiments, the first electrode 11 may be formed by depositing or sputtering a material for forming the first electrode 11 on the substrate. The first electrode 11 may be an anode. The material for forming the first electrode 11 may be of materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO, but the structure of the first electrode 11 is not limited thereto.

The organic layer 15 is located on the first electrode 11.

The organic layer 15 may include a hole transport region, an emission layer, and an electron transport region.

The hole transport region may be between the first electrode 11 and the emission layer.

The hole transport region may include a hole injection layer, a hole transport layer, an electron blocking layer, a buffer layer, or any combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, which are sequentially stacked in this stated order from the first electrode 11.

When the hole transport region includes a hole injection layer (HIL), the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary according to a material that is used to form the hole injection layer, and the structure and thermal characteristics of the hole injection layer. For example, the deposition conditions may include a deposition temperature of about 100°C to about 500°C, a vacuum pressure of about 1,33*10⁻⁶ Pa (10⁻⁸ torr) to about 1,33*10⁻¹Pa (10⁻³ torr), and a deposition rate of about 0.01 Å/sec to about 100 Å/sec. However, the deposition conditions are not limited thereto.

When the hole injection layer is formed using spin coating, coating conditions may vary according to the material used to form the hole injection layer, and the structure and thermal properties of the hole injection layer. For example, a coating speed may be from about 2,000 rpm to about 5,000 rpm, and a temperature at which a heat treatment is performed to remove a solvent after coating may be from about 80°C to about 200°C. However, the coating conditions are not limited thereto.

Conditions for forming a hole transport layer and an electron blocking layer may be understood by referring to conditions for forming the hole injection layer.

The hole transport region may include m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201 below, a compound represented by Formula 202 below, or any combination thereof:

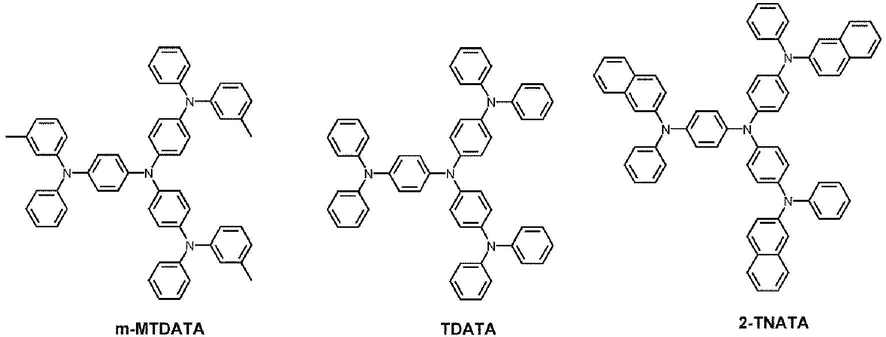

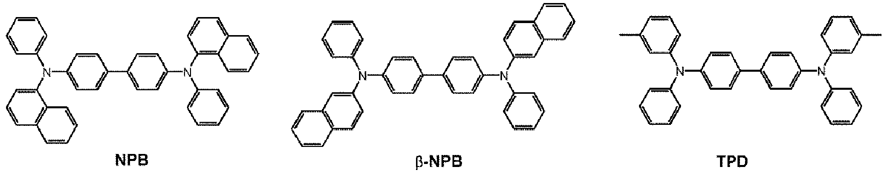

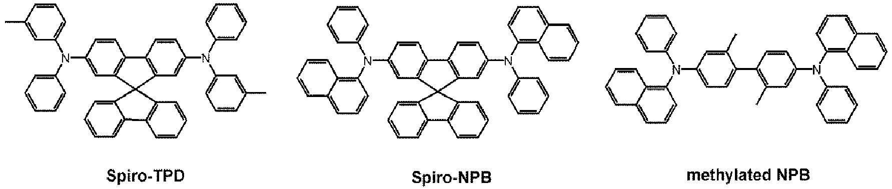

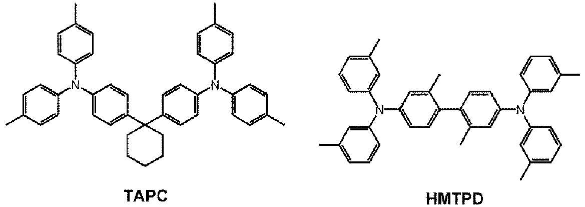

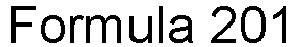

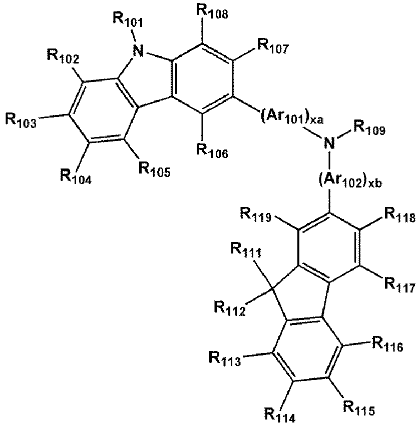

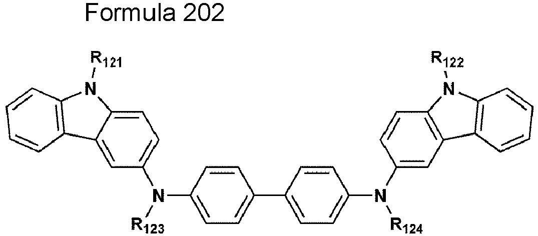

Ar₁₀₁ and Ar₁₀₂ in Formula 201 may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₂-C₁₀ heterocycloalkyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, or any combination thereof.

The designations xa and xb in Formula 201 may each independently be an integer from 0 to 5, or 0, 1 or 2. For example, xa may be 1 and xb may be 0, but xa and xb are not limited thereto.

R₁₀₁ to R₁₀₈, R₁₁₁ to R₁₁₉ and R₁₂₁ to R₁₂₄ in Formulae 201 and 202 may each independently be:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, a pentyl group, or a hexyl group), or a C₁-C₁₀ alkoxy group (for example, a methoxy group, an ethoxy group, a propoxy group, a butoxy group, or a pentoxy group);
a C₁-C₁₀ alkyl group or a C₁-C₁₀ alkoxy group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or any combination thereof; or
a phenyl group, a naphthyl group, an anthracenyl group, a fluorenyl group, or a pyrenyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, or any combination thereof.
R₁₀₉ in Formula 201 may be a phenyl group, a naphthyl group, an anthracenyl group, or a pyridinyl group, each unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group, a pyridinyl group, or any combination thereof.

In one or more embodiments, the compound represented by Formula 201 may be represented by Formula 201A below:

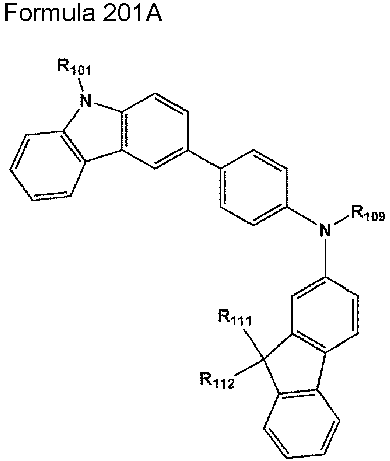

R₁₀₁, R₁₁₁, R₁₁₂, and R₁₀₉ in Formula 201A may be understood by referring to the description provided herein.

For example, the hole transport region may include at least one of compounds HT1 to HT20 illustrated below, but are not limited thereto:

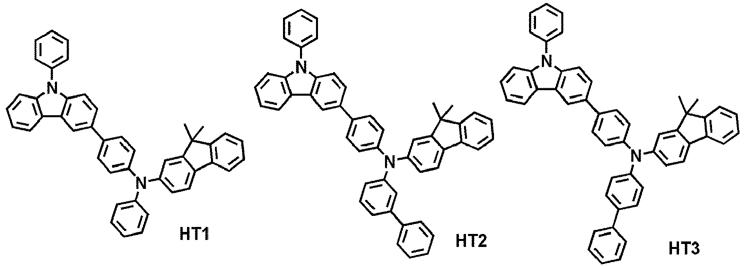

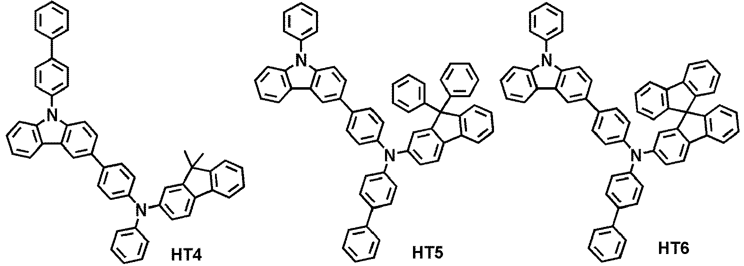

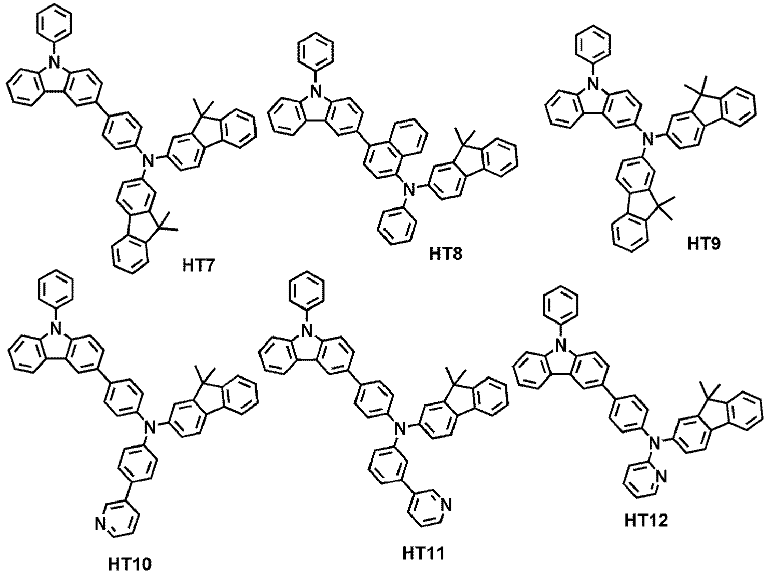

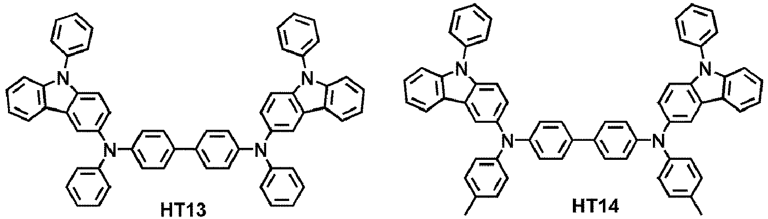

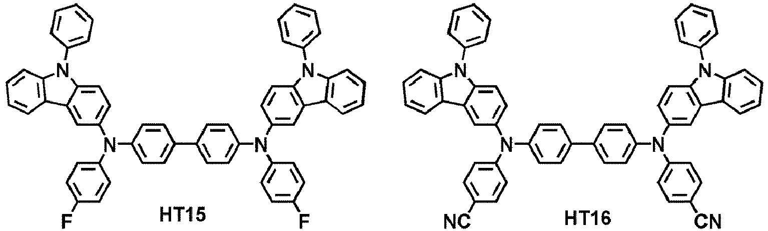

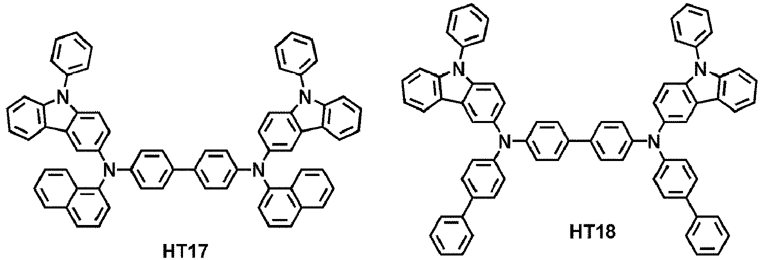

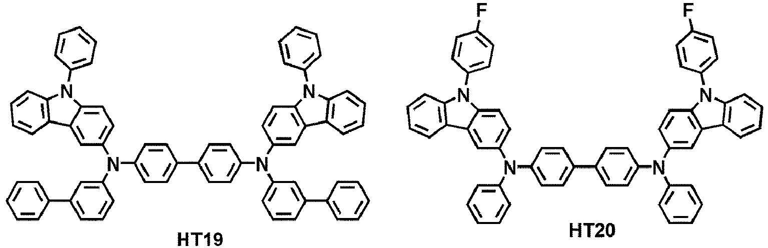

The thickness of the hole transport region may be in a range of about 100 Å to about 10,000 Å, for example, about 100 Å to about 1,000 Å. When the hole transport region includes a hole injection layer, a hole transport layer, or any combination thereof, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example about 100 Å to about 1,500 Å. When the thicknesses of the hole transport region, the hole injection layer and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be a quinone derivative, a metal oxide, a cyano group-containing compound, or any combination thereof, but embodiments of the present disclosure are not limited thereto. Examples of the p-dopant are a quinone derivative, such as tetracyanoquinodimethane (TCNQ), 2,3,5,6-tetrafluoro-tetracyano-1,4-benzoquinone dimethane (F4-TCNQ), or F6-TCNNQ; a metal oxide, such as a tungsten oxide or a molybdenum oxide; a cyano group-containing compound, such as Compound HT-D1 below; or any combination thereof.

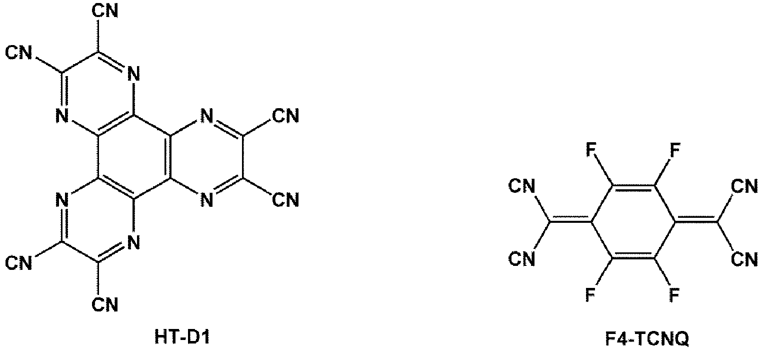

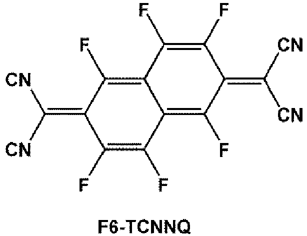

The hole transport region may include a buffer layer.

Also, the buffer layer may compensate for an optical resonance distance according to a wavelength of light emitted from the emission layer, and thus, efficiency of a formed organic light-emitting device may be improved.

Meanwhile, when the hole transport region includes an electron blocking layer, a material for the electron blocking layer may be a material for the hole transport region described above, a material for a host to be explained later, or any combination thereof. For example, when the hole transport region includes an electron blocking layer, a material for the electron blocking layer may be mCP.

Then, an emission layer (EML) may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a material that is used to form the emission layer.

The emission layer may include the composition including the first compound through the third compound as described herein.

In one or more embodiments, the emission layer may include a host and a dopant, the dopant may include the first compound, and the host may include the second compound and the third compound.

The weight ratio of the second compound to the third compound may be from 1 : 9 to 9 : 1, from 2 : 8 to 8 : 2, from 3 : 7 to 7 : 3, or from 4 : 6 to 6 : 4. In one or more embodiments, the weight ratio of the second compound and the third compound may be 5: 5, but embodiments are not limited.

Meanwhile, the emission layer may further include any dopant and/or host in addition to the composition described herein.

When the organic light-emitting device is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit white light.

When the emission layer includes a host and a dopant, an amount of the dopant may be in a range of about 0.01 parts by weight to about 15 parts by weight based on 100 parts by weight of the host, but embodiments of the present disclosure are not limited thereto.

A thickness of the emission layer may be in a range of about 100 Å to about 1,000 Å, for example, about 200 Å to about 600 Å. When the thickness of the emission layer is within this range, excellent light-emission characteristics may be obtained without a substantial increase in driving voltage.

Then, an electron transport region may be disposed on the emission layer.

The electron transport region may include a hole blocking layer, an electron transport layer, an electron injection layer, or any combination thereof.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of BCP, Bphen, and BAIq.

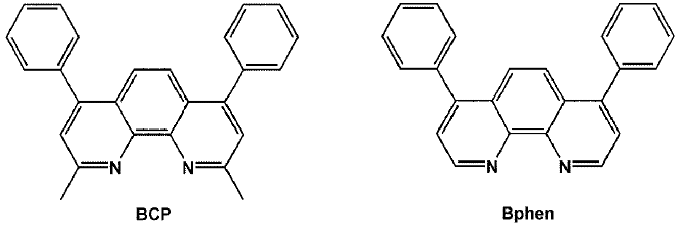

The thickness of the hole blocking layer may be in a range of about 20 Å to about 1,000 Å, for example, about 30 Å to about 300 Å. When the thickness of the hole blocking layer is within these ranges, the hole blocking layer may have excellent hole blocking characteristics without a substantial increase in driving voltage.

The electron transport layer may include BCP, Bphen, TPBi, Alq₃, BAIq, TAZ, NTAZ, or any combination thereof.

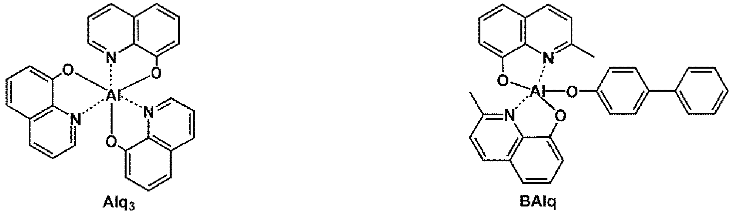

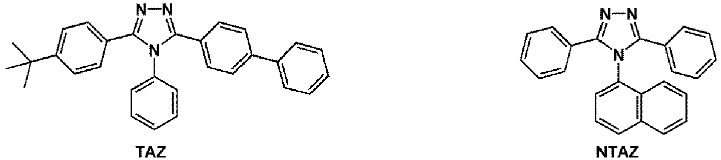

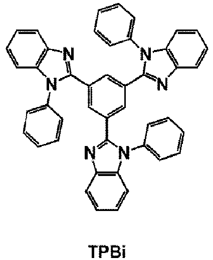

In one or more embodiments, the electron transport layer may include at least one of ET1 to ET25:

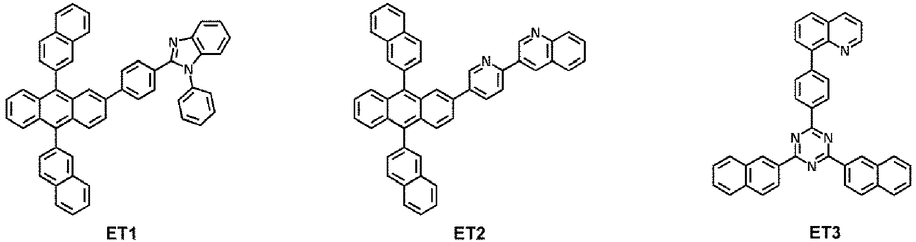

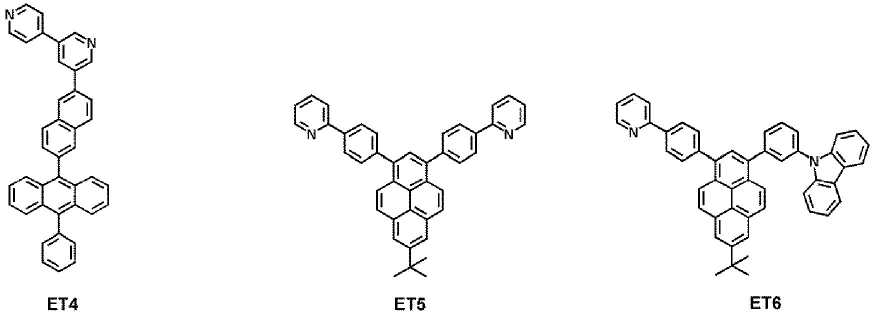

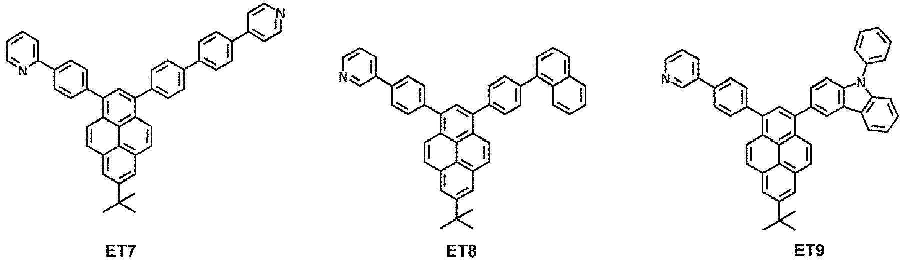

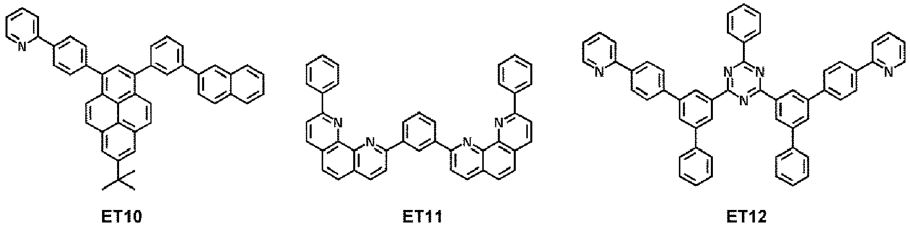

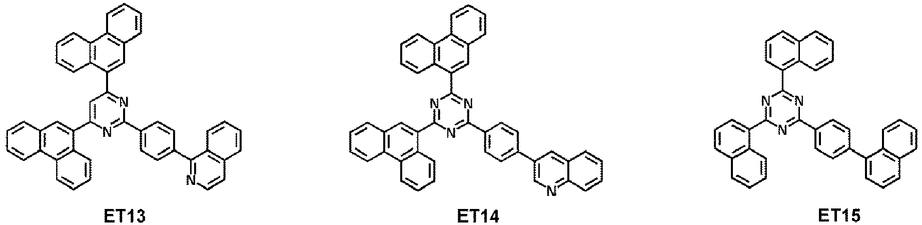

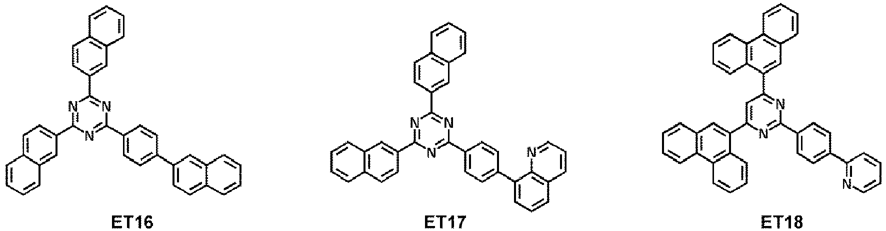

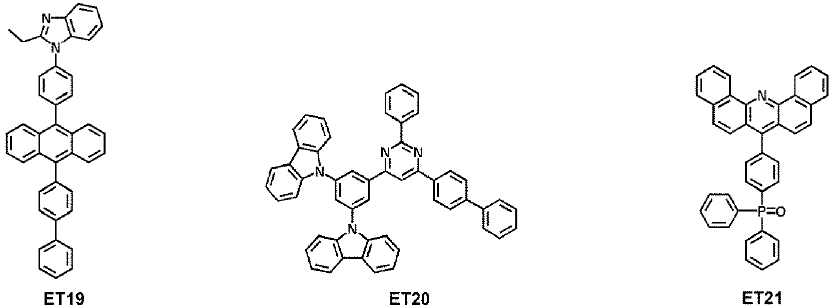

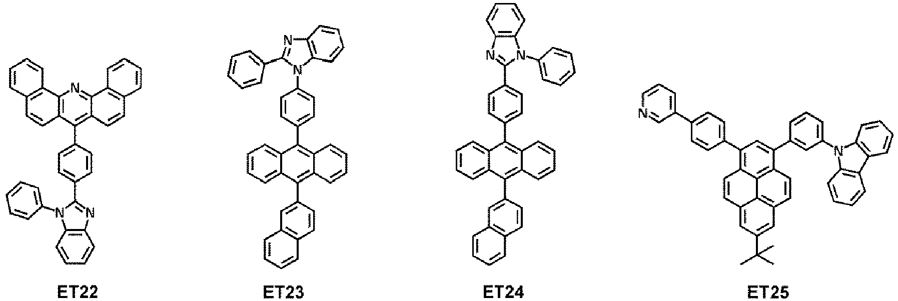

The thickness of the electron transport layer may be in a range of about 100 Å to about 1,000 Å, for example, about 150 Å to about 500 Å. When the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1, ET-D2, or a combination thereof.

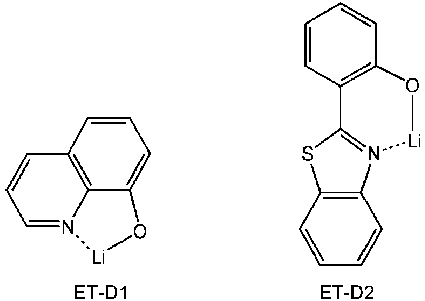

The electron transport region may include an electron injection layer (EIL) that promotes flow of electrons from the second electrode 19 thereinto.

The electron injection layer may include LiF, NaCl, CsF, Li₂O, BaO, or any combination thereof.

The thickness of the electron injection layer may be in a range of about 1 Å to about 100 Å, and, for example, about 3 Å to about 90 Å. When the thickness of the electron injection layer is within the range described above, the electron injection layer may have satisfactory electron injection characteristics without a substantial increase in driving voltage.

The second electrode 19 is located on the organic layer 15. The second electrode 19 may be a cathode. A material for forming the second electrode 19 may be metal, an alloy, an electrically conductive compound, or a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be formed as the material for forming the second electrode 19. To manufacture a top-emission type light-emitting device, a transmissive electrode formed using ITO or IZO may be used as the second electrode 19.

Hereinbefore, the organic light-emitting device has been described with reference to FIGURE, but embodiments of the present disclosure are not limited thereto.

Hereinafter, a compound and an organic light-emitting device according to embodiments are described in detail with reference to Synthesis Example and Examples. However, the organic light-emitting device is not limited thereto. The wording "B was used instead of A" used in describing Synthesis Examples means that an amount of A used was identical to an amount of B used, in terms of a molar equivalent.

### Examples

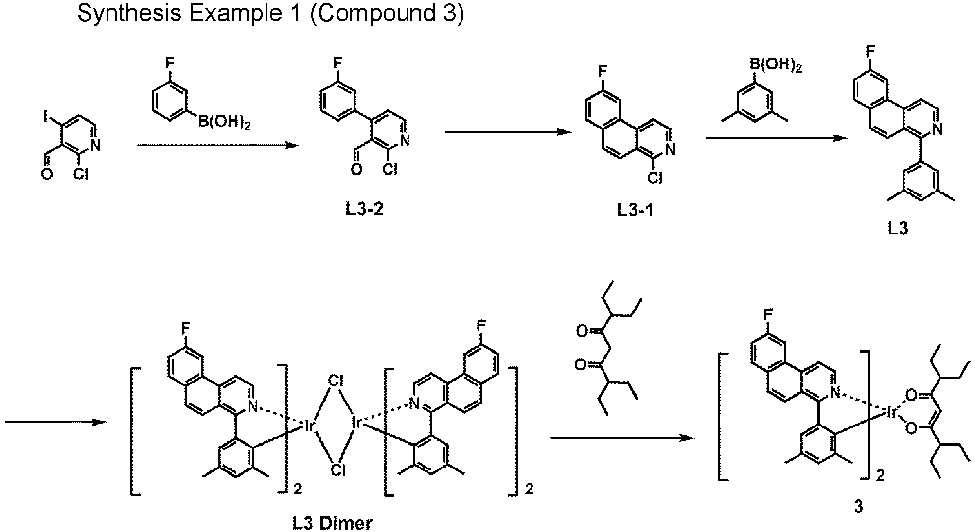

### Synthesis of Intermediate L3-2

2.5 g (9.3 mmol) of 2-chloro-4-iodo-nicotinaldehyde was mixed with 100 ml of tetrahydrofuran and 30 ml of water, and 0.53 g (0.46 mmol) of Pd(PPh₃)₄, 1.3 g (9.3 mmol) of 3-fluorophenylboronic acid, and 3.2 g (23.0 mmol) of K₂CO₃ were added to the mixture, followed by heating at a temperature of 80°C for 24 hours while refluxing. When the reaction was completed, the reaction mixture was concentrated under reduced pressure, dichloromethane and water were added thereto, and an extraction process was performed thereon to obtain an organic layer. The organic layer was dried by using magnesium sulfate, distilled under reduced pressure, and purified by column chromatography to obtain 1.1 g of Intermediate L3-2 (yield of 51 %).

LCMS : m/z calcd for C₁₂H₇CIFNO 235.02; Found 236.06.

### Synthesis of Intermediate L3-1

5.8 g (17.0 mmol) of (methoxymethyl)triphenylphosphonium chloride and 1.6 g (6.8 mmol) of Intermediate L3-2 were added to 50 ml of tetrahydrofuran and mixed together, and then, 17 ml of 1.0 M potassium tert-butoxide solution (in THF) was slowly added dropwise thereto at room temperature and mixed for 24 hours. When the reaction was completed, the organic layer, obtained by adding water and ethyl acetate to the reaction mixture and performing an extraction process thereon, was dried by using magnesium sulfate and distilled under reduced pressure. The resulting product was dried under reduced pressure, and then, mixed with 40 ml of dichloromethane, and then, 1.5 ml of methanesulfonic acid was slowly added dropwise thereto at room temperature, followed by stirring at room temperature for about 12 hours. When the reaction was completed, an organic layer, obtained by adding saturated aqueous sodium hydrogen carbonate solution and performing an extraction process thereon, was dried by using magnesium sulfate, distilled under reduced pressure, and purified by column chromatography to obtain 1.1 g of Intermediate L3-1 (yield of 72%).

LCMS : m/z calcd for C₁₃H₇CIFN 231.03; Found 231.98.

### Synthesis of Intermediate L3

0.7 g (3.0 mmol) of Intermediate L3-1 was mixed with 30 ml of THF and 10 ml of water, and 0.5 g (3.6 mmol) of 3,5-dimethylphenylboronic acid, 0.24 g (0.2 mmol) of Pd(PPh₃)₄, and 1.0 g (7.5 mmol) of K₂CO₃ were added thereto, and the mixture was heated while refluxing for 24 hours. When the reaction was completed, an organic layer, obtained by adding ethyl acetate and water and performing an extraction process thereon, was dried by using magnesium sulfate, distilled under reduced pressure, and purified by column chromatography to obtain 0.72 g of Intermediate L3 (yield 80%).

LCMS : m/z calcd for C₂₁H₁₆FN 301.13; Found 302.05.

### Synthesis of Intermediate L3 Dimer

40 mL of ethoxyethanol and 15 mL of distilled water were mixed with 1.05 g (3.4 mmol) of Intermediate L3 and 0.6 g (1.6 mmol) of iridium chloride, and then, the mixture was heated while refluxing for 24 hours. When the reaction was completed, the temperature was lowered to room temperature, and the solid produced therefrom was filtered and washed sufficiently in the order of water/methanol/hexane. The solid obtained was dried in a vacuum oven to obtain 1.0 g of Intermediate L3 Dimer.

### Synthesis of Compound 3

1.0 g (0.63 mmol) of Intermediate L3 Dimer, 0.96 g (4.5 mmol) of 3,7-diethylnonane-4,6-dione, and 0.48 g (4.5 mmol) of Na₂CO₃ were mixed with 40 mL of ethoxyethanol, and then, the mixture was stirred for 24 hours at a temperature of 90 °C. When the reaction was completed, the temperature was lowered to room temperature, and the solid produced therefrom was filtered and purified by liquid chromatography to obtain 0.8 g of Compound 3 (yield of 65%).

LCMS : m/z calcd for C₅₅H₅₃F₂IrN₂O₂, 1004.37; Found 1005.25.

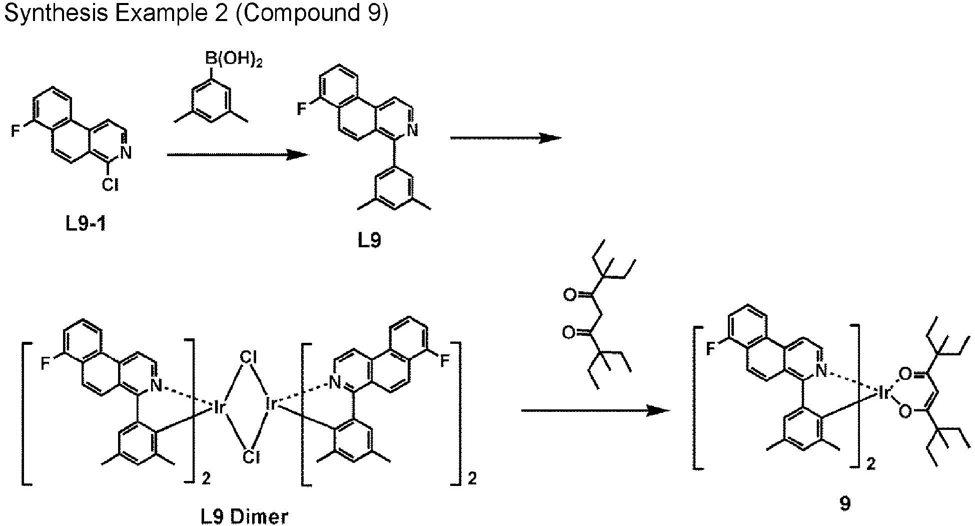

### Synthesis of Intermediate L9

Intermediate L9 was synthesized in the same manner as used in synthesizing Intermediate L3 in Synthesis Example 1, except that Intermediate L9-1 was used instead of Intermediate L3-1.

LC-MS m/z = 303(M+H)⁺

### Synthesis of Intermediate L9 Dimer

Intermediate L9 Dimer was synthesized in the same manner as used in synthesizing Intermediate L3 Dimer in Synthesis Example 1, except that Intermediate L9 was used instead of Intermediate L3.

### Synthesis of Compound 9

Compound 9 was synthesized in the same manner as used to synthesize Compound 3 of Synthesis Example 1, except that Intermediate L9 Dimer and 3,7-diethyl-3,7-dimethylnonane-4,6-dione were used instead of Intermediate L3 Dimer and 3,7-diethylnonane-4,6-d ione.

LC-MS m/z = 1035(M+H)⁺

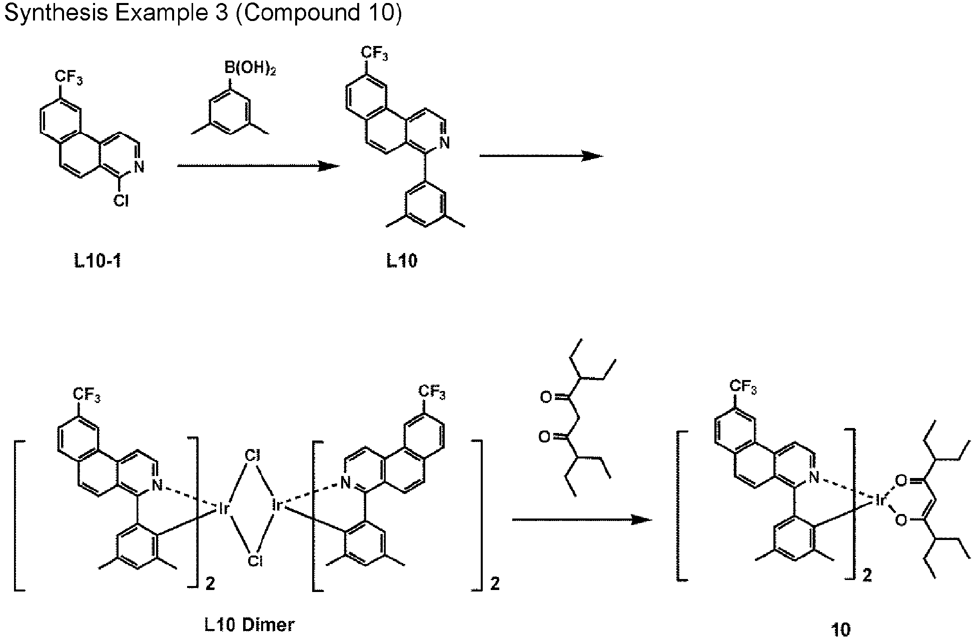

### Synthesis of Intermediate L10

Intermediate L10 was synthesized in the same manner as used in synthesizing Intermediate L3 in Synthesis Example 1, except that Intermediate L10-1 was used instead of Intermediate L3-1.

LCMS : m/z calcd for C₂₂H₁₆F₃N 351.36; Found 352.21.

### Synthesis of Intermediate L10 Dimer

Intermediate L10 Dimer was synthesized in the same manner as used in synthesizing Intermediate L3 Dimer in Synthesis Example 1, except that Intermediate L10 was used instead of Intermediate L3.

### Synthesis of Compound 10

Compound 10 was synthesized in the same manner as used to synthesize Compound 3 of Synthesis Example 1, except that Intermediate L10 Dimer was used instead of Intermediate L3 Dimer.

LCMS : m/z calcd for C₅₇H₅₃F₆IrN₂O₂ 1104.35; Found 1105.40.

### Example 1

A glass substrate with ITO/Ag/ITO deposited thereon as an anode with a thickness of 70/1000/70 Å thereon, which was manufactured by Corning Inc., was cut to a size of 50 mm×50 mm×0.5 mm, and the glass substrate was sonicated by using isopropyl alcohol and pure water for 5 minutes each, and then ultraviolet (UV) light was irradiated for 30 minutes thereto and ozone was exposed thereto for cleaning. Then, the resultant glass substrate was loaded onto a vacuum deposition apparatus.

On the anode, 2-TNATA was vacuum deposited to form a hole injection layer having a thickness of 600 Å, and 4,4'-bis[N-(1-naphthyl)-N-phenylamino] biphenyl (hereinafter referred to as NPB) was vacuum-deposited on the hole injection layer to form a hole transport layer having a thickness of 1350 Å.

Then, a host (the mixture of Compound H1-14 and Compound H2-6 (the weight ratio of 5:5)) and a dopant (Compound 3) were co-deposited on the hole transport layer at a weight ratio of 98 : 2 to form an emission layer having a thickness of 400 Å.

Then, BCP was vacuum-deposited on the emission layer to form a hole blocking layer having a thickness of 50 Å and then, Alq₃ was vacuum-deposited on the hole blocking layer to form an electron transport layer having a thickness of 350 Å, and then, LiF was vacuum-deposited on the electron transport layer to form an electron injection layer having a thickness of 10 Å, and Mg and Ag were co-deposited on the electron injection layer at the weight ratio of 90:10 to form a cathode having a thickness of 120 Å, thereby completing the manufacture of an organic light-emitting device (emission of red light).

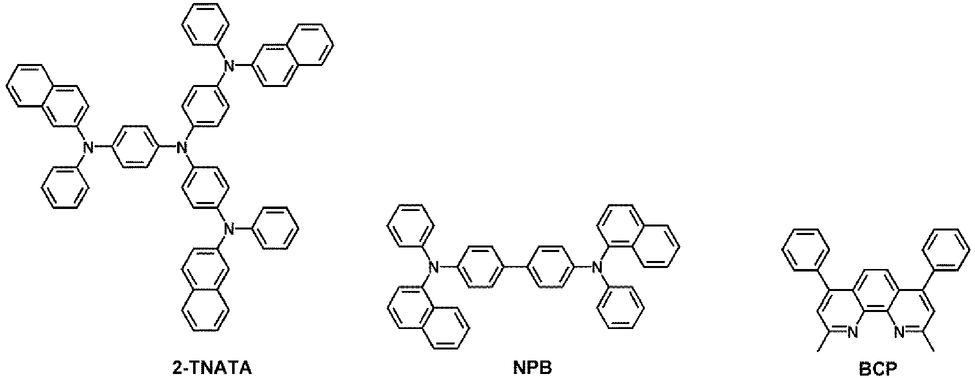

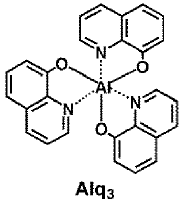

### Examples 2 to 3 and Comparative Example 1

Organic light-emitting devices were manufactured in the same manner as in Example 1, except that in forming an emission layer, for use as a dopant, corresponding compounds shown in Table 1 were used instead of Compound 3.

### Evaluation Example 1: Evaluation on characteristics of organic light-emitting device

With respect to each of the organic light-emitting devices manufactured according to Examples 1 to 3 and Comparative Example 1, the driving voltage, current density, maximum of external quantum efficiency (Max EQE), FWHM of EL spectrum, emission color, color coordinate, and lifespan (LT₉₇) were evaluated. Results thereof are shown in Table 1. This evaluation was performed using a current-voltage meter (Keithley 2400) and a luminescence meter (Minolta Cs-1000A), and the lifespan (LT₉₇)(at 3500 nit) was evaluated by measuring the amount of time that elapsed until luminance was reduced to 97% of the initial brightness of 100%. Lifespan (LT₉₇) is expressed as a relative value (%) to the lifespan of Comparative Example 1.

**Table 1**

| | Host compound No. | | Dopant compound No. | Driving Voltage (V) | Current density (mA/cm²) | Max EQE (%) | FWHM (nm) | Emission color | Color coordinates (CIEx) | LT97 (Relative value, %) |
|---|---|---|---|---|---|---|---|---|---|---|
| Example 1 | H1-14 | H2-6 | 3 | 3.61 | 11.1 | 31.1 | 46.34 | red | 0.675, 0.324 | 113 |
| | Weight ratio of 5:5 | | | | | | | | | |
| Example 2 | H1-14 | H2-6 | 9 | 3.6 | 12.1 | 31 | 46.2 | red | 0.678, 0.321 | 125 |
| | Weight ratio of 5:5 | | | | | | | | | |
| Example 3 | H1-14 | H2-6 | 10 | 4.06 | 12.9 | 30.5 | 47.16 | red | 0.678, 0.321 | 102 |
| | Weight ratio of 5:5 | | | | | | | | | |
| Comparative Example 1 | H1-14 | H2-6 | A | 4.12 | 15.5 | 28.8 | 47.07 | red | 0.680, 0.318 | 100 |
| | Weight ratio of 5:5 | | | | | | | | | |

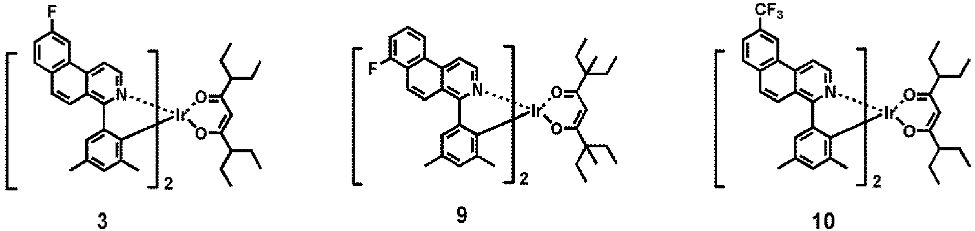

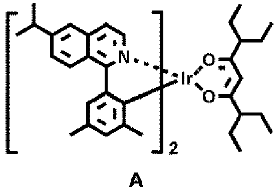

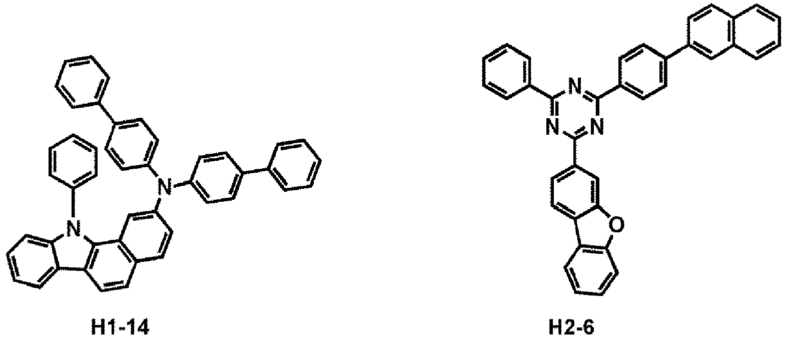

From Table 1, it was confirmed that the organic light-emitting devices of Example 1 to 3 have improved characteristics compared to the organic light-emitting device of Comparative Example 1 in terms of the driving voltage, external quantum efficiency, and lifespan.

The composition has excellent electrical properties and stability. Accordingly, an electronic device, for example, an organic light-emitting device using the composition may have improved characteristics in terms of the driving voltage, external quantum efficiency, and lifespan.

## Claims

1. A composition comprising:
a first compound, a second compound, and a third compound, wherein
the first compound comprises a compound represented by Formula 1,
the second compound comprises a compound represented by Formula 2, and
the third compound comprises a compound represented by Formula 3: 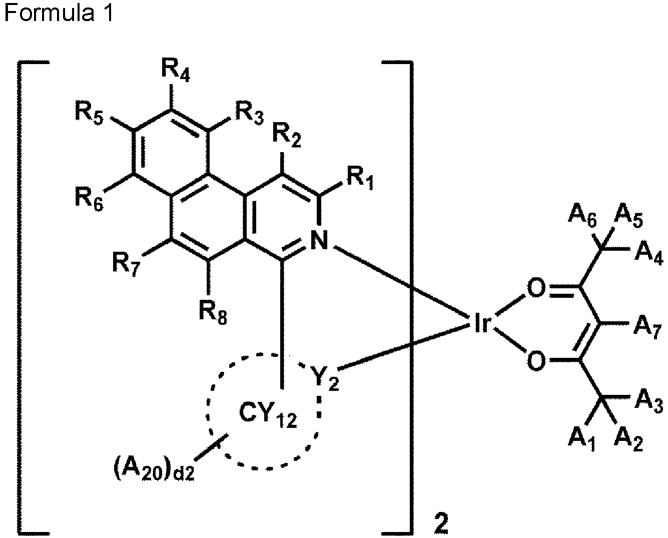 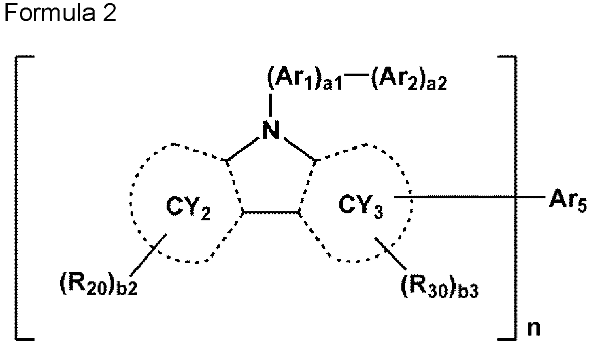 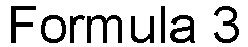 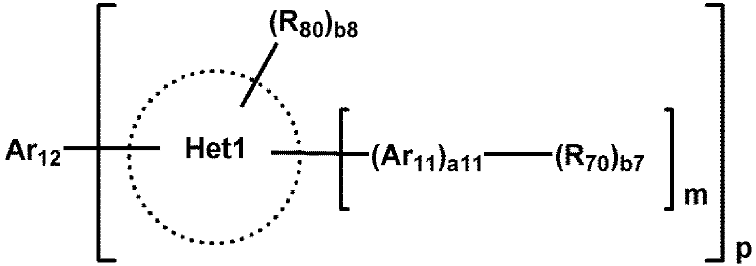 wherein
Y₂ in Formula 1 is C,
ring CY₁₂ in Formula 1 is a C₅-C₆₀ carbocyclic group or a C₁-C₆₀ heterocyclic group,
Ar₁, Ar₂, and Ar₁₁ in Formulae 2 and 3 are each independently a C₅-C₆₀ carbocyclic group which is unsubstituted or substituted with at least one R₆₁ or a C₁-C₆₀ heterocyclic group which is unsubstituted or substituted with at least one R₆₁,
Ar₅ and A₁₂ in Formulae 2 and 3 are each independently a single bond, a C₅-C₆₀ carbocyclic group which is unsubstituted or substituted with at least one R₆₅, or a C₁-C₆₀ heterocyclic group which is unsubstituted or substituted with at least one R₆₅, or does not exist,
n in Formula 2 is 1, 2, or 3, and when n is 1, Ar₅ does not exist,
p in Formula 3 is 1, 2, or 3, and when p is 1, Ar₁₂ does not exist,
a1 and a2 in Formula 2 are each independently an integer from 0 to 5, and the sum of a1 and a2 is 1 or more,
ring CY₂ and ring CY₃ in Formula 2 are each independently a C₅-C₆₀ carbocyclic group or a C₁-C₆₀ heterocyclic group, and ring CY₂ and ring CY₃ are optionally linked to each other with a C₅-C₆₀ carbocyclic group which is unsubstituted or substituted with at least one R₆₆ or a C₁-C₆₀ heterocyclic group which is unsubstituted or substituted with at least one R₆₆ therebetween,
Het1 in Formula 3 is a π electron-depleted nitrogen-containing C₁-C₆₀ cyclic group,
a11 and m in Formula 3 are each independently an integer from 1 to 10,
R₁ to R₈, A₂₀, A₁ to A₇, R₂₀, R₃₀, R₆₁, R₆₅, R₆₆, R₇₀, and R₈₀ in Formulae 1 to 3 are each independently hydrogen, deuterium, -F, -Cl, -Br, -I, -SF₅, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₂-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇),-P(=O)(Q₈)(Q₉), or -P(Q₈)(Q₉),
b2, b3, b7, and b8 in Formulae 2 and 3 are each independently an integer from 0 to 20, when b2 is 2 or more, two or more R₂₀(s) are identical to or different from each other, when b3 is 2 or more, two or more R₃₀(s) are identical to or different from each other, when b7 is 2 or more, two or more R₇₀(s) are identical to or different from each other, and when b8 is 2 or more, two or more R₈₀(s) are identical to or different from each other,
d2 in Formula 1 is an integer from 0 to 10, and when d2 is 2 or more, two or more A₂₀(s) are identical to or different from each other,
at least one of R₁ to R₈, A₂₀, or any combination thereof comprises at least one fluoro group (-F),
two or more of R₁ to R₈ and A₂₀ in Formula 1 are optionally linked to form a C₅-C₆₀ carbocyclic group which is unsubstituted or substituted with at least one R₁ₐ or a C₁-C₆₀ heterocyclic group which is unsubstituted or substituted with at least one R₁ₐ,
two or more of A₁ to A₇ in Formula 1 are optionally linked to form a C₅-C₆₀ carbocyclic group which is unsubstituted or substituted with at least one R₁ₐ or a C₁-C₆₀ heterocyclic group which is unsubstituted or substituted with at least one R₁ₐ,
two or more of ring CY₂, ring CY₃, R₂₀, and R₃₀ in Formula 2 are optionally linked to form a C₅-C₆₀ carbocyclic group which is unsubstituted or substituted with at least one R₁ₐ or a C₁-C₆₀ heterocyclic group which is unsubstituted or substituted with at least one R₁ₐ,
R₁ₐ is understood by referring to the description of A₇ provided above, and
a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₂-C₁₀ heterocycloalkyl group, the substituted C₃-C₁₀ cycloalkenyl group, the substituted C₂-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group is:
deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or C₁-C₆₀ alkoxy group;
a C₁-C₆₀ alkyl group, a C₂-C₆₀ alkenyl group, a C₂-C₆₀ alkynyl group, or a C₁-C₆₀ alkoxy group, each substituted with deuterium, -F, -Cl, -Br, -I, -CD₃, -CD₂H, -CDH₂, -CF₃,-CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₂-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂),-Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉), or any combination thereof;
a C₃-C₁₀ cycloalkyl group, a C₂-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃,-CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₂-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂),-Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), -P(Q₂₈)(Q₂₉), or any combination thereof;
-N(Q31)(Q32), -Si(Q₃₃)(Q₃₄)(Q₃₅), -Ge(Q₃₃)(Q₃₄)(Q₃₅), -B(Q36)(Q37),-P(=O)(Q₃₈)(Q₃₉),or -P(Q₃₈)(Q₃₉); or
any combination thereof,
wherein Q₁ to Q₉, Q₁₁ to Q₁₉, Q₂₁ to Q₂₉, and Q₃₁ to Q₃₉ are each independently hydrogen; deuterium; -F; -CI; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group, unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₃-C₁₀ cycloalkyl group; a C₂-C₁₀ heterocycloalkyl group; a C₃-C₁₀ cycloalkenyl group; a C₂-C₁₀ heterocycloalkenyl group; a C₆-C₆₀ aryl group, unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

2. The composition of claim 1, wherein
ring CY₁₂ in Formula 1 is a benzene group, a naphthalene group, a 1,2,3,4-tetrahydronaphthalene group, a thiophene group, a furan group, a pyrrole group, a cyclopentadiene group, a silole group, a benzothiophene group, a benzofuran group, an indole group, an indene group, a benzosilole group, a dibenzothiophene group, a dibenzofuran group, a carbazole group, a fluorene group, or a dibenzosilole group.

3. The composition of claims 1 or 2, wherein
R₁ to R₈ and A₁ to A₇ are each independently:
hydrogen, deuterium, or -F;
a C₁-C₂₀ alkyl group, a C₃-C₁₀ cycloalkyl group, a C₂-C₁₀ heterocycloalkyl group, or a phenyl group, each unsubstituted or substituted with deuterium, -F, a C₁-C₂₀ alkyl group, a C₃-C₁₀ cycloalkyl group, a C₂-C₁₀ heterocycloalkyl group, a phenyl group, or any combination thereof; or
-Si(Q₃)(Q₄)(Q₅) or -Ge(Q₃)(Q₄)(Q₅), and
A₂₀ in Formula 1 is:
hydrogen or deuterium;
a C₁-C₂₀ alkyl group, a C₃-C₁₀ cycloalkyl group, a C₂-C₁₀ heterocycloalkyl group, or a phenyl group, each unsubstituted or substituted with deuterium, a C₁-C₂₀ alkyl group, a C₃-C₁₀ cycloalkyl group, a C₂-C₁₀ heterocycloalkyl group, a phenyl group, or any combination thereof; or
-Si(Q₃)(Q₄)(Q₅) or -Ge(Q₃)(Q₄)(Q₅).

4. The composition of any of claims 1-3, wherein
each of at least one of R₁ to R₈ in Formula 1 is independently:
a fluoro group (-F); or
a fluorinated C₁-C₂₀ alkyl group, a fluorinated C₃-C₁₀ cycloalkyl group, a fluorinated C₂-C₁₀ heterocycloalkyl group, or a fluorinated phenyl group, each unsubstituted or substituted with deuterium, a C₁-C₂₀ alkyl group, a C₃-C₁₀ cycloalkyl group, a C₂-C₁₀ heterocycloalkyl group, a phenyl group, or any combination thereof.

5. The composition of any of claims 1-4, wherein
at least one of A₁ to A₆ in Formula 1 are each independently an unsubstituted or substituted C₂-C₆₀ alkyl group, an unsubstituted or substituted C₃-C₁₀ cycloalkyl group, or an unsubstituted or substituted C₂-C₁₀ heterocycloalkyl group; and/or
wherein
A₁ to A₆ are each independently an unsubstituted or substituted C₁-C₆₀ alkyl group, an unsubstituted or substituted C₃-C₁₀ cycloalkyl group, or an unsubstituted or substituted C₂-C₁₀ heterocycloalkyl group.

6. The composition of any of claims 1-5, wherein a group represented by 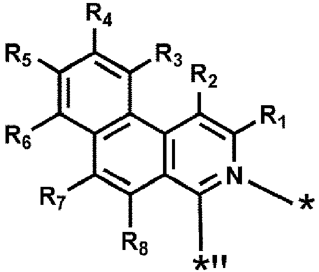 in Formula 1 is a group represented by one of Formulae CY1 to CY108: 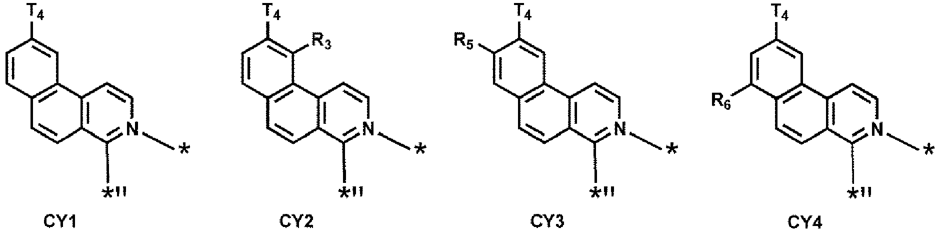 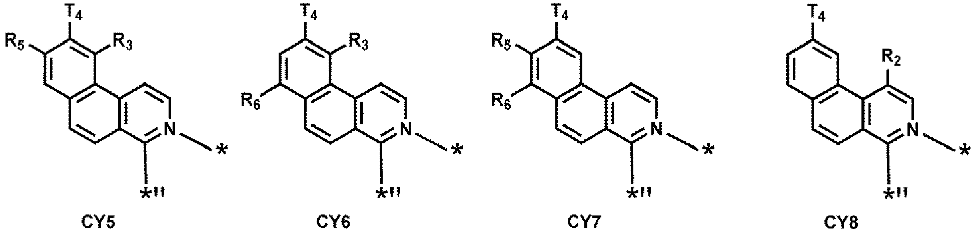 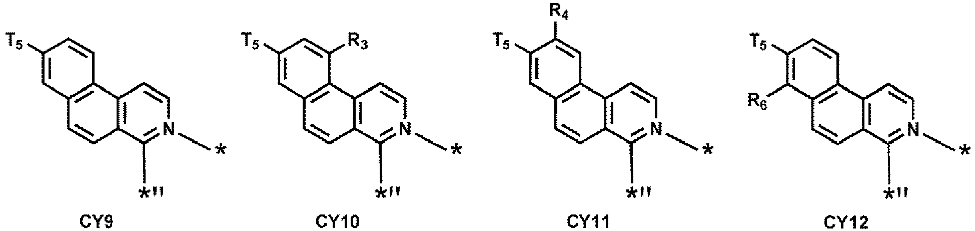 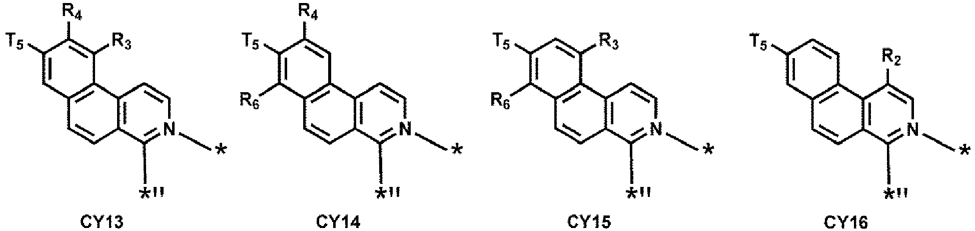 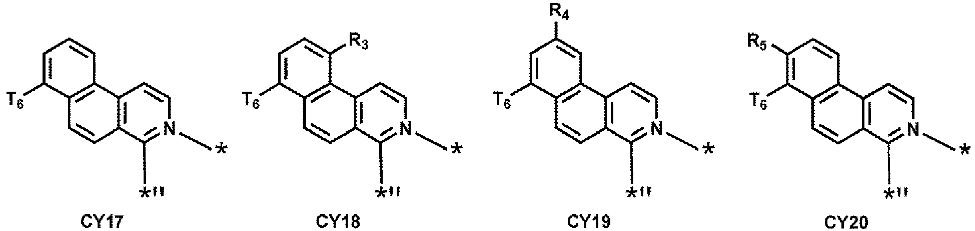 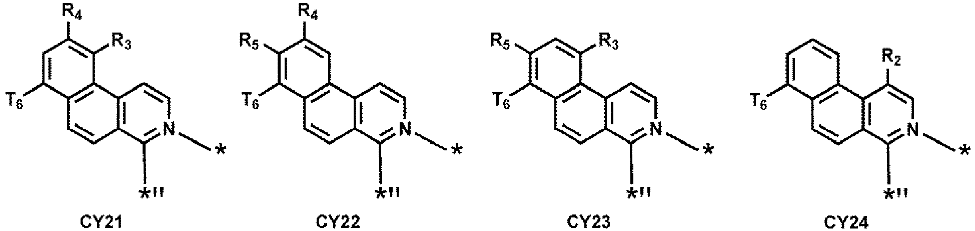 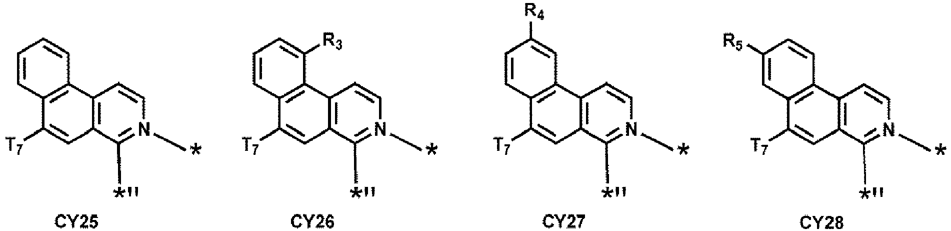 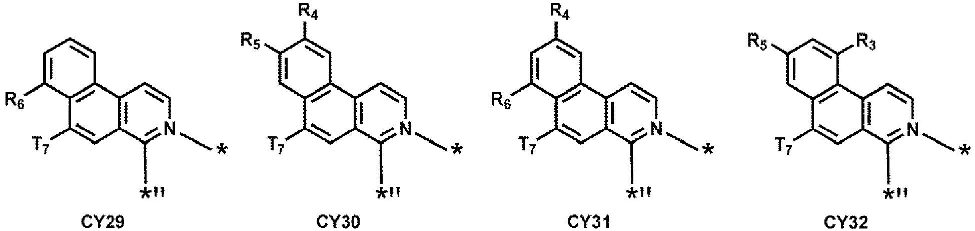 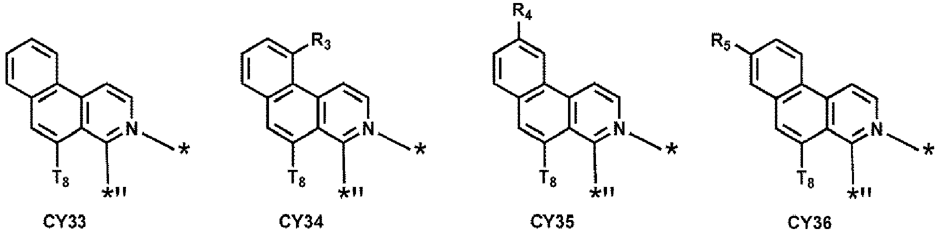 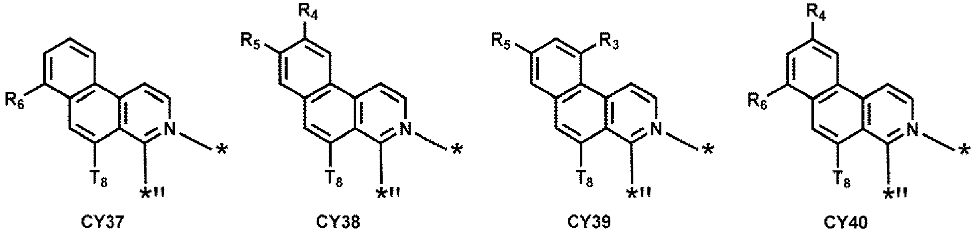 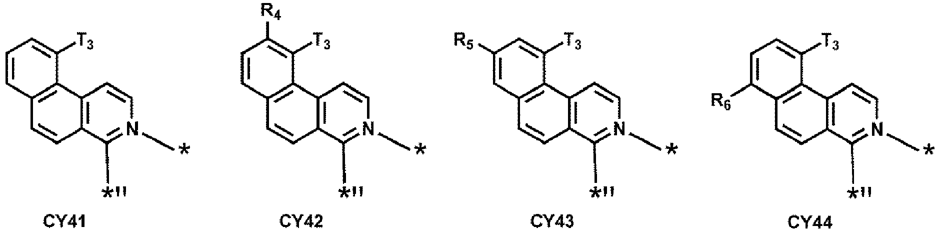 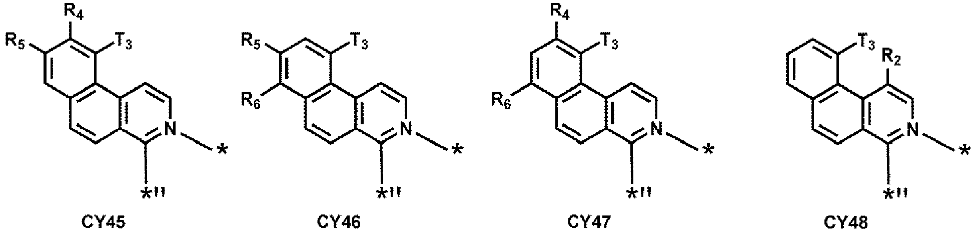 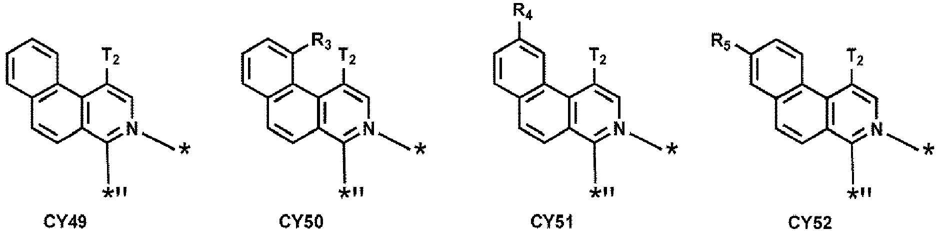 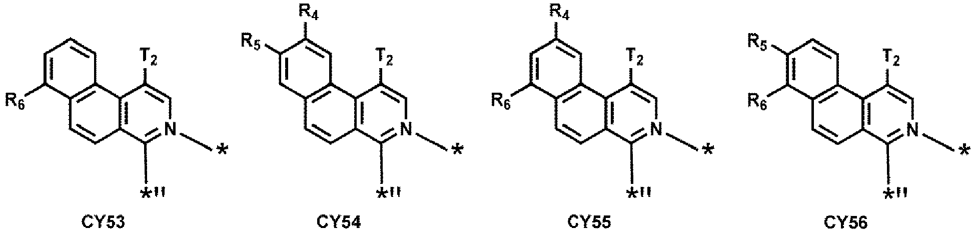 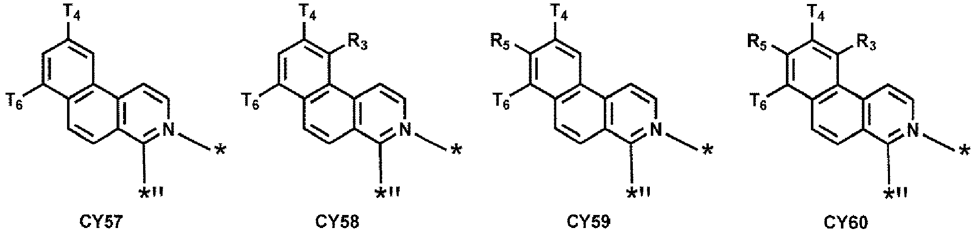 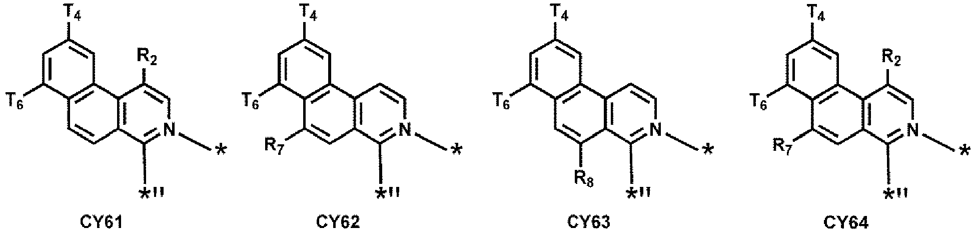 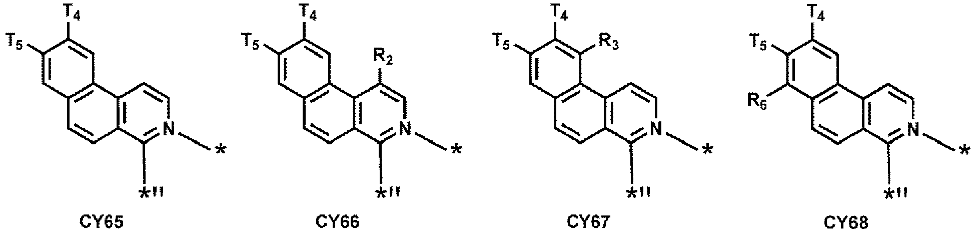 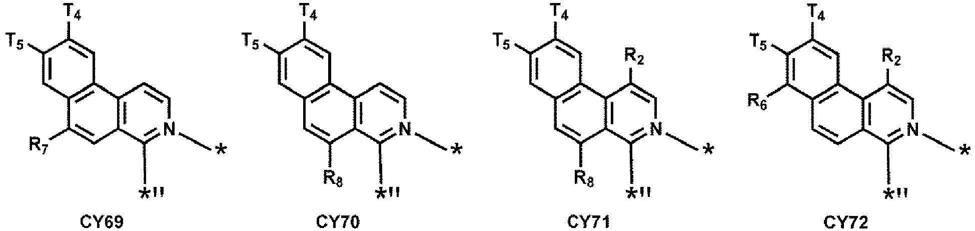 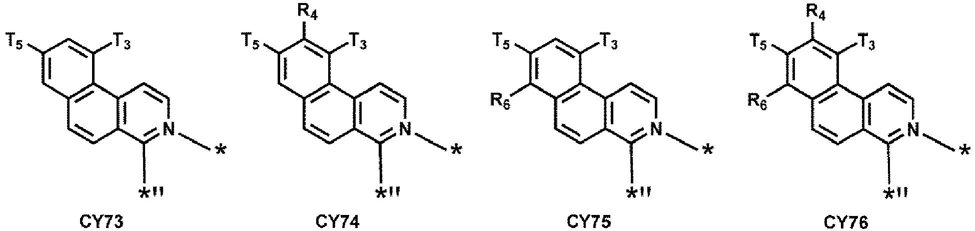 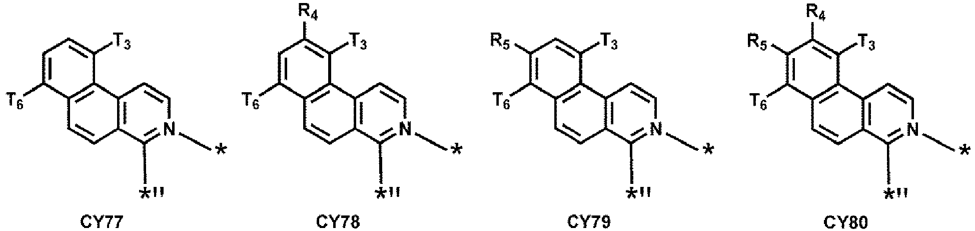 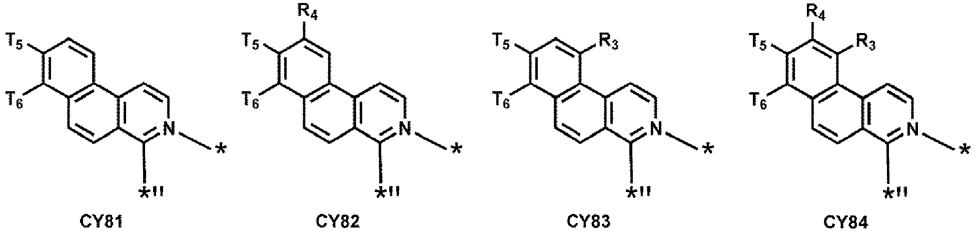 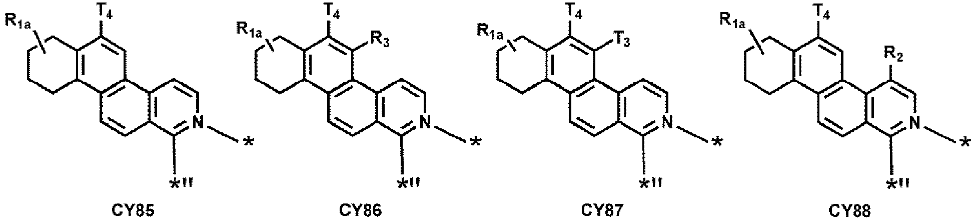 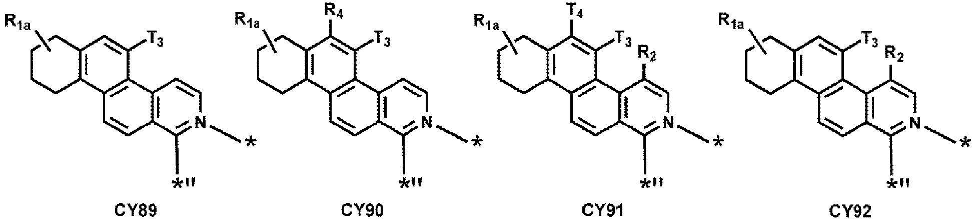 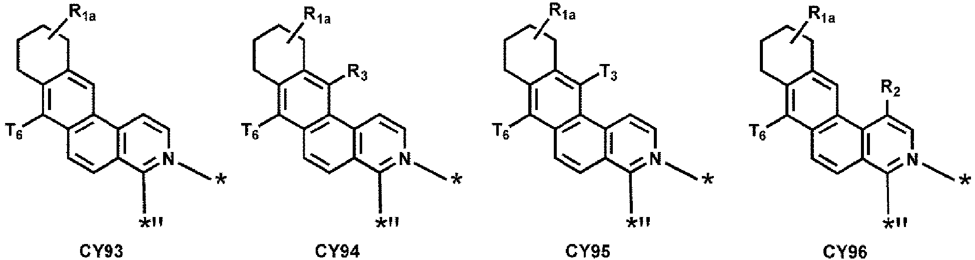 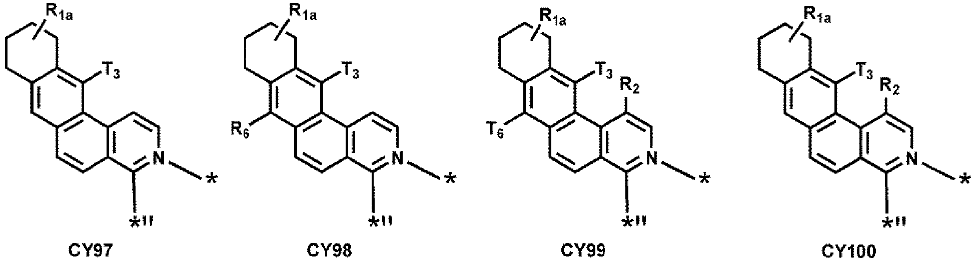 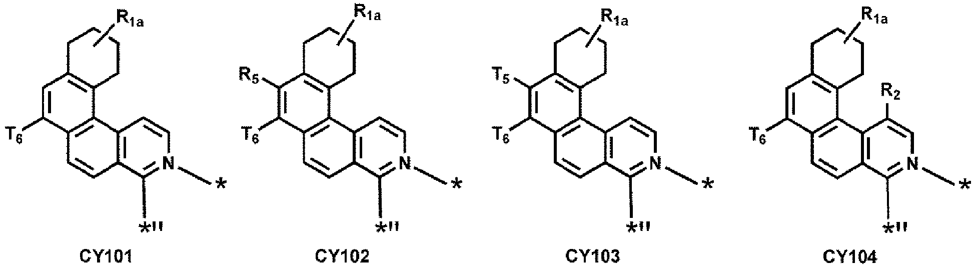 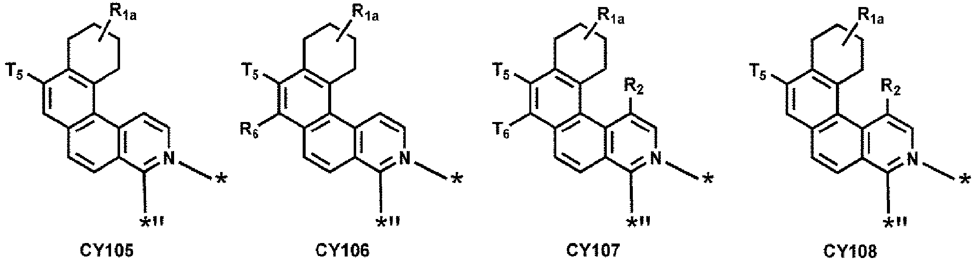
wherein, in Formulae CY1 to CY108,
T₂ to T₈ are each independently:
a fluoro group (-F); or
a fluorinated C₁-C₂₀ alkyl group, a fluorinated C₃-C₁₀ cycloalkyl group, a fluorinated C₂-C₁₀ heterocycloalkyl group, or a fluorinated phenyl group, each unsubstituted or substituted with deuterium, a C₁-C₂₀ alkyl group, a C₃-C₁₀ cycloalkyl group, a C₂-C₁₀ heterocycloalkyl group, a phenyl group, or any combination thereof; or
each of R₂ to R₈ and R₁ₐ are the same as described in claim 1, and R₂ to R₈ are not hydrogen,
* indicates a binding site to Ir in Formula 1, and
*" indicates a binding site to a neighboring atom in Formula 1.

7. The composition of any of claims 1-6, wherein a group represented by 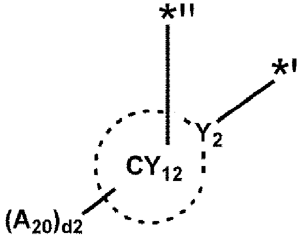 in Formula 1 is a group represented by one of Formulae A(1) to A(7): 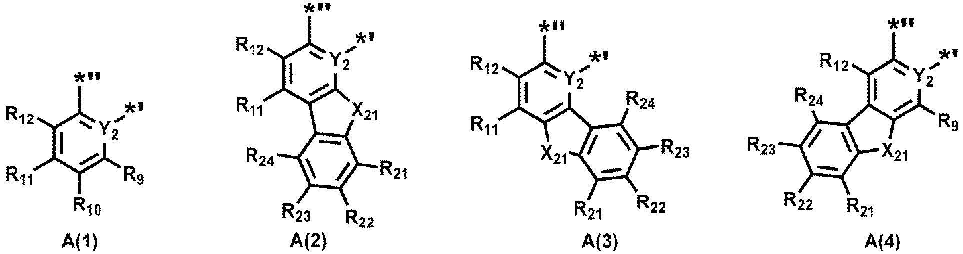 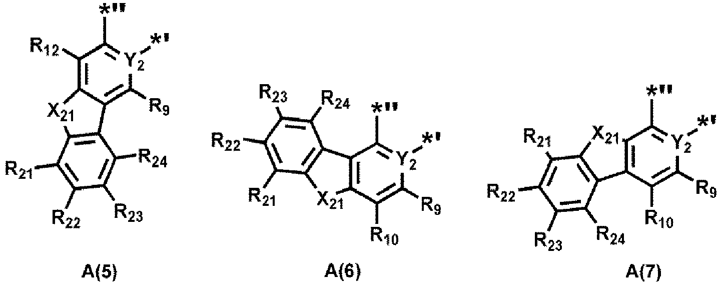
wherein, in Formulae A(1) to A(7),
Y₂ is C,
X₂₁ is O, S, N(R₂₅), C(R₂₅)(R₂₆), or Si(R₂₅)(R₂₆),
each of R₉ to R₁₂ and R₂₁ to R₂₆ are the same as described in connection with A₂₀ in claim 1,
*' indicates a binding site to Ir in Formula 1, and
*" indicates a binding site to a neighboring atom in Formula 1; and/or
wherein
the first compound comprises at least one of Compounds 1 to 53:

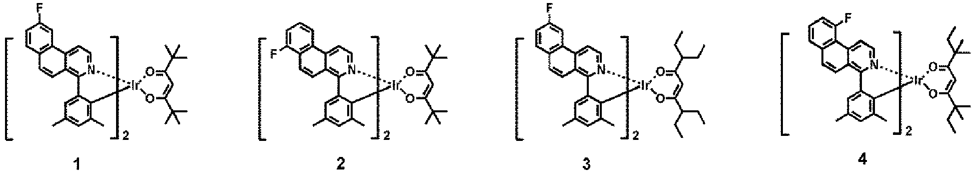

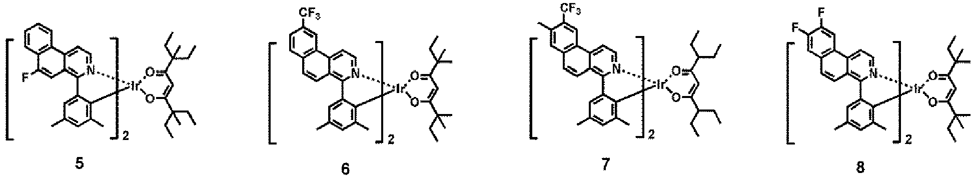

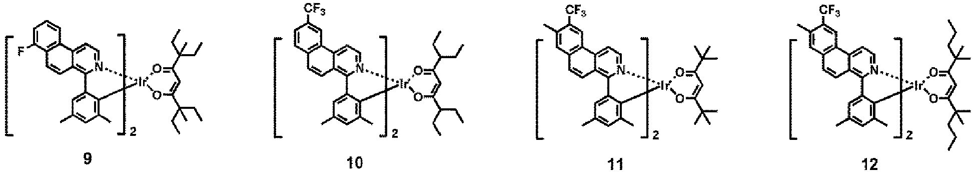

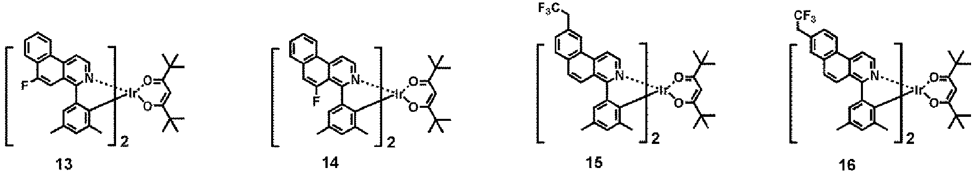

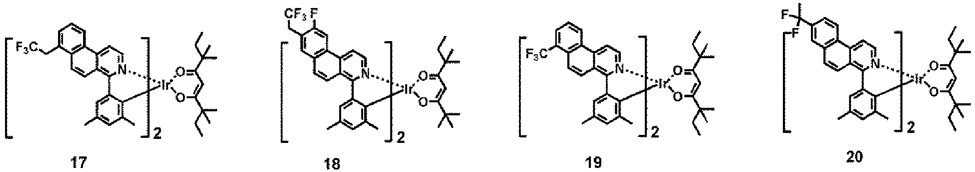

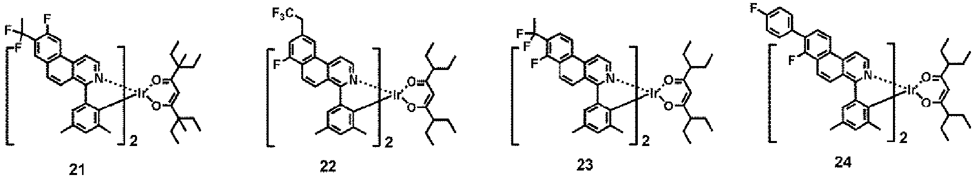

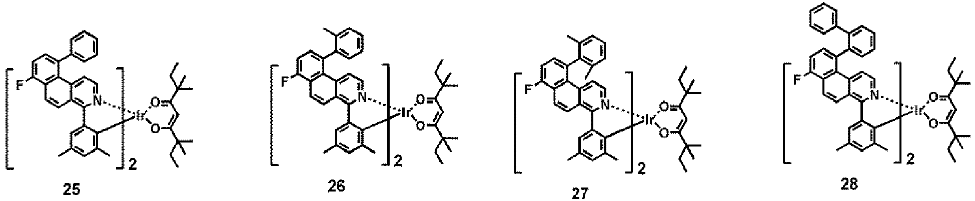

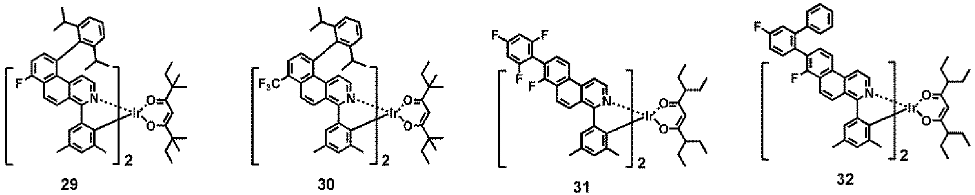

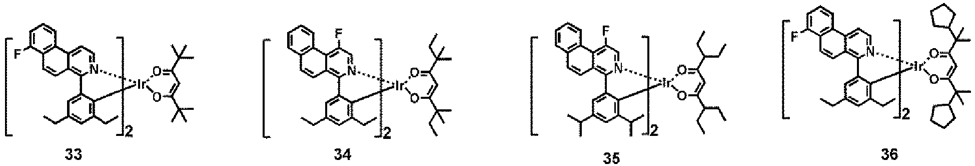

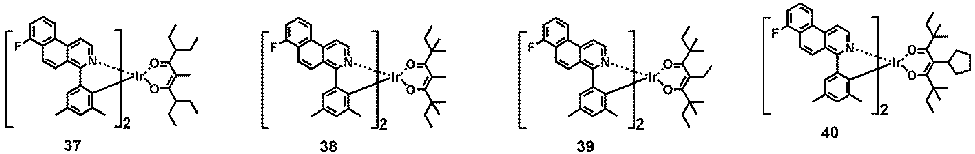

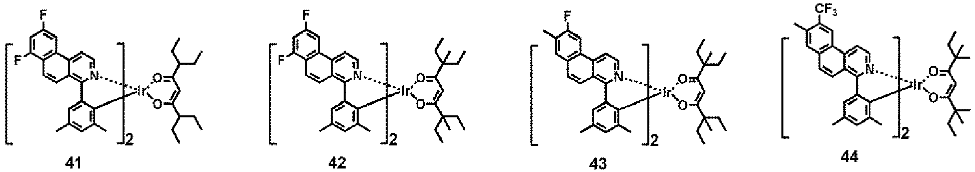

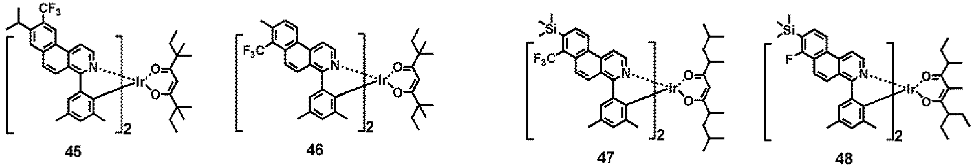

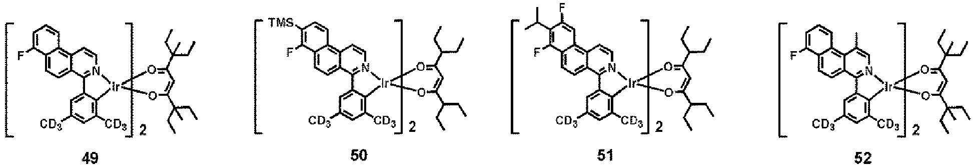

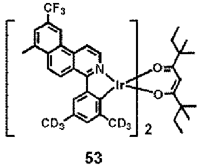

8. The composition of any of claims 1-7, wherein
Ar₁, Ar₂, and Ar₁₁ in Formulae 2 and 3 are each independently a group derived from i) a first ring unsubstituted or substituted with at least one R₆₁, ii) a second ring unsubstituted or substituted with at least one R₆₁, iii) a condensed cyclic group in which two or more first rings are condensed with each other, unsubstituted or substituted with at least one R₆₁, iv) a condensed cyclic group in which two or more second rings are condensed with each other, unsubstituted or substituted with at least one R₆₁, or v) a condensed cyclic group in which at least one first ring and at least one second ring are condensed with each other, unsubstituted or substituted with at least one R₆₁,
Ar₅ and Ar₁₂ in Formulae 2 and 3 are each independently a single bond or a group derived from i) a first ring unsubstituted or substituted with at least one R₆₅, ii) a second ring unsubstituted or substituted with at least one R₆₅, iii) a condensed cyclic group in which two or more first rings are condensed with each other, unsubstituted or substituted with at least one R₆₅, iv) a condensed cyclic group in which two or more second rings are condensed with each other, unsubstituted or substituted with at least one R₆₅, or v) a condensed cyclic group in which at least one first ring and at least one second ring are condensed with each other, unsubstituted or substituted with at least one R₆₅, or does not exist,
ring CY₂ and ring CY₃ in Formula 2 are each independently i) a first ring, ii) a second ring, iii) a condensed cyclic group in which two or more first rings are condensed with each other, iv) a condensed cyclic group in which two or more second rings are condensed with each other, or v) a condensed cyclic group in which at least one first ring and at least one second ring are condensed with each other,
Het1 in Formula 3 is a group derived from i) a first ring, ii) a condensed cyclic group in which two or more first rings are condensed with each other, or iii) a condensed cyclic group in which at least one first ring and at least one second ring are condensed with each other,
the first ring is an imidazole group, a pyrazole group, a thiazole group, an isothiazole group, an oxazole group, an isoxazole group, a pyridine group, a pyrazine group, a pyridazine group, a pyrimidine group, a triazole group, a tetrazole group, an oxadiazole group, a triazine group, or a thiadiazole group, and
the second ring is a benzene group, a cyclopentadiene group, a pyrrole group, a furan group, a thiophene group, or a silole group.

9. The composition of any of claims 1-8, wherein
Ar₁, Ar₂, and Ar₁₁ in Formulae 2 and 3 are each independently a π electron-rich C₃-C₆₀ cyclic group unsubstituted or substituted with at least one R₆₁,
Ar₅ and Ar₁₂ in Formulae 2 and 3 are each independently a single bond or a π electron-rich C₃-C₆₀ cyclic group unsubstituted or substituted with at least one R₆₅, or do not exist, and
ring CY₂ and ring CY₃ in Formula 2 are each independently a π electron-rich C₃-C₆₀ cyclic group.

10. The composition of any of claims 1-9, wherein a group represented by 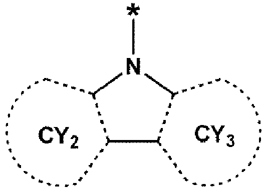 in Formula 2 is represented by one of Formulae 2-1 to 2-93: 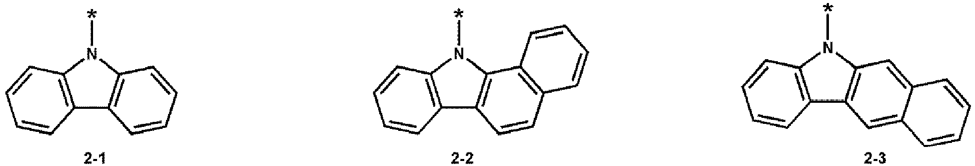 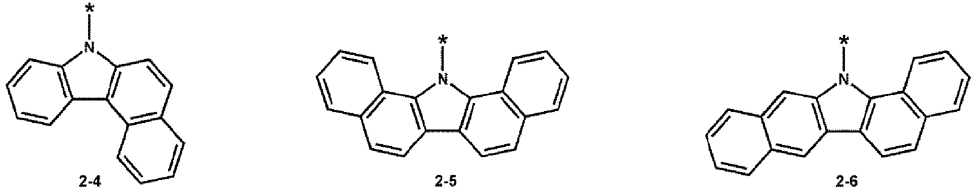 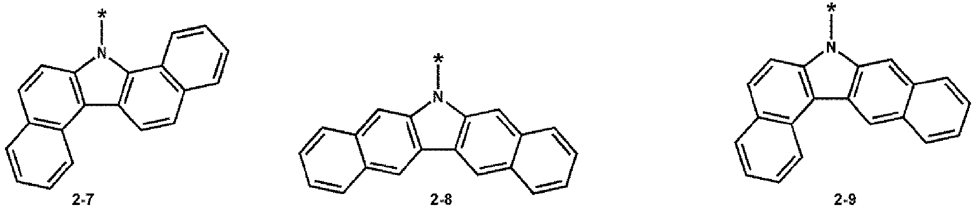 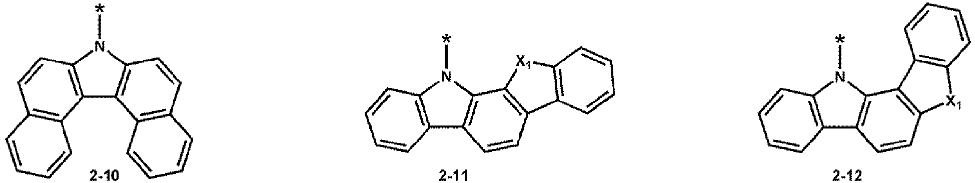 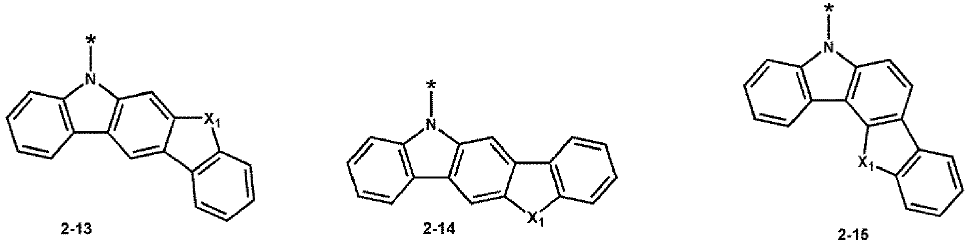 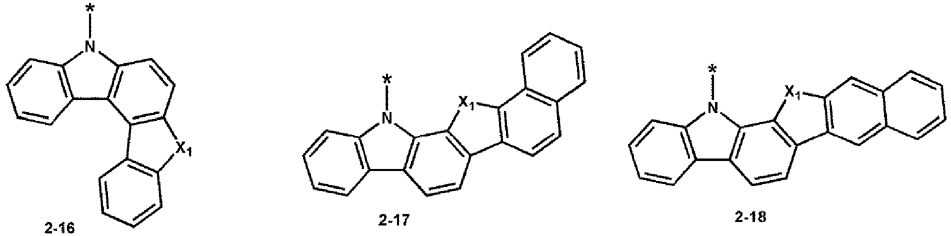 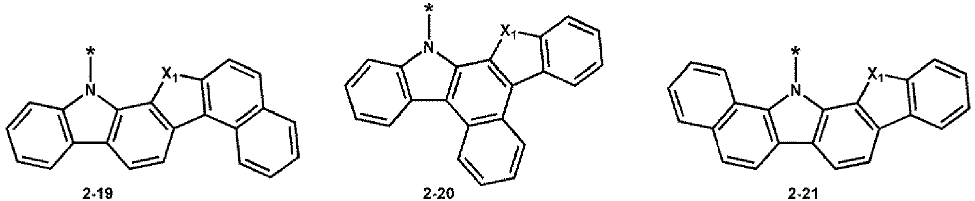 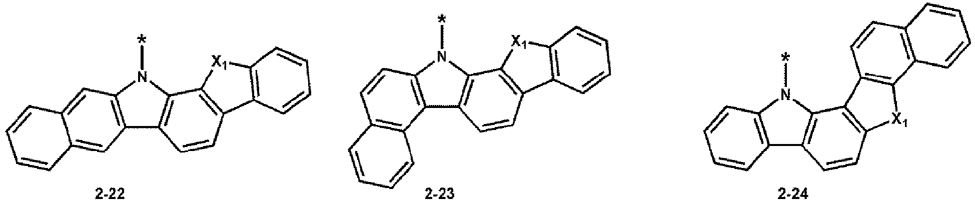 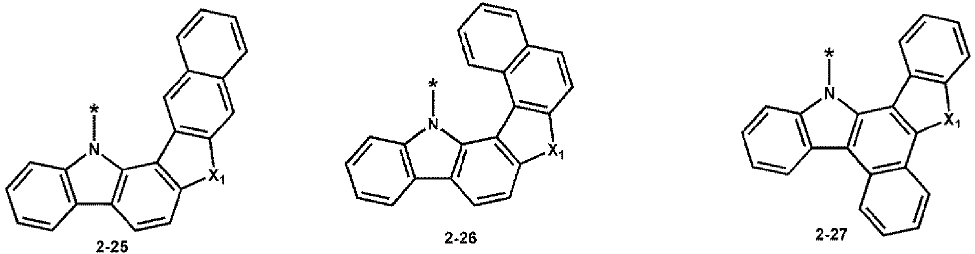 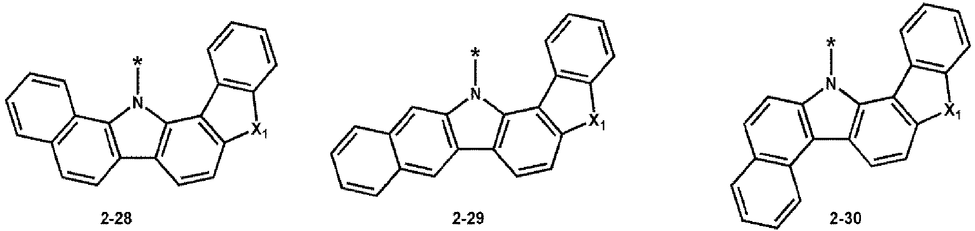 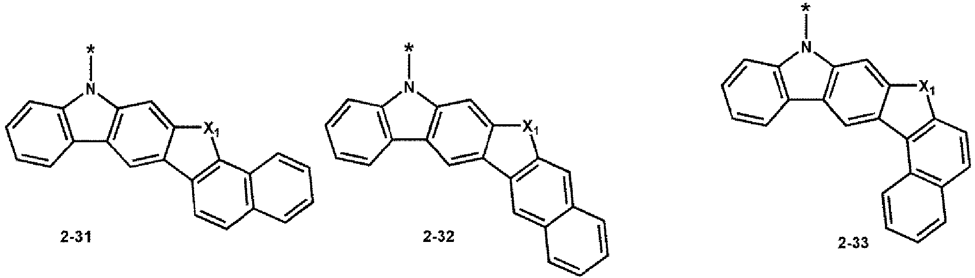 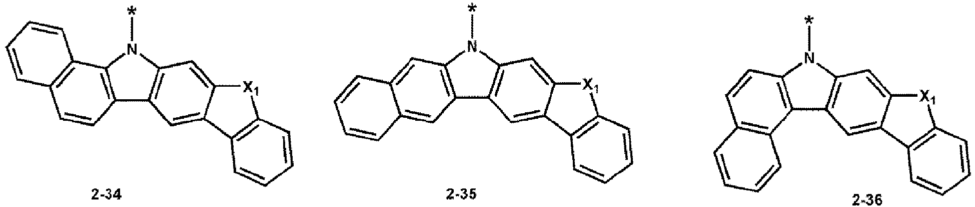 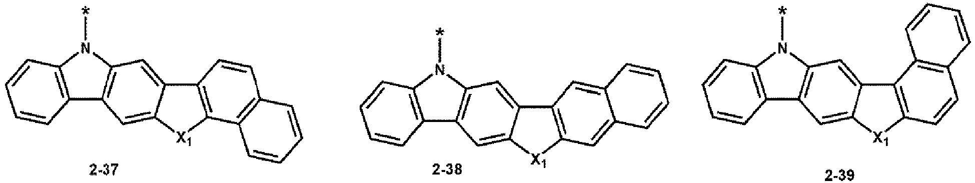 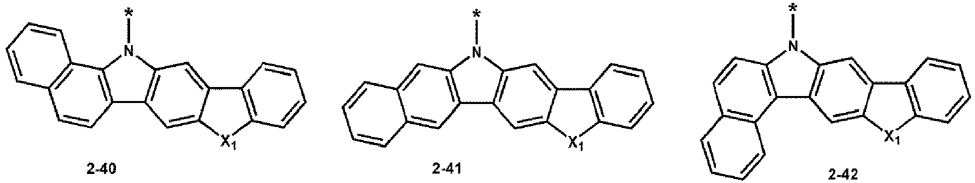 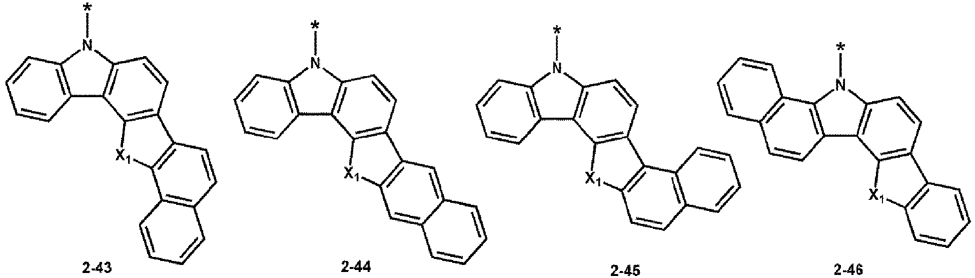 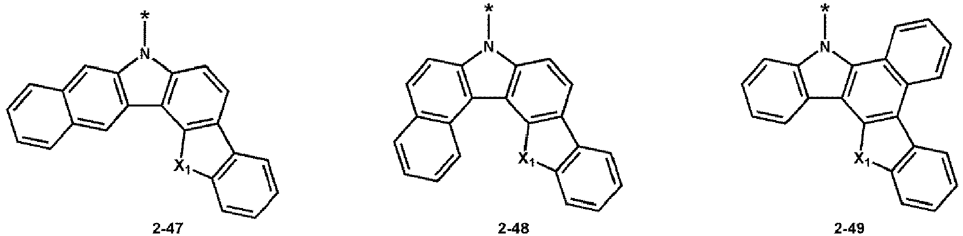 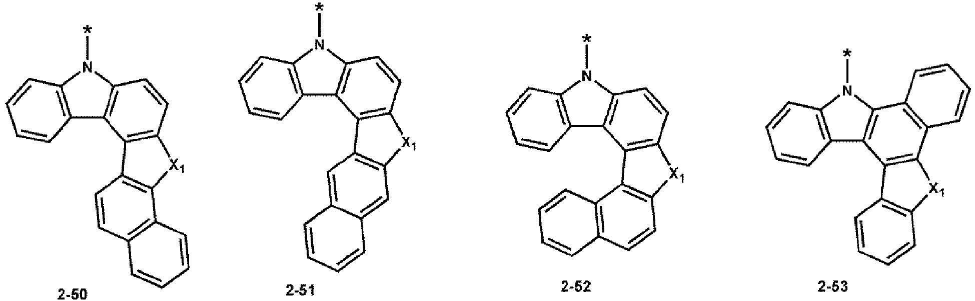 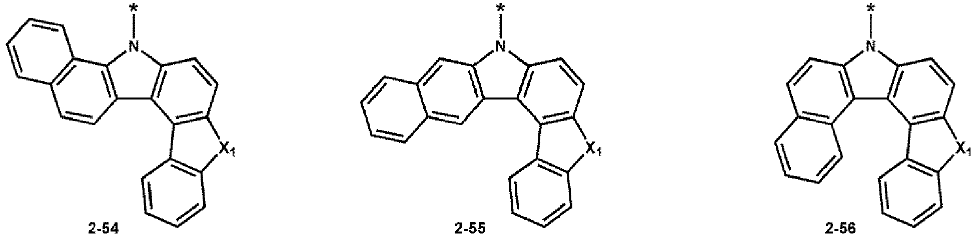 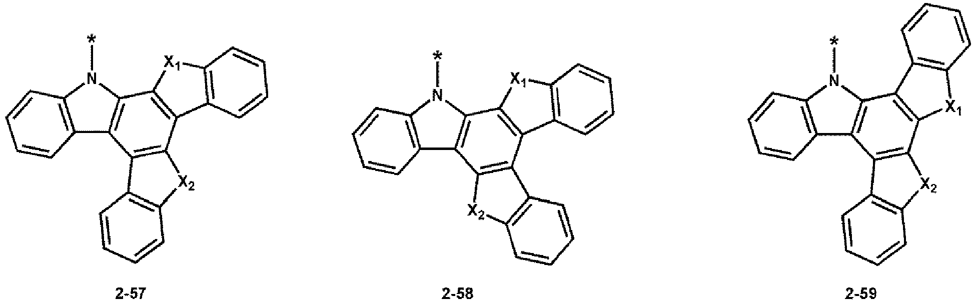 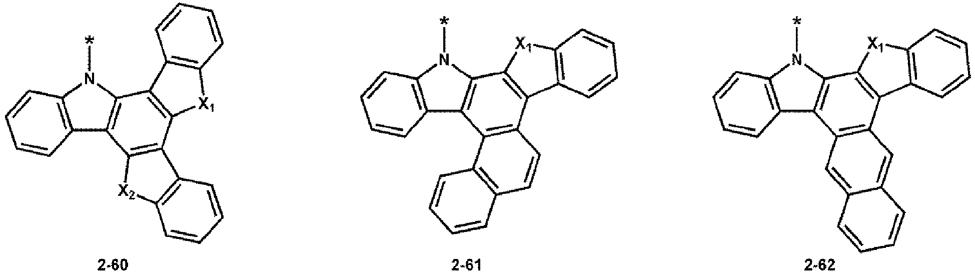 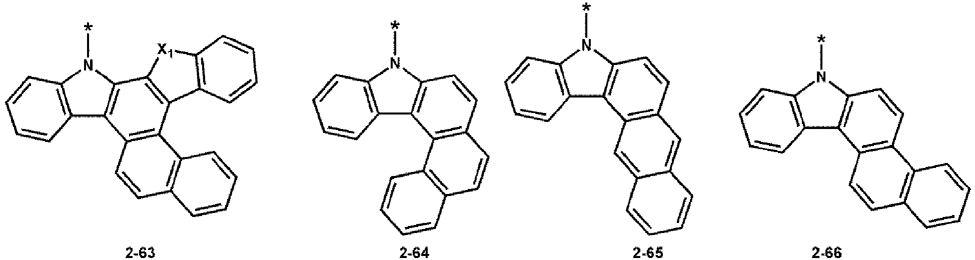 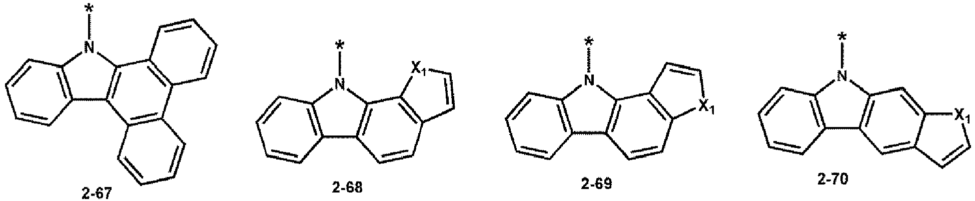 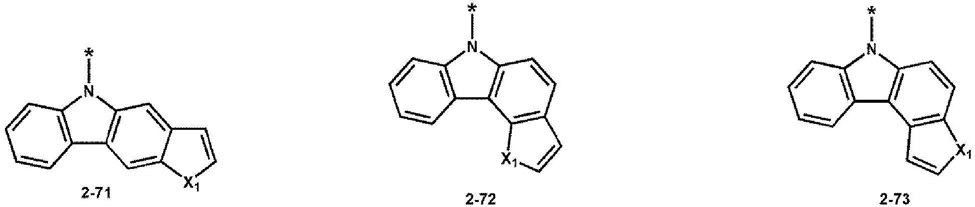 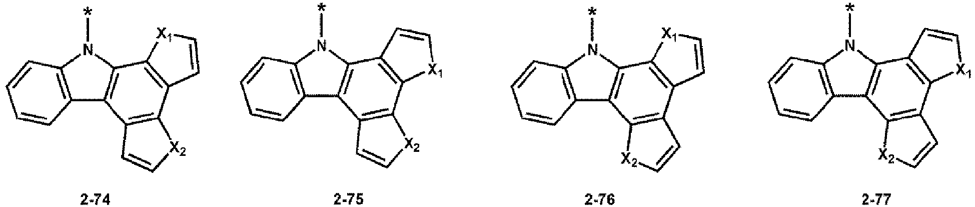 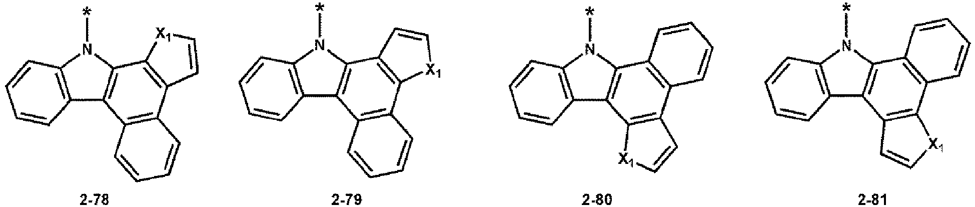 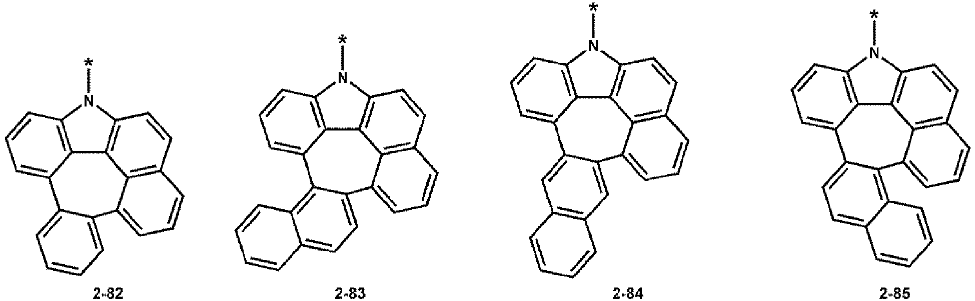 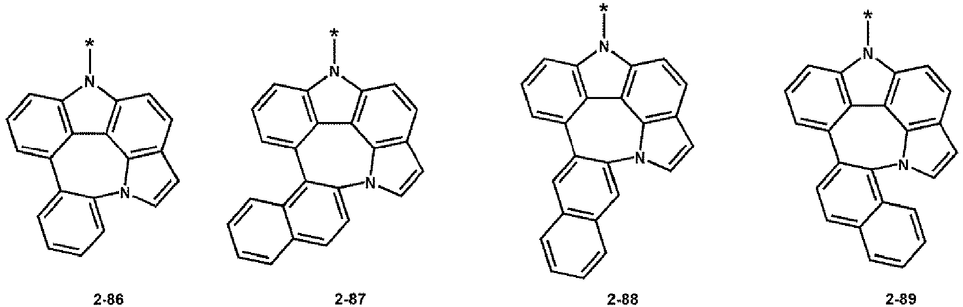 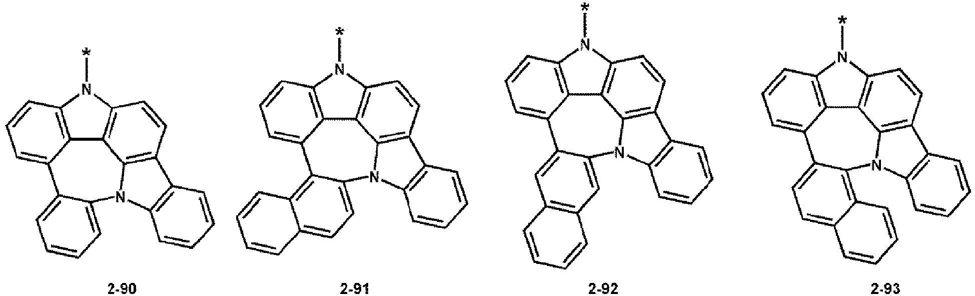
wherein, in Formulae 2-1 to 2-93,
X₁ is O, S, N(R₃₁), C(R₃₁)(R₃₂), or Si(R₃₁)(R₃₂),
X₂ is O, S, N(R₃₃), C(R₃₃)(R₃₄), or Si(R₃₃)(R₃₄),
R₃₁ to R₃₄ are the same as described in connection with R₃₀ in claim 1, and
* indicates a binding site to Ar₁ or Ar₂ in Formula 2.

11. The composition of any of claims 1-10, wherein
Het1 in Formula 3 is a group derived from one of Formulae 3-1 to 3-40: 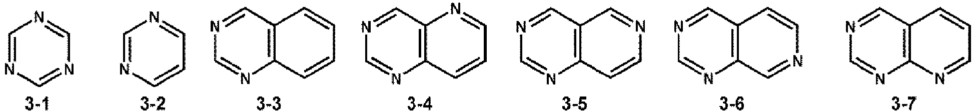 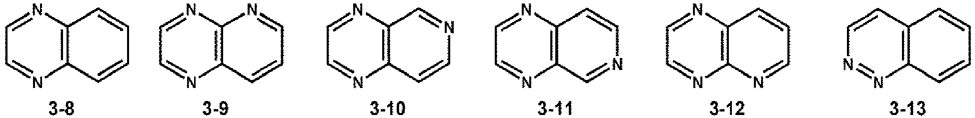 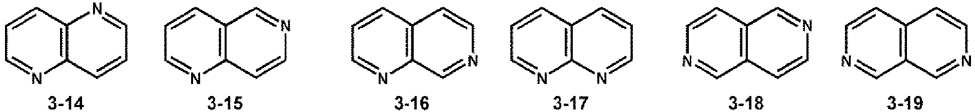 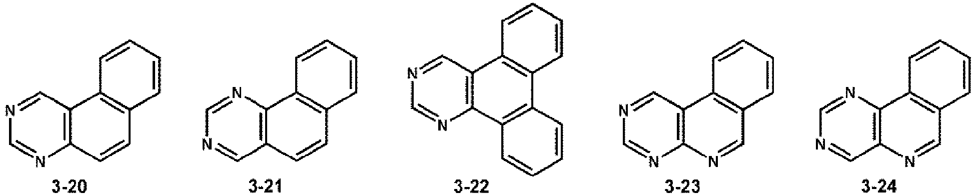 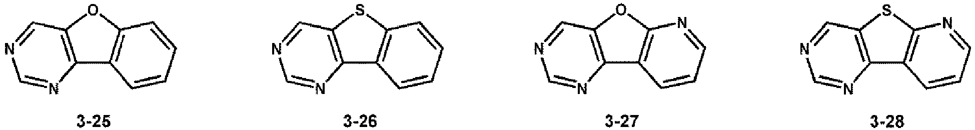 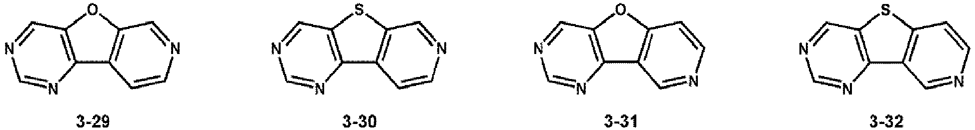 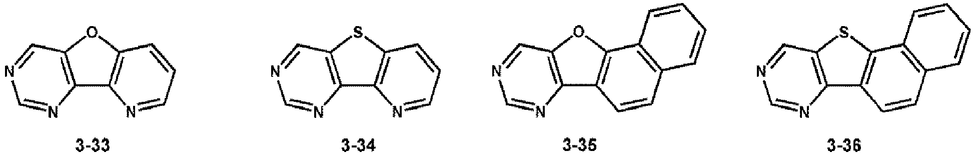 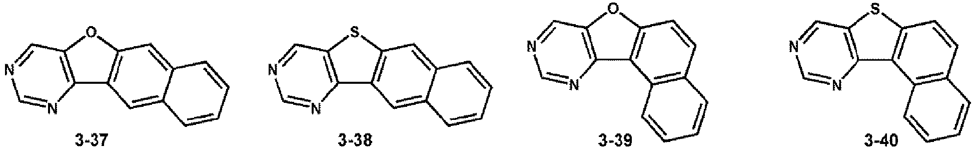 ; and/or wherein
a11 and m in Formula 3 are each independently an integer from 1 to 3.

12. The composition of any of claims 1-11, wherein
R₂₀, R₃₀, R₆₁, R₆₅, R₆₆, R₇₀ and R₈₀ in Formulae 2 and 3 are each independently:
hydrogen or deuterium;
a C₁-C₂₀ alkyl group or a C₁-C₂₀ alkoxy group, each unsubstituted or substituted with deuterium, a phenyl group, a naphthyl group, an anthracenyl group, a phenanthrenyl group, a triphenylenyl group, a fluorenyl group, a di(C₁-C₁₀ alkyl)fluorenyl group, a di(C₆-C₆₀ aryl)fluorenyl group, a dibenzosilolyl group, a di(C₁-C₁₀ alkyl)dibenzosilolyl group, a di(C₆-C₆₀ aryl)dibenzosilolyl group, a carbazolyl group, a (C₁-C₁₀ alkyl)carbazolyl group, a (C₆-C₆₀ aryl)carbazolyl group, a dibenzofuranyl group, a dibenzothiophenyl group, a biphenyl group, a terphenyl group, -N(Q₃₁)(Q₃₂), or any combination thereof;
a π electron-rich C₃-C₆₀ cyclic group, unsubstituted or substituted with deuterium, a C₁-C₂₀ alkyl group, a C₁-C₂₀ alkoxy group, a phenyl group, a naphthyl group, an anthracenyl group, a phenanthrenyl group, a triphenylenyl group, a fluorenyl group, a di(C₁-C₁₀ alkyl)fluorenyl group, a di(C₆-C₆₀ aryl)fluorenyl group, a dibenzosilolyl group, a di(C₁-C₁₀ alkyl)dibenzosilolyl group, a di(C₆-C₆₀ aryl)dibenzosilolyl group, a carbazolyl group, a (C₁-C₁₀ alkyl)carbazolyl group, a (C₆-C₆₀ aryl)carbazolyl group, a dibenzofuranyl group, a dibenzothiophenyl group, a biphenyl group, a terphenyl group, -N(Q₃₁)(Q₃₂), or any combination thereof; or
-N(Q₁)(Q₂).

13. The composition of any of claims 1-12, wherein
the second compound comprises at least one of Compounds H1-1 to H1-72, and the third compound comprises at least one of Compounds H2-1 to H2-61:

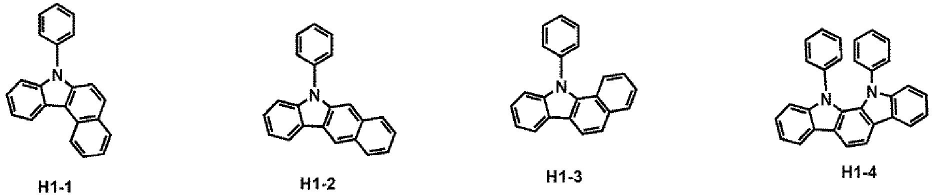

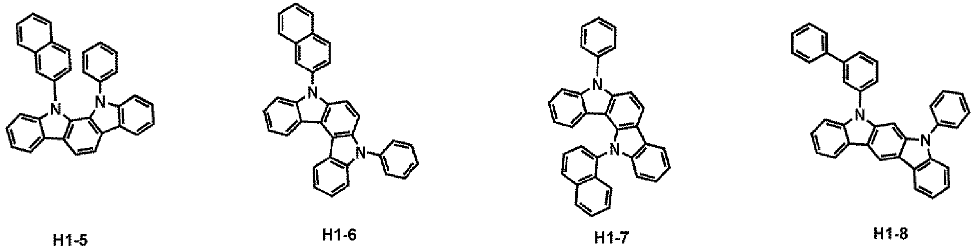

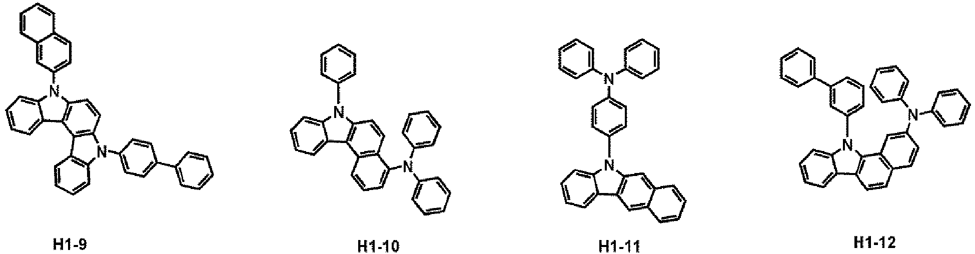

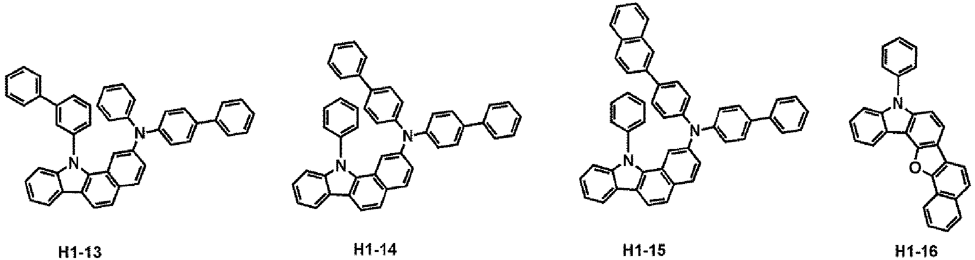

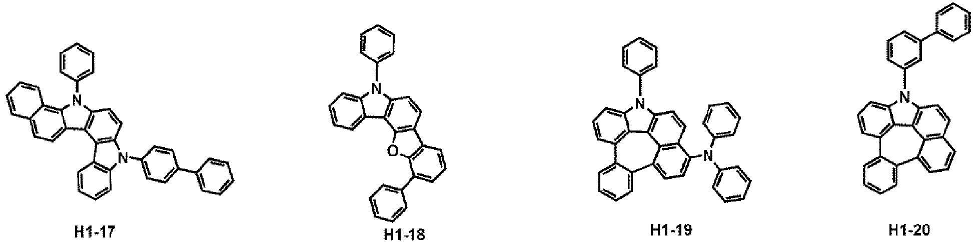

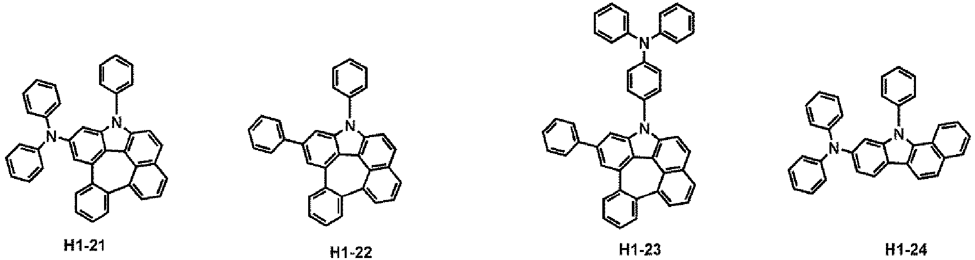

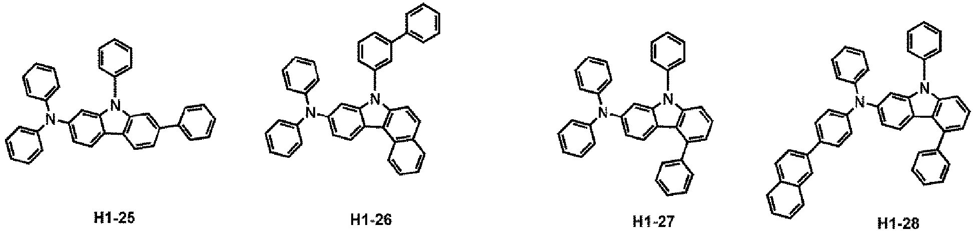

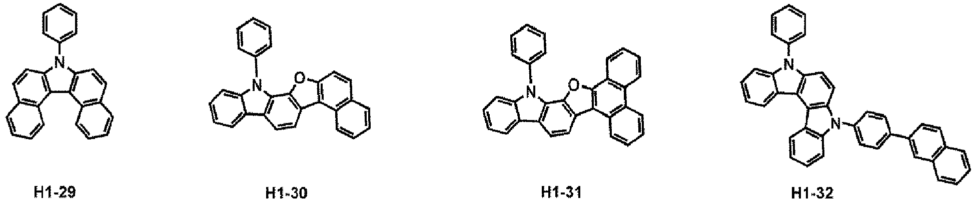

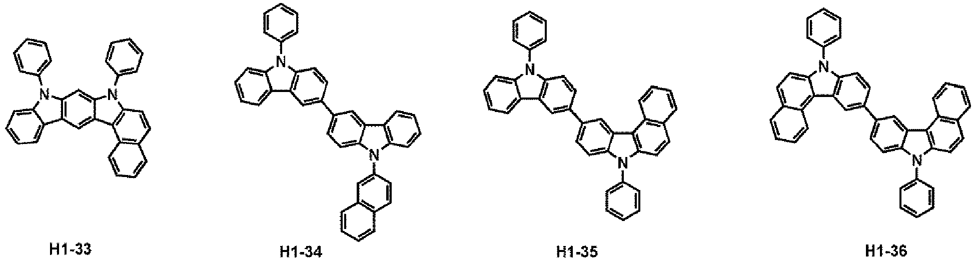

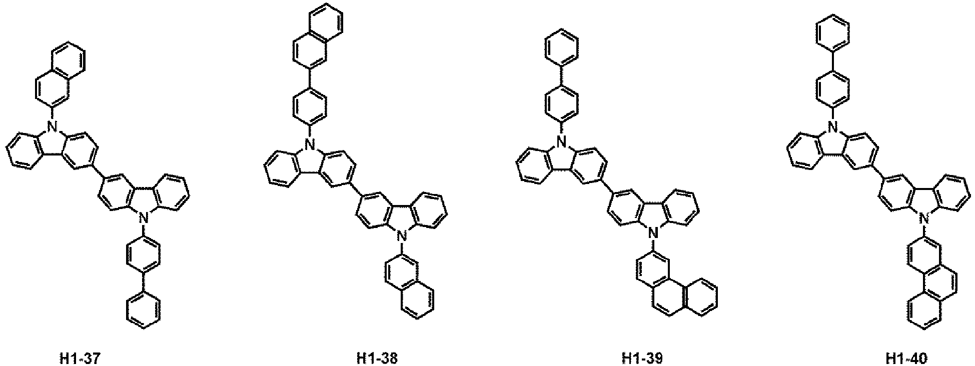

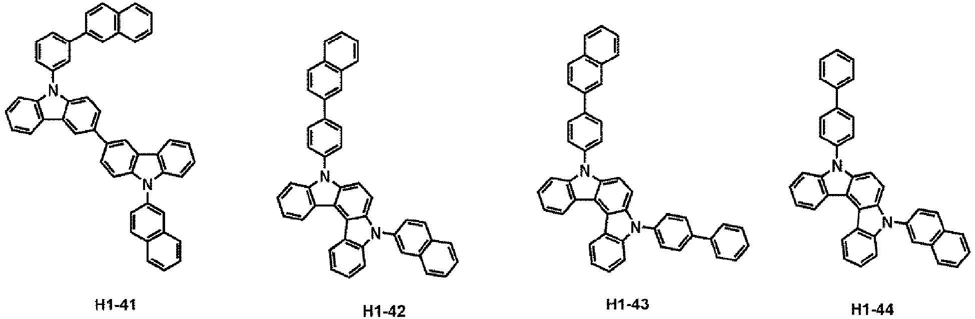

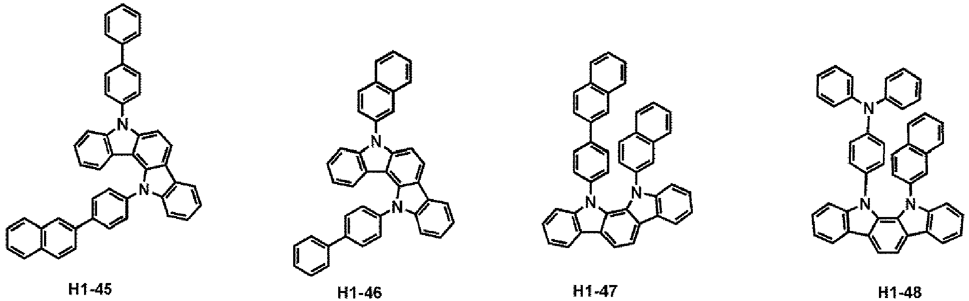

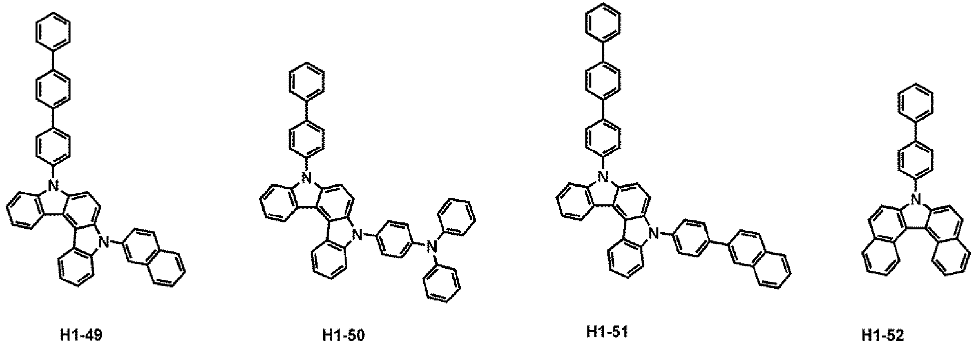

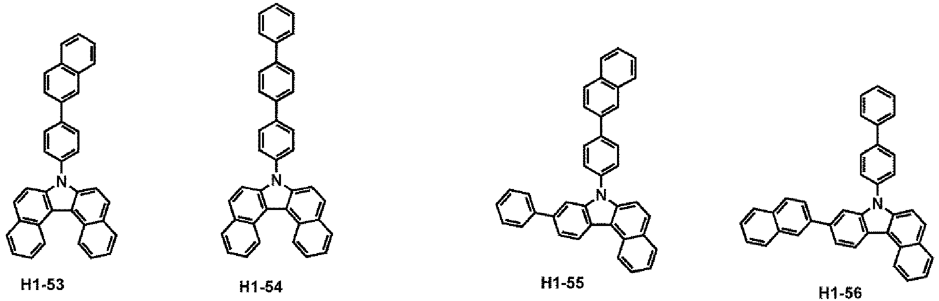

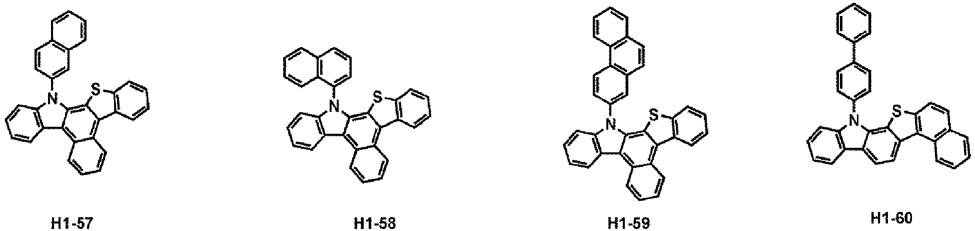

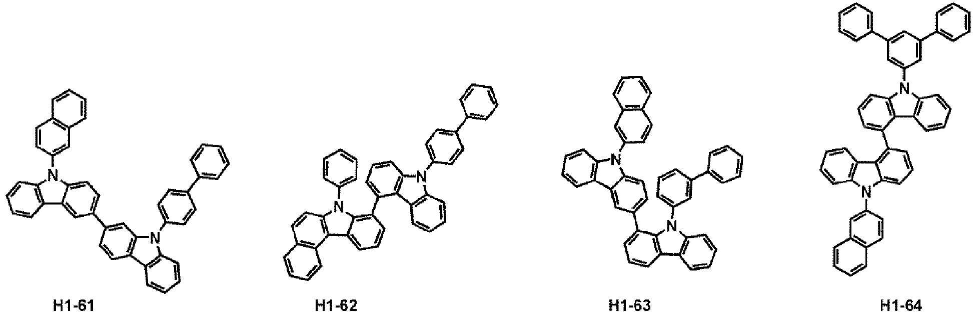

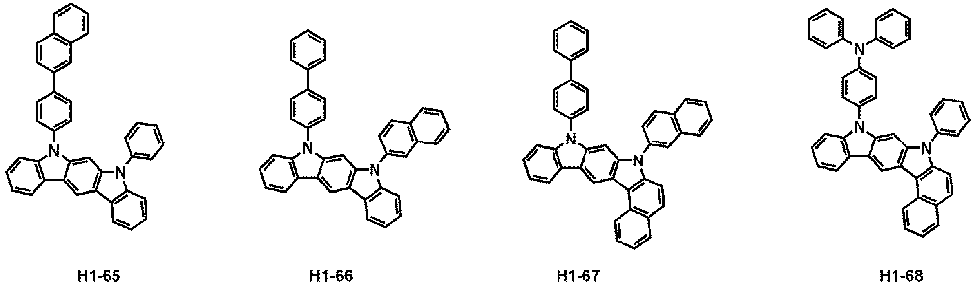

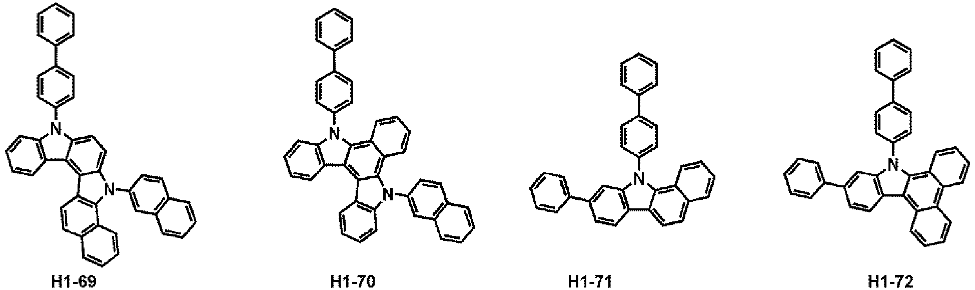

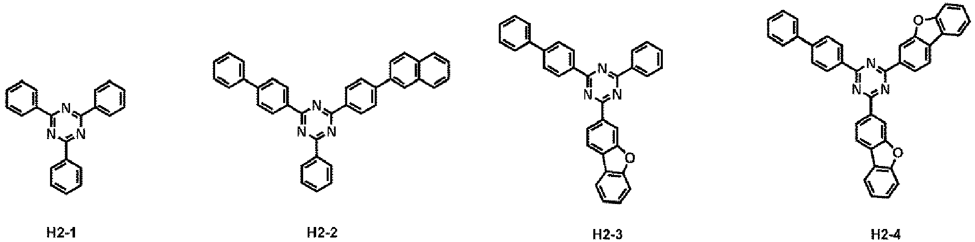

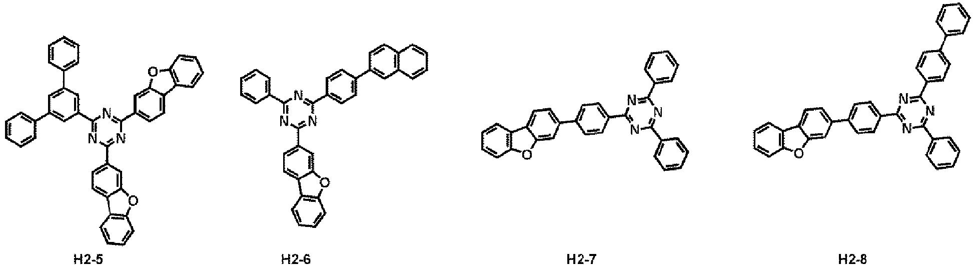

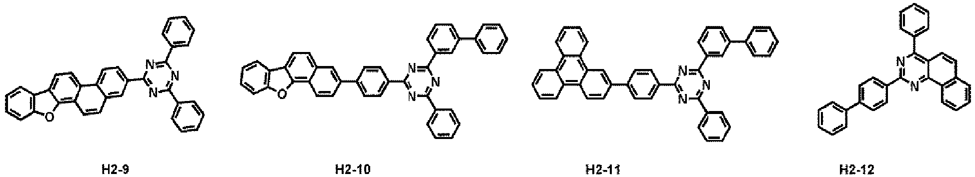

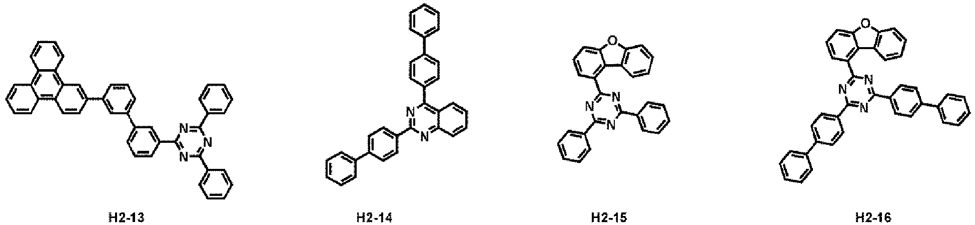

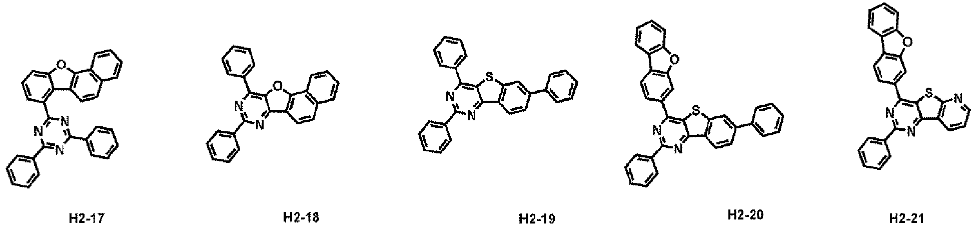

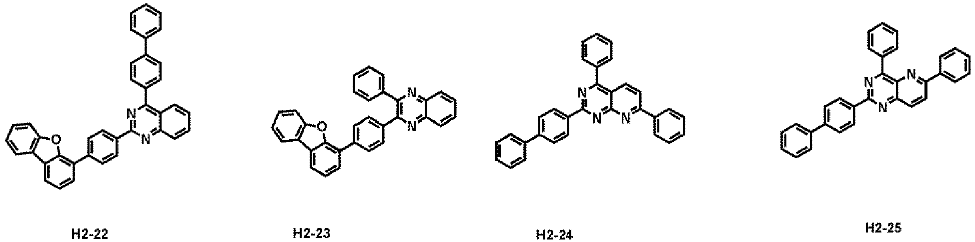

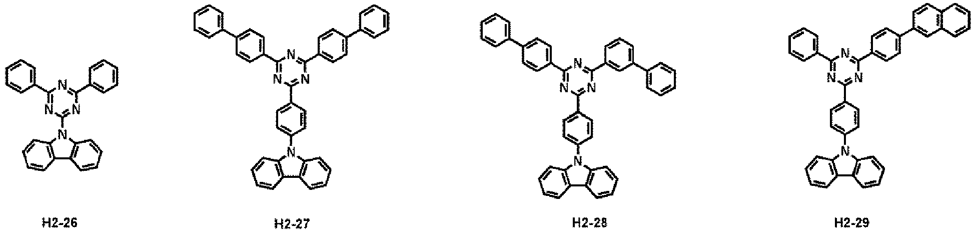

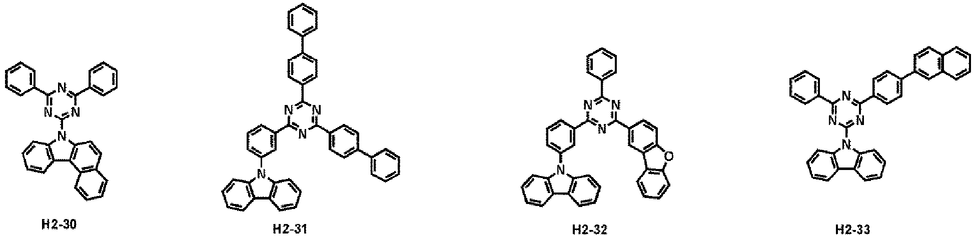

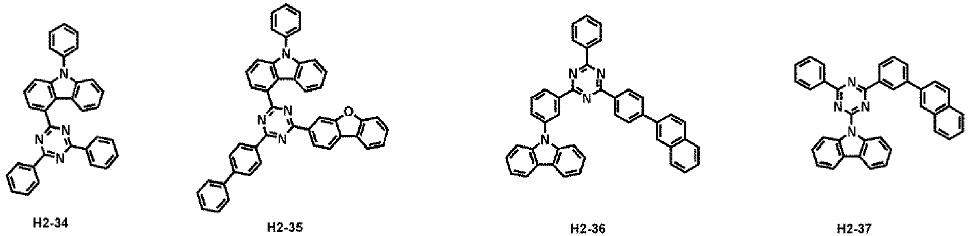

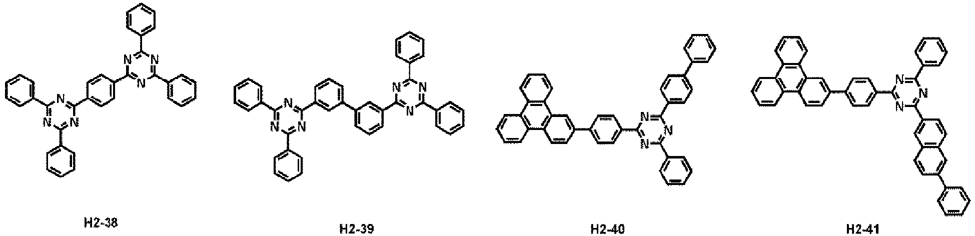

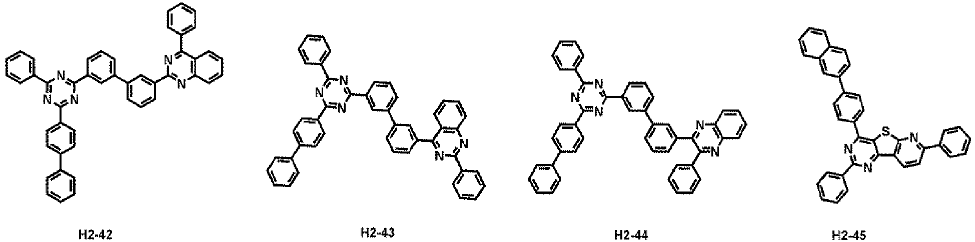

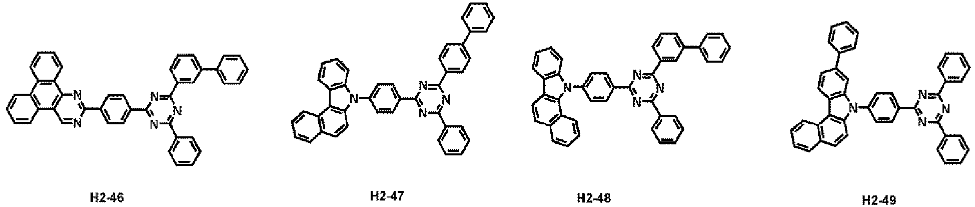

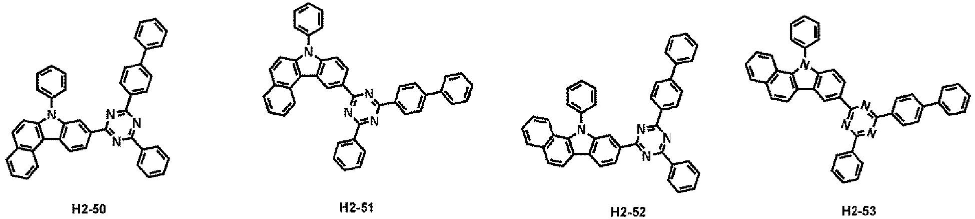

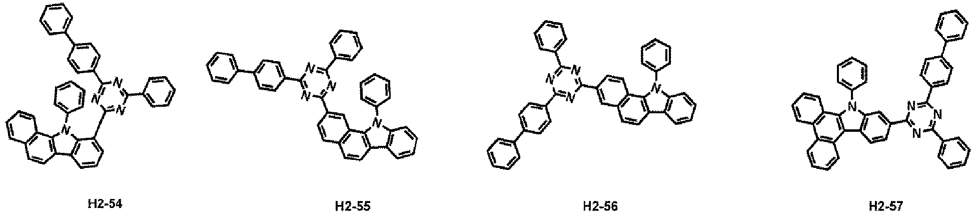

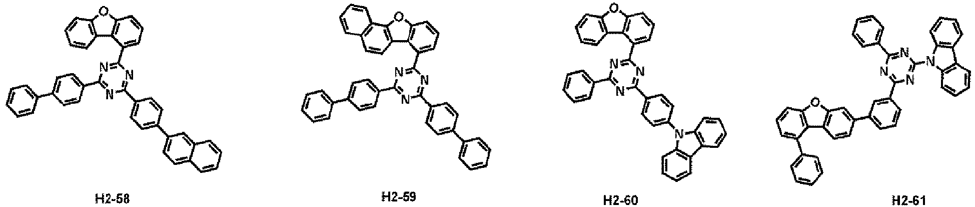

14. An organic light-emitting device comprising:
a first electrode;
a second electrode; and
an organic layer disposed between the first electrode and the second electrode and comprising an emission layer,
wherein the organic layer comprises the composition of any of claims 1-13;
preferably wherein
the first electrode is an anode,
the second electrode is a cathode,
the organic layer further comprises a hole transport region between the first electrode and the emission layer and an electron transport region between the emission layer and the second electrode,
the hole transport region comprises a hole injection layer, a hole transport layer, an electron blocking layer, a buffer layer, or any combination thereof, and
the electron transport region comprises a hole blocking layer, an electron transport layer, an electron injection layer, or any combination thereof.

15. The organic light-emitting device of claim 14, wherein
the emission layer comprises the composition of any of claims 1-13; and/or
wherein
the emission layer emits red light.

## Patentansprüche

1. Zusammensetzung, umfassend:
eine erste Verbindung, eine zweite Verbindung und eine dritte Verbindung, wobei
die erste Verbindung eine Verbindung umfasst, dargestellt durch Formel 1,
die zweite Verbindung eine Verbindung umfasst, dargestellt durch Formel 2, und
die dritte Verbindung eine Verbindung umfasst, dargestellt durch Formel 3: 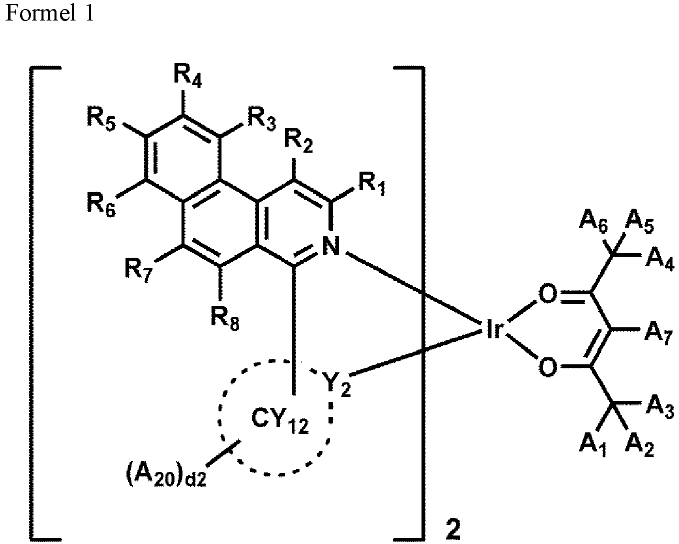 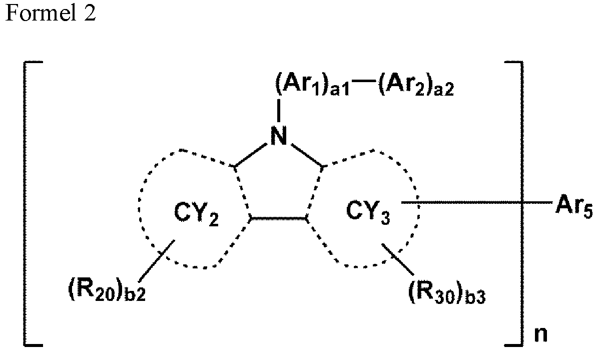 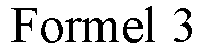 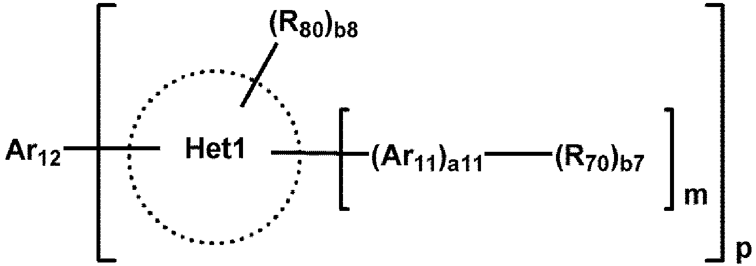 wobei
Y₂ in Formel 1 C ist,
Ring CY₁₂ in Formel 1 eine carbocyclische C₅-C₆₀-Gruppe oder eine heterocyclische C₁-C₆₀-Gruppe ist,
Ar₁, Ar₂ und Ar₁₁ in Formel 2 und 3 jeweils unabhängig eine carbocyclische C₅-C₆₀ Gruppe, die unsubstituiert oder substituiert mit mindestens einem R₆₁ ist, oder eine heterocyclische C₁-C₆₀-Gruppe, die unsubstituiert oder substituiert mit mindestens einem R₆₁ ist, sind,
Ar₅ und A₁₂ in Formel 2 und 3 jeweils unabhängig voneinander eine Einfachbindung, eine carbocyclische C₅-C₆₀-Gruppe, die unsubstituiert oder substituiert mit mindestens einem R₆₅ ist, oder eine heterocyclische C₁-C₆₀-Gruppe, die unsubstituiert oder substituiert mit mindestens einem R₆₅ ist, sind oder sie nicht vorhanden sind,
n in Formel 2 1, 2 oder 3 ist, und wenn n 1 ist, Ar₅ nicht vorhanden ist,
p in Formel 3 1, 2 oder 3 ist, und wenn p 1 ist, Ar₁₂ nicht vorhanden ist,
a1 und a2 in Formel 2 jeweils unabhängig eine ganze Zahl von 0 bis 5 sind, und die Summe von a1 und a2 1 oder größer ist,
Ring CY₂ und Ring CY₃ in Formel 2 jeweils unabhängig eine carbocyclische C₅-C₆₀-Gruppe oder eine heterocyclische C₁-C₆₀-Gruppe sind und Ring CY₂ und Ring CY₃ optional mit einer carbocyclischen C₅-C₆₀-Gruppe unsubstituiert oder substituiert mit mindestens einem R₆₆ oder einer heterocyclischen C₁-C₆₀-Gruppe unsubstituiert oder substituiert mit mindestens einem R₆₆ aneinander gebunden sind,
Het1 in Formel 3 eine π-Elektronen abgereicherte stickstoffhaltige cyclische C₁-C₆₀-Gruppe ist,
a11 und m in Formel 3 jeweils unabhängig eine ganze Zahl von 1 bis 10 sind,
R₁ bis R₈, A₂₀, A₁ bis A₇, R₂₀, R₃₀, R₆₁, R₆₅, R₆₆, R₇₀ und R₈₀ in Formel 1 bis 3 jeweils unabhängig Wasserstoff, Deuterium, -F, -Cl, -Br, -I, -SF₅, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₃-C₁₀-Cycloalkylgruppe, eine substituierte oder unsubstituierte C₂-C₁₀-Heterocycloalkylgruppe, eine substituierte oder unsubstituierte C₃-C₁₀-Cycloalkenylgruppe, eine substituierte oder unsubstituierte C₂-C₁₀-Heterocycloalkenylgruppe, eine substituierte oder unsubstituierte C₆-C₆₀-Arylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte monovalente nicht-aromatische kondensierte polyzyklische Gruppe, eine substituierte oder unsubstituierte monovalente nicht-aromatische kondensierte heteropolycyclische Gruppe, -N(Q₁)(Q₂), -Si(Q₃)(Q₄)(Q₅),-Ge(Q₃)(Q₄)(Q₅), -B(Q₆)(Q₇), - P(=O)(Q₈)(Q₉) oder -P(Q₈)(Q₉) sind,
b2, b3, b7 und b8 in Formel 2 und 3 jeweils unabhängig eine ganze Zahl von 0 bis 20 sind, wenn b2 2 oder mehr ist, zwei oder mehrere R₂₀(s) gleich oder verschieden voneinander sind, wenn b3 2 oder mehr ist, zwei oder mehrere R₃₀(s) gleich oder verschieden voneinander sind, wenn b7 2 oder mehr ist, zwei oder mehrere R₇₀(s) gleich oder verschieden voneinander sind, und wenn b8 2 oder mehr ist, zwei oder mehrere R₈₀(s) gleich oder voneinander verschieden sind,
d2 in Formel 1 eine ganze Zahl von 0 bis 10 ist, und wenn d2 2 oder mehr ist, zwei oder mehrere A₂₀(s) gleich oder verschieden voneinander sind,
mindestens eines von R₁ bis R₈, A₂₀ oder eine beliebige Kombination davon mindestens eine Fluorgruppe (-F) umfasst,
zwei oder mehrere von R₁ bis R₈ und A₂₀ in Formel 1 optional verbunden sind, um eine carbocyclische C₅-C₆₀ Gruppe zu bilden, die unsubstituiert oder substituiert mit mindestens einem R₁ₐ oder eine heterocyclische C₁-C₆₀-Gruppe, die unsubstituiert oder substituiert mit mindestens einem R₁ₐ ist,
zwei oder mehrere von A₁ bis A₇ in Formel 1 optional verbunden sind, um eine carbocyclische C₅-C₆₀ Gruppe zu bilden, die unsubstituiert oder substituiert mit mindestens einem R₁ₐ oder eine heterocyclische C₁-C₆₀-Gruppe, die unsubstituiert oder substituiert mit mindestens einem R₁ₐ ist,
zwei oder mehrere von Ring CY₂, Ring CY₃, R₂₀ und R₃₀ in Formel 2 optional verbunden sind, um eine carbocyclische C₅-C₆₀ Gruppe zu bilden, die unsubstituiert oder substituiert mit mindestens einem R₁ₐ oder eine heterocyclische C₁-C₆₀-Gruppe, die unsubstituiert oder substituiert mit mindestens einem R₁ₐ ist,
R₁ₐ zu verstehen ist, dass es sich auf die oben bereitgestellte Beschreibung von A₇ bezieht, und
ein Substituent der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₃-C₁₀-Cycloalkylgruppe, der substituierten C₂-C₁₀-Heterocycloalkylgruppe, der substituierten C₃-C₁₀-Cycloalkenylgruppe, der substituierten C₂-C₁₀-Heterocycloalkenylgruppe, der substituierten C₆-C₆₀-Arylgruppe, der substituierten C₆-C₆₀-Aryloxygruppe, der substituierten C₆-C₆₀-Arylthiogruppe, der substituierten C₁-C₆₀-Heteroarylgruppe, der substituierten monovalenten nicht-aromatischen kondensierten polycyclischen Gruppe, und der substituierten monovalenten nicht-aromatischen kondensierten heteropolycyclischen Gruppe wie folgt ist:
Deuterium, -F, -Cl, -Br, -I, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe oder eine C₁-C₆₀-Alkoxygruppe;
eine C₁-C₆₀-Alkylgruppe, eine C₂-C₆₀-Alkenylgruppe, eine C₂-C₆₀-Alkinylgruppe oder eine C₁-C₆₀-Alkoxygruppe, jeweils substituiert mit Deuterium, -F, -Cl, -Br, -I, -CD₃, -CD₂H,-CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine C₃-C₁₀-Cycloalkylgruppe, eine C₂-C₁₀-Heterocycloalkylgruppe, eine C₃-C₁₀-Cycloalkenylgruppe, eine C₂-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine monovalente nicht-aromatische kondensierte polycyclische Gruppe, eine monovalente nicht-aromatische kondensierte heteropolycyclische Gruppe, -N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉),-P(Q₁₈)(Q₁₉) oder eine beliebige Kombination davon;
eine C₃-C₁₀-Cycloalkylgruppe, eine C₂-C₁₀-Heterocycloalkylgruppe, eine C₃-C₁₀-Cycloalkenylgruppe, eine C₂-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine monovalenten nichtaromatischen kondensierten polycyclischen Gruppe oder eine monovalenten nichtaromatischen kondensierten heteropolycyclischen Gruppe, jeweils unsubstituiert oder substituiert mit Deuterium, -F, -Cl, -Br, -I, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder einem Salz davon, eine Sulfonsäuregruppe oder einem Salz davon, eine Phosphorsäuregruppe oder einem Salz davon, eine C₁-C₆₀-Alkylgruppe, eine C₂-C₆₀-Alkenylgruppe, eine C₂-C₆₀-Alkynylgruppe, eine C₁-C₆₀-Alkoxygruppe, eine C₃-C₁₀-Cycloalkylgruppe, eine C₂-C₁₀-Heterocycloalkylgruppe, eine C₃-C₁₀-Cycloalkenylgruppe, eine C₂-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine monovalenten nichtaromatischen kondensierten polycyclischen Gruppe und eine monovalenten nichtaromatischen kondensierten heteropolycyclischen Gruppe, -N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), -P(Q₂₈)(Q₂₉) oder eine beliebige Kombination davon;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), P(=O)(Q₃₈)(Q₃₉) oder -P(Q₃₈)(Q₃₉); oder
eine beliebige Kombination davon,
wobei Q₁ bis Q₉, Q₁₁ bis Q₁₉, Q₂₁ bis Q₂₉ und Q₃₁ bis Q₃₉ jeweils unabhängig Wasserstoff; Deuterium; -F; -Cl; -Br; -I; eine Hydroxylgruppe; eine Cyanogruppe; eine Nitrogruppe; eine Aminogruppe; eine Amidinogruppe; eine Hydrazingruppe; eine Hydrazongruppe; eine Carbonsäuregruppe oder ein Salz davon; eine Sulfonsäuregruppe oder ein Salz davon; eine Phosphorsäuregruppe oder ein Salz davon; eine C₁-C₆₀-Alkylgruppe unsubstituiert oder substituiert mit Deuterium, eine C₁-C₆₀-Alkylgruppe, eine C₆-C₆₀-Arylgruppe oder eine beliebige Kombination davon; eine C₂-C₆₀-Alkenylgruppe; eine C₂-C₆₀-Alkinylgruppe; eine C₁-C₆₀-Alkoxygruppe; eine C₃-C₁₀-Cycloalkylgruppe; eine C₂-C₁₀-Heterocycloalkylgruppe; eine C₃-C₁₀-Cycloalkenylgruppe; eine C₂-C₁₀-Heterocycloalkenylgruppe; eine C₆-C₆₀-Arylgruppe unsubstituiert oder substituiert mit Deuterium, eine C₁-C₆₀-Alkylgruppe, eine C₆-C₆₀-Arylgruppe oder eine beliebige Kombination davon; eine C₆-C₆₀-Aryloxygruppe; eine C₆-C₆₀-Arylthiogruppe; eine C₁-C₆₀-Heteroarylgruppe; eine monovalente nicht-aromatische kondensierte polycyclische Gruppe; oder eine monovalente nicht-aromatische kondensierte heteropolycyclische Gruppe sind.

2. Zusammensetzung nach Anspruch 1, wobei
Ring CY₁₂ in Formel 1 eine Benzolgruppe, eine Naphthalingruppe, eine 1,2,3,4-Tetrahydronaphthalingruppe, eine Thiophengruppe, eine Furangruppe, eine Pyrrolgruppe, eine Cyclopentadiengruppe, eine Silolgruppe, eine Benzothiophengruppe, eine Benzofurangruppe, eine Indolgruppe, eine Indengruppe, eine Benzosilolgruppe, eine Dibenzothiophengruppe, eine Dibenzofurangruppe, eine Carbazolgruppe, eine Fluorengruppe oder eine Dibenzosilolgruppe ist.

3. Zusammensetzung nach Anspruch 1 oder 2, wobei
R₁ bis R₈ und A₁ bis A₇ jeweils unabhängig wie folgt sind:
Wasserstoff, Deuterium oder -F;
eine C₁-C₂₀-Alkylgruppe, eine C₃-C₁₀-Cycloalkylgruppe, eine C₂-C₁₀-Heterocycloalkylgruppe oder eine Phenylgruppe ist, jeweils unsubstituiert oder substituiert mit Deuterium, -F, einer C₁-C₂₀-Alkylgruppe, einer C₃-C₁₀-Cycloalkylgruppe, einer C₂-C₁₀-Heterocycloalkylgruppe, einer Phenylgruppe oder einer beliebigen Kombination davon; oder
-Si(Q₃)(Q₄)(Q₅) oder -Ge(Q₃)(Q₄)(Q₅), und
A₂₀ in Formel 1 wie folgt ist:
Wasserstoff oder Deuterium;
eine C₁-C₂₀-Alkylgruppe, eine C₃-C₁₀-Cycloalkylgruppe, eine C₂-C₁₀-Heterocycloalkylgruppe oder eine Phenylgruppe ist, jeweils unsubstituiert oder substituiert mit Deuterium, einer C₁-C₂₀-Alkylgruppe, einer C₃-C₁₀-Cycloalkylgruppe, einer C₂-C₁₀-Heterocycloalkylgruppe, einer Phenylgruppe oder einer beliebigen Kombination davon; oder
-Si(Q₃)(Q₄)(Q₅) oder -Ge(Q₃)(Q₄)(Q₅).

4. Zusammensetzung nach einem der Ansprüche 1-3, wobei
mindestens eines von R₁ bis R₈ in Formel 1 unabhängig wie folgt ist:
eine Fluorgruppe (-F); oder
eine fluorierte C₁-C₂₀-Alkylgruppe, eine fluorierte C₃-C₁₀-Cycloalkylgruppe, eine fluorierte C₂-C₁₀-Heterocycloalkylgruppe oder eine fluorierte Phenylgruppe, jeweils unsubstituiert oder substituiert mit Deuterium, einer C₁-C₂₀-Alkylgruppe, einer C₃-C₁₀-Cycloalkylgruppe, einer C₂-C₁₀-Heterocycloalkylgruppe, einer Phenylgruppe oder eine beliebige Kombination davon.

5. Zusammensetzung nach einem der Ansprüche 1-4, wobei
mindestens eines von A₁ bis A₆ in Formel 1 jeweils unabhängig eine unsubstituierte oder substituierte C₂-C₆₀-Alkylgruppe, eine unsubstituierte oder substituierte C₃-C₁₀-Cycloalkylgruppe oder eine unsubstituierte oder substituierte C₂-C₁₀-Heterocycloalkylgruppe ist; und/oder
wobei
A₁ bis A₆ sind jeweils unabhängig eine unsubstituierte oder substituierte C₁-C₆₀-Alkylgruppe, eine unsubstituierte oder substituierte C₃-C₁₀-Cycloalkylgruppe oder eine unsubstituierte oder substituierte C₂-C₁₀-Heterocycloalkylgruppe sind.

6. Zusammensetzung nach einem der Ansprüche 1-5, wobei eine Gruppe, dargestellt durch 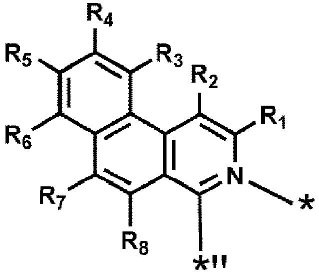 in Formel 1, eine Gruppe ist, die durch eine von Formel CY1 bis CY108 dargestellt ist: 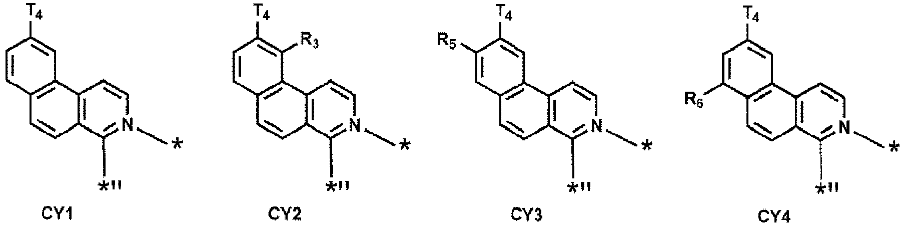 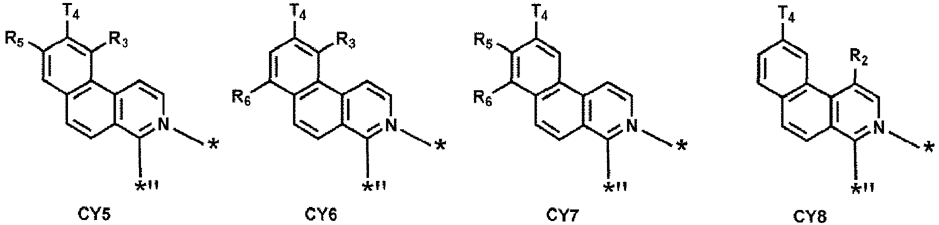 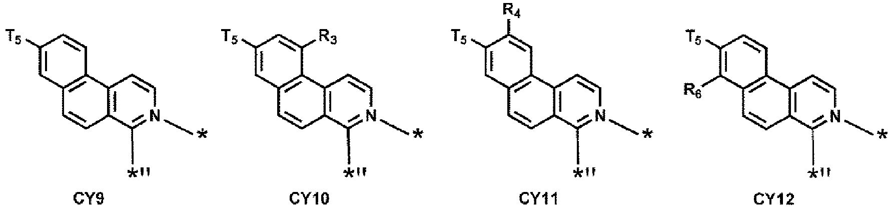 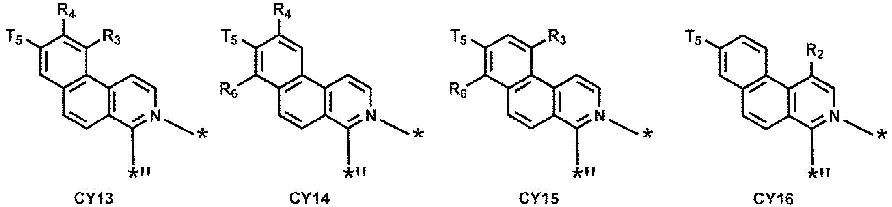 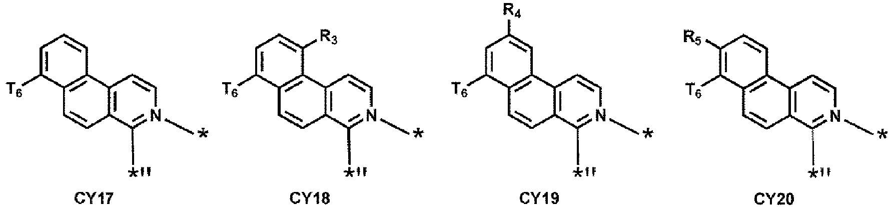 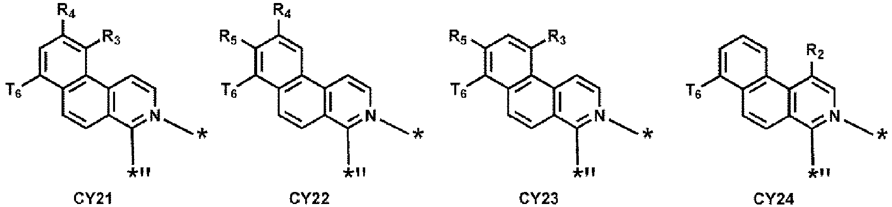 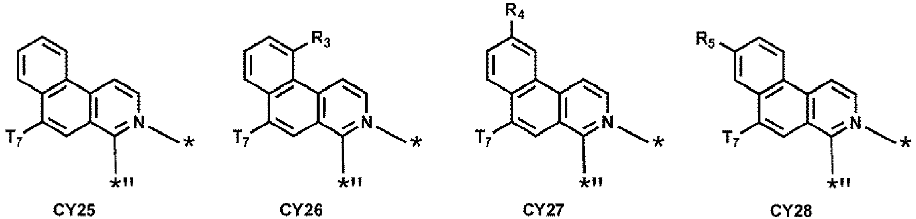 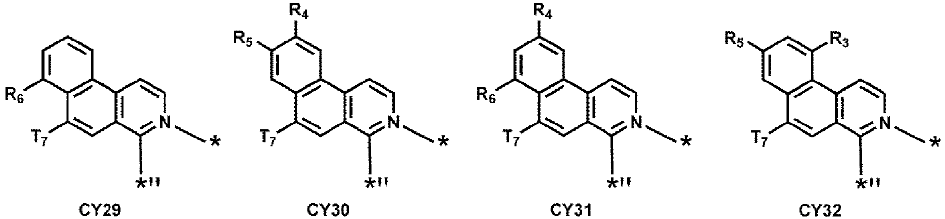 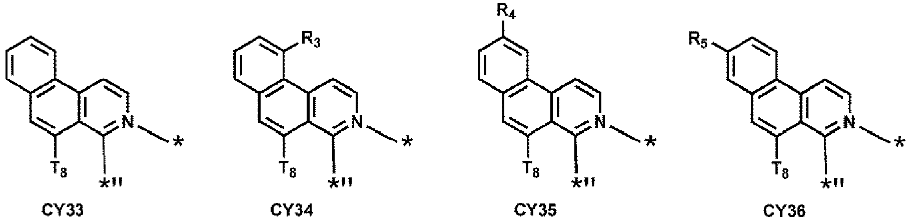 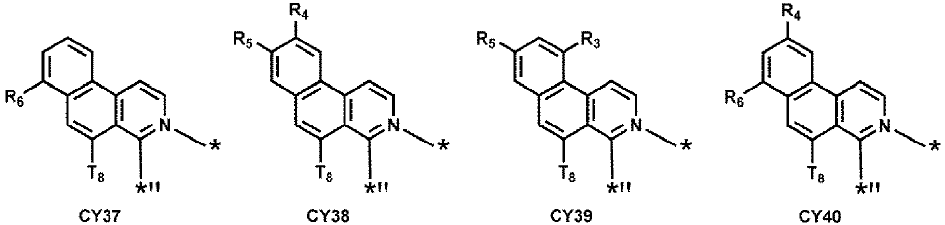 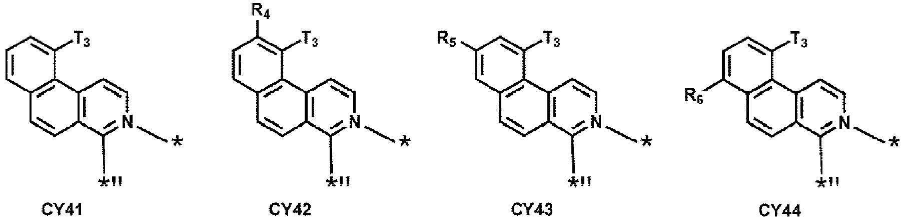 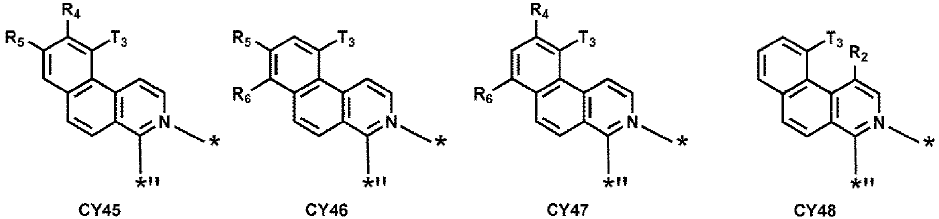 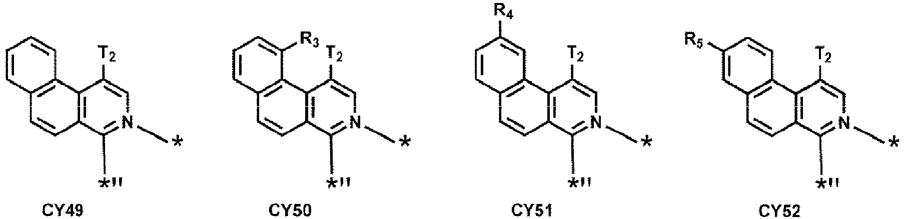 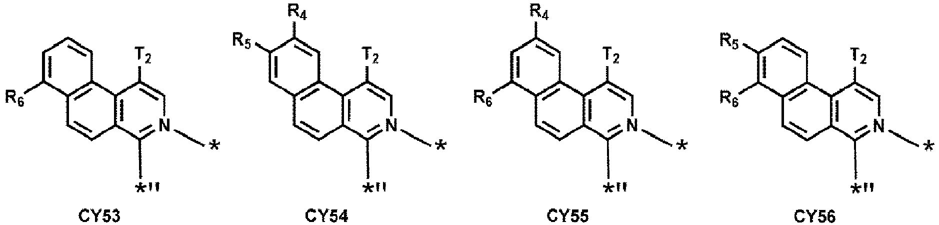 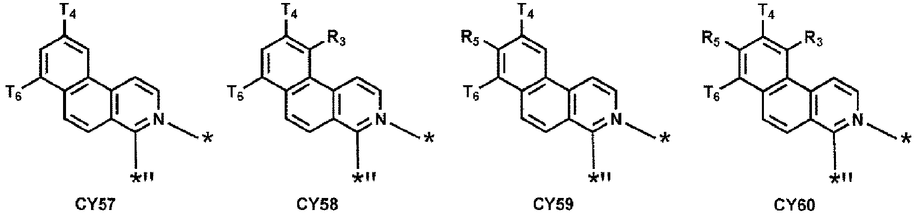 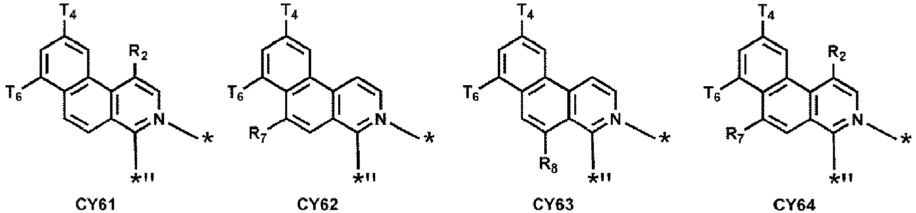 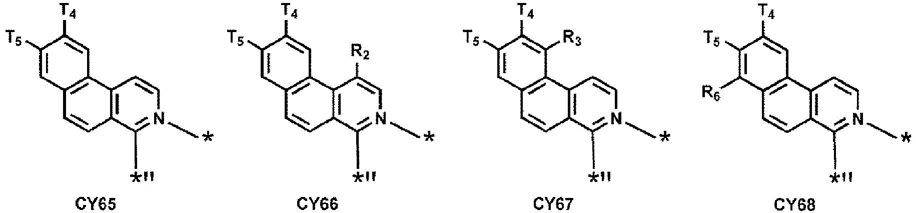 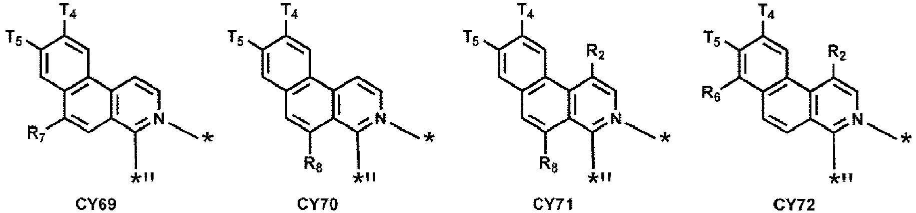 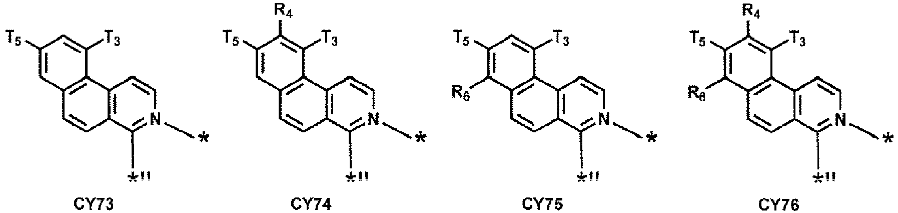 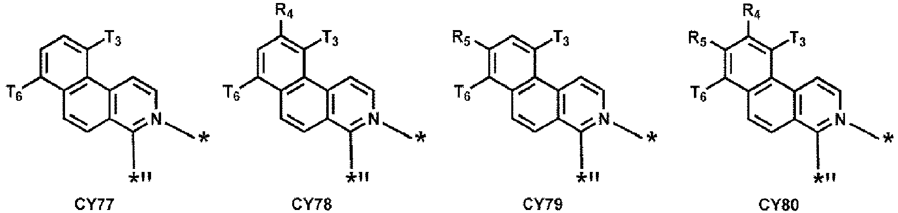 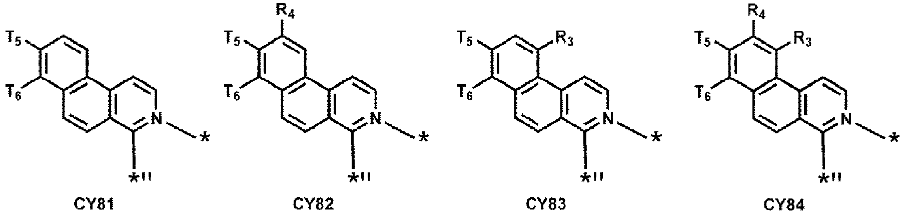 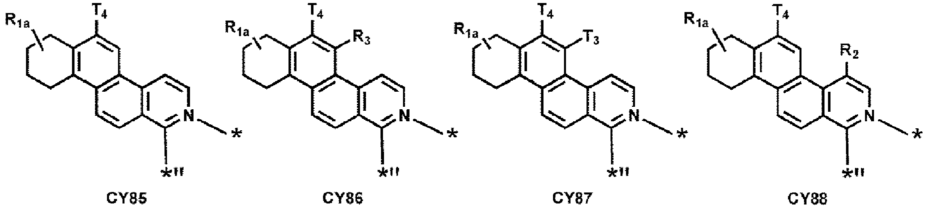 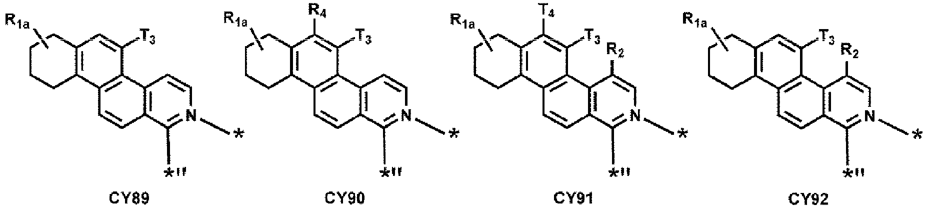 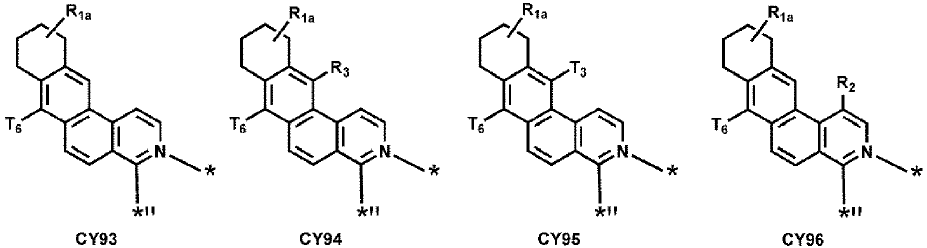 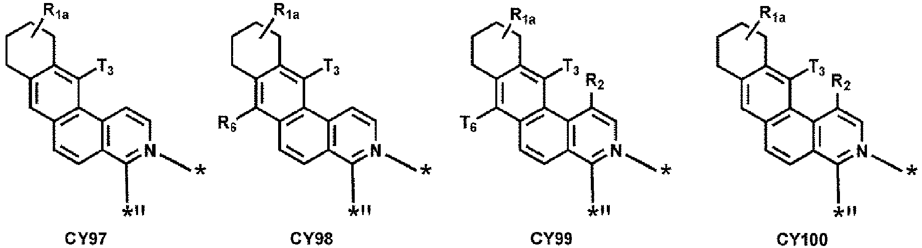 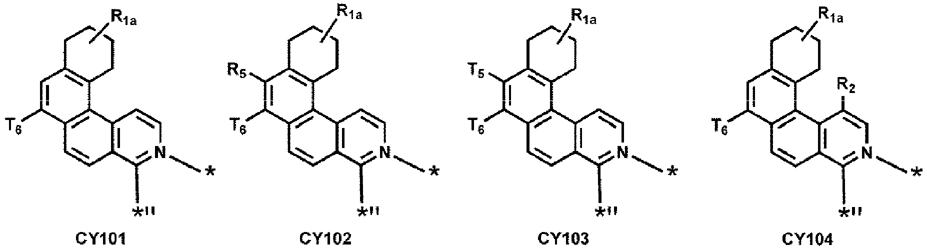 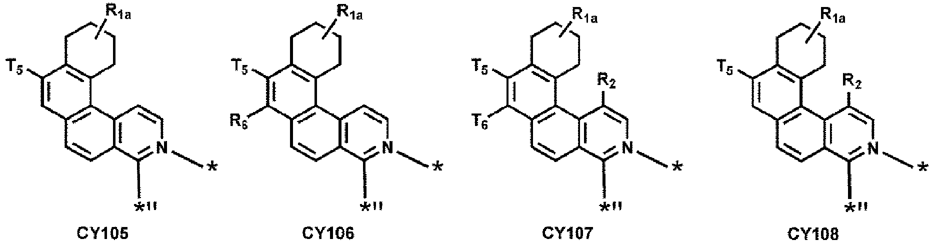
wobei, in Formel CY1 bis CY108,
T₂ bis T₈ jeweils unabhängig wie folgt sind:
eine Fluorgruppe (-F); oder
eine fluorierte C₁-C₂₀-Alkylgruppe, eine fluorierte C₃-C₁₀-Cycloalkylgruppe, eine fluorierte C₂-C₁₀-Heterocycloalkylgruppe oder eine fluorierte Phenylgruppe, jeweils unsubstituiert oder substituiert mit Deuterium, einer C₁-C₂₀ -Alkylgruppe, einer C₃-C₁₀-Cycloalkylgruppe, einer C₂-C₁₀-Heterocycloalkylgruppe, einer Phenylgruppe, oder eine beliebige Kombination davon; oder
jedes von R₂ bis R₈ und R₁ₐ gleich wie beschrieben in Anspruch 1 sind, und R₂ bis R₈ nicht Wasserstoff sind,
^{∗} eine Bindungsstelle an Ir in Formel 1 angibt, und
^{∗}" eine Bindungsstelle zu einem benachbarten Atom in Formel 1 angibt.

7. Zusammensetzung nach einem der Ansprüche 1-6, wobei eine Gruppe, dargestellt durch 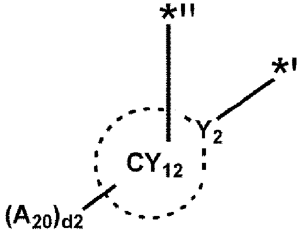 in Formel 1, eine Gruppe ist, die durch eine von Formeln A(1) bis A(7) dargestellt ist: 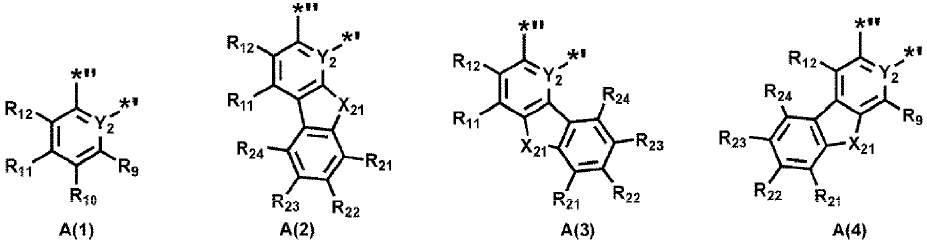 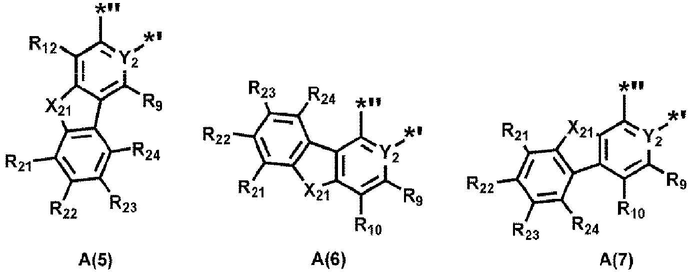
wobei, in Formel A(1) bis A(7),
Y₂ C ist,
X₂₁ O, S, N(R₂₅), C(R₂₅)(R₂₆) oder Si(R₂₅)(R₂₆) ist,
jedes von R₉ bis R₁₂ und R₂₁ bis R₂₆ gleich wie beschrieben in Verbindung mit A₂₀ in Anspruch 1 sind,
^{∗}' eine Bindungsstelle an Ir in Formel 1 angibt, und
^{∗}" eine Bindungsstelle zu einem benachbarten Atom in Formel 1 angibt; und/oder
wobei
die erste Verbindung mindestens eine von Verbindung 1 bis 53 umfasst:

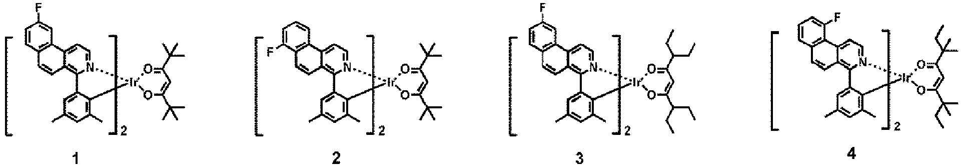

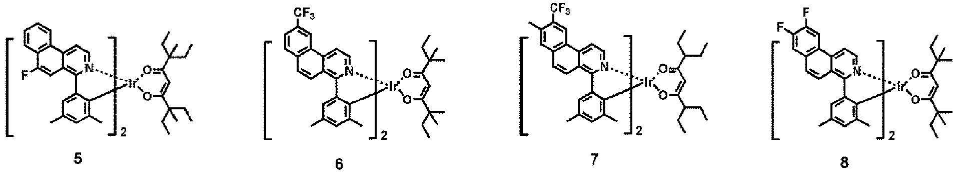

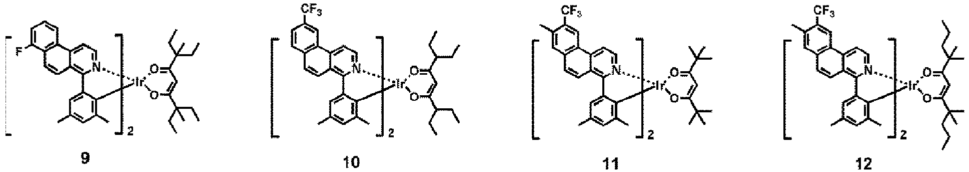

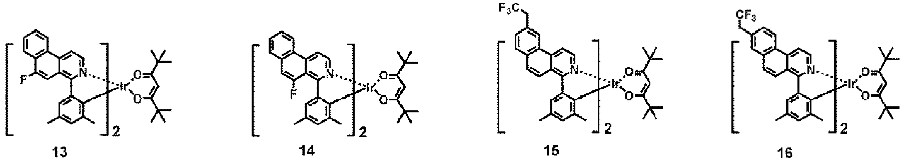

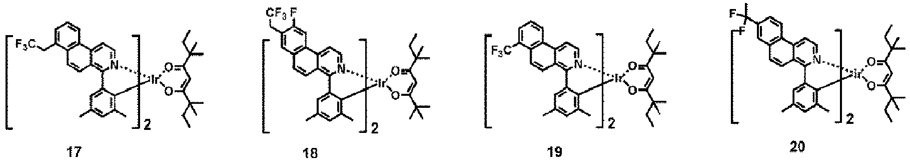

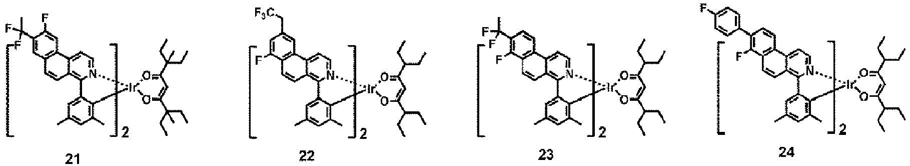

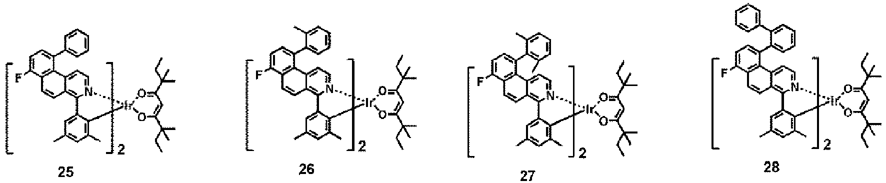

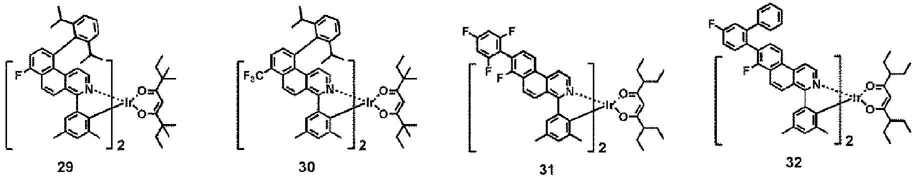

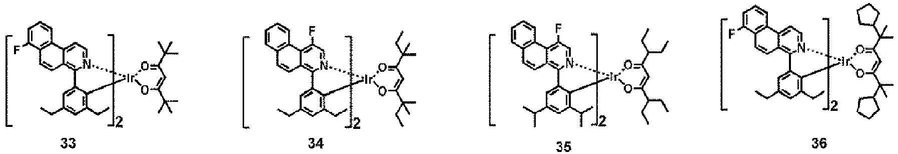

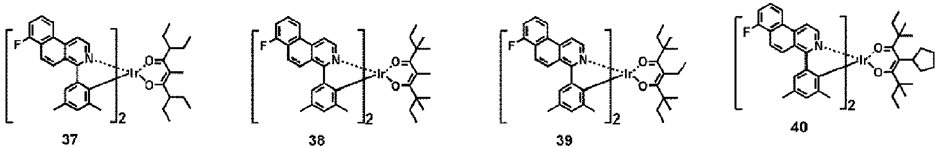

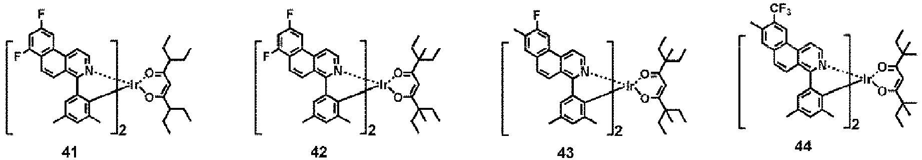

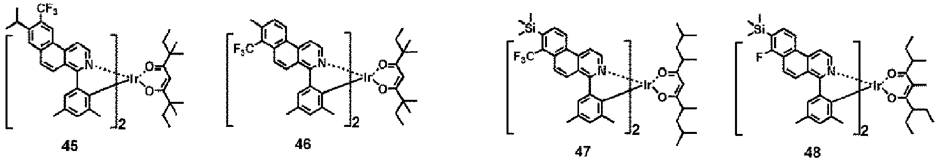

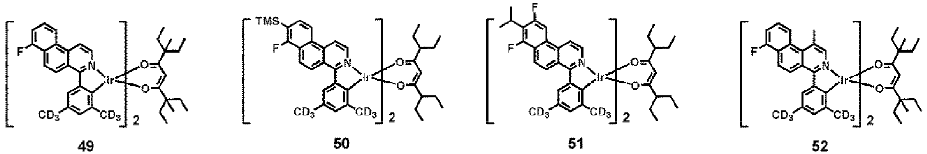

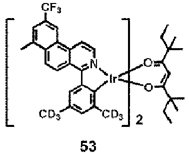

8. Zusammensetzung nach einem der Ansprüche 1-7, wobei
Ar₁, Ar₂ und Ar₁₁ in Formel 2 und 3 jeweils unabhängig eine Gruppe sind, abgeleitet von i) einem ersten Ring, der unsubstituiert oder substituiert mit mindestens einem R₆₁ ist, ii) einem zweiten Ring, der unsubstituiert oder substituiert mit mindestens einem R₆₁ ist, iii) einer kondensierten cyclischen Gruppe, in der zwei oder mehr erste Ringe miteinander kondensiert sind, die unsubstituiert oder substituiert mit mindestens einem R₆₁ sind, iv) einer kondensierten cyclischen Gruppe, in der zwei oder mehr zweite Ringe miteinander kondensiert sind, die unsubstituiert oder substituiert mit mindestens einem R₆₁ sind, oder v) einer kondensierten cyclischen Gruppe, in der mindestens ein erster Ring und mindestens ein zweiter Ring miteinander kondensiert sind, die unsubstituiert oder substituiert mit mindestens einem R₆₁ sind,
Ar₅ und Ar₁₂ in Formel 2 und 3 jeweils unabhängig eine Einfachbindung oder eine Gruppe sind, abgeleitet von i) einem ersten Ring, der unsubstituiert oder substituiert mit mindestens einem R₅₅ ist, ii) einem zweiten Ring, der unsubstituiert oder substituiert mit mindestens einem R₆₅ ist, iii) einer kondensierten cyclischen Gruppe, in der zwei oder mehr erste Ringe miteinander kondensiert sind, die unsubstituiert oder substituiert mit mindestens einem R₆₅ sind, iv) einer kondensierten cyclischen Gruppe, in der zwei oder mehr zweite Ringe miteinander kondensiert sind, die unsubstituiert oder substituiert mit mindestens einem R₆₅ sind, oder v) einer kondensierten cyclischen Gruppe, in der mindestens ein erster Ring und mindestens ein zweiter Ring miteinander kondensiert sind, die unsubstituiert oder substituiert mit mindestens einem R₆₅ sind, oder nicht vorhanden sind,
Ring CY₂ und Ring CY₃ in Formel 2 jeweils unabhängig voneinander i) ein erster Ring, ii) ein zweiter Ring, iii) eine kondensierte cyclische Gruppe, in der zwei oder mehrere erste Ringe miteinander kondensiert sind, iv) eine kondensierte cyclische Gruppe, in der zwei oder mehrere zweite Ringe miteinander kondensiert sind, oder v) eine kondensierte cyclische Gruppe, in der mindestens ein erster Ring und mindestens ein zweiter Ring miteinander kondensiert sind, sind,
Het1 in Formel 3 eine Gruppe ist, abgeleitet von i) einem ersten Ring, ii) einer kondensierten cyclischen Gruppe, in der zwei oder mehrere erste Ringe miteinander kondensiert sind, oder iii) einer kondensierten cyclischen Gruppe, in der mindestens ein erster Ring und mindestens ein zweiter Ring miteinander kondensiert sind,
der erste Ring eine Imidazolgruppe, eine Pyrazolgruppe, eine Thiazolgruppe, eine Isothiazolgruppe, eine Oxazolgruppe, eine Isoxazolgruppe, eine Pyridingruppe, eine Pyrazingruppe, eine Pyridazingruppe, eine Pyrimidingruppe, eine Triazolgruppe, eine Tetrazolgruppe, eine Oxadiazolgruppe, eine Triazingruppe oder eine Thiadiazolgruppe ist, und
der zweite Ring eine Benzolgruppe, eine Cyclopentadiengruppe, eine Pyrrolgruppe, eine Furangruppe, eine Thiophengruppe oder eine Silolgruppe ist.

9. Zusammensetzung nach einem der Ansprüche 1-8, wobei
Ar₁, Ar₂ und Ar₁₁ in Formel 2 und 3 jeweils unabhängig eine π-Elektronen reiche cyclische C₁-C₆₀-Gruppe, unsubstituiert oder substituiert mit mindestens einem R₆₁, sind,
Ar₅ und Ar₁₂ in Formel 2 und 3 jeweils unabhängig eine Einfachbindung oder eine π-Elektronen reiche cyclische C₃-C₆₀-Gruppe, die unsubstituiert oder mit mindestens einem R₆₅ substituiert ist, sind, oder sie nicht vorhanden sind, und
Ring CY₂ und Ring CY₃ in Formel 2 jeweils unabhängig eine π-Elektronen reiche cyclische C₃-C₆₀-Gruppe sind.

10. Zusammensetzung nach einem der Ansprüche 1-9, wobei eine Gruppe, dargestellt durch eine von Formel 2-1 bis 2-93: 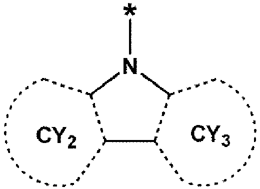 in Formel 2, dargestellt ist durch 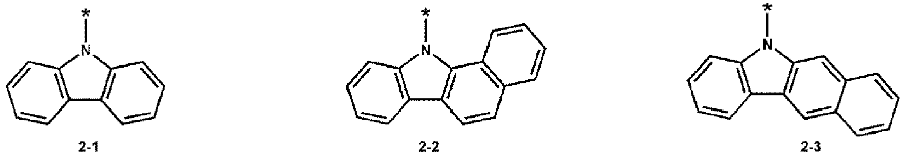 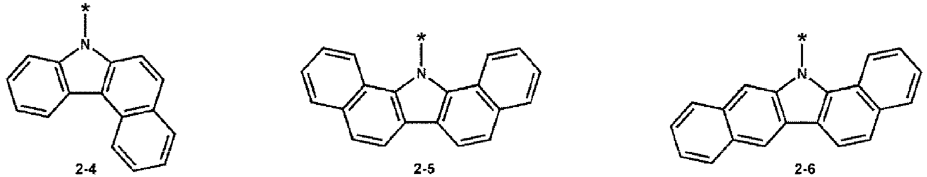 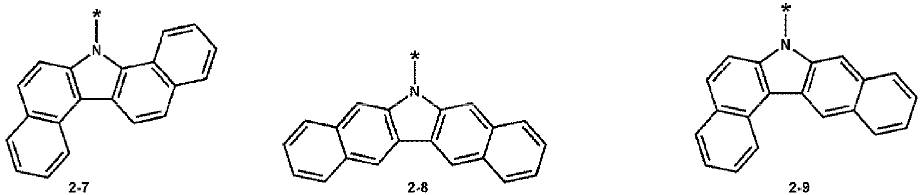 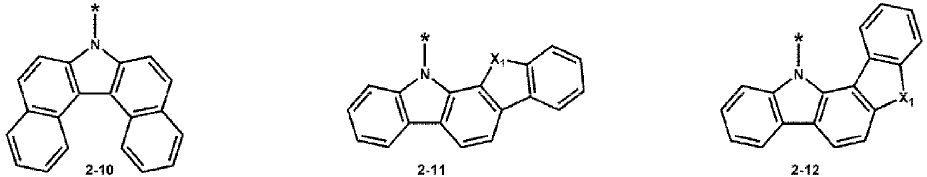 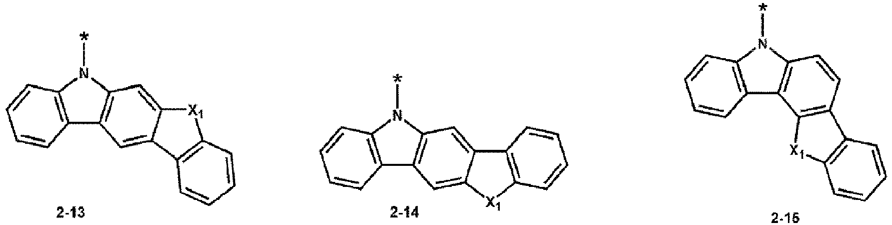 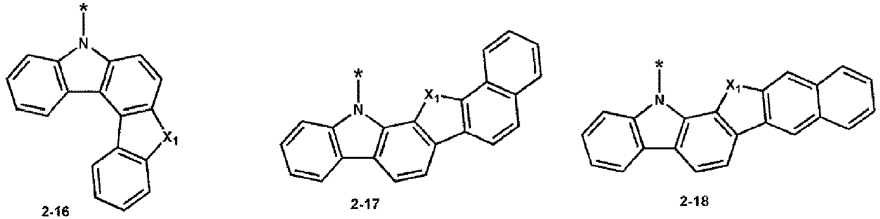 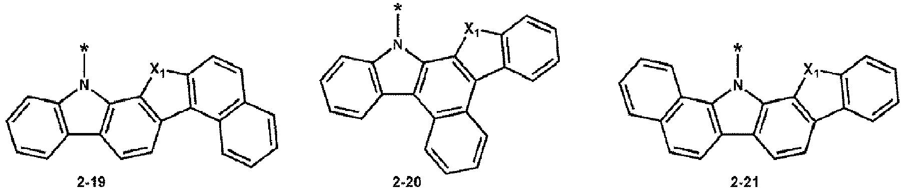 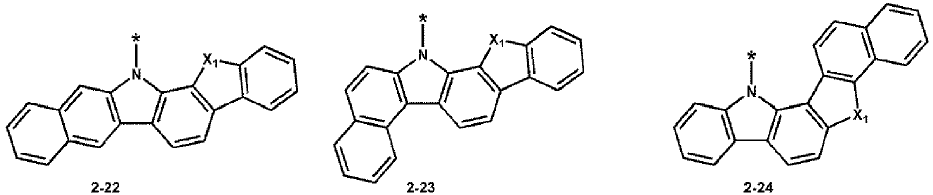 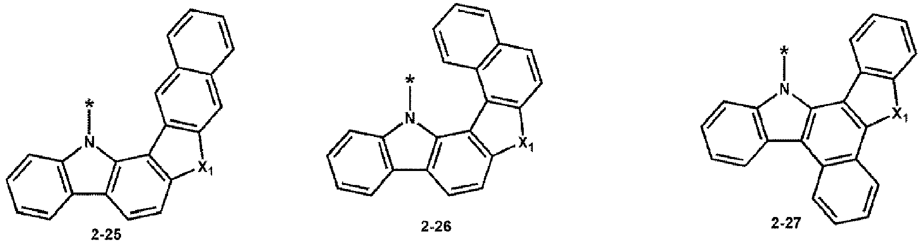 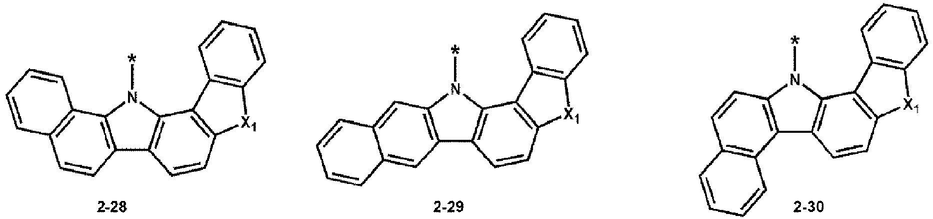 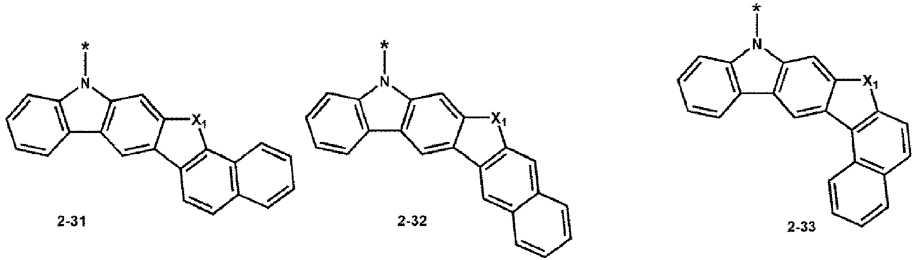 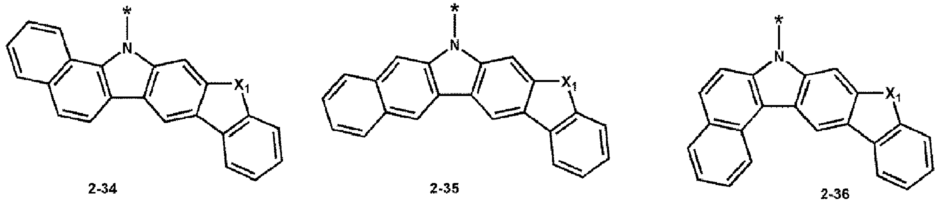 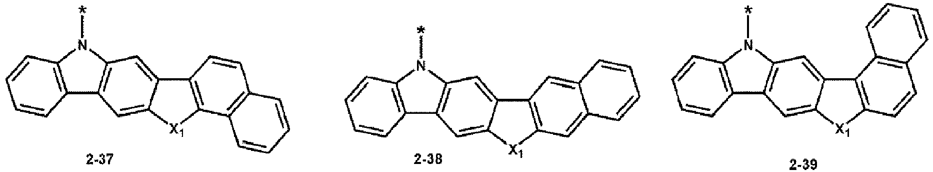 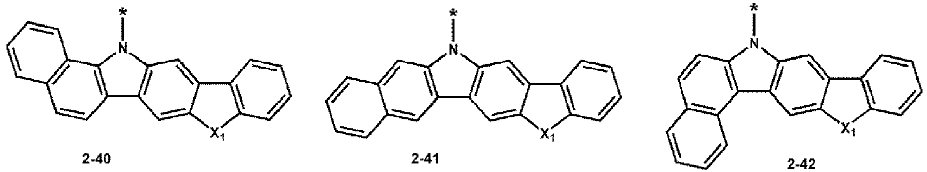 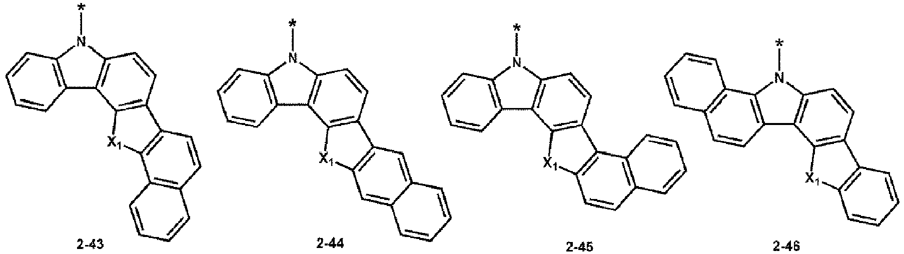 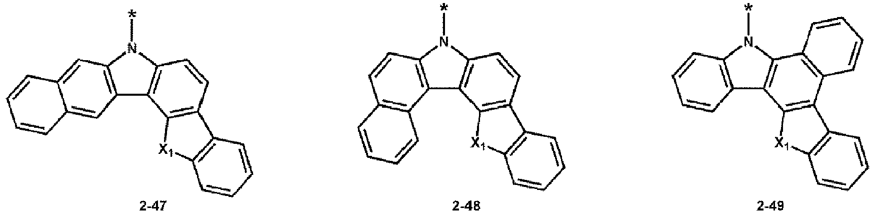 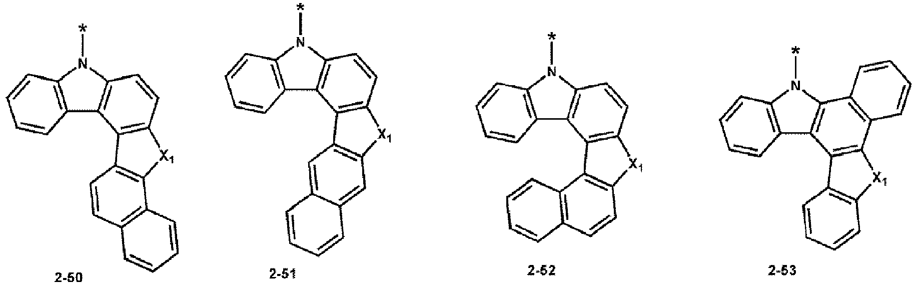 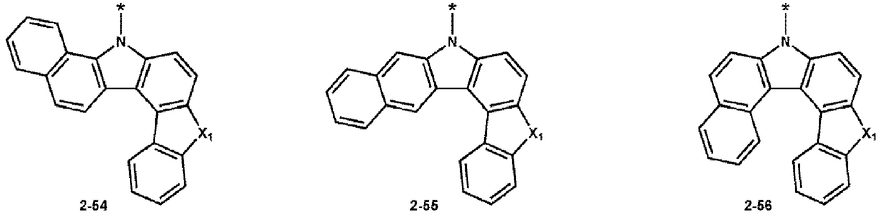 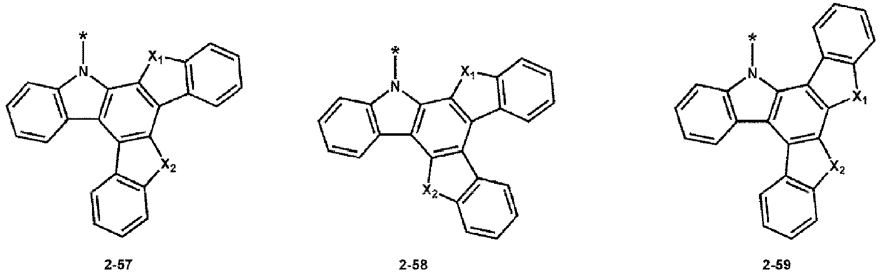 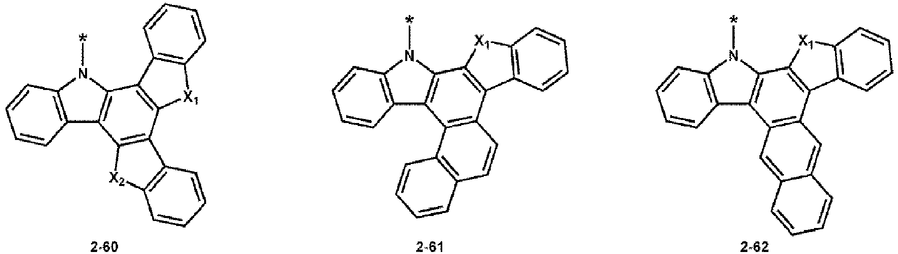 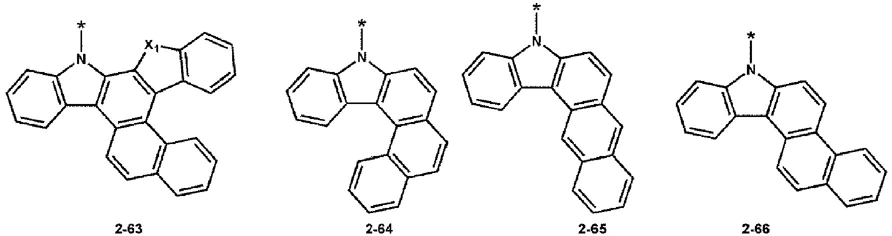 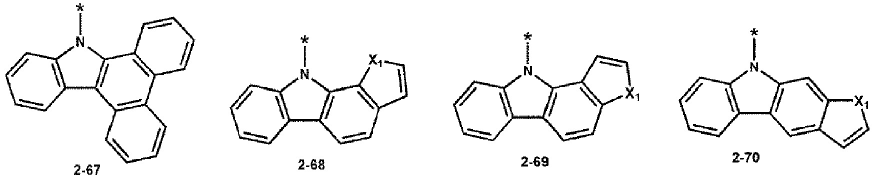 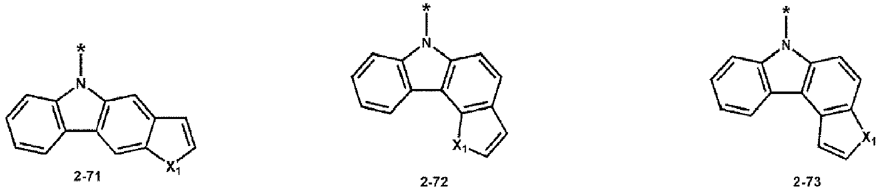 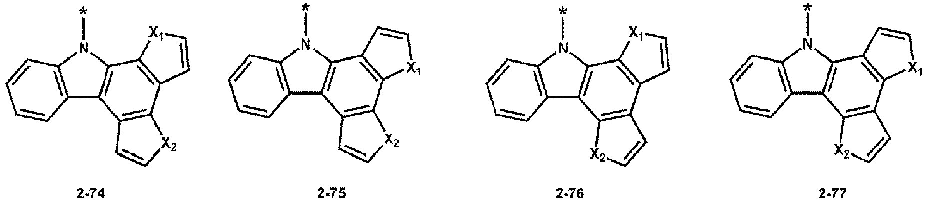 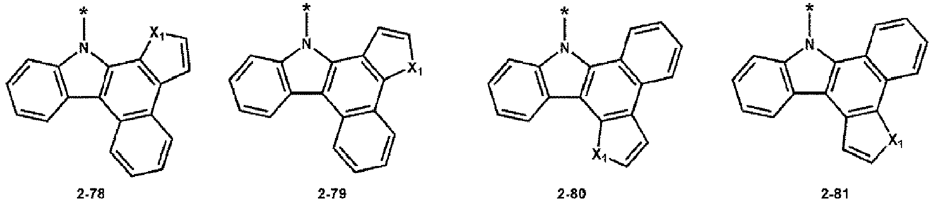 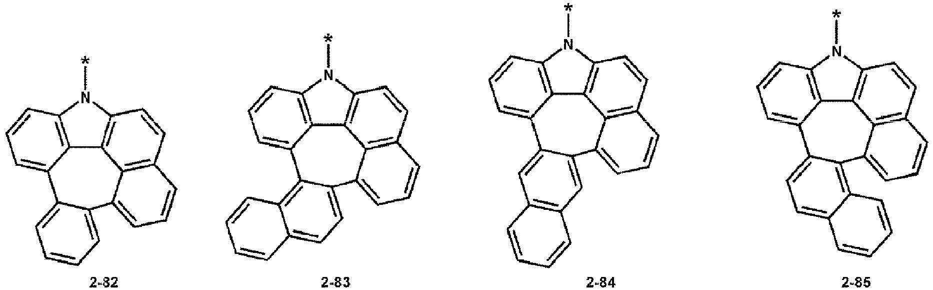 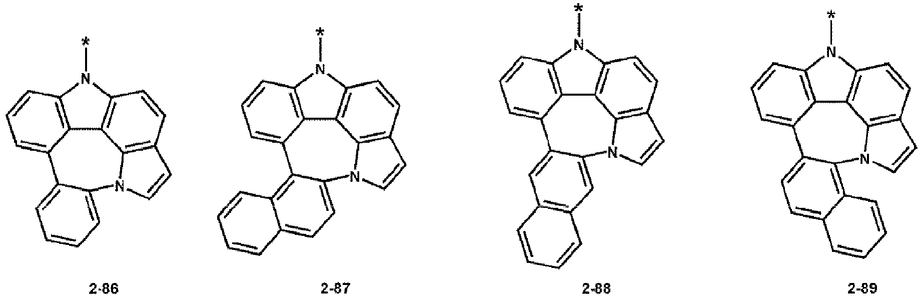 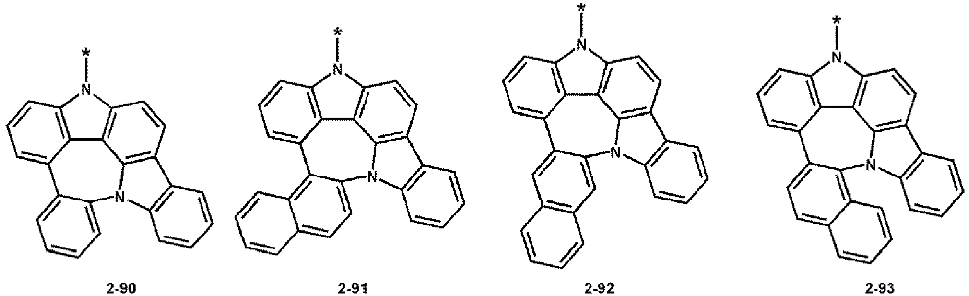
wobei, in Formel 2-1 bis 2-93,
X₁ O, S, N(R₃₁), C(R₃₁)(R₃₂) oder Si(R₃₁)(R₃₂) ist,
X₂ O, S, N(R₃₃), C(R₃₃)(R₃₄) oder Si(R₃₃)(R₃₄) ist,
R₃₁ bis R₃₄ gleich wie beschrieben in Verbindung mit R₃₀ in Anspruch 1 sind, und ^{∗} eine Bindungsstelle an Ar₁ oder Ar₂ in Formel 2 angibt.

11. Zusammensetzung nach einem der Ansprüche 1-10, wobei
Het1 in Formel 3 eine Gruppe ist, abgeleitet von einer von Formel 3-1 bis 3-40: 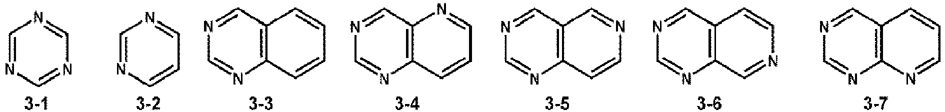 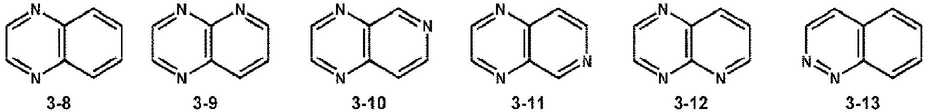 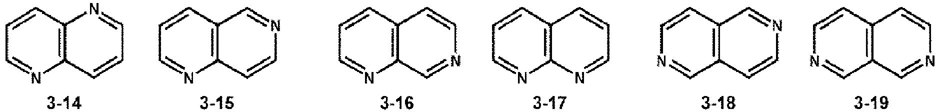 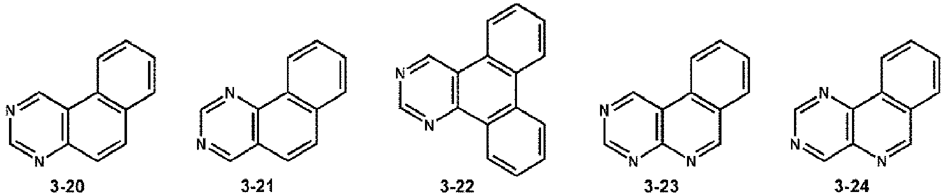 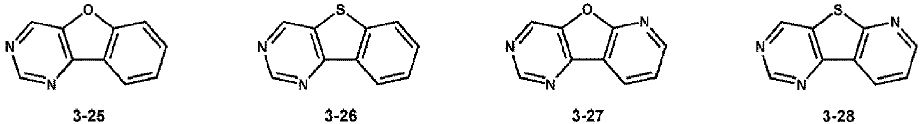 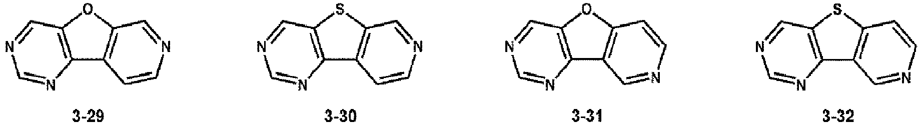 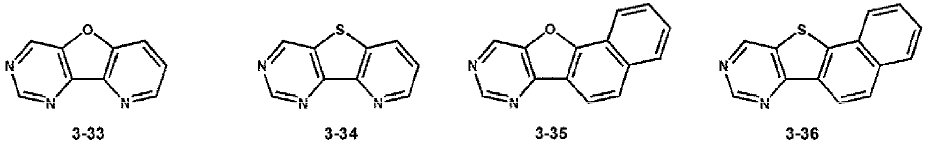 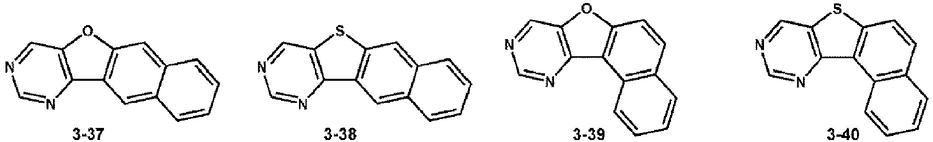
; und/oder
wobei
a11 und m in Formel 3 jeweils unabhängig eine ganze Zahl von 1 bis 3 sind.

12. Zusammensetzung nach einem der Ansprüche 1-11, wobei
R₂₀, R₃₀, R₆₁, R₆₅, R₆₆, R₇₀ und R₈₀ in Formel 2 und 3 jeweils unabhängig wie folgt sind: Wasserstoff oder Deuterium;
eine C₁-C₂₀-Alkylgruppe oder eine C₁-C₂₀-Alkoxygruppe, jeweils unsubstituiert oder substituiert mit Deuterium, eine Phenylgruppe, eine Naphthylgruppe, eine Anthracenylgruppe, eine Phenanthrenylgruppe, eine Triphenylenylgruppe, eine Fluorenylgruppe, eine di(C₁-C₁₀-Alkyl)fluorenylgruppe, eine di(C₆-C₆₀-Aryl)fluorenylgruppe, eine Dibenzosilolylgruppe, eine di(C₁-C₁₀-Alkyl)dibenzosilolylgruppe, eine di(C₆-C₆₀-Aryl)dibenzosilolylgruppe, eine Carbazolylgruppe, eine (C₁-C₁₀-Alkyl)carbazolylgruppe, eine (C₆-C₆₀-Aryl)carbazolylgruppe, eine Dibenzofuranylgruppe, eine Dibenzothiophenylgruppe, eine Biphenylgruppe, eine Terphenylgruppe, -N(Q₃₁)(Q₃₂), oder eine beliebige Kombination davon;
eine π-Elektronen reiche cyclische C₃-C₆₀-Gruppe, unsubstituiert oder substituiert mit Deuterium, eine C₁-C₂₀-Alkylgruppe oder eine C₁-C₂₀-Alkoxygruppe, eine Phenylgruppe, eine Naphthylgruppe, eine Anthracenylgruppe, eine Phenanthrenylgruppe, eine Triphenylenylgruppe, eine Fluorenylgruppe, eine di(C₁-C₁₀-Alkyl)fluorenylgruppe, eine di(C₆-C₆₀-Aryl)fluorenylgruppe, eine Dibenzosilolylgruppe, eine di(C₁-C₁₀-Alkyl)dibenzosilolylgruppe, eine di(C₆-C₆₀-Aryl)dibenzosilolylgruppe, eine Carbazolylgruppe, eine (C₁-C₁₀-Alkyl)carbazolylgruppe, eine (C₆-C₆₀-Aryl)carbazolylgruppe, eine Dibenzofuranylgruppe, eine Dibenzothiophenylgruppe, eine Biphenylgruppe, eine Terphenylgruppe, -N(Q₃₁)(Q₃₂), oder eine beliebige Kombination davon; oder -N(Q₁)(Q₂).

13. Zusammensetzung nach einem der Ansprüche 1-12, wobei
die zweite Verbindung mindestens eine von Verbindung H1-1 bis H1-72 umfasst, und die dritte Verbindung mindestens eine von Verbindung H2-1 bis H2-61 umfasst:

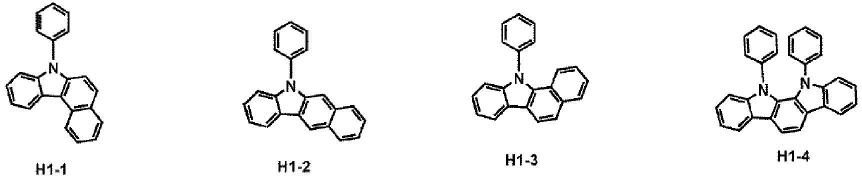

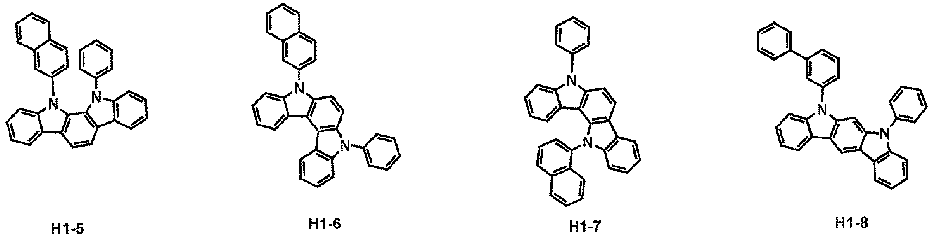

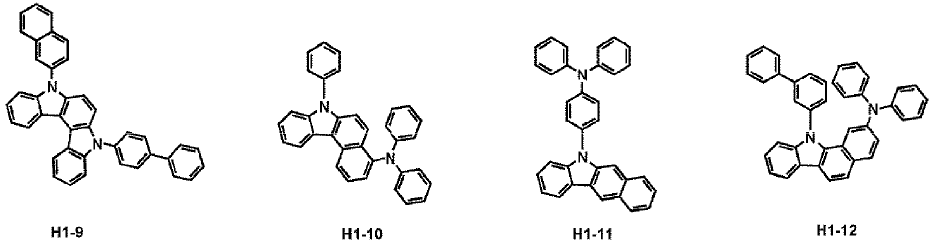

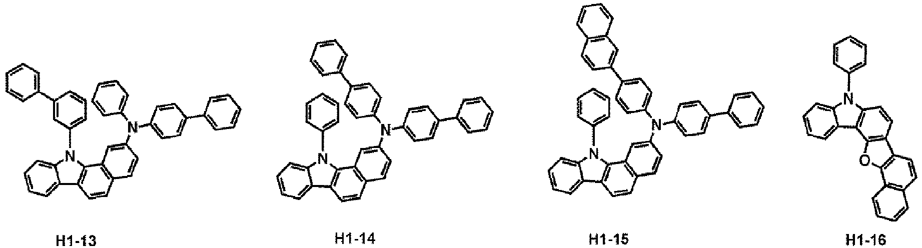

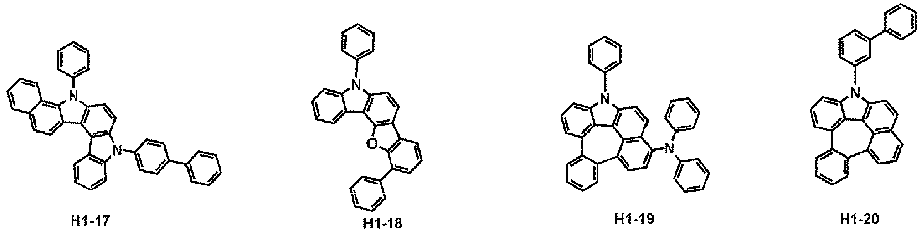

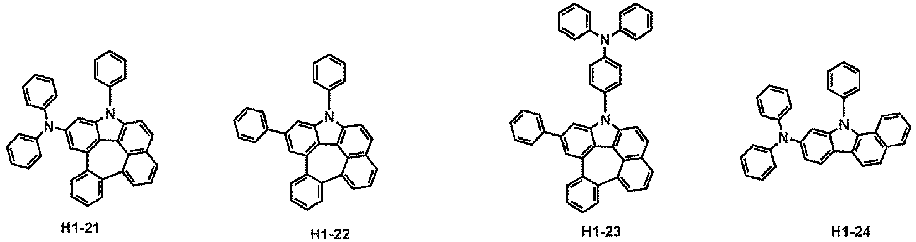

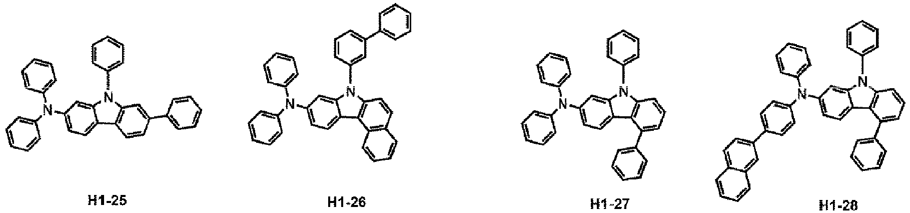

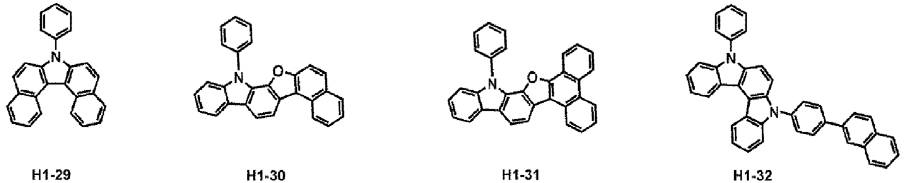

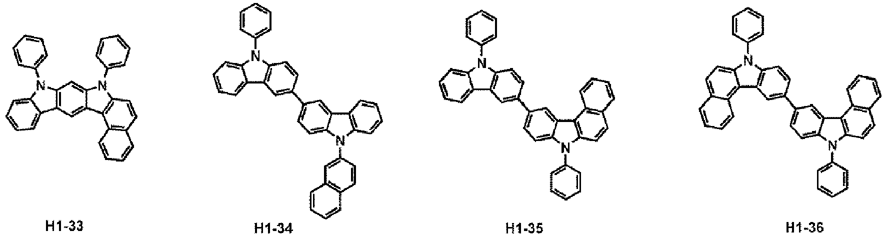

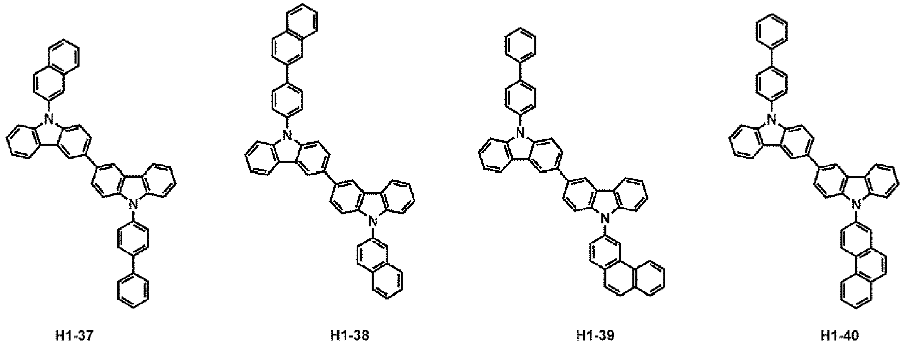

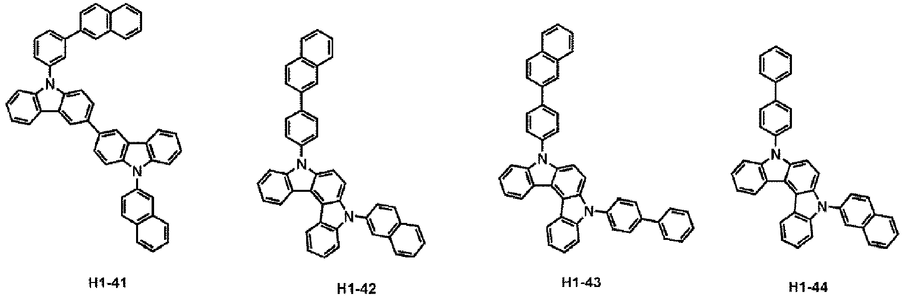

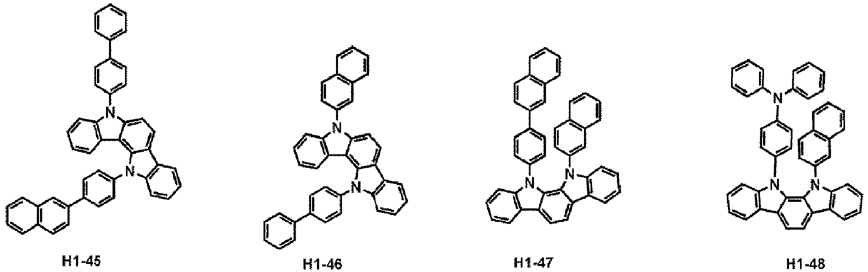

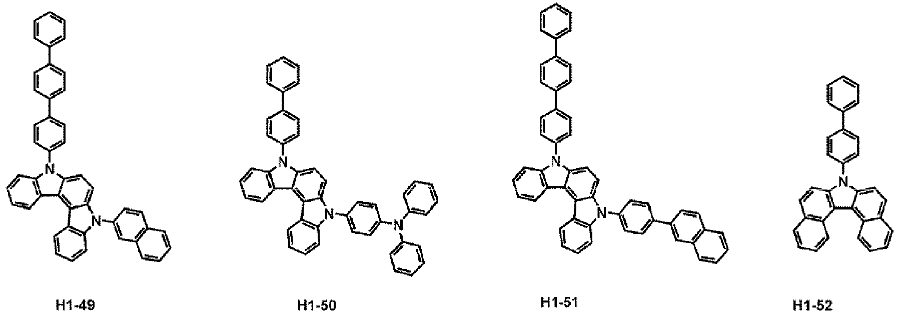

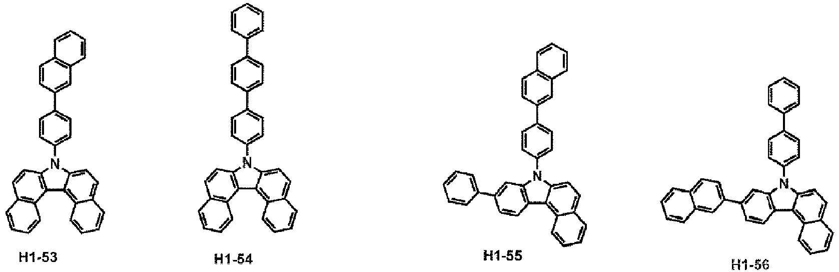

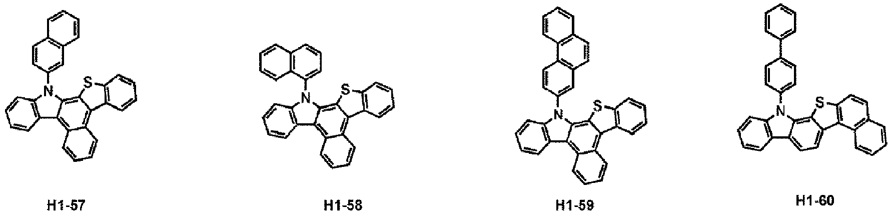

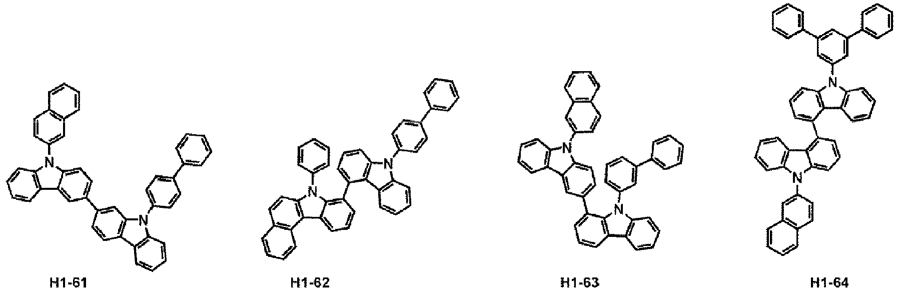

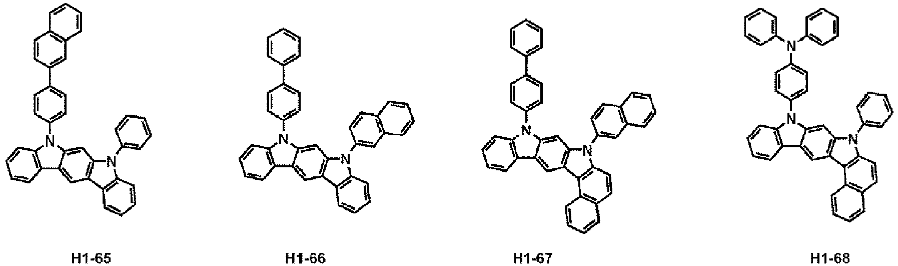

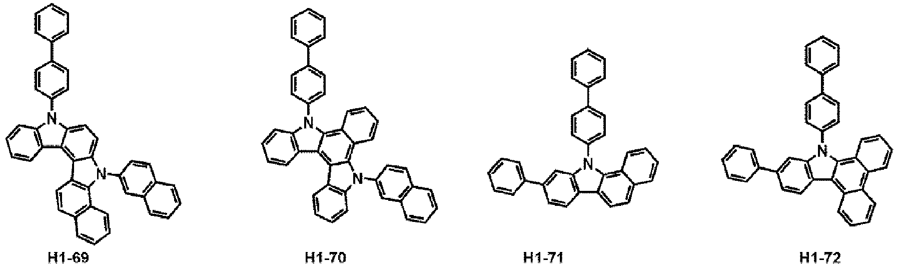

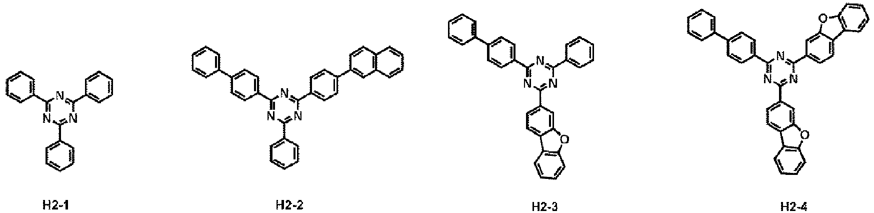

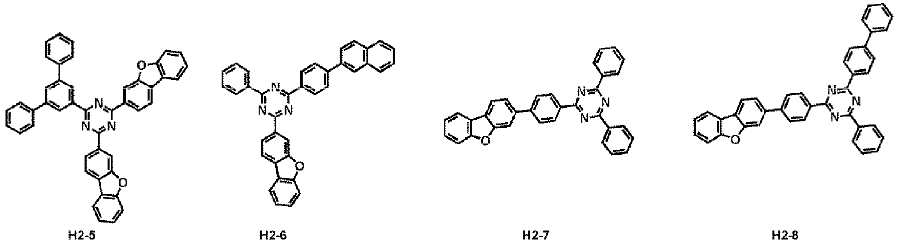

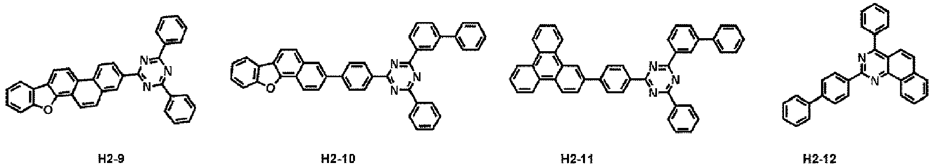

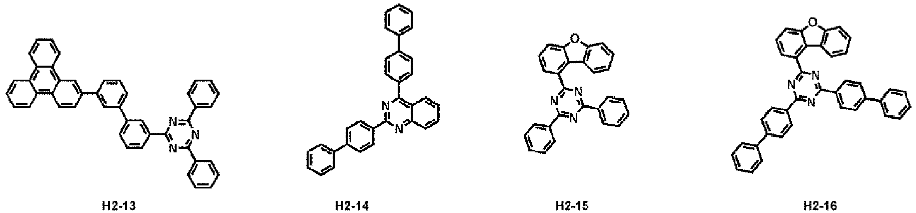

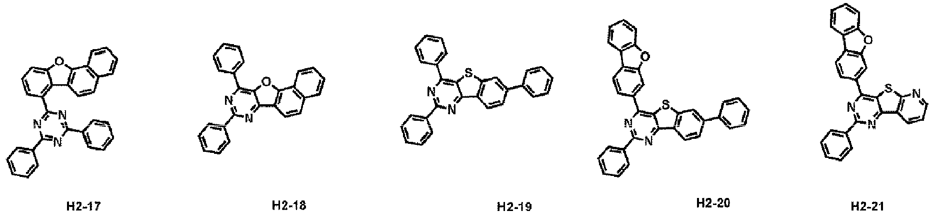

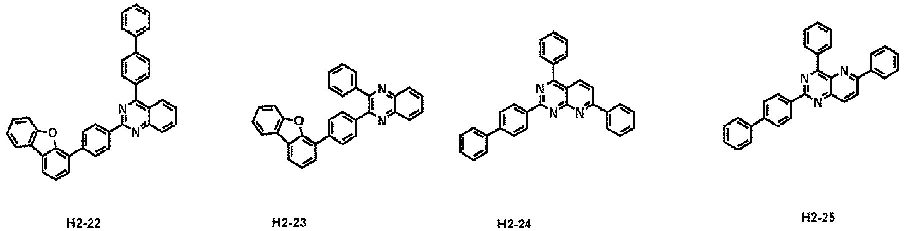

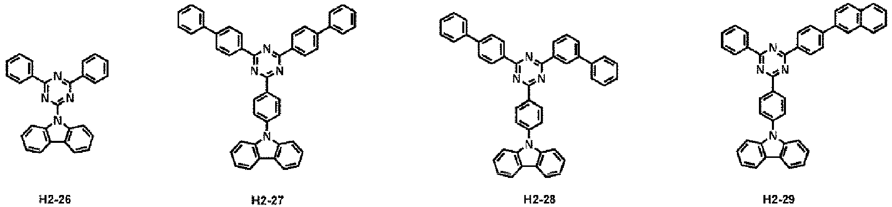

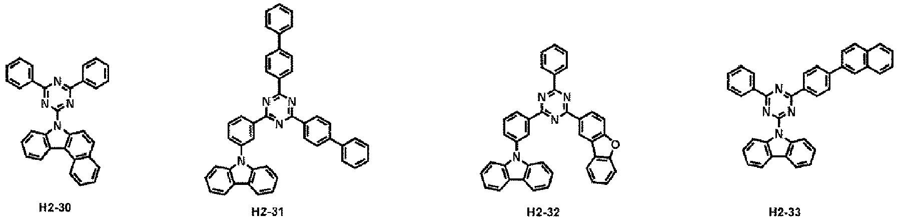

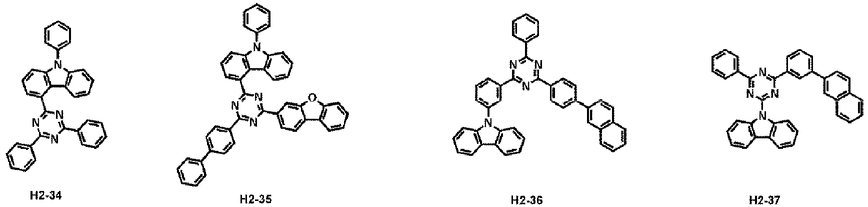

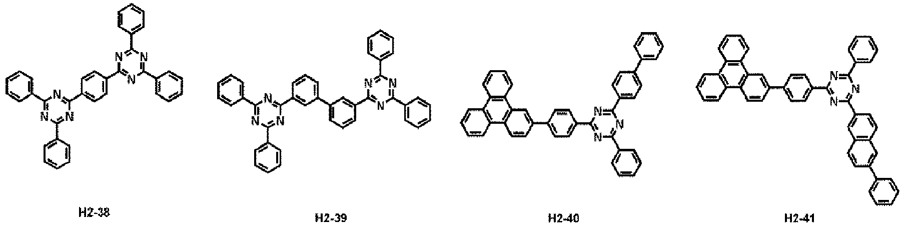

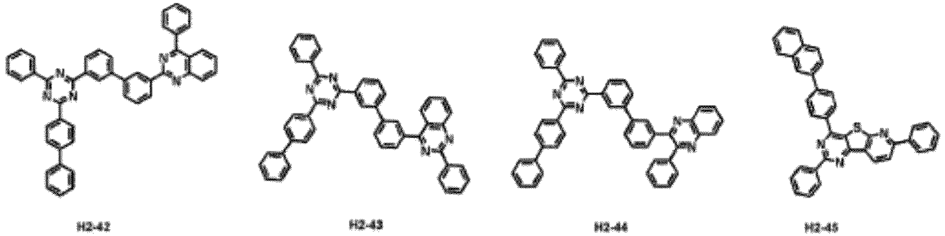

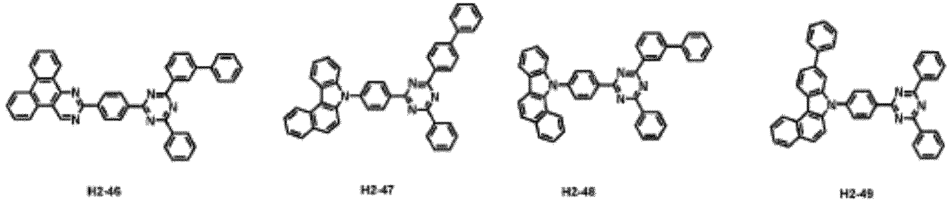

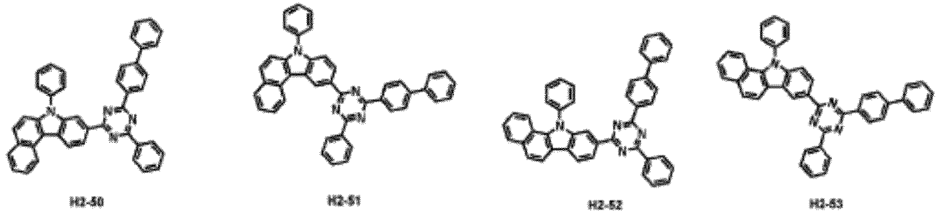

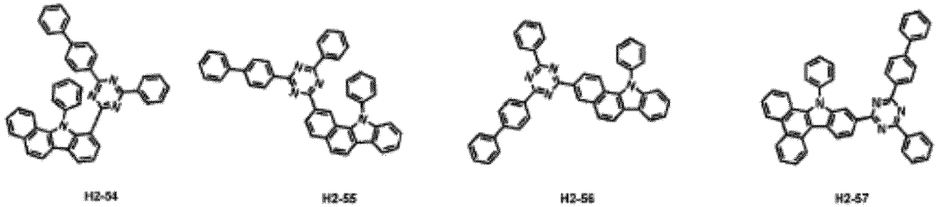

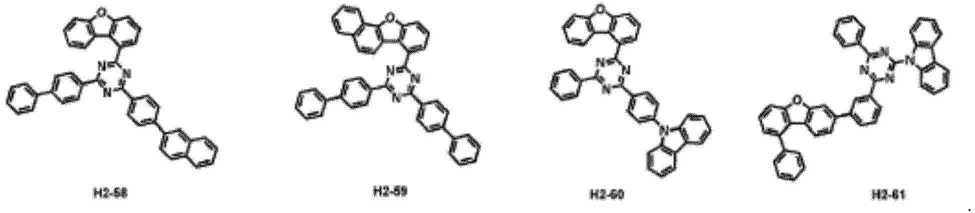

14. Organische lichtemittierende Vorrichtung, umfassend:
eine erste Elektrode;
eine zweite Elektrode; und
eine organische Schicht, die zwischen der ersten Elektrode und der zweiten Elektrode angeordnet ist und umfassend eine Emissionsschicht,
wobei die organische Schicht die Zusammensetzung nach einem der Ansprüche 1-13 umfasst;
vorzugsweise wobei
die erste Elektrode eine Anode ist,
die zweite Elektrode eine Kathode ist,
die organische Schicht ferner einen Lochtransportbereich zwischen der ersten Elektrode und der Emissionsschicht und einen Elektronentransportbereich zwischen der Emissionsschicht und der zweiten Elektrode umfasst,
der Lochtransportbereich eine Lochinjektionsschicht, eine Lochtransportschicht, eine Elektronensperrschicht, eine Pufferschicht oder eine beliebige Kombination davon umfasst, und
der Elektronentransportbereich eine Lochsperrschicht, eine Elektronentransportschicht, eine Elektroneninjektionsschicht oder eine beliebige Kombination davon umfasst.

15. Organische lichtemittierende Vorrichtung nach Anspruch 14, wobei
die Emissionsschicht die Zusammensetzung nach einem der Ansprüche 1-13 umfasst; und/oder
wobei
die Emissionsschicht vorzugsweise rotes Licht emittiert.

## Revendications

1. Composition comprenant :
un premier composé, un deuxième composé et un troisième composé, ledit premier composé comprenant un composé représenté par la formule 1, ledit deuxième composé comprenant un composé représenté par la formule 2 et ledit troisième composé comprenant un composé représenté par la formule 3 : 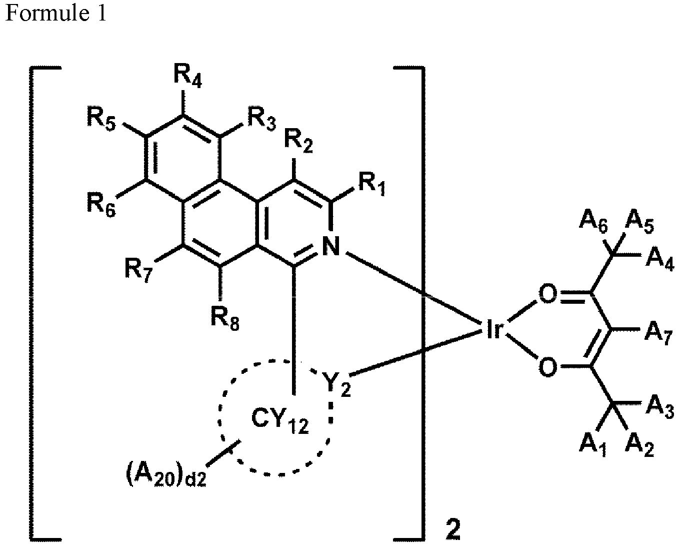 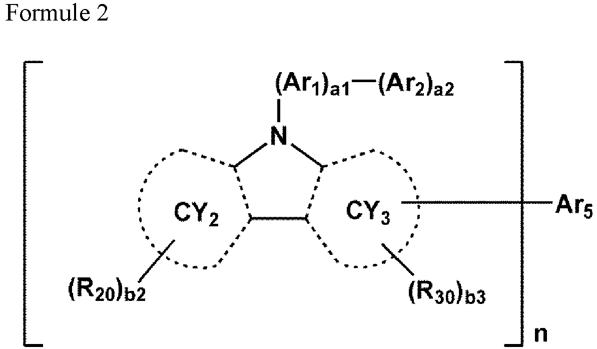 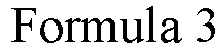 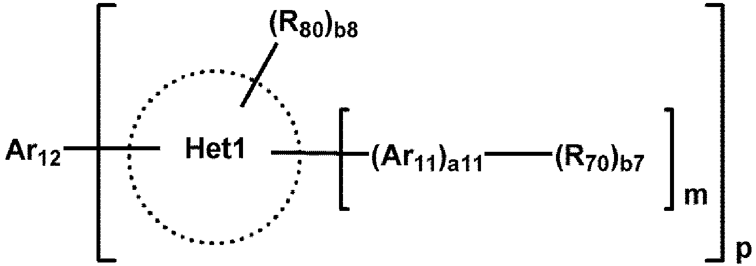
dans lesquelles,
Y₂ dans la formule 1 représente un atome C,
le noyau CY₁₂ dans la formule 1 représente un groupe C₅-C₆₀ carbocyclique ou un groupe C₁-C₆₀ hétérocyclique,
Ar₁, Ar₂ et Ar₁₁ dans les formules 2 et 3 représentent chacun indépendamment un groupe C₅-C₆₀ carbocyclique qui est non substitué ou substitué par au moins un groupe R₆₁ ou un groupe C₁-C₆₀ hétérocyclique qui est non substitué ou substitué par au moins un groupe R₆₁,
Ar₅ et A₁₂ dans les formules 2 et 3 représentent chacun indépendamment une liaison simple, un groupe C₅-C₆₀ carbocyclique qui est non substitué ou substitué par au moins un groupe R₆₅, ou un groupe C₁-C₆₀ hétérocyclique qui est non substitué ou substitué par au moins un groupe R₆₅, ou n'existent pas,
n dans la formule 2 vaut 1, 2 ou 3, et lorsque n vaut 1, Ar₅ n'existe pas,
p dans la formule 3 vaut 1, 2 ou 3, et lorsque p vaut 1, Ar₁₂ n'existe pas,
a1 et a2 dans la formule 2 représentent chacun indépendamment un entier valant de 0 à 5, et la somme de a1 et a2 vaut 1 ou plus,
le noyau CY₂ et le noyau CY₃ dans la formule 2 représentent chacun indépendamment un groupe C₅-C₆₀ carbocyclique ou un groupe C₁-C₆₀ hétérocyclique, et le noyau CY₂ et le noyau CY₃ sont éventuellement liés l'un à l'autre avec un groupe C₅-C₆₀ carbocyclique qui est non substitué ou substitué par au moins un groupe R₆₆ ou un groupe C₁-C₆₀ hétérocyclique qui est non substitué ou substitué par au moins un groupe R₆₆ entre eux,
Het1 dans la formule 3 représente un groupe C₁-C₆₀ cyclique contenant de l'azote appauvri en électrons π,
a11 et m dans la formule 3 représentent chacun indépendamment un entier valant de 1 à 10,
R₁ à R₈, A₂₀, A₁ à A₇, R₂₀, R₃₀, R₆₁, R₆₅, R₆₆, R₇₀ et R₈₀ dans les formules 1 à 3 représentent chacun indépendamment un atome d'hydrogène, un atome de deutérium, un groupe -F, -Cl, -Br, - I, -SF₅, un groupe hydroxy, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe C₁-C₆₀ alkyle substitué ou non substitué, un groupe C₂-C₆₀ alcényle substitué ou non substitué, un groupe C₂-C₆₀ alcynyle substitué ou non substitué, un groupe C₁-C₆₀ alcoxy substitué ou non substitué, un groupe C₃-C₁₀ cycloalkyle substitué ou non substitué, un groupe C₂-C₁₀ hétérocycloalkyle substitué ou non substitué, un groupe C₃-C₁₀ cycloalcényle substitué ou non substitué, un groupe C₂-C₁₀ hétérocycloalcényle substitué ou non substitué, un groupe C₆-C₆₀ aryle substitué ou non substitué, un groupe C₆-C₆₀ aryloxy substitué ou non substitué, un groupe C₆-C₆₀ arylthio substitué ou non substitué, un groupe C₁-C₆₀ hétéroaryle substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅), -Ge(Q₃)(Q₄)(Q₅), -B(Q₆)(Q₇), -P(=O)(Q₈)(Q₉) ou -P(Q₈)(Q₉),
b2, b3, b7 et b8 dans les formules 2 et 3 représentent chacun indépendamment un entier valant de 0 à 20, lorsque b2 vaut 2 ou plus, deux groupes R₂₀ ou plus sont identiques les uns aux autres ou différents les uns des autres, lorsque b3 vaut 2 ou plus, deux groupes R₃₀ ou plus sont identiques les uns aux autres ou différents les uns des autres, lorsque b7 vaut 2 ou plus, deux groupes R₇₀ ou plus sont identiques les uns aux autres ou différents les uns des autres, et lorsque b8 vaut 2 ou plus, deux groupes R₈₀ ou plus sont identiques les uns aux autres ou différents les uns des autres,
d2 dans la formule 1 représente un entier valant de 0 à 10, et lorsque d2 vaut 2 ou plus, deux groupes A₂₀ ou plus sont identiques les uns aux autres ou différents les uns des autres,
au moins l'un des groupes R₁ à R₈, A₂₀, ou toute combinaison de ceux-ci comprend au moins un groupe fluoro (-F),
deux groupes ou plus parmi R₁ à R₈ et A₂₀ dans la formule 1 sont éventuellement liés pour former un groupe C₅-C₆₀ carbocyclique qui est non substitué ou substitué par au moins un groupe R₁ₐ ou un groupe C₁-C₆₀ hétérocyclique qui est non substitué ou substitué par au moins un groupe R₁ₐ,
deux groupes ou plus parmi A₁ à A₇ dans la formule 1 sont éventuellement liés pour former un groupe C₅-C₆₀ carbocyclique qui est non substitué ou substitué par au moins un groupe R₁ₐ ou un groupe C₁-C₆₀ hétérocyclique qui est non substitué ou substitué par au moins un groupe R₁ₐ,
deux groupes ou plus parmi le noyau CY₂, le noyau CY₃, les groupes R₂₀ et R₃₀ dans la formule 2 sont éventuellement liés pour former un groupe C₅-C₆₀ carbocyclique qui est non substitué ou substitué par au moins un groupe R₁ₐ ou un groupe C₁-C₆₀ hétérocyclique qui est non substitué ou substitué par au moins un groupe R₁ₐ,
R₁ₐ est compris en se référant à la description de A₇ fournie ci-dessus, et
un substituant du groupe C₁-C₆₀ alkyle substitué, du groupe C₂-C₆₀ alcényle substitué, du groupe C₂-C₆₀ alcynyle substitué, du groupe C₁-C₆₀ alcoxy substitué, du groupe C₃-C₁₀ cycloalkyle substitué, du groupe C₂-C₁₀ hétérocycloalkyle substitué, du groupe C₃-C₁₀ cycloalcényle substitué, du groupe C₂-C₁₀ hétérocycloalcényle substitué, du groupe C₆-C₆₀ aryle substitué, du groupe C₆-C₆₀ aryloxy substitué, du groupe C₆-C₆₀ arylthio substitué, du groupe C₁-C₆₀ hétéroaryle substitué, du groupe polycyclique condensé non aromatique monovalent substitué, et du groupe hétéropolycyclique condensé non aromatique monovalent substitué représente :
un atome de deutérium, un groupe -F, -Cl, -Br, -I, -CD₃, -CD₂H, -CDH₂, -CF₃, -CF₂H, - CFH₂, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₆₀ alkyle, un groupe C₂-C₆₀ alcényle, un groupe C₂-C₆₀ alcynyle ou un groupe C₁-C₆₀ alcoxy ;
un groupe C₁-C₆₀ alkyle, un groupe C₂-C₆₀ alcényle, un groupe C₂-C₆₀ alcynyle, ou un groupe C₁-C₆₀ alcoxy, chacun substitué par un atome de deutérium, un groupe -F, -Cl, -Br, -I, - CD₃, -CD₂H, -CDH₂, -CF₃, - CF₂H, -CFH₂, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₃-C₁₀ cycloalkyle, un groupe C₂-C₁₀ hétérocycloalkyle, un groupe C₃-C₁₀ cycloalcényle, un groupe C₂-C₁₀ hétérocycloalcényle, un groupe C₆-C₆₀ aryle, un groupe C₆-C₆₀ aryloxy, un groupe C₆-C₆₀ arylthio, un groupe C₁-C₆₀ hétéroaryle, un groupe polycyclique condensé non aromatique monovalent, un groupe hétéropolycyclique condensé non aromatique monovalent, -N(Q₁₁)(Q₁₂), -Si(Q₁₃)(Q₁₄)(Q₁₅),-Ge(Q₁₃)(Q₁₄)(Q₁₅), -B(Q₁₆)(Q₁₇), -P(=O)(Q₁₈)(Q₁₉), -P(Q₁₈)(Q₁₉), ou toute combinaison de ceux-ci ;
un groupe C₃-C₁₀ cycloalkyle, un groupe C₂-C₁₀ hétérocycloalkyle, un groupe C₃-C₁₀ cycloalcényle, un groupe C₂-C₁₀ hétérocycloalcényle, un groupe C₆-C₆₀ aryle, un groupe C₆-C₆₀ aryloxy, un groupe C₆-C₆₀ arylthio, un groupe C₁-C₆₀ hétéroaryle, un groupe polycyclique condensé non aromatique monovalent, ou un groupe hétéropolycyclique condensé non aromatique monovalent, chacun non substitué ou substitué par un atome de deutérium, un groupe -F, -Cl, -Br, -I, -CD₃, -CD₂H, -CDH₂, -CF₃, - CF₂H, -CFH₂, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₆₀ alkyle, un groupe C₂-C₆₀ alcényle, un groupe C₂-C₆₀ alcynyle, un groupe C₁-C₆₀ alcoxy, un groupe C₃- C₁₀ cycloalkyle, un groupe C₂-C₁₀ hétérocycloalkyle, un groupe C₃-C₁₀ cycloalcényle, un groupe C₂-C₁₀ hétérocycloalcényle, un groupe C₆-C₆₀ aryle, un groupe C₆-C₆₀ aryloxy, un groupe C₆-C₆₀ arylthio, un groupe C₁-C₆₀ hétéroaryle, un groupe polycyclique condensé non aromatique monovalent, un groupe hétéropolycyclique condensé non aromatique monovalent, -N(Q₂₁)(Q₂₂),-Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), -P(Q₂₈)(Q₂₉), ou toute combinaison de ceux-ci ;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), P(=O)(Q₃₈)(Q₃₉) ou - P(Q₃₈)(Q₃₉) ; ou toute combinaison de ceux-ci,
Q₁ à Q₉, Q₁₁ à Q₁₉, Q₂₁ à Q₂₉, et Q₃₁ à Q₃₉ représentant chacun indépendamment un atome d'hydrogène; un atome de deutérium ; un groupe -F ; -Cl ; -Br ; -I ; un groupe hydroxy ; un groupe cyano ; un groupe nitro ; un groupe amidino ; un groupe hydrazine ; un groupe hydrazone ; un groupe acide carboxylique ou un sel de celui-ci ; un groupe acide sulfonique ou un sel de celui-ci ; un groupe acide phosphorique ou un sel de celui-ci ; un groupe C₁-C₆₀ alkyle, non substitué ou substitué par un atome de deutérium, un groupe C₁-C₆₀ alkyle, un groupe C₆-C₆₀ aryle, ou toute combinaison de ceux-ci ; un groupe C₂-C₆₀ alcényle ; un groupe C₂-C₆₀ alcynyle ; un groupe C₁-C₆₀ alcoxy ; un groupe C₃-C₁₀ cycloalkyle ; un groupe C₂-C₁₀ hétérocycloalkyle ; un groupe C₃-C₁₀ cycloalcényle ; un groupe C₂-C₁₀ hétérocycloalcényle ; un groupe C₆-C₆₀ aryle, non substitué ou substitué par un atome de deutérium, un groupe C₁-C₆₀ alkyle, un groupe C₆-C₆₀ aryle, ou toute combinaison de ceux-ci ; un groupe C₆-C₆₀ aryloxy ; un groupe C₆-C₆₀ arylthio ; un groupe C₁-C₆₀ hétéroaryle; un groupe polycyclique condensé non aromatique monovalent ; ou un groupe hétéropolycyclique condensé non aromatique monovalent.

2. Composition selon la revendication 1,
le noyau CY₁₂ dans la formule 1 représentant un groupe benzène, un groupe naphtalène, un groupe 1,2,3,4-tétrahydronaphtalène, un groupe thiophène, un groupe furane, un groupe pyrrole, un groupe cyclopentadiène, un groupe silole, un groupe benzothiophène, un groupe benzofurane, un groupe indole, un groupe indène, un groupe benzosilole, un groupe dibenzothiophène, un groupe dibenzofurane, un groupe carbazole, un groupe fluorène ou un groupe dibenzosilole.

3. Composition selon la revendication 1 ou 2,
R₁ à R₈ et A₁ à A₇ représentant chacun indépendamment :
un atome d'hydrogène, un atome de deutérium ou un groupe -F ;
un groupe C₁-C₂₀ alkyle, un groupe C₃-C₁₀ cycloalkyle, un groupe C₂-C₁₀ hétérocycloalkyle ou un groupe phényle, chacun non substitué ou substitué par un atome de deutérium, un groupe -F, un groupe C₁-C₂₀ alkyle, un groupe C₃-C₁₀ cycloalkyle, un groupe C₂-C₁₀ hétérocycloalkyle, un groupe phényle, ou toute combinaison de ceux-ci ; ou
-Si(Q₃)(Q₄)(Q₅) ou -Ge(Q₃)(Q₄)(Q₅), et
A₂₀ dans la formule 1 représentant :
un atome d'hydrogène ou de deutérium ;
un groupe C₁-C₂₀ alkyle, un groupe C₃-C₁₀ cycloalkyle, un groupe C₂-C₁₀ hétérocycloalkyle ou un groupe phényle, chacun non substitué ou substitué par un atome de deutérium, un groupe C₁-C₂₀ alkyle, un groupe C₃-C₁₀ cycloalkyle, un groupe C₂-C₁₀ hétérocycloalkyle, un groupe phényle, ou toute combinaison de ceux-ci ; ou
-Si(Q₃)(Q₄)(Q₅) ou -Ge(Q₃)(Q₄)(Q₅).

4. Composition selon l'une quelconque des revendications 1 à 3,
au moins l'un des groupes R₁ à R₈ dans la formule 1 représentant indépendamment :
un groupe fluoro (-F) ; ou
un groupe C₁-C₂₀ alkyle fluoré, un groupe C₃-C₁₀ cycloalkyle fluoré, un groupe C₂-C₁₀ hétérocycloalkyle fluoré, ou un groupe phényle fluoré, chacun non substitué ou substitué par un atome de deutérium, un groupe C₁-C₂₀ alkyle, un groupe C₃-C₁₀ cycloalkyle, un groupe C₂-C₁₀ hétérocycloalkyle, un groupe phényle, ou toute combinaison de ceux-ci.

5. Composition selon l'une quelconque des revendications 1 à 4,
au moins l'un des groupes A₁ à A₆ dans la formule 1 représentant chacun indépendamment un groupe C₂-C₆₀ alkyle substitué ou non substitué, un groupe C₃-C₁₀ cycloalkyle substitué ou non substitué, ou
un groupe C₂-C₁₀ hétérocycloalkyle substitué ou non substitué ; et/ou
A₁ à A₆ représentant chacun indépendamment un groupe C₁-C₆₀ alkyle substitué ou non substitué, un groupe C₃-C₁₀ cycloalkyle substitué ou non substitué, ou un groupe C₂-C₁₀ hétérocycloalkyle substitué ou non substitué.

6. Composition selon l'une quelconque des revendications 1 à 5, un groupe représenté par 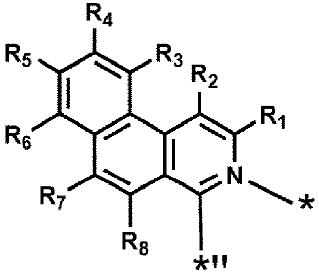 dans la formule 1 étant un groupe représenté par l'une des formules CY1 à CY108 : 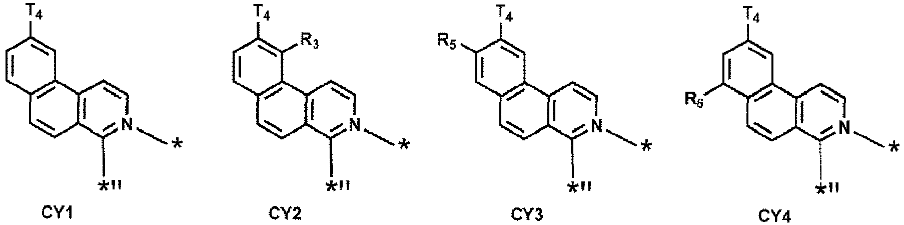 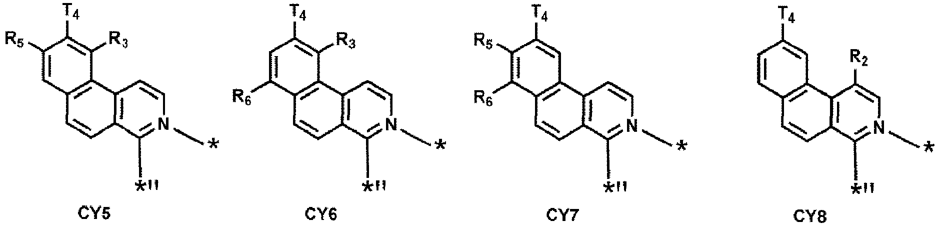 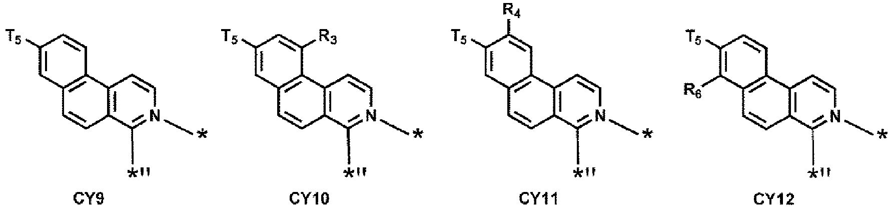 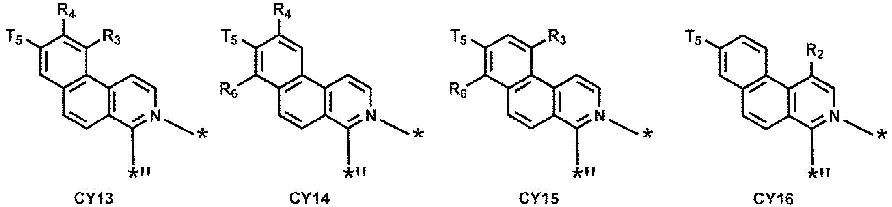 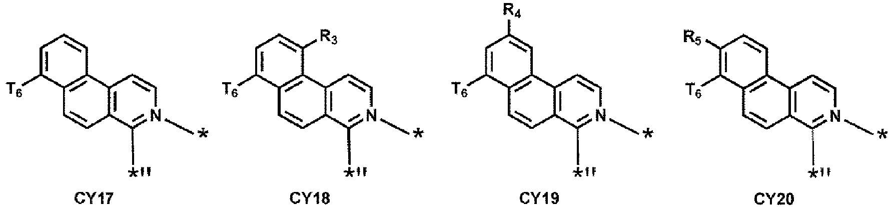 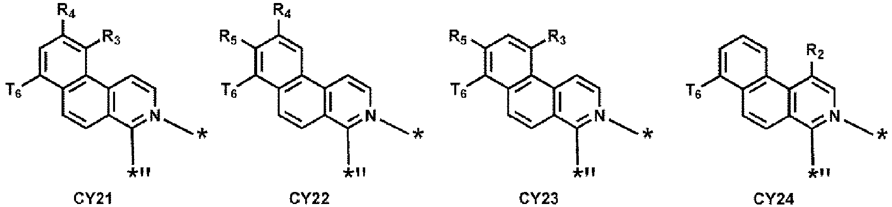 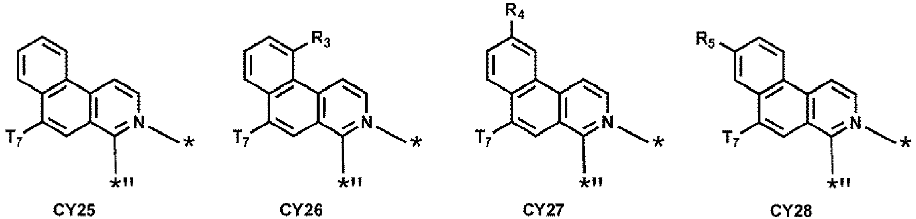 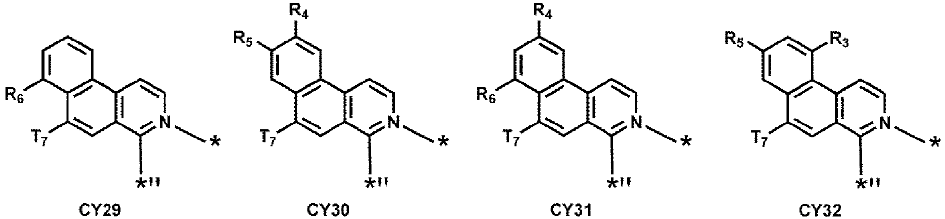 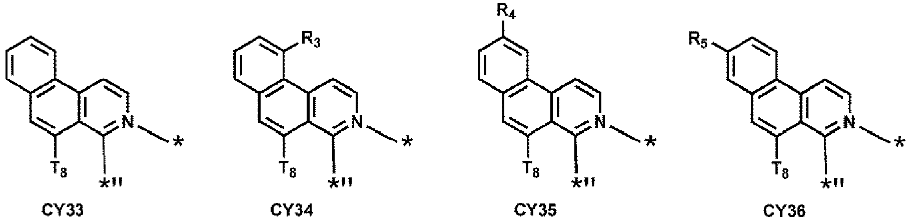 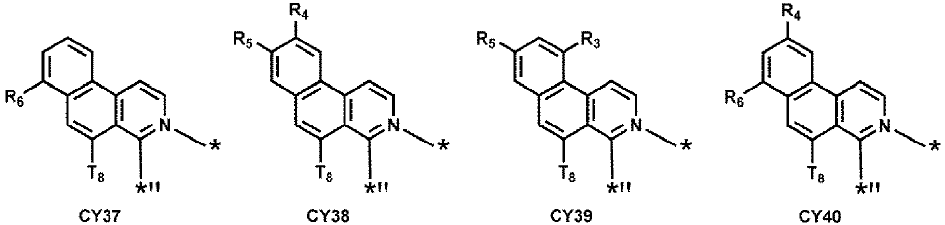 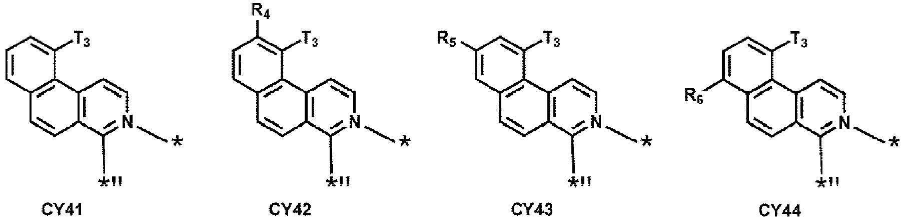 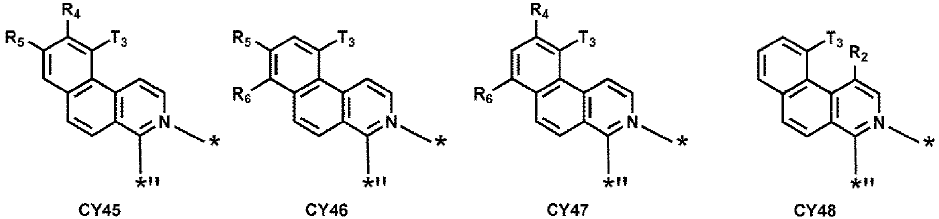 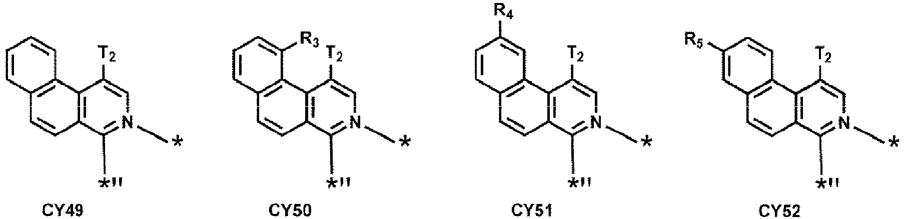 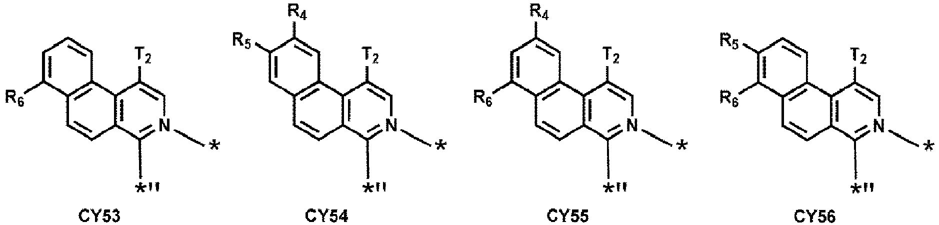 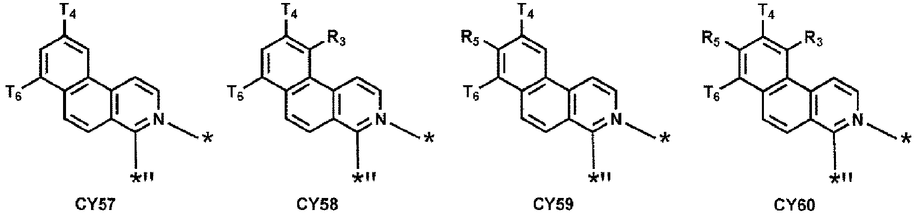 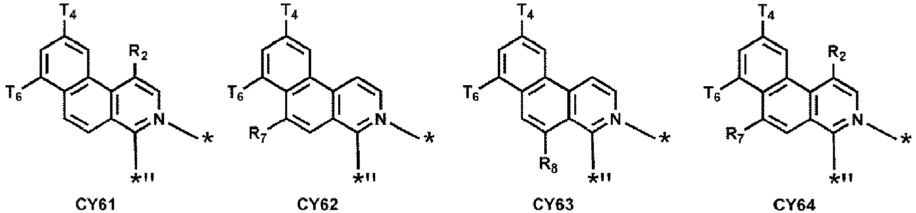 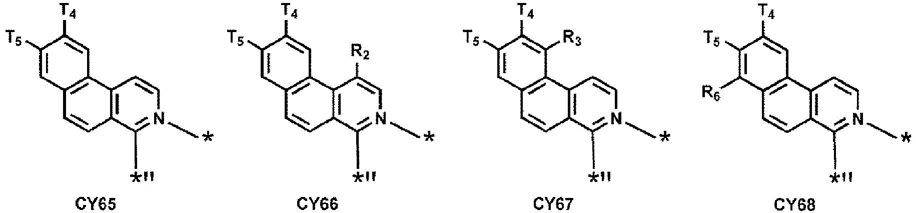 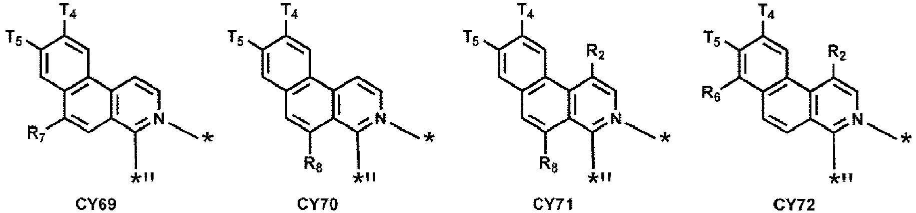 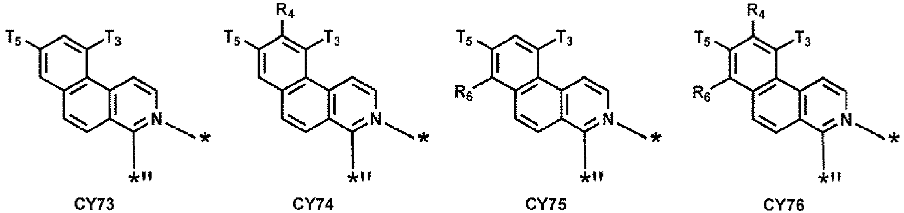 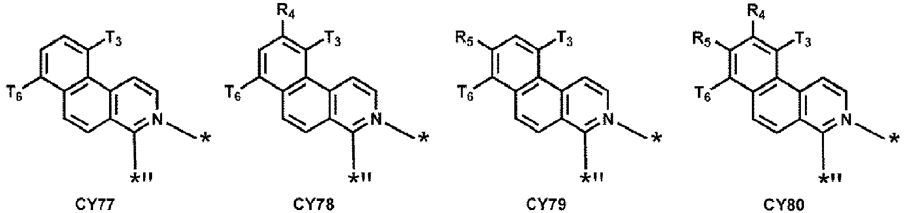 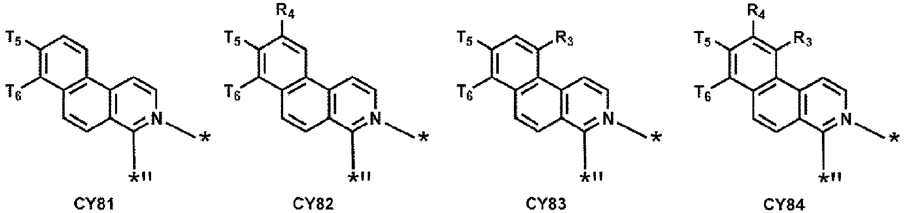 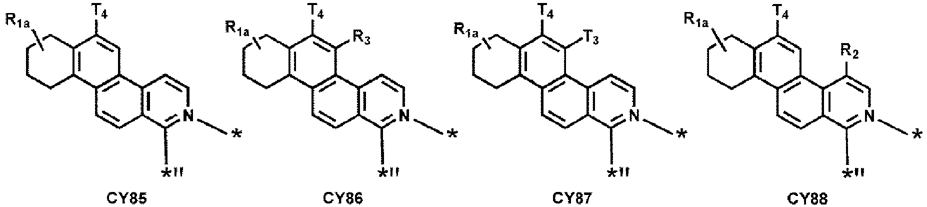 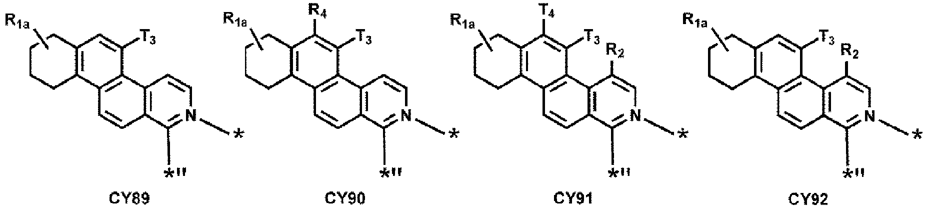 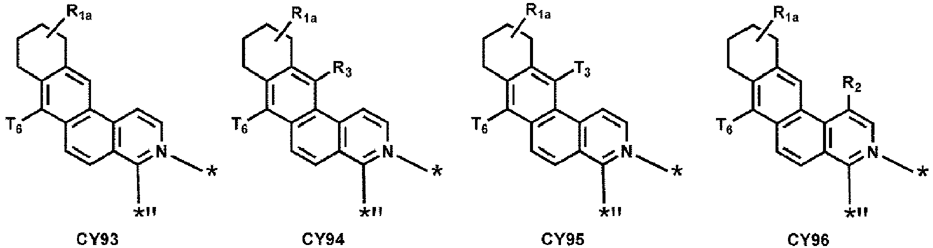 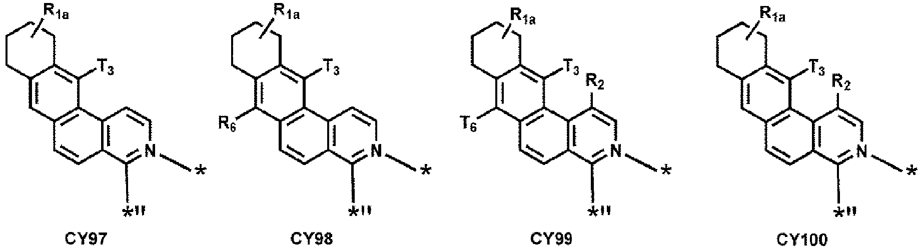 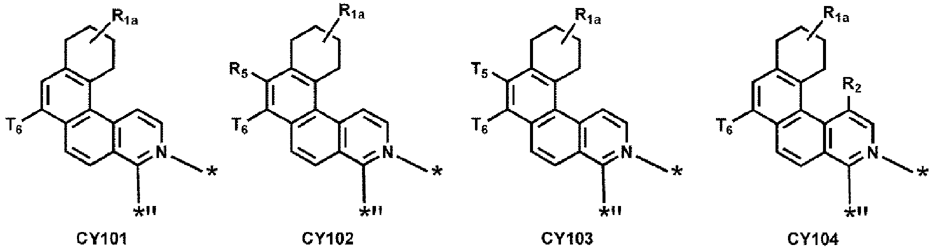 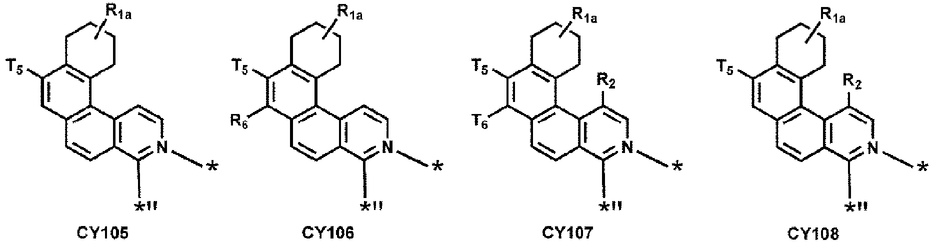
dans lesquelles, dans les formules CY1 à CY108,
T₂ à T₈ représentent chacun indépendamment :
un groupe fluoro (-F) ; ou
un groupe C₁-C₂₀ alkyle fluoré, un groupe C₃-C₁₀ cycloalkyle fluoré, un groupe C₂-C₁₀ hétérocycloalkyle fluoré, ou un groupe phényle fluoré, chacun non substitué ou substitué par un atome de deutérium, un groupe C₁-C₂₀ alkyle, un groupe C₃-C₁₀ cycloalkyle, un groupe C₂-C₁₀ hétérocycloalkyle, un groupe phényle, ou toute combinaison de ceux-ci ; ou
chacun des groupes R₂ à R₈ et R₁ₐ sont les mêmes que ceux décrits dans la revendication 1, et R₂ à R₈ ne représente pas un atome d'hydrogène,
^{∗} indique un site de liaison à Ir dans la formule 1, et
^{∗}" indique un site de liaison à un atome voisin dans la formule 1.

7. Composition selon l'une quelconque des revendications 1 à 6, un groupe représenté par 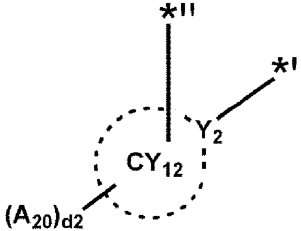 dans la formule 1 représentant un groupe représenté par l'une des formules A(1) à A(7) : 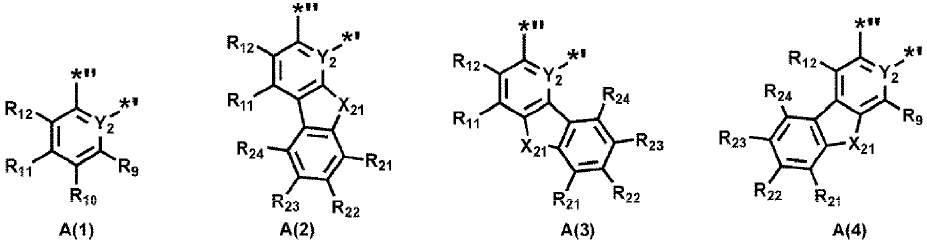 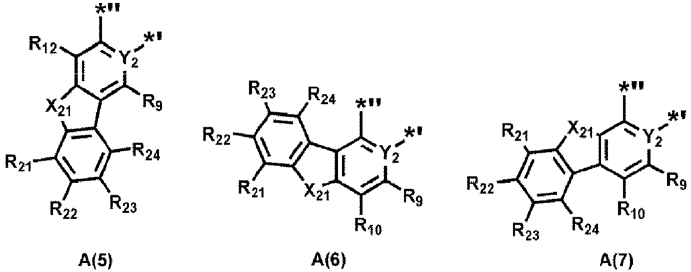
dans lesquelles, dans les formules A(1) à A(7),
Y₂ représente un atome C,
X₂₁ représente un atome O, un atome S, un groupe N(R₂₅), C(R₂₅)(R₂₆) ou Si(R₂₅)(R₂₆),
chacun des groupes R₉ à R₁₂ et R₂₁ à R₂₆ sont les mêmes que ceux décrits en lien avec A₂₀ dans la revendication 1,
^{∗}' indique un site de liaison à Ir dans la formule 1, et
^{∗}" indique un site de liaison à un atome voisin dans la formule 1 ; et/ou
ledit premier composé comprenant au moins l'un des composés 1 à 53 :

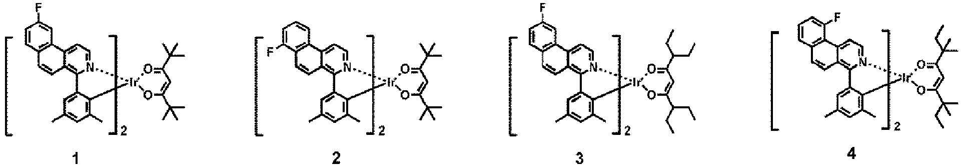

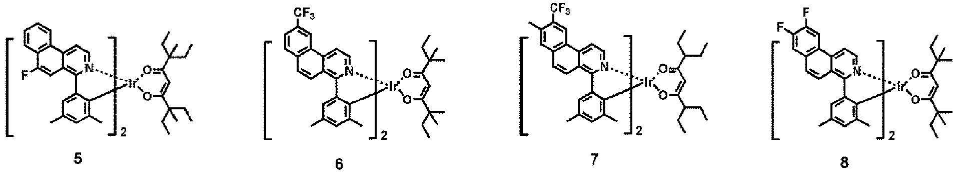

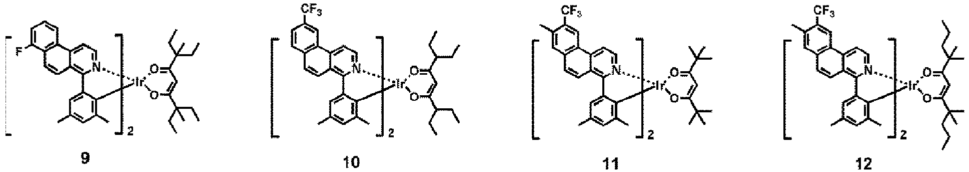

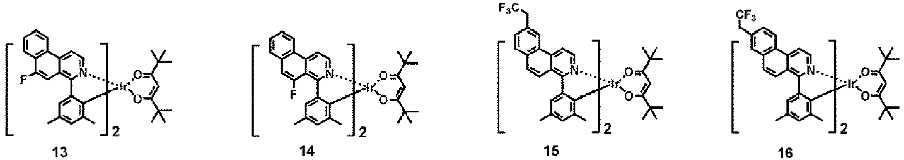

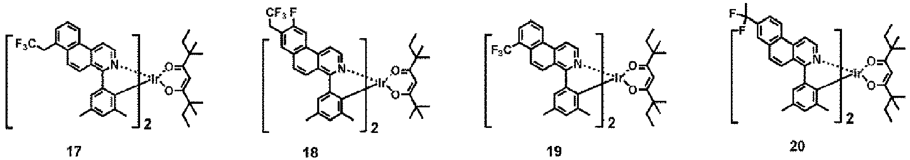

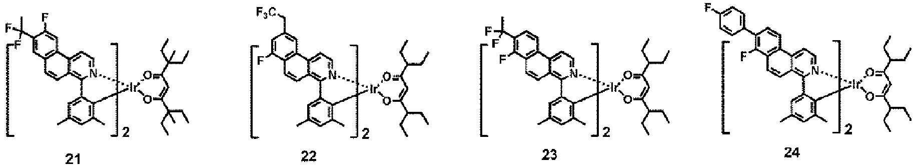

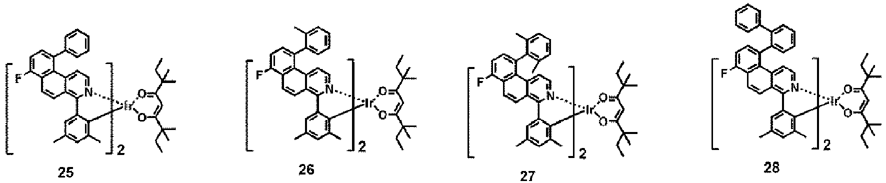

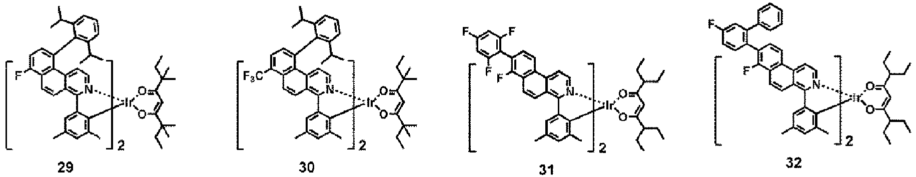

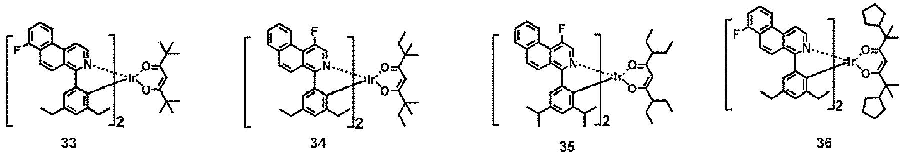

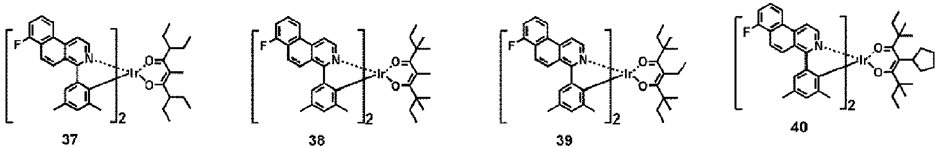

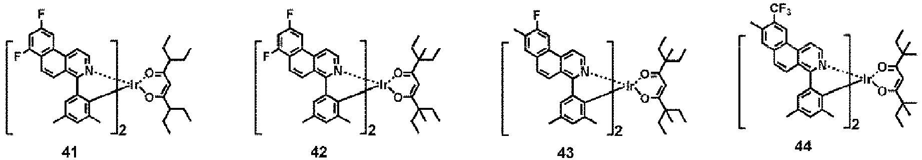

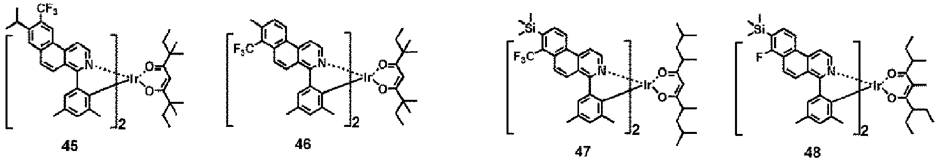

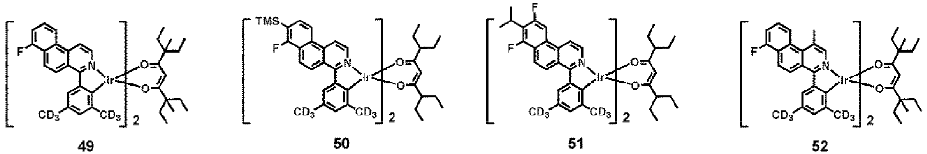

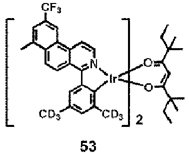

8. Composition selon l'une quelconque des revendications 1 à 7,
Ar₁, Ar₂, et Ar₁₁ dans les formules 2 et 3 représentant chacun indépendamment un groupe dérivé i) d'un premier noyau non substitué ou substitué par au moins un groupe R₆₁, ii) d'un second noyau non substitué ou substitué par au moins un groupe R₆₁, iii) d'un groupe cyclique condensé dans lequel deux premiers noyaux ou plus sont condensés l'un à l'autre, non substitué ou substitué par au moins un groupe R₆₁, iv) d'un groupe cyclique condensé dans lequel deux seconds noyaux ou plus sont condensés l'un à l'autre, non substitué ou substitué par au moins un groupe R₆₁, ou v) d'un groupe cyclique condensé dans lequel au moins un premier noyau et au moins un second noyau sont condensés l'un à l'autre, non substitué ou substitué par au moins un groupe R₆₁,
Ar₅ et Ar₁₂ dans les formules 2 et 3 représentant chacun indépendamment une liaison simple ou un groupe dérivé i) d'un premier noyau non substitué ou substitué par au moins un groupe R₆₅, ii) d'un second noyau non substitué ou substitué par au moins un groupe R₆₅, iii) d'un groupe cyclique condensé dans lequel deux premiers noyaux ou plus sont condensés l'un à l'autre, non substitué ou substitué par au moins un groupe R₆₅, iv) d'un groupe cyclique condensé dans lequel deux seconds noyaux ou plus sont condensés l'un à l'autre, non substitué ou substitué par au moins un groupe R₆₅, ou v) d'un groupe cyclique condensé dans lequel au moins un premier noyau et au moins un second noyau sont condensés l'un à l'autre, non substitué ou substitué par au moins un groupe R₆₅, ou n'existant pas,
le noyau CY₂ et le noyau CY₃ dans la formule 2 représentant chacun indépendamment i) un premier noyau, ii) un second noyau, iii) un groupe cyclique condensé dans lequel deux premiers noyaux ou plus sont condensés l'un à l'autre, iv) un groupe cyclique condensé dans lequel deux seconds noyaux ou plus sont condensés l'un à l'autre, ou v) un groupe cyclique condensé dans lequel au moins un premier noyau et au moins un second noyau sont condensés l'un à l'autre,
Het1 dans la formule 3 représentant un groupe dérivé i) d'un premier noyau, ii) d'un groupe cyclique condensé dans lesquels deux premiers noyaux ou plus sont condensés les uns aux autres, ou iii) d'un groupe cyclique condensé dans lequel au moins un premier noyau et au moins un second noyau sont condensés l'un à l'autre,
le premier noyau représentant un groupe imidazole, un groupe pyrazole, un groupe thiazole, un groupe isothiazole, un groupe oxazole, un groupe isoxazole, un groupe pyridine, un groupe pyrazine, un groupe pyridazine, un groupe pyrimidine, un groupe triazole, un groupe tétrazole, un groupe oxadiazole, un groupe triazine ou un groupe thiadiazole, et
le second noyau représentant un groupe benzène, un groupe cyclopentadiène, un groupe pyrrole, a un groupe furane, un groupe thiophène ou un groupe silole.

9. Composition selon l'une quelconque des revendications 1 à 8,
Ar₁, Ar₂ et Ar₁₁ dans les formules 2 et 3 représentant chacun indépendamment un groupe C₃-C₆₀ cyclique riche en électrons π non substitué ou substitué par au moins un groupe R₆₁,
Ar₅ et Ar₁₂ dans les formules 2 et 3 représentant chacun indépendamment une liaison simple ou un groupe C₃-C₆₀ cyclique riche en électrons π non substitué ou substitué par au moins un groupe R₆₅, ou n'existant pas, et
le noyau CY₂ et le noyau CY₃ dans la formule 2 représentant chacun indépendamment un groupe C₃-C₆₀ cyclique riche en électrons π.

10. Composition selon l'une quelconque des revendications 1 à 9, un groupe représenté par l'une des formules 2-1 à 2-93 : 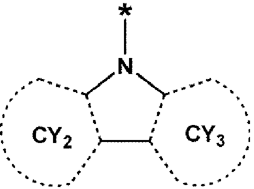 dans la formule 2 étant représenté par 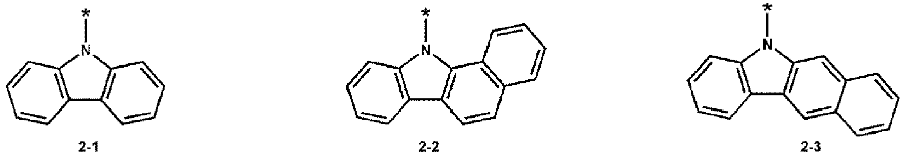 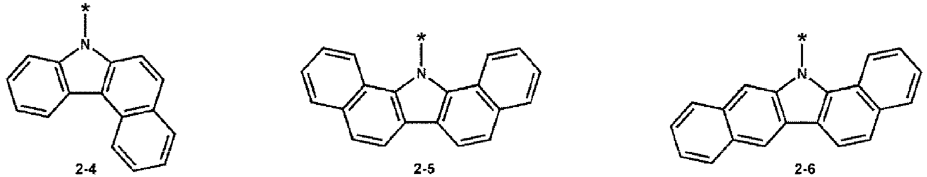 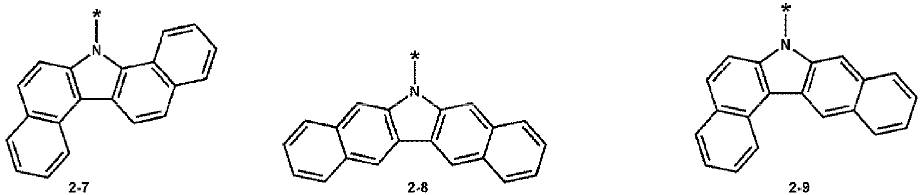 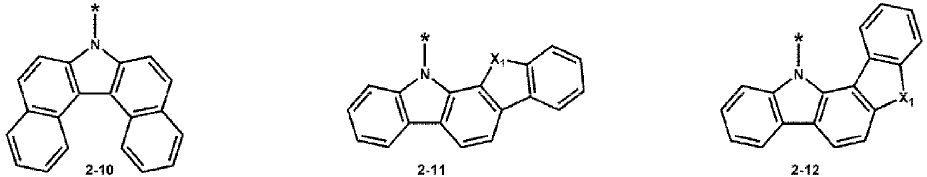 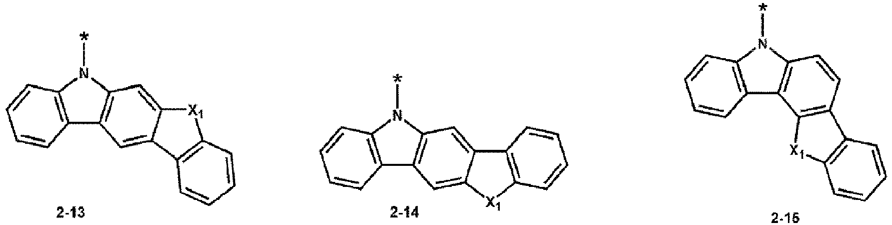 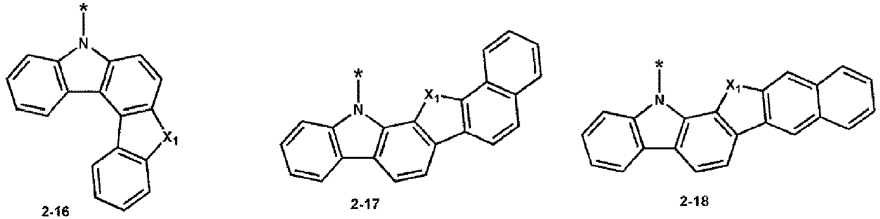 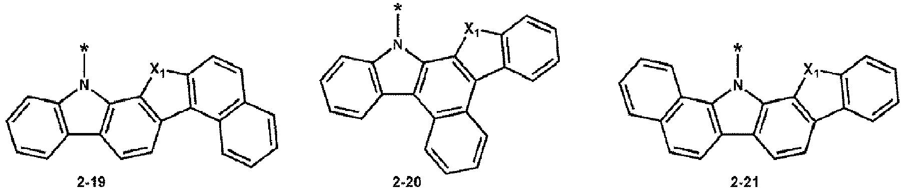 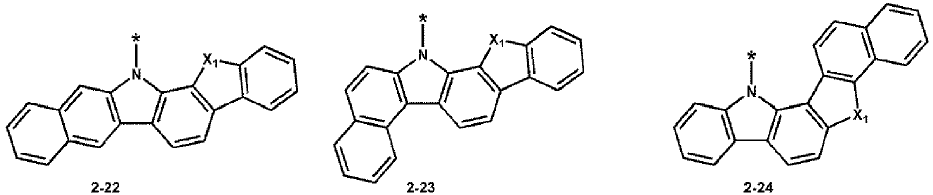 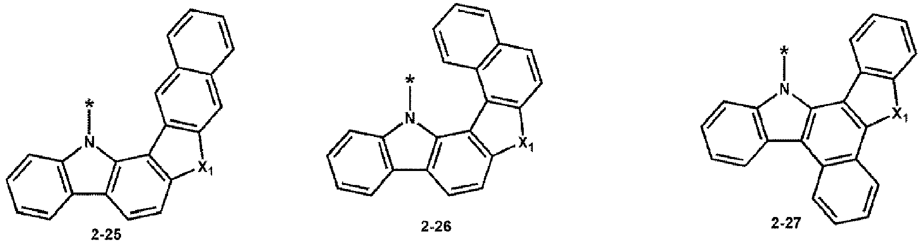 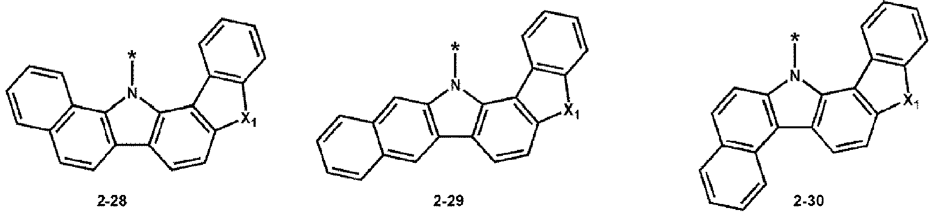 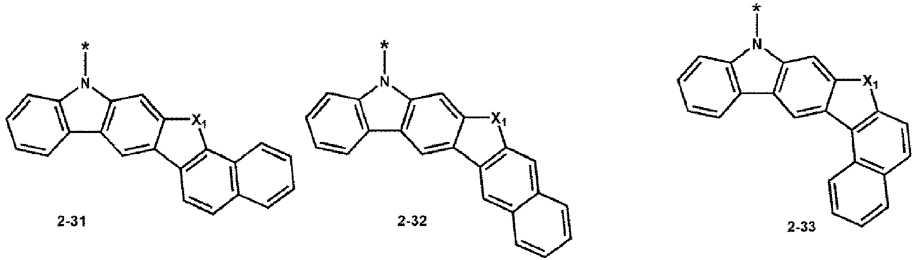 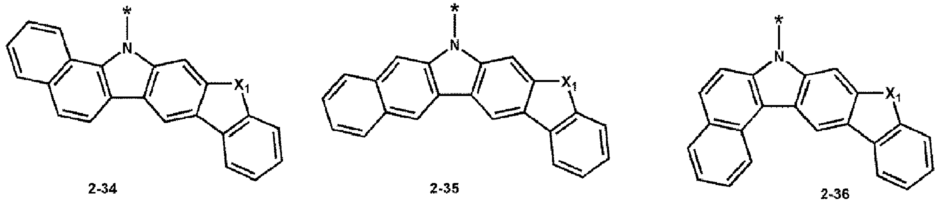 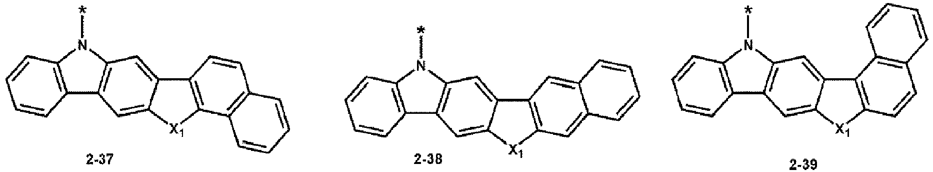 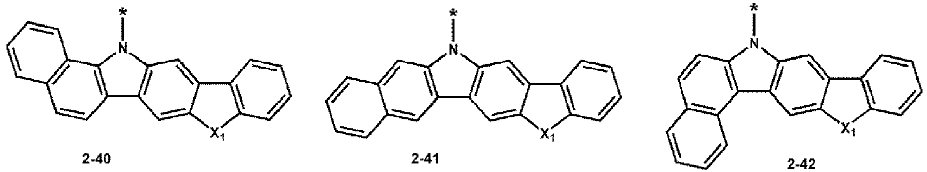 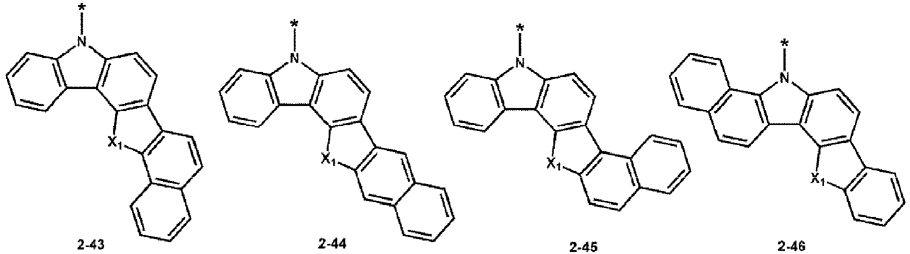 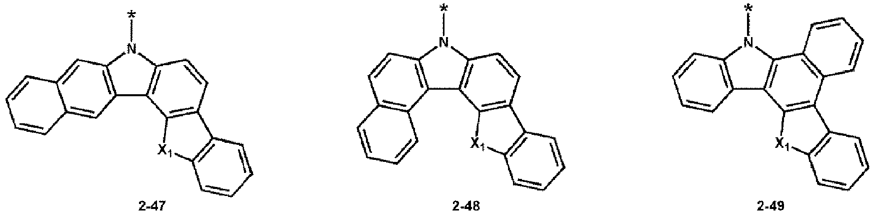 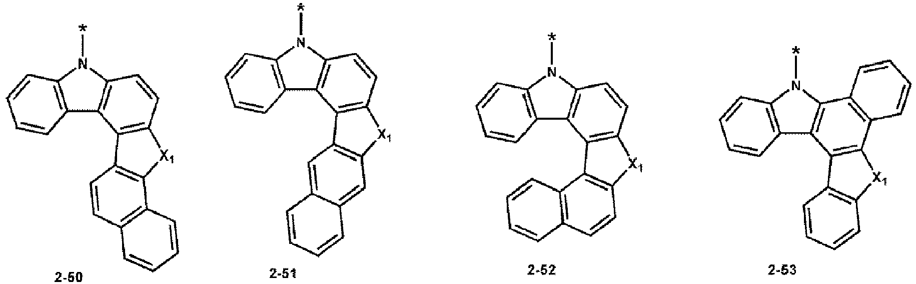 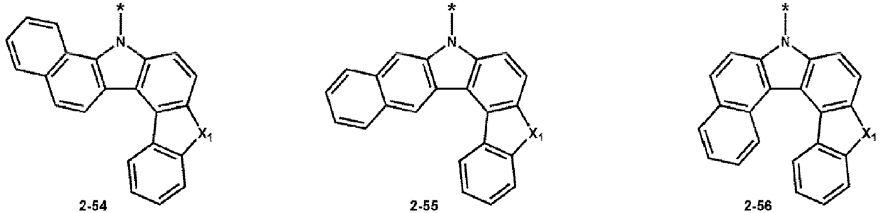 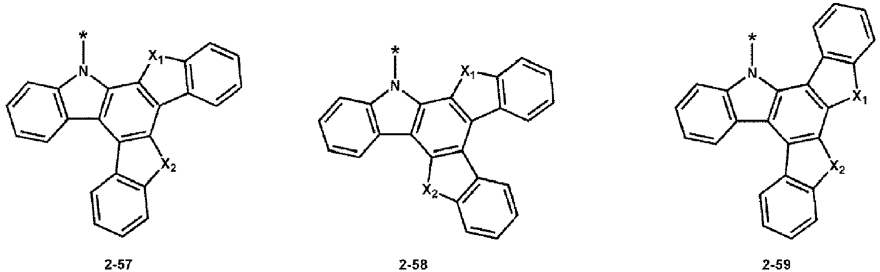 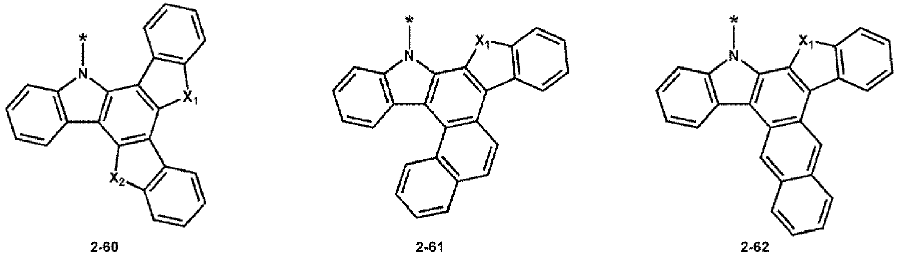 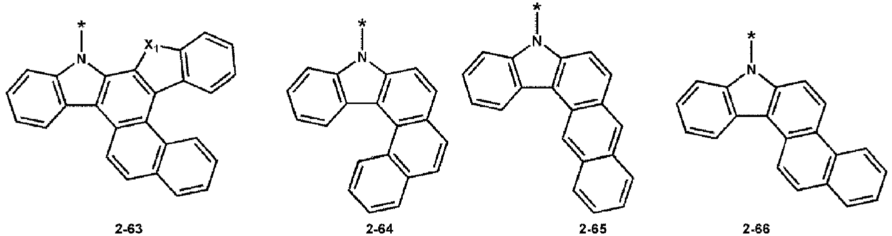 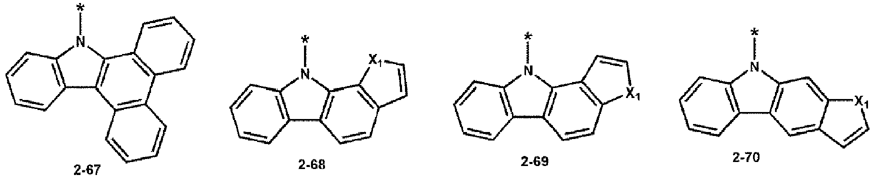 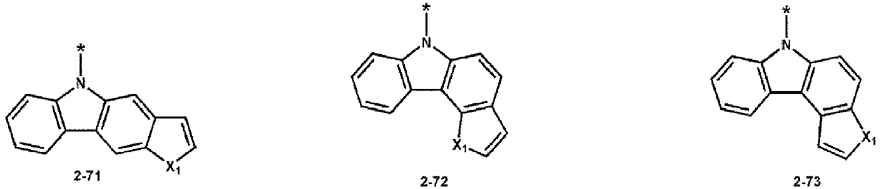 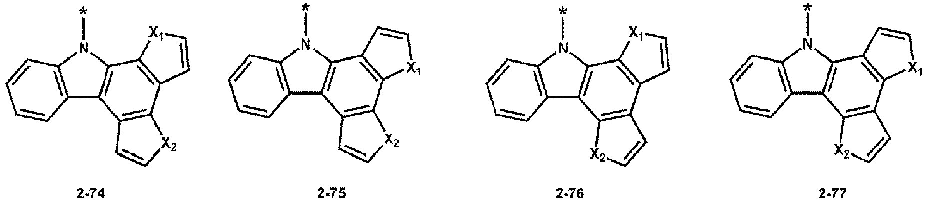 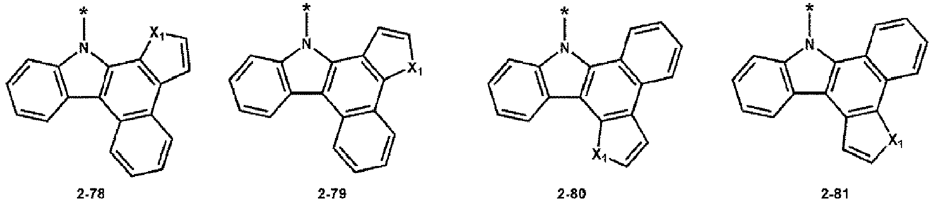 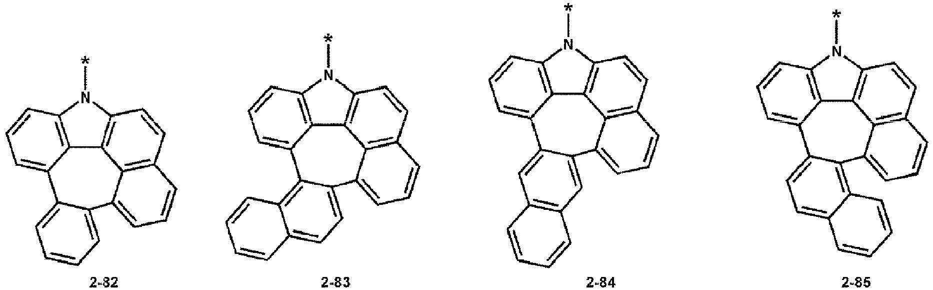 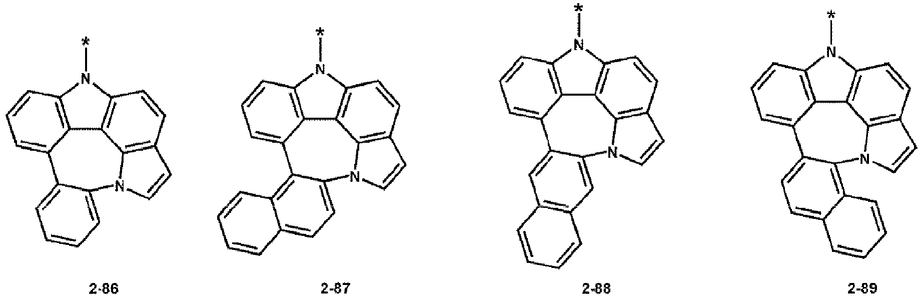 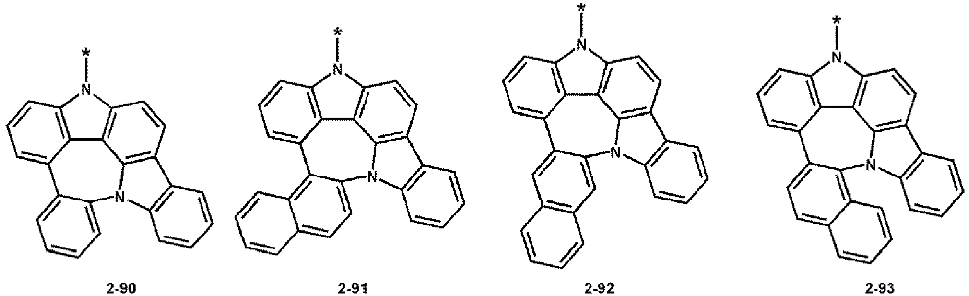
dans lesquelles, dans les formules 2-1 à 2-93,
X₁ représente un atome O, un atome S, un groupe N(R₃₁), C(R₃₁)(R₃₂) ou Si(R₃₁)(R₃₂),
X₂ représente un atome O, un atome S, un groupe N(R₃₃), C(R₃₃)(R₃₄) ou Si(R₃₃)(R₃₄),
R₃₁ à R₃₄ sont les mêmes que ceux décrits en lien avec R₃₀ dans la revendication 1, et
^{∗} indique un site de liaison à Ar₁ ou Ar₂ dans la formule 2.

11. Composition selon l'une quelconque des revendications 1 à 10,
Het1 dans la formule 3 représentant un groupe dérivé de l'une des formules 3-1 à 3-40 : 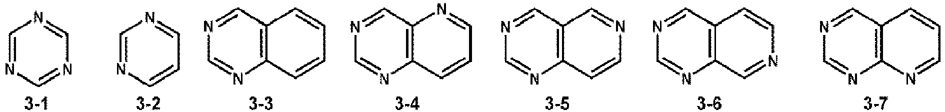 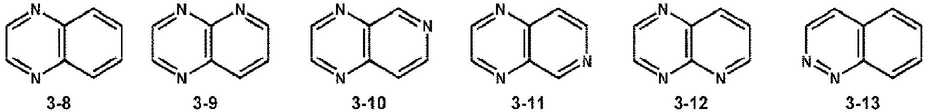 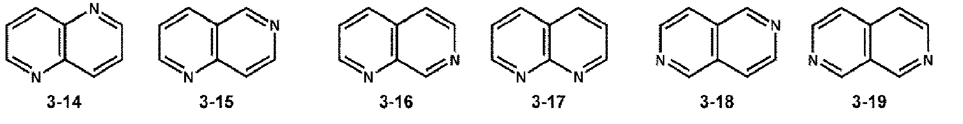 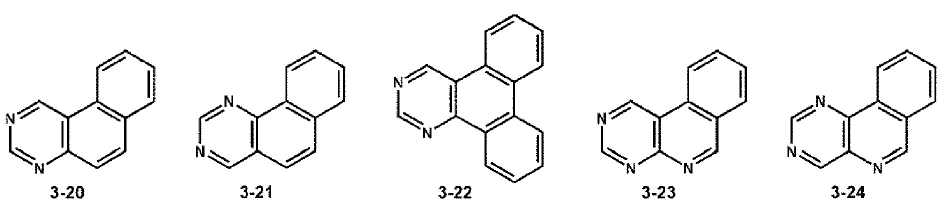 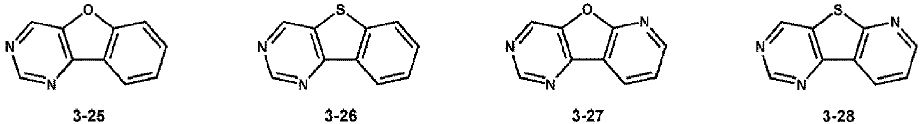 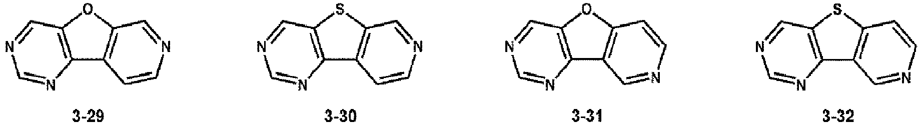 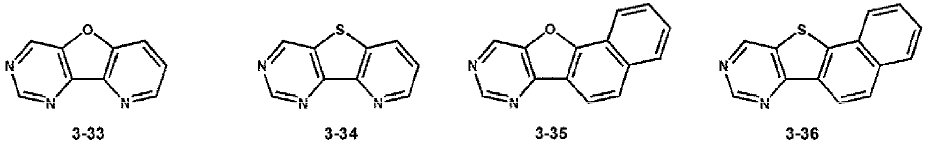 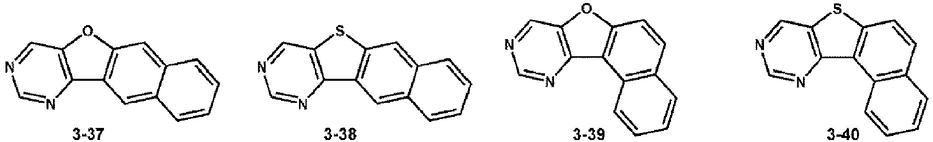 ; et/ou
a11 et m dans la formule 3 représentant chacun indépendamment un entier valant de 1 à 3.

12. Composition selon l'une quelconque des revendications 1 à 11,
R₂₀, R₃₀, R₆₁, R₆₅, R₆₆, R₇₀ et R₈₀ dans les formules 2 et 3 représentant chacun indépendamment :
un atome d'hydrogène ou de deutérium ;
un groupe C₁-C₂₀ alkyle ou un groupe C₁-C₂₀ alcoxy, chacun non substitué ou substitué par un atome de deutérium, un groupe phényle, un groupe naphtyle, un groupe anthracényle, un groupe phénanthrényle, un groupe triphénylényle, un groupe fluorényle, un groupe di(C₁-C₁₀ alkyl)fluorényle, un groupe di(C₆-C₆₀ aryl)fluorényle, un groupe dibenzosilolyle, un groupe di(C₁-C₁₀ alkyl)dibenzosilolyle, un groupe di(C₆-C₆₀ aryl)dibenzosilolyle, un groupe carbazolyle, un groupe (C₁-C₁₀ alkyl)carbazolyle, un groupe (C₆-C₆₀ aryl)carbazolyle, un groupe dibenzofuranyle, un groupe dibenzothiophényle, un groupe biphényle, un groupe terphényle, -N(Q₃₁)(Q₃₂), ou toute combinaison de ceux-ci ;
un groupe C₃-C₆₀ cyclique riche en électrons π, non substitué ou substitué par un atome de deutérium, un groupe C₁-C₂₀ alkyle, un groupe C₁-C₂₀ alcoxy, un groupe phényle, un groupe naphtyle, un groupe anthracényle, un groupe phénanthrényle, un groupe triphénylényle, un groupe fluorényle, un groupe di(C₁-C₁₀ alkyl)fluorényle, un groupe di(C₆-C₆₀ aryl)fluorényle, un groupe dibenzosilolyle, un groupe di(C₁-C₁₀ alkyl)dibenzosilolyle, un groupe di(C₆-C₆₀ aryl)dibenzosilolyle, un groupe carbazolyle, un groupe (C₁-C₁₀ alkyl)carbazolyle, un groupe (C₆-C₆₀ aryl)carbazolyle, un groupe dibenzofuranyle, un groupe dibenzothiophényle, un groupe biphényle, un groupe terphényle, -N(Q₃₁)(Q₃₂), ou toute combinaison de ceux-ci ; ou
-N(Q₁)(Q₂).

13. Composition selon l'une quelconque des revendications 1 à 12,
ledit deuxième composé comprenant au moins l'un des composés H1-1 à H1-72 et ledit troisième composé comprenant au moins l'un des composés H2-1 à H2-61 :

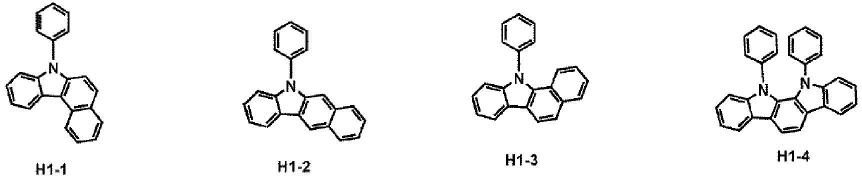

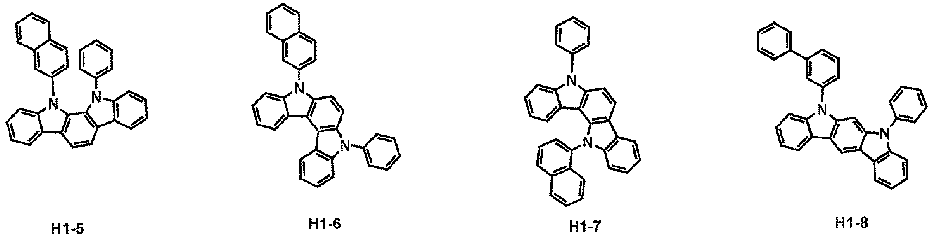

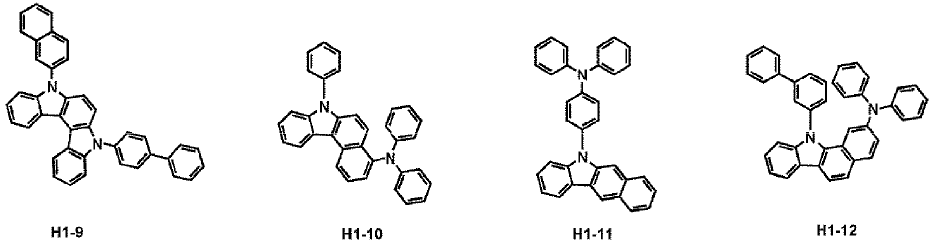

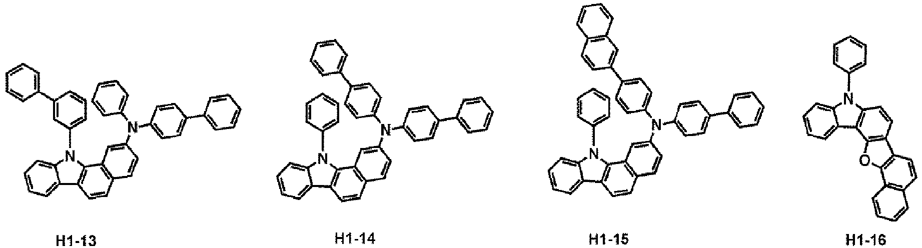

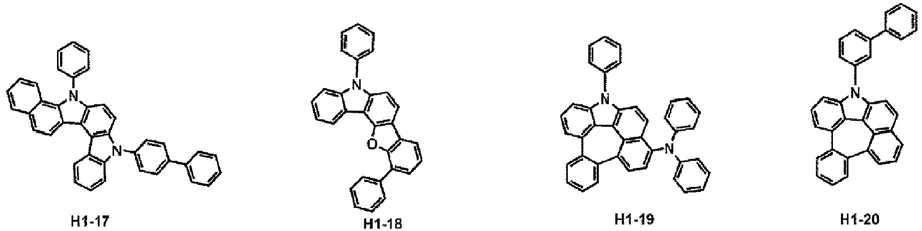

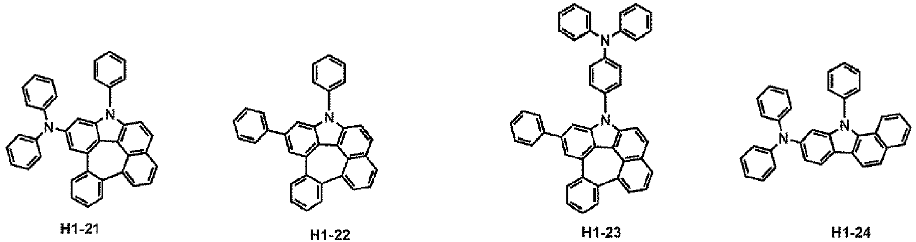

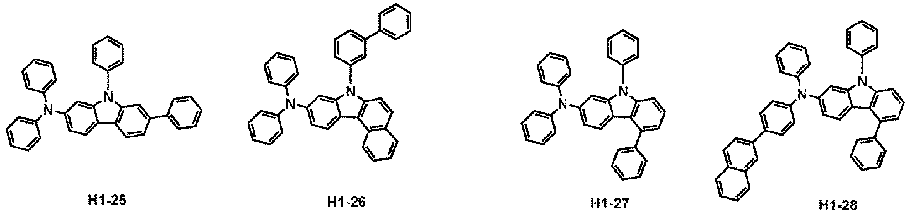

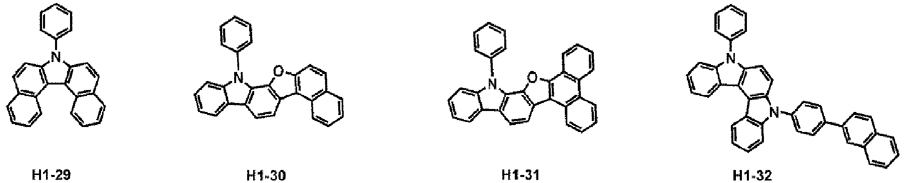

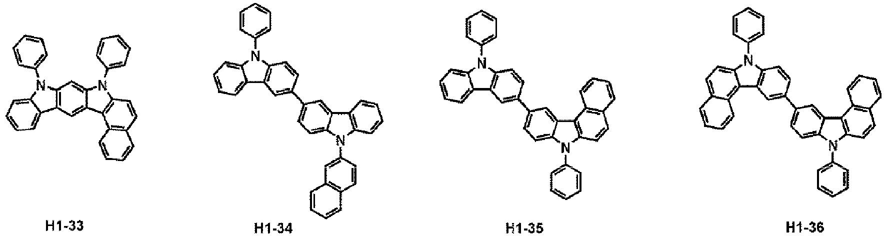

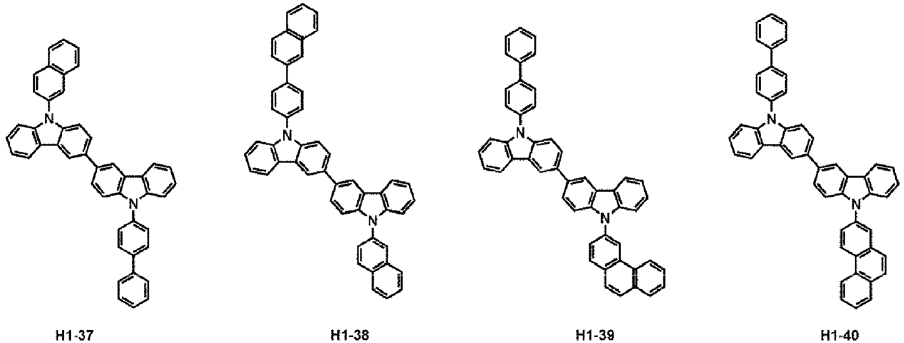

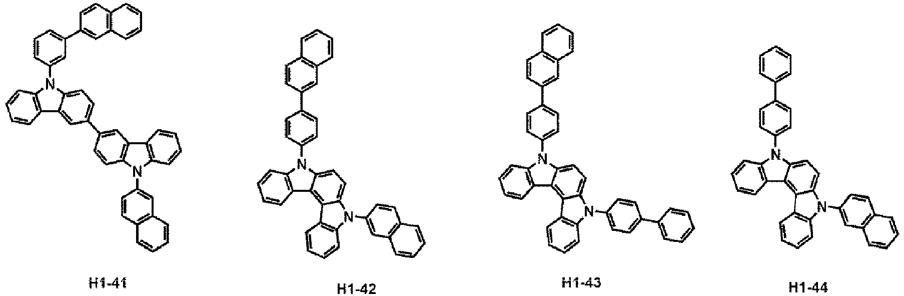

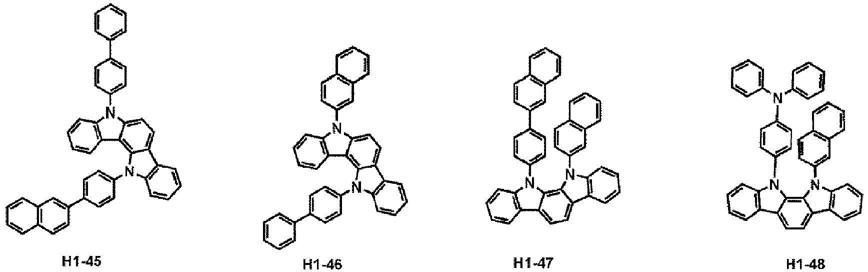

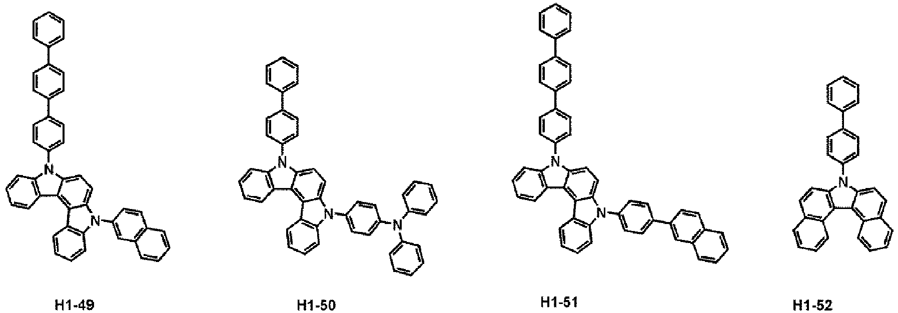

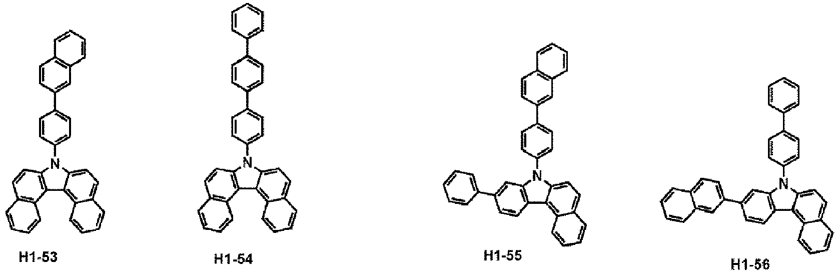

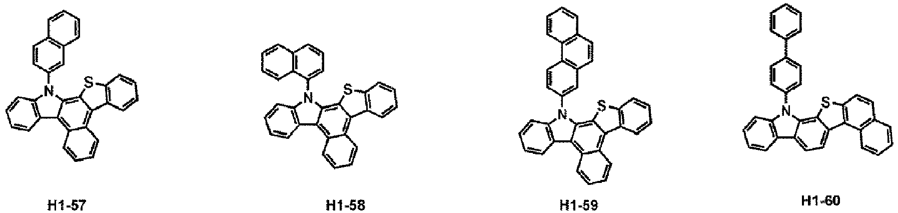

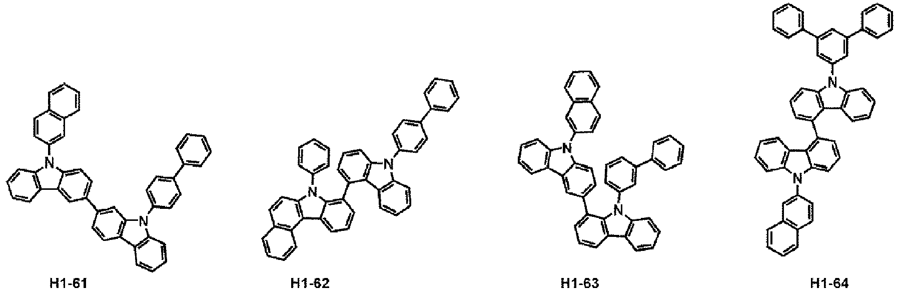

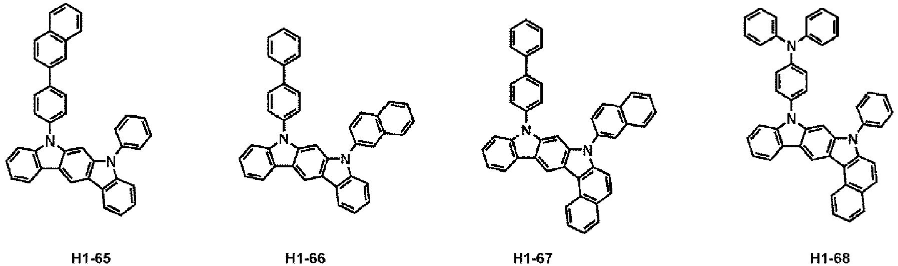

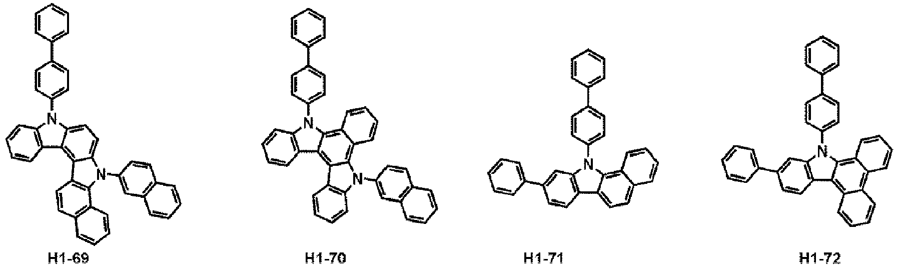

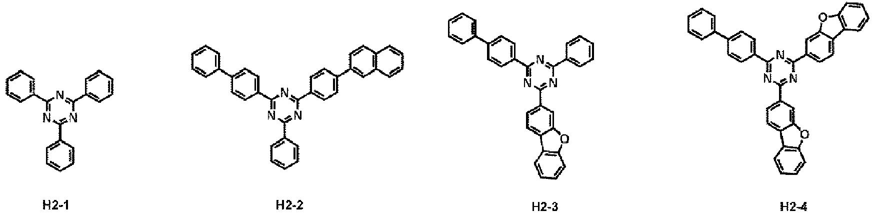

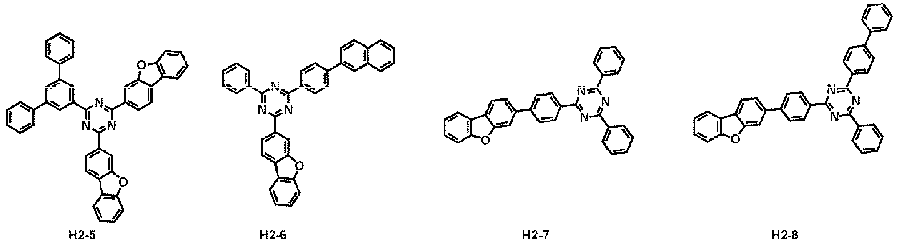

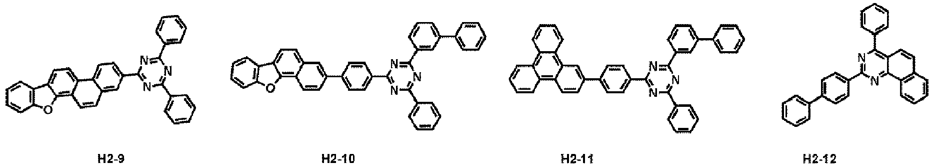

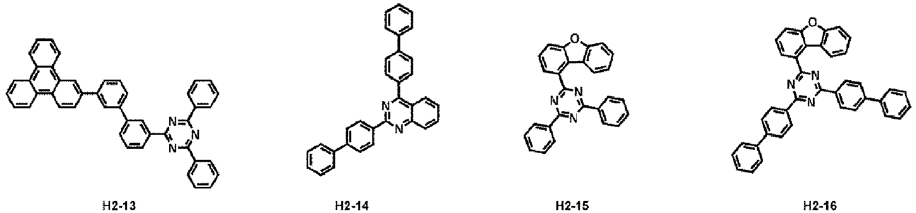

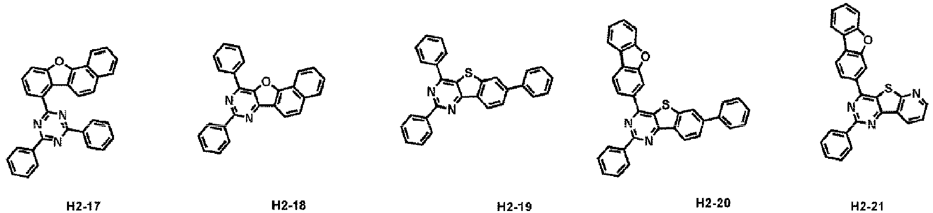

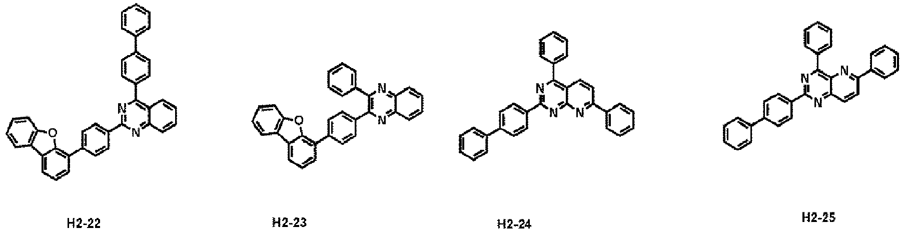

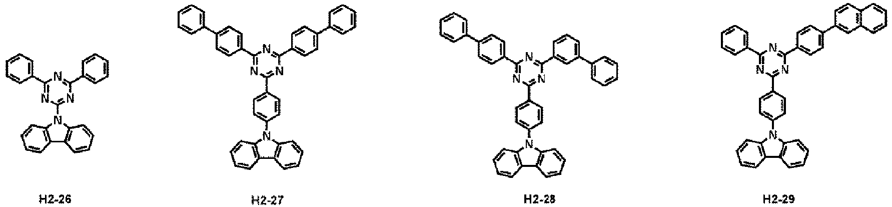

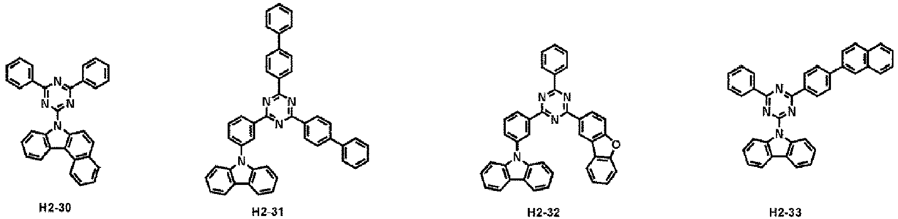

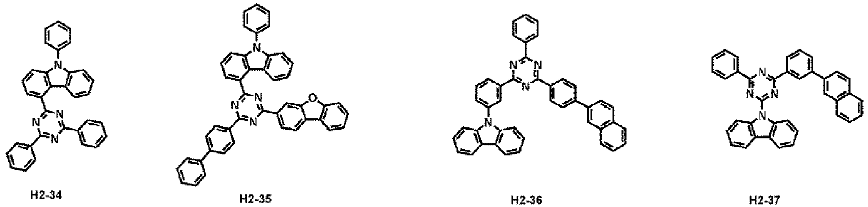

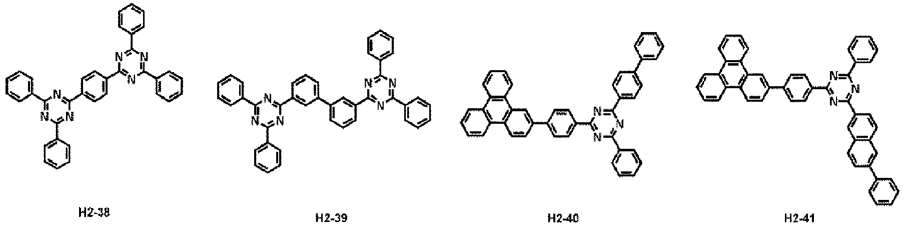

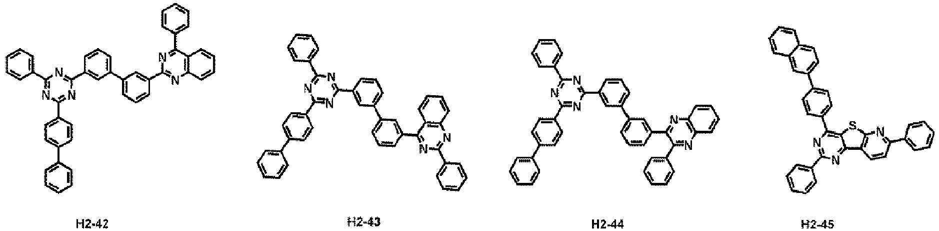

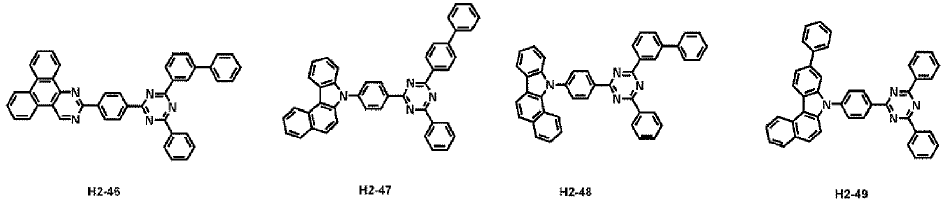

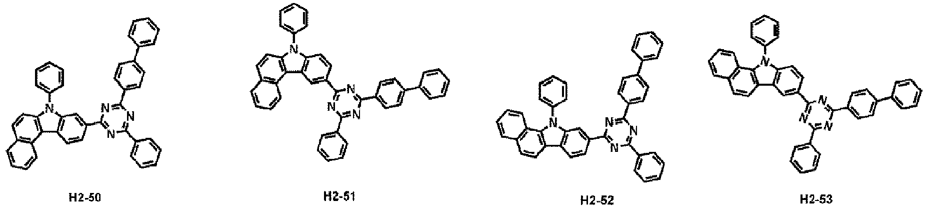

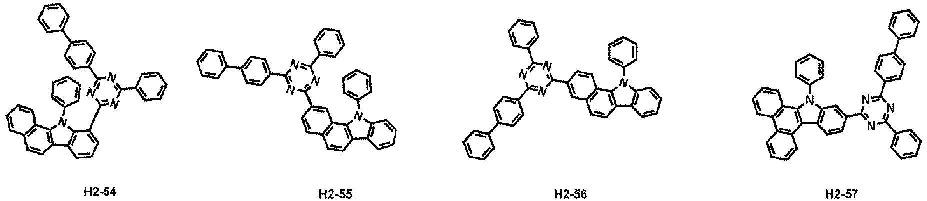

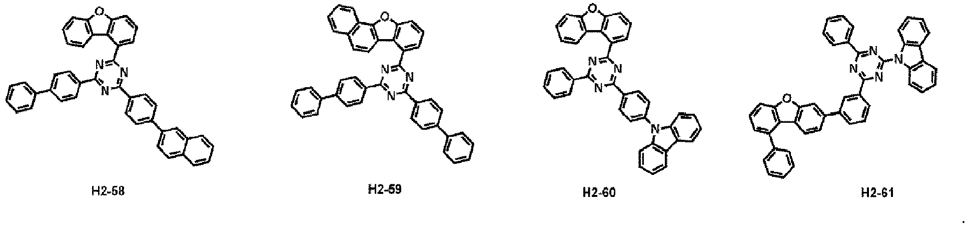

14. Dispositif électroluminescent organique comprenant :
une première électrode ;
une seconde électrode ; et
une couche organique disposée entre la première électrode et la seconde électrode et comprenant une couche d'émission,
ladite couche organique comprenant la composition selon l'une quelconque des revendications 1 à 13 ;
de préférence
ladite première électrode étant une anode,
ladite seconde électrode étant une cathode,
ladite couche organique comprenant en outre une région de transport de trous entre la première électrode et la couche d'émission et une région de transport d'électrons entre la couche d'émission et la seconde électrode,
ladite région de transport de trous comprenant une couche d'injection de trous, une couche de transport de trous, une couche de blocage d'électrons, une couche tampon, ou toute combinaison de celles-ci, et
ladite région de transport d'électrons comprenant une couche de blocage de trous, une couche de transport d'électrons, une couche d'injection d'électrons, ou toute combinaison de celles-ci.

15. Dispositif électroluminescent organique selon la revendication 14,
ladite couche d'émission comprenant la composition selon l'une quelconque des revendications 1 à 13 ; et/ou
ladite couche d'émission émettant de la lumière rouge.
